**Europäisches Patentamt**

**European Patent Office**

**Office européen des brevets**

(19)

(11) Publication number : **0 482 853 A2**

(12) # EUROPEAN PATENT APPLICATION

(21) Application number : **91309684.8**

(22) Date of filing : **18.10.91**

(51) Int. Cl.⁵ : **G06F 11/14**

(30) Priority : **22.10.90 US 602845**

(43) Date of publication of application :
**29.04.92 Bulletin 92/18**

(84) Designated Contracting States :
**DE FR GB**

(71) Applicant : **International Business Machines
Corporation
Old Orchard Road
Armonk, N.Y. 10504 (US)**

(72) Inventor : **Williams, Michael Stephen
11200 Barrington Way
Austin, Texas 78759 (US)**

(74) Representative : **Blakemore, Frederick
Norman
IBM United Kingdom Limited Intellectual
Property Department Hursley Park
Winchester Hampshire SO21 2JN (GB)**

(54) **Method and apparatus for storage device management.**

(57) Disclosed is a volume managing system for computer storage devices. Physical volumes are logically partitioned, with multiple copies of data being maintained for system recovery purposes. A scheme for monitoring, updating, and recovering data in the event of data errors is achieved by maintaining a volume group status area on each physical volume, the status area reflecting status for all physical volumes defined for a given volume group. Updates to this status area occur serially, thereby protecting against all volumes becoming corrupted at once. A method of updating subsequent status changes, while the first status change is still in progress, provides for improved system throughput.

FIG. 1

This invention relates in general to data processing methods for use in data processing systems for managing physical storage space on a storage device and in particular to an improved method for maintaining redundant data on these storage devices.

The prior art discloses a number of data processing systems which employ disk storage devices for storing data employed by the system. These devices store various types of information such as the operating system under which the microprocessor operates, different application programs that are run by the system and information that is created and manipulated by the various application programs.

Disk storage devices have generally comprised one or more magnetic or optical disks having a plurality of concentric tracks which are divided into sectors or blocks. Each surface of a disk generally stores information and disk drives are configured with multiple disks and multiple heads to permit one access mechanism to position the heads to one of several concentric recording tracks. Most current disk drives employ an addressing convention that specifies a physical storage location by the number of the cylinder (CC), the number of the magnetic head (H) and the sector number (S). The number of the cylinder is also the number of the tracks where multiple heads are employed and the head number is equivalent to the disk surface in a multi-disk configuration. The "CCHS" addressing format is employed independent of the capacity of the disk file since it is capable of addressing any configuration that may exist.

The capacity of disk storage devices measured in terms of bytes is dependent on the recording technology employed, the track density, disk size and the number of disks. As a result disk drives are manufactured in various capacities, data rates and access times.

Most data processing systems generally employ a number of disk drives for storing data. Since each device is a failure independent unit, it is sometimes advantageous to spread the data to be stored over a number of smaller capacity drives rather than having one large capacity device. This configuration permits a copy of critical data to be stored in a separate device which can be accessed if the primary copy is not available.

A concept known as mirroring can be used to support replication and recovery from media failures, as is described in Mirroring of Data on a partition basis (31514), Research Disclosure # 315, July 1990, wherein data is mirrored or replicated on a partition(physically contiguous collection of bytes) basis. This provides even greater flexibility in backup and recovery of critical data because of its finer granularity in defining storage areas to be duplicated.

The task of allocating disk storage space in the system is generally the responsibility of the operating system. Unix (Trademark of UNIX System Laboratories, Inc.) type operating system such as the IBM AIX (Trademark of IBM) operating system which is employed on the IBM Risc System/6000 (Trademark of IBM) engineering workstation have a highly developed system for organizing files. In Unix parlance a "file" is the basic structure that is used for storing information that is employed in the system. For example a file may be a directory which is merely a listing of other files in the system, or a data file. Each file must have a unique identifier. A user assigns a name to a file and the operating system assigns an inode number and a table is kept to translate names to numbers. A file name is merely a sequence of characters. Files may be organized by assigning related files to the same directory, which characteristically is another file with a name and which merely lists the name and inode number of the files stored in that directory.

The AIX operating system also organizes file directories in groups which are given a file name since they are also considered to be a file. The resultant organization is known as a hierarchical file system which resembles an inverted tree structure with the root directory at the top and a multi-level branching structure descending from the root. Both directories and non-directory type files can be stored at each level. Files that are listed by name in a directory at one level are located at the next lower level. A file is identified in the hierarchical file system by specifying its name preceded by the description of the path that is traced from the root level to the named file. The path descriptor is in terms of the directory names through which the path descends. If the current directory is the root directory the full path is expressed. If the current directory is some intermediate directory, the path description may be shortened to define the shorter path.

The various files of the operating system are themselves organized in a hierarchical file system. For example a number of subdirectories descend from the root directory and list files that are related. The subdirectories have names such as / which stores the AIX kernel files; /bin which store the AIX utilities, /tmp which stores temporary files; and /u which store the users files.

As indicated previously the task of assigning AIX files to specific addressable storage units on the disk drive is the responsibility of the operating system. Prior to actually assigning a file to disk blocks, a determination is made to divide the available disk storage space of the storage subsystem into a number of different areas so each area can store files having the same general function. These assigned areas are often referred to as virtual disks or logical volumes. The term mini-disk is used in the IBM RT system and the term A-disk in IBM's VM system. The term logical volume is used on IBM's AIX system.

Several advantages are obtained from the standpoint of management and control when files having the same characteristics are stored in one defined area of the disk drive. For example, a certain group of files may not be changed at all over a certain period time while others may change quite rapidly so that they would be backed up at different times. It is also simpler for the administrator to assign these files to a virtual disk or logical volume in accordance with their function and manage all the files in one group the same. These are just two examples of many where the provision of virtual disks/logical volumes simplifies the administration and control by the operating system of the storage of files in the storage subsystem.

Conventional methods for protecting the data integrity in data processing systems are not efficient in a logical volume environment. What an end user perceives to be a single volume of data could actually have data spread across numerous physical volumes. US-A- 4,507,751 describes a conventional log write ahead method used in a conventional database.

Methods for extending data integrity to a virtual disk system are shown in US-A- 4,498,145, US-A-4,4945,474 both and US-A- 4,930,128. However these methods introduce considerable overhead in maintaining error logs and recovery procedures. These systems are further limited in that a fault or error in the data merely results in the data being restored to an older version of the data, thereby loosing the updated data.

Other methods provided data redundancy, where an old and new copy of data is maintained. Once the new copy of data is verified to be valid, it becomes the old copy and what was once old copy can now be overwritten with new data. Thus, the old and new copies ping-pong back and forth in their roles of having old or new data. As the number of physical data volumes is increased under this method, severe overhead impacts system performance and throughput in maintaining this technique.

It is thus desirable to provide for a data processing system which has a virtual disk/logical volume data system with data redundancy for error recovery that has a minimal impact on system performance.

According, the present invention provides a method for managing a plurality of data storage devices associated with a computer system and having a first physical volume and subsequent physical volumes and being partitioned into one or more logical volumes, each of said logical volumes being further partitioned into one or more logical partitions each of which comprises one or more physical partitions of said storage devices, said method comprising the steps of:

determining status information for each of said physical partitions and recording said status information in a memory of said computer system;

recording said status information in a status area existing on each of said data storage devices;

creating updated status information when a write request is generated for any of said physical partitions;

updating said status area on said first physical volume with said updated status information; and

updating said status area of each subsequent physical volume within said storage devices in succession with said updated status information, wherein if a second or subsequent write request is received prior to completing an update of each of said storage device status areas as a result of a prior write request, said status information is updated in said computer memory and used in updating said next succeeding physical volume status area.

The present invention also provides a computer system including means for managing a plurality of data storage devices associated with said computer system and having a first physical volume and subsequent physical volumes and being partitioned into one or more logical volumes, each of said logical volumes being further partitioned into one or more logical partitions each of which comprises one or more physical partitions of said data storage devices, said managing means comprising:

means for maintaining status information for each of said physical partitions in a memory of said computer system;

recording means for recording said status information in a status area existing on each of said data storage devices;

means for creating updated status information when a write request is generated for any of said physical partitions;

first update means for updating said status area on said first physical volume with said updated status information; and

subsequent update means for updating said status area of each subsequent physical volume within said data storage devices in succession with said updated status information, wherein if a second or subsequent write request is received prior to completing an update of each of said data storage device status areas as a result of a prior write request, said status information is updated in said computer memory and used in updating said next succeeding physical volume status area.

The present invention is directed to the aforementioned performance problems which are introduced in a system which maintains multiple copies of data. In accordance with the new data processing method, a physical partition comprising a plurality of physically contiguous disk blocks or sectors is established as the basic unit of space allocation, while the disk block is kept as the basic unit of addressability of the disk file. A plurality of physical partitions are grouped together and called a physical volume. A plurality of physical volumes that are grouped together is referred to as a volume group. The number of physical blocks contained in each physical partition and the number of physical partitions in each physical volume is fixed when the physical volume is installed into the volume group. Stated differently, all physical partitions in a physical volume group are the same size. Different volume groups may have different partition sizes.

When an AIX file system, i.e., a group of related files, is to be installed on the system, a logical volume is created which includes only the minimum number of physical partitions on the disk required to store the file system. As more storage space is needed by the file system, the logical volume manager allocates an additional physical partition to the logical volume. The individual physical partitions of the logical volume may be on different disk drives.

A partition map is maintained by the logical volume manager which specifies the physical address of the beginning of each physical partition in terms of its device address and block number on the device, to assist in correlating logical addresses provided by the system to real addresses on the disk file.

Data being stored within the system can be mirrored, where redundant copies of the data are stored in separate physical partitions. Mirroring is achieved by adding an additional structuring mechanism between the logical volume and the physical partitions therewithin. The logical volume is instead made up of logical partitions, which function identically to the physical partitions previously discussed. These logical partitions are then made up of one or more physical partitions. When more than one physical partition is associated with a logical partition, the logical partition is said to be mirrored. When a logical partition is mirrored then a request to read from a logical partition may read from any physical partition. These multiple, physical partitions are where the redundant copies of data are stored. Thus, a logical partition's data can be mirrored on any number of physical partitions associated therewith.

When a write request for a logical volume is received, data on all physical copies of the logical partition, i.e. all copies of the physical partitions, must be written before the write request can be returned to the caller or requestor. Whenever data on a logical volume is updated or written to, it is possible through system malfunctions or physical volume unavailability that any particular physical copy will have a write failure. This failure causes the data in this particular physical copy to be incorrect, and out of synchronization with other copies of the same data. When this occurs, this physical copy is said to be stale and cannot be used to satisfy a subsequent read request.

Status information regarding stale data must be stored on permanent storage so that the information is maintained through system crashes/reboots or power interruption. This stale information is stored in a Status Area(VGSA) that is written to all active physical volumes in the volume group. With mirroring, this volume group is a collection of physical volumes where the physical partitions may be allocated to make up the logical partitions of the logical volume. Each physical volume contains a copy of the VGSA so that any physical volume can be used to determine the state of any physical partition allocated to any logical volume in the volume group. A volume group may contain many physical volumes, and a change in the state of any physical partition will result in the updating of the VGSAs on each physical volume. In the present preferred embodiment, there is a limit of 32 physical volumes per volume group.

When a physical partition goes stale due to a write request that has some failure, the originating request must wait for all VGSAs to be updated with the new state information before being allowed to be returned to the caller. If the first request is actively updating VGSAs and a second request requires a VGSA update, it must wait until the first is completed, causing degradation in system performance. For example, in a worst case scenario, where the second request immediately followed the first request, the first request would take N x Q time(where N is the number of VGSAs to update and Q is the time required per VGSA) and the second request would similarly take N x Q time, resulting in a delay of 2N x Q for the second request to return to the originator.

One possible solution is to write the VGSAs in parallel. However, this allows for the possibility of loosing a majority of the VGSAs due to a system catastrophic failure, such as a power outage in the middle of the write, which could potentially corrupt all VGSAs and therefore loose the stale status information for all the physical partitions. Therefore, the VGSAs must be written serially to prevent this potential loss.

The present invention addresses this problem of system degradation, when updating multiple VGSAs serially, by using a concept hereinafter called the Wheel. The Wheel maintains and updates the VGSAs on all physical volumes in the volume group for a given request. The Wheel accepts requests, modifies a memory version of the VGSA as per that request, initiates the VGSA writes, and when all VGSAs have been updated for that request, finally returns that request to its originator. The Wheel also ensures that the request will not be held up longer than the time it takes to write N + 1 VGSAs( again, where N is the number of VGSAs and physical volumes in the volume group), as opposed to other methods which could take as long as the time it takes to write 2N VGSAs.

In order that the invention will be fully understood preferred embodiments thereof will now be described, by way of example only, with reference to the accompanying drawings in which:

Fig. 1 is a functional block diagram of a data processing system in which the method of the present invention may be advantageously employed;

Fig. 2 is a diagrammatic illustration of the hierarchical file system organization of the files containing the information to be stored on the system shown in Fig. 1;

Fig. 3 is a diagrammatic illustration of a disk file storage device shown functionally in Fig. 1;

Fig. 4 is a diagram illustrating the physical relationships of various physical storage components employed in the real addressing architecture of a disk file;

Fig. 5 illustrates the general layout of a Physical Volume.

Fig. 6 illustrates the general layout of the Logical Volume Manager Area;

Fig. 7 illustrates the details of the Volume Group Status Area Structure;

Fig. 8 illustrates the details of the Volume Group Data Area Structure.

Fig. 9 illustrates the layout of a Logical Volume; (There is no Fig. 10, 11 or Fig. 12.)

Fig. 13 illustrates the system relationship to a logical volume manager pseudo-device driver;

Fig. 14 illustrates the interrelationship between logical volumes, logical partitions, and physical partitions;

Fig. 15 illustrates the interrelationship between physical partitions, physical volumes, and volume groups;

Fig. 16 illustrate the Volume Group Status Area WHEEL concept;

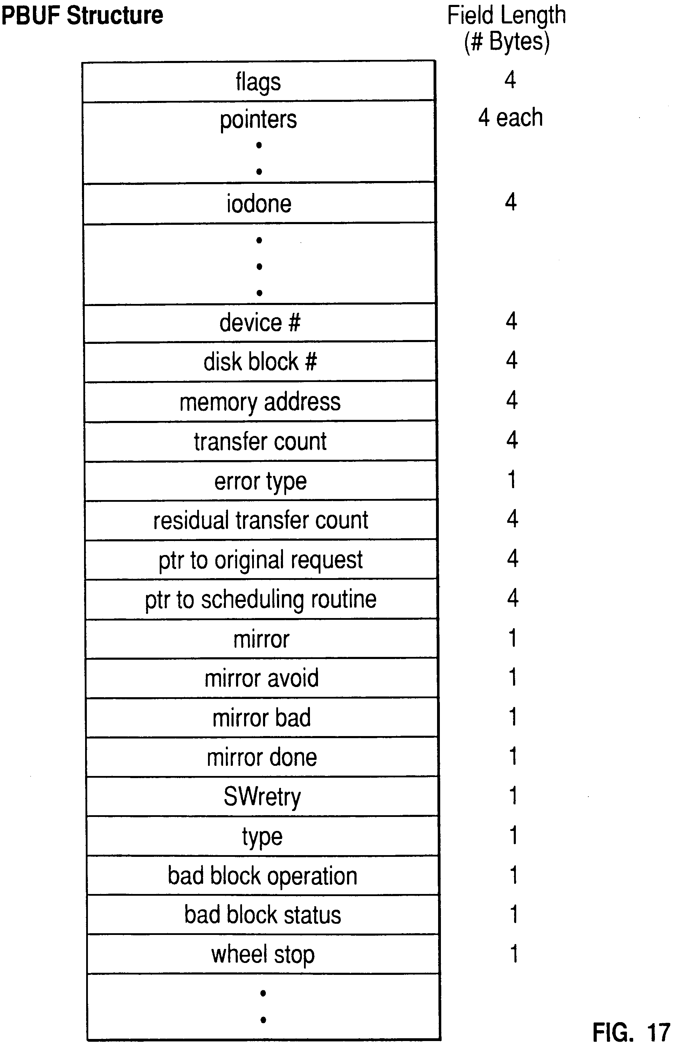

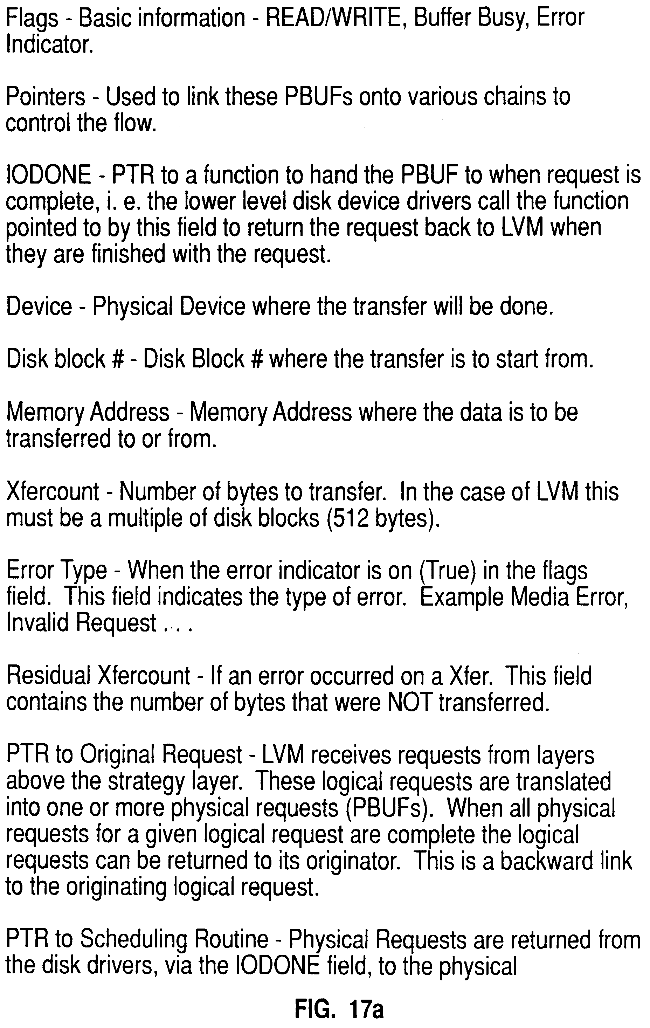

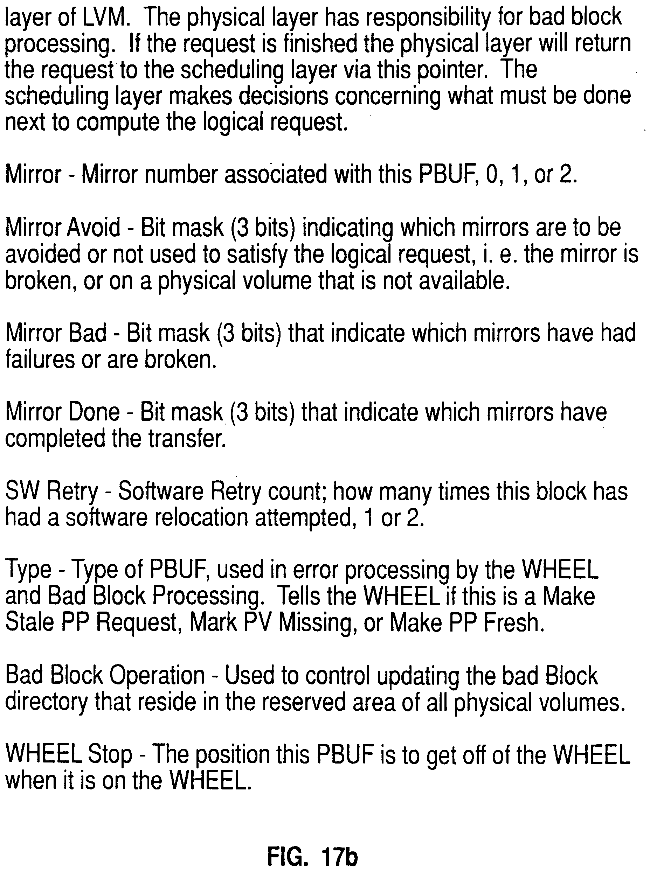

Fig. 17 illustrates the PBUF data structure;

Figs. 17a and 17b illustrate the PBUF data structure elements;

Fig. 18 illustrates the Logical Volume Device Driver Scheduler initial request policy;

Fig. 19 illustrates the Logical Volume Device Driver Scheduler post request policy;

Fig. 20 illustrates the Logical Volume Device Driver Volume Group Status Area processing; and

Fig. 21 illustrates the code used to implement the WHEEL function. The code has been written in the C programming language.

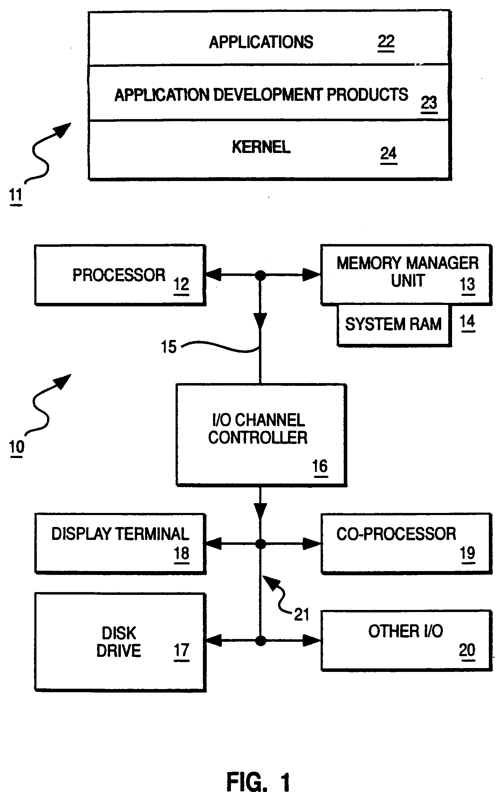

Fig. 1 illustrates functionally a typical data processing system 10 in which embodies the method of the present invention for managing storage space. As shown in Fig. 1, the system hardware 10 comprises a microprocessor 12, a memory manager unit 13, a main system memory 14, an I/O channel controller 16 and an I/O bus 21. A number of different functional I/O units are shown connected to bus 21 including the disk drive 17. The information that is stored in the system is shown functionally by block 11 in Fig. 1 and comprises generally a number of application programs 22, the operating system kernel 24 which in this instance may be assumed to be the AIX operating system. Also shown is a group of application development programs 23 which may be tools used by program development personnel during the process of developing other programs.

An example of a commercial system represented by Fig. 1 is the IBM Risc System/6000 engineering workstation which employs the AIX operating system. The AIX operating system is a Unix type operating system and employs many of its features including system calls and file organization.

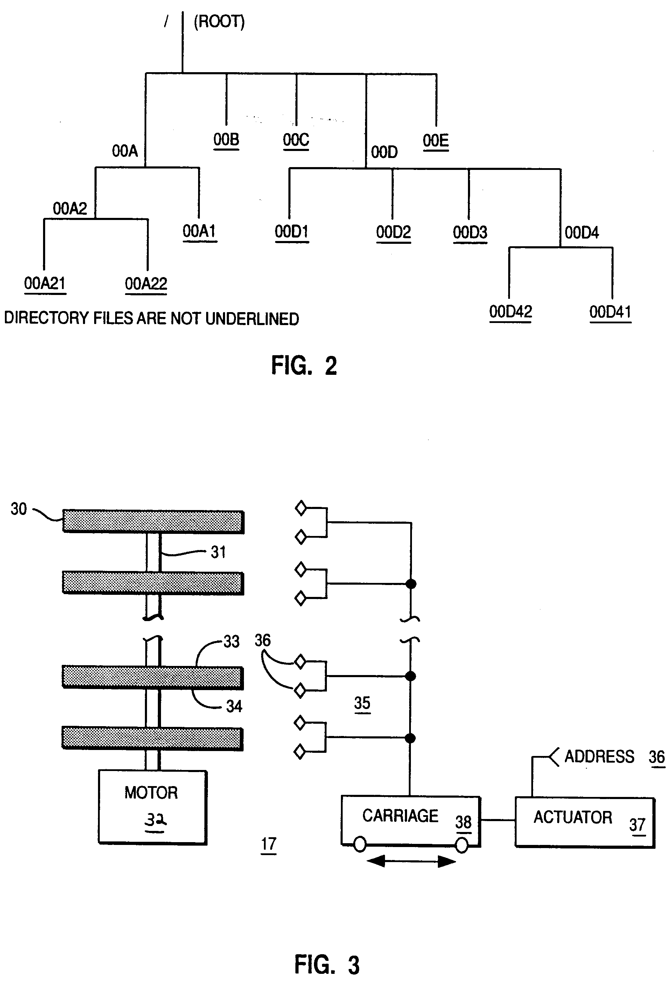

Fig. 2 illustrates the file organization structure of the AIX operating system. The basic unit of information stored is termed a "file." Each file has a name such as "my_file.001". Files may be grouped together and a list generated of all file names in the group. The list is called a directory and is per se a file, with a name such as "my_direct.010". The organization shown in Fig. 2 is called an inverted tree structure since the root of the file organization is at the top. The root level of the organization may contain directory files and other type files. As shown in Fig. 2, a root directory file lists the names of other files 00A, 00B, 00C, 00D, and 00E. The files listed in a directory file at one level appear as files at the next lower level. The file name includes a user assigned name and a path definition. The path definition begins at the root directory which, by convention is specified by a "slash character," (/) followed by the file name or the directory name that is in the path that must be traced to reach the named file.

Each of the program areas shown in block 11 in Fig. 1 includes a large number of individual files which are organized in the manner shown in Fig. 2. The term "File System" is used to identify a group of files that share a common multi-level path or a portion of their respective multi-level paths.

The method of the present invention junctions to manage storage space on the disk drive 17 shown in Fig. 1 for all of the files represented in block 11 of Fig. 1 and the files that would be represented on the hierarchical storage system shown in Fig. 2.

The disk drive 17 in practice may comprise a plurality of individual disk drives. One such device is shown diagrammatically in Fig. 3. The device as shown in Fig. 3 comprises a plurality of circular magnetic disks 30 which are mounted on a shaft 31 which is rotated at a constant speed by motor 32. Each surface 33 and 34 of the disk 30 is coated with magnetic material and has a plurality of concentric magnetic tracks. Other embodiments would have disk 30 coated with material to allow optical storage of data.

The disk drive 17 further includes a mechanism 35 for positioning a plurality of transducers 36, one of each being associated with one surface, conjointly to one of the concentrically recording track positions in response to an address signal 36 supplied to actuator 37 attached to move carriage 38. One recording track on each surface of each disk belongs to an imaginary cylinder of recording tracks that exist at each track position.

The physical address to the disk drive takes the form of a five byte address designated "CCHS" where CC represents the cylinder or track number, H represents the number assigned to the magnetic head or transducer which also corresponds to the disk surface since there is one head per surface, and S represents the sector or block number of a portion of the track. The block is established as the smallest unit of data that can be addressed on the device. Other embodiments could support other physical head to disk configurations and still be within the scope of this invention. For example, instead of a single head or transducer corresponding to each disk surface, multiple heads or transducer might be utilized to reduce the seek time required to attain a desired track location.

From a programming standpoint a disk drive is sometimes referred to as a Physical Volume (PV) and is viewed as a sequence of disk blocks. A Physical Volume has one device address and cannot include two separate disk devices since each device has a separate accessing mechanism and requires a unique address.

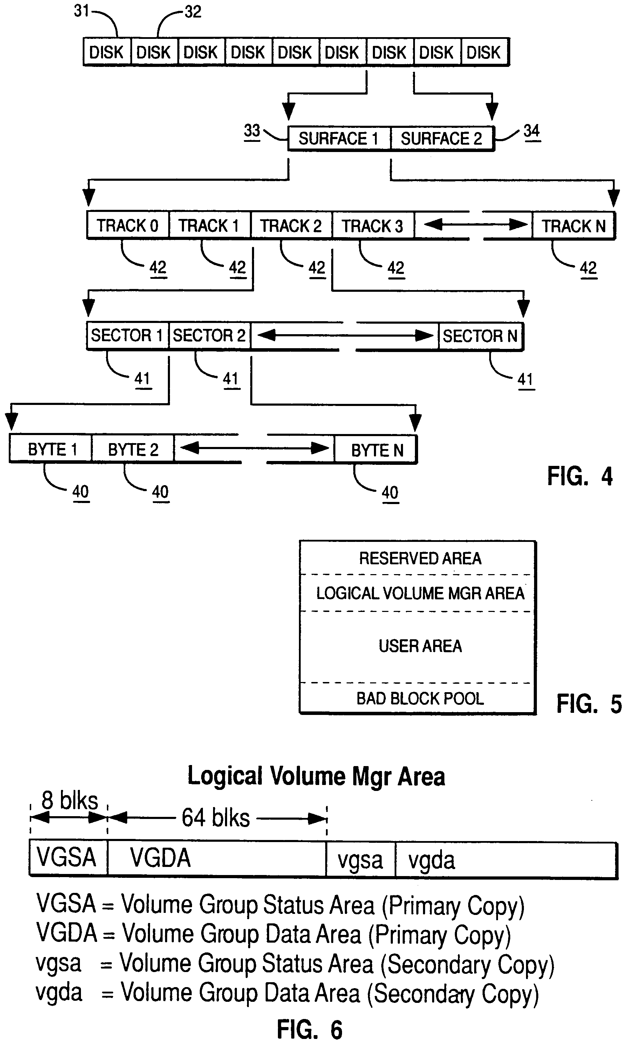

Fig. 4 illustrates the physical relationship of the various storage elements involved in the addressing architecture of a disk drive which to a large extent is generally standardized in the industry.

Each byte position 40 stores one byte of data. The sector or block 41 comprises a specified plurality of sequential or contiguous byte positions generally 512 and is the lowest level of an addressable element. Sectors or blocks 41 are combined into tracks 42 , which are combined into surfaces 33 and 34, which are combined into disks 31 ,32 ..., which are combined into disk drives or disk storage devices 17 of Fig. 1. If more than one disk storage device 17 is employed the combination of two or more devices is referred to as a physical string of disk drives or disk files. In practice a disk or a disk track 42 may contain one or more sectors 17 having a number of defects sufficient to render the block unusable.

The layout of a Physical Volume is shown in Fig. 5. Each physical volume, for example each separate disk drive, reserves an area of the volume for storing information that is used by the system when the power is first turned on. This is now a standard convention in the industry where, for example, tracks or cylinders 0-4 are reserved for special information.

Each physical volume reserves at least two cylinders for special use. The Boot Code, which may be used to load diagnostics software, or the kernel of the Operating System, is held in a normal logical volume and no longer requires a special physical volume location.

The first reserved cylinder is cylinder 0, the first cylinder on any physical volume. Each physical volume uses the first four tracks of cylinder 0 to store various types of configuration and operation information about the Direct Access Storage Devices (DASD) that are attached to the system. Some of this information is placed on the cylinder by the physical volume manufacturer, and some of it is written by the operating system on the first 4 tracks of cylinder 0.

The second reserved cylinder on the physical volume is for the exclusive use of the Customer Engineer and is called the CE cylinder. This is always the last cylinder on the physical volume and is used for diagnostic purposes. The CE cylinder cannot be used for user data. The Boot Code area and the Non-Reserved area are pointed to by the contents of an IPL Record interpreted in the context of the contents of a Configuration Record.

The Initial Program Load (IPL) Record consisting of one block contains information that allows the system to read the Boot Code (if any) and initialize the physical volume. The IPL Record can be divided into four logical sections: The first section is the IPL Record ID. The second section contains format information about the physical volume. The third section contains information about where the Boot Code (if any) is located and its length. The fourth section contains information about where the non-reserved area of the physical volume is located and its length.

One track is also reserved for the Power On System Test (POST) control block that is created in memory during system initialization.

The first part of the non-reserved area of a physical volume contains a Logical Volume Manager Area. The invention hereinafter disclosed is primarily concerned with the management of this Logical Volume Manager Area. Fig. 6 is an exploded view of the Logical Volume Manager Area, which has a Volume Group Status Area and Volume Group Data Area. Secondary copies of these areas may also immediately follow the primary copies. To save space on the physical volumes, the size of this Logical Volume Manger Area is variable. It is dependent on the size of the physical volume and the number of logical volumes allowed in the volume group.

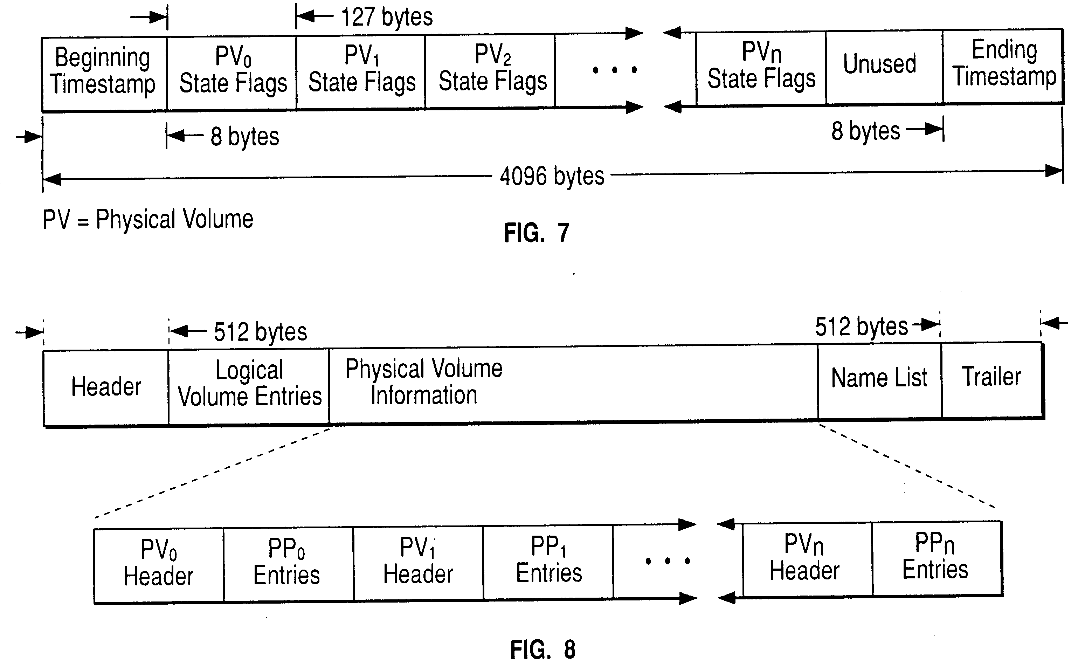

As previously mentioned, each physical volume contains a Volume Group Status Area(VGSA). The Status Area indicates the state of each physical partition on the physical volume. Every physical volume within a volume group contains an identical copy of the Status Area. The Status Area can be duplicated on the same physical volume, is not contained within any physical partition, and has the format shown in Fig. 7. The Status Area should be allocated on DASD in such as way as to reduce the probability of a single failure obliterating both copies of it.

The details of the Status Area are shown in Fig. 7. The various fields within the Status Area are interpreted as follows:
BEGINNING_TIMESTAMP and ENDING_TIMESTAMP are used when the VG is varied on to validate the VGSA and control the recovery of the most recent VGSA. Each timestamp is 8 bytes long. The recovery and validation process will be discussed later. PARTITION_STATE_FLAGS occupy the remainder of the VGSA. The flags are evenly divided among the maximum of 32 PVs in a VG. That means each PV has 127 bytes of state flags. That leaves 24 bytes of the 4096 in each VGSA unused. It also limits the number of PPs on any PV to 127 x 8 or 1016 partitions. This should not restrict the use of any portion of any disk since the size of the partitions are not a factor, only the quantity.

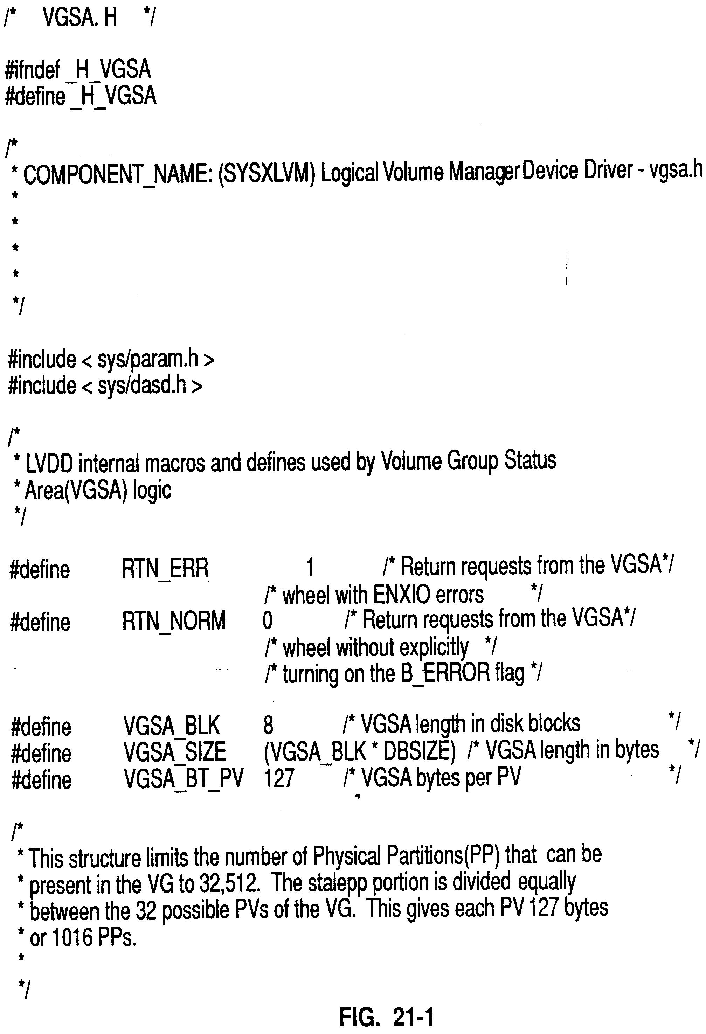

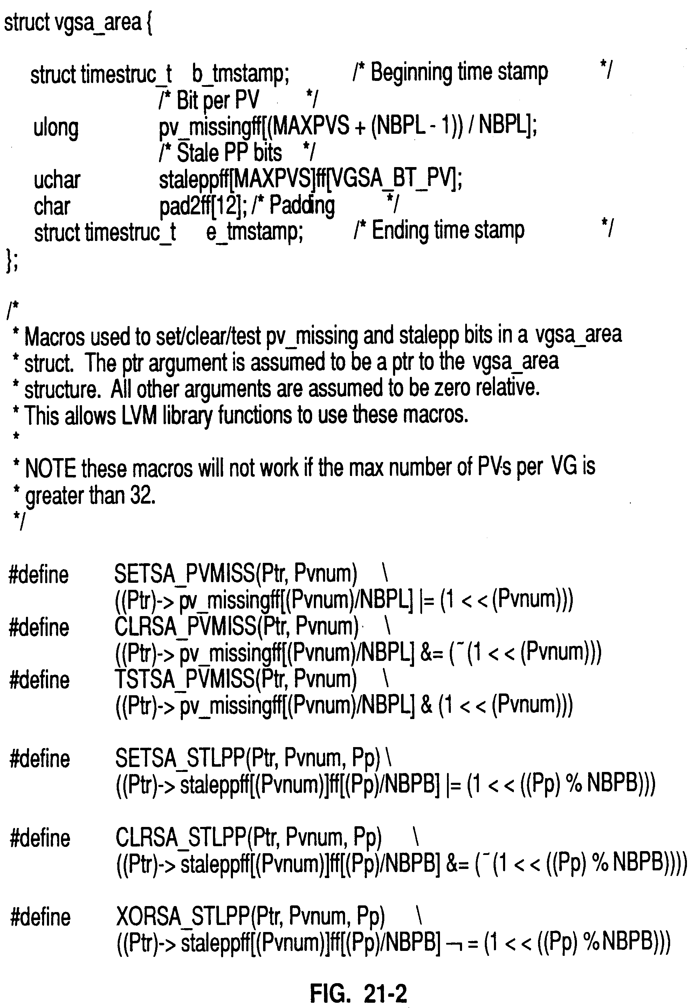

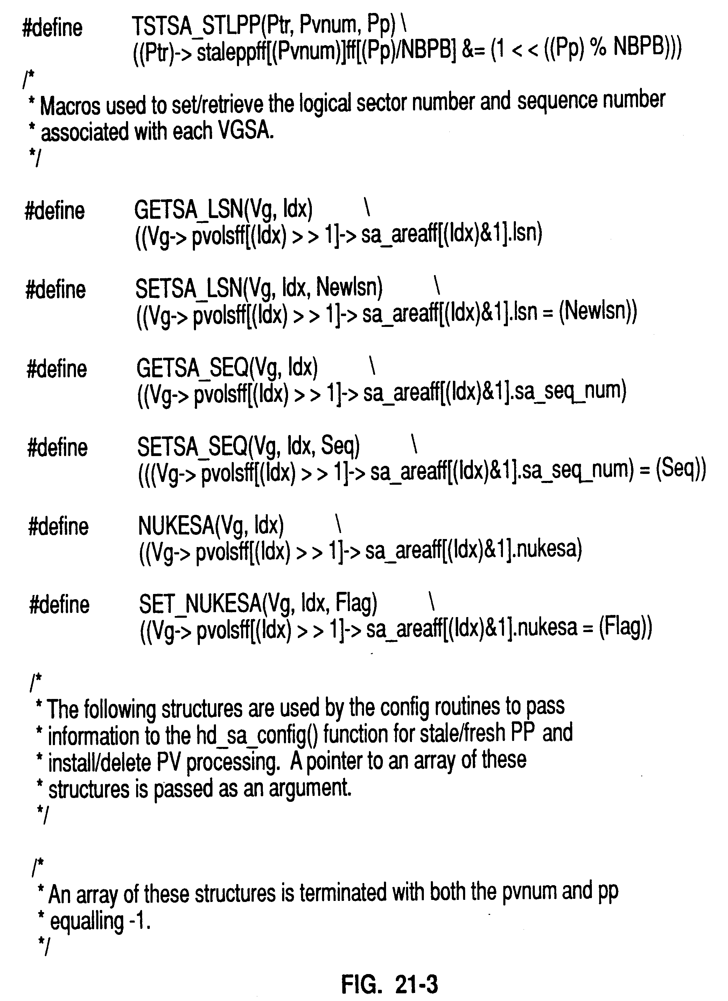

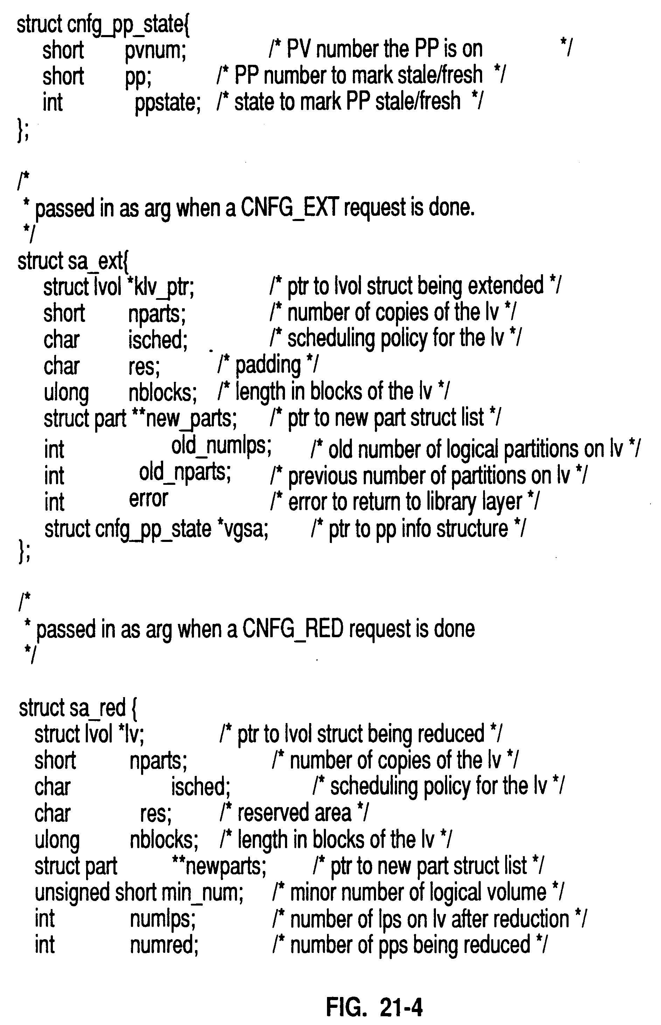

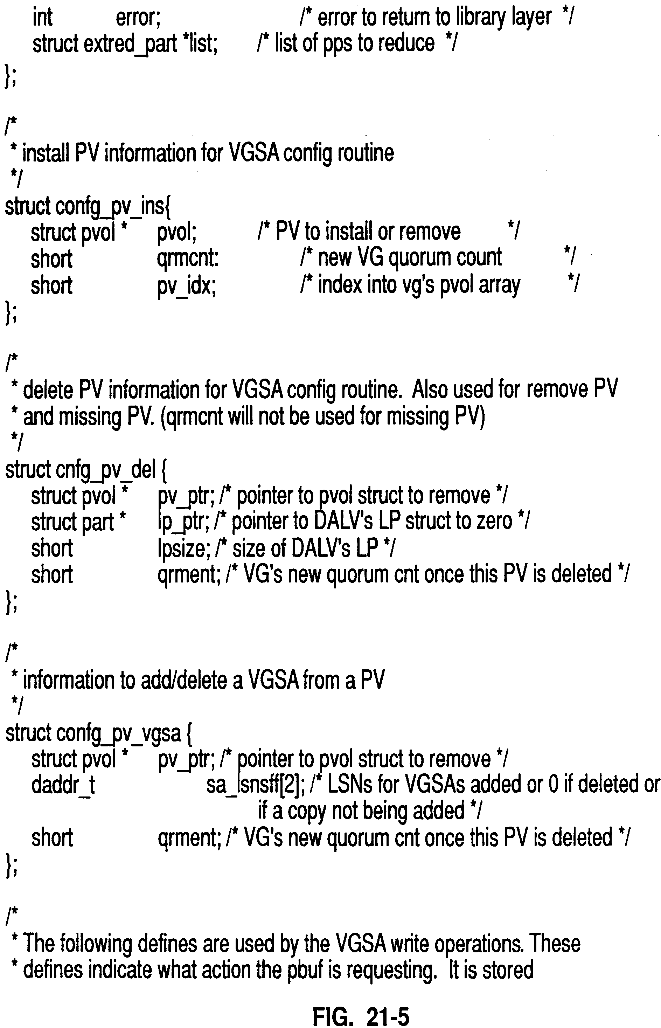

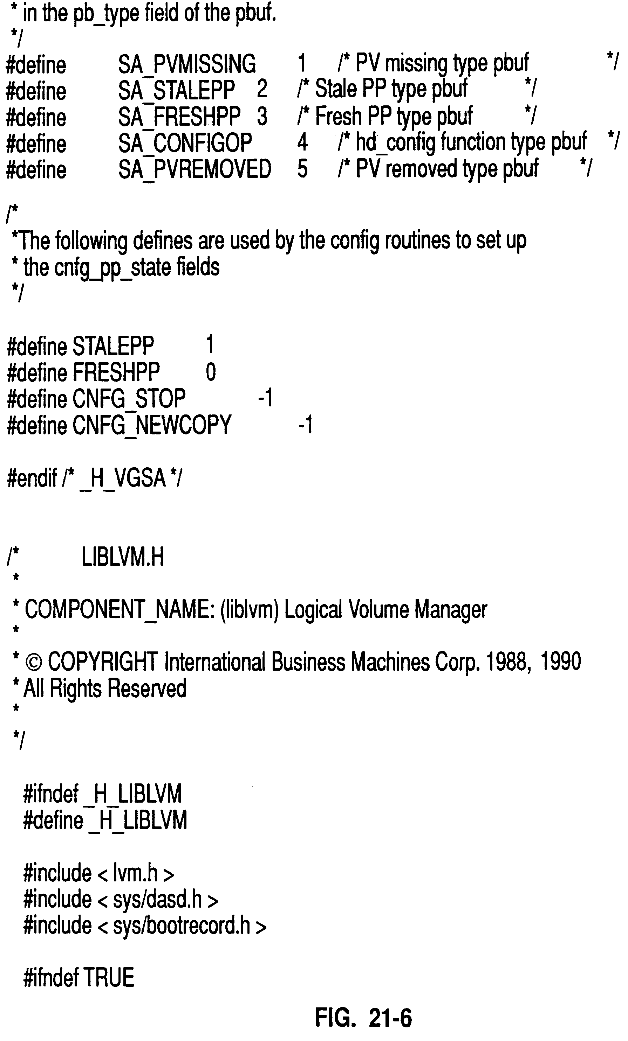

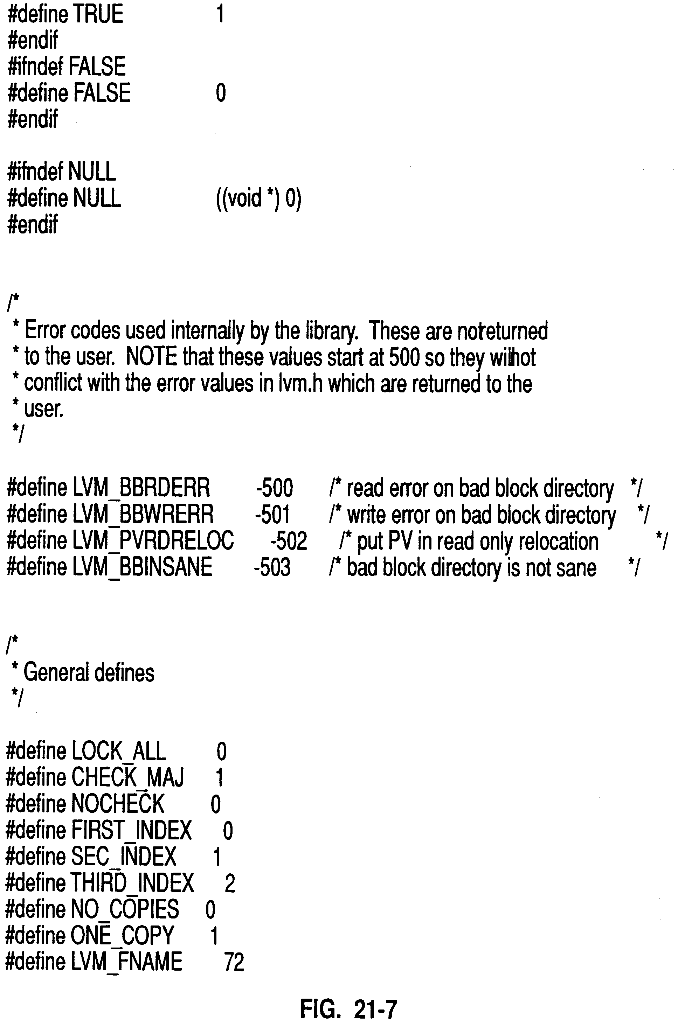

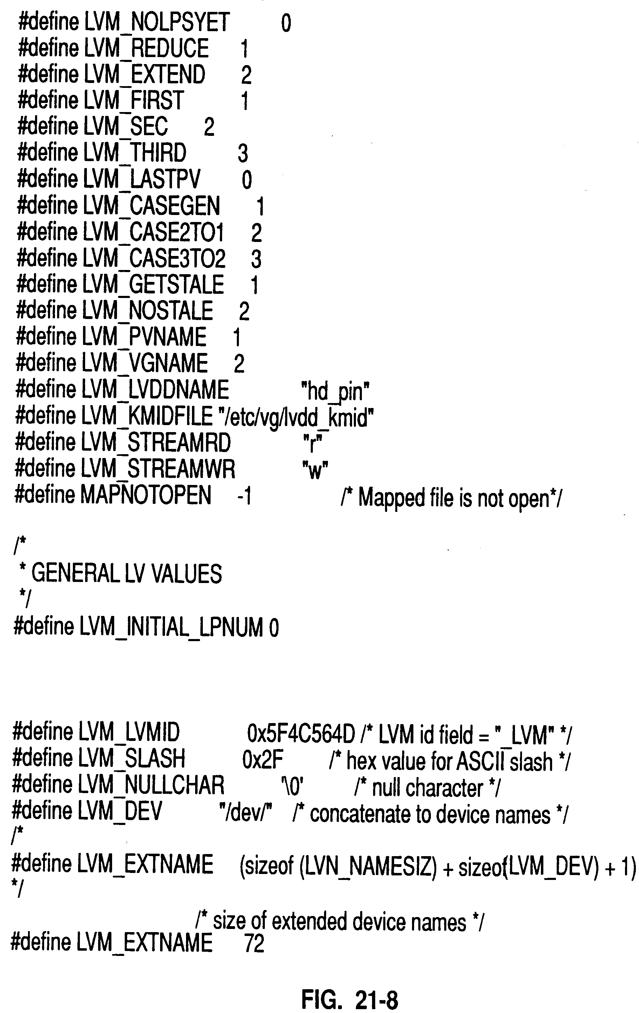

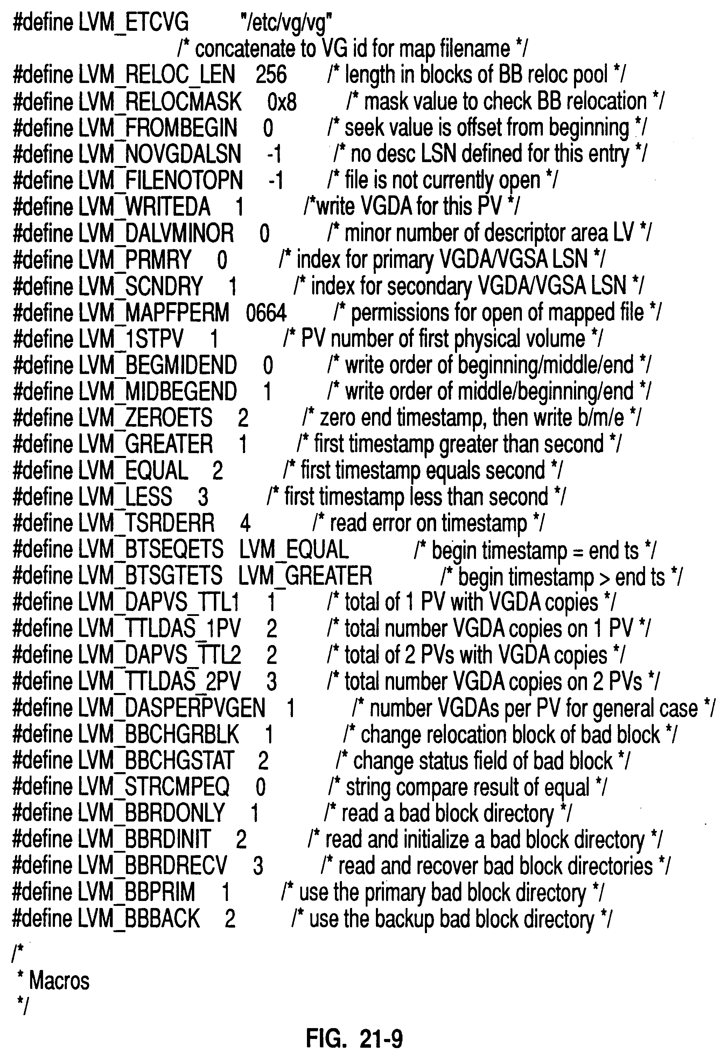

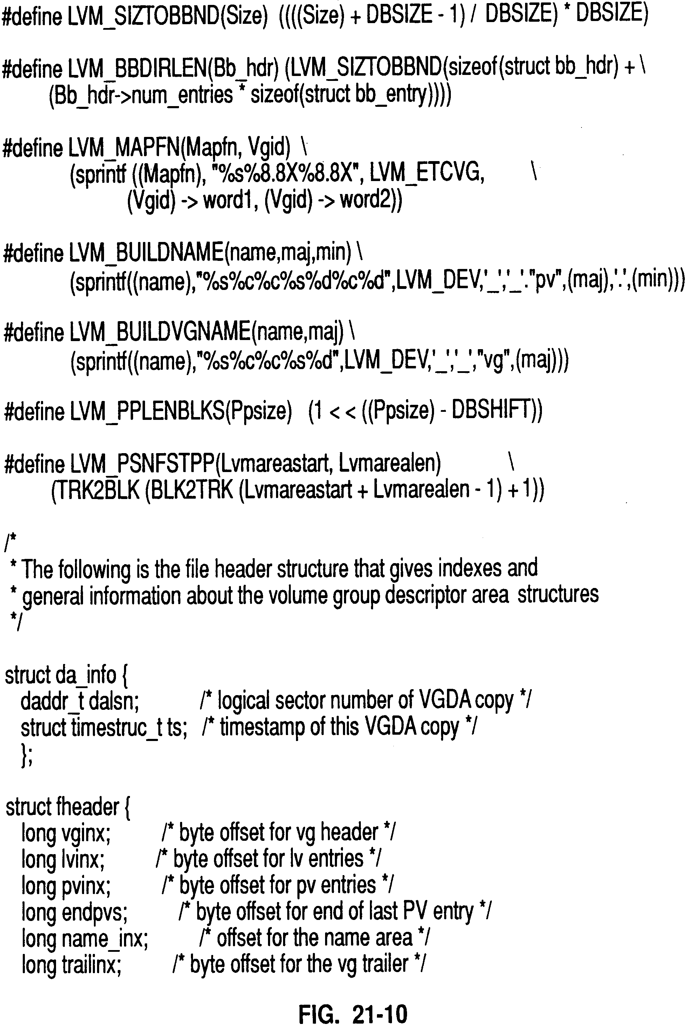

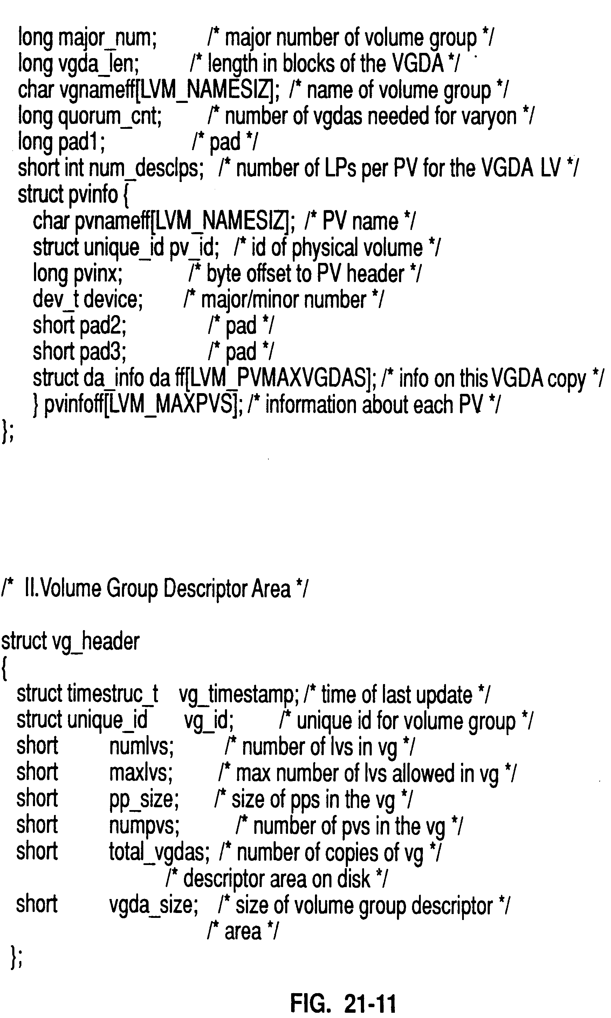

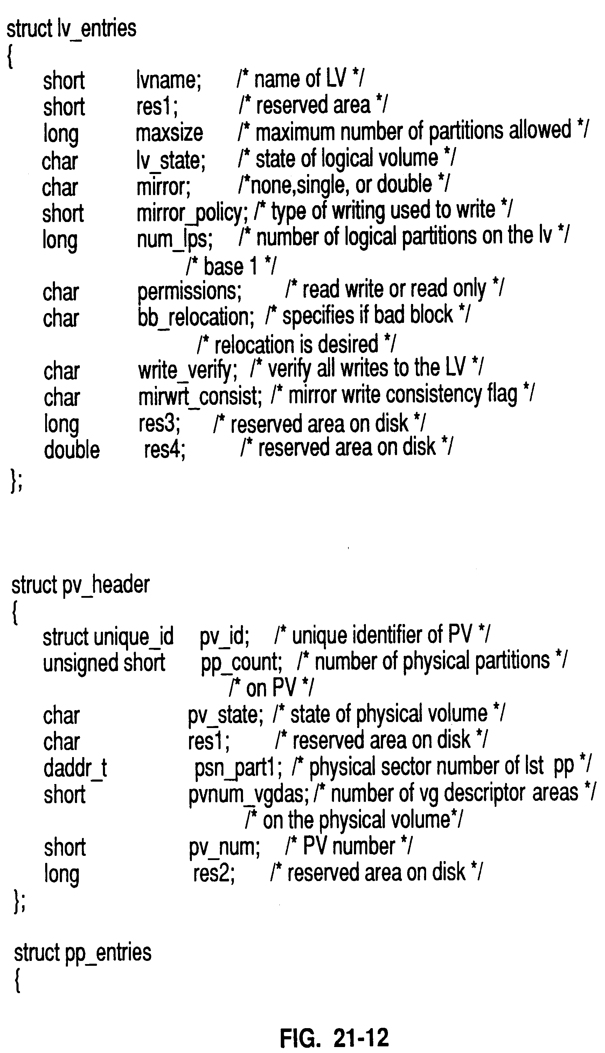

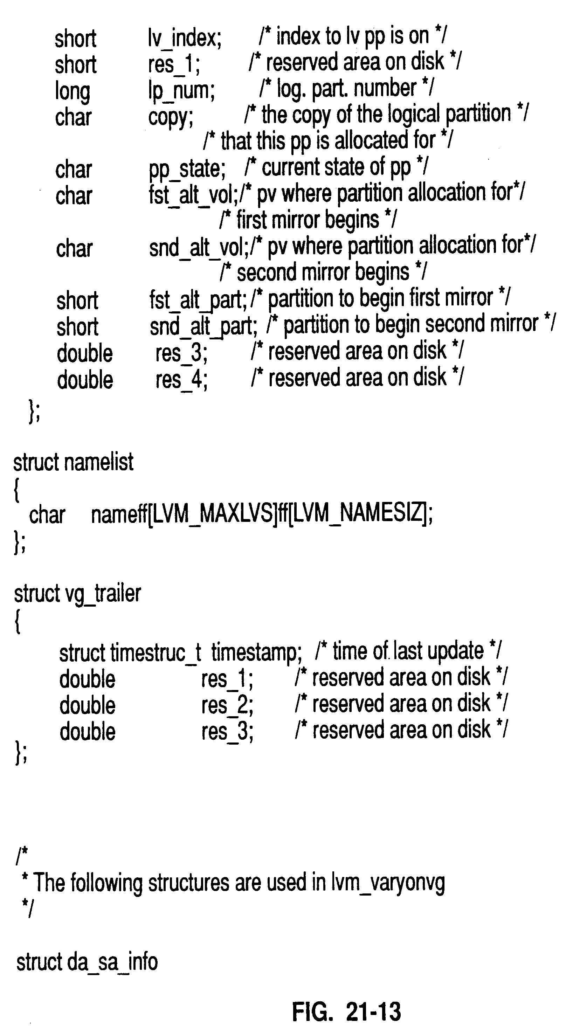

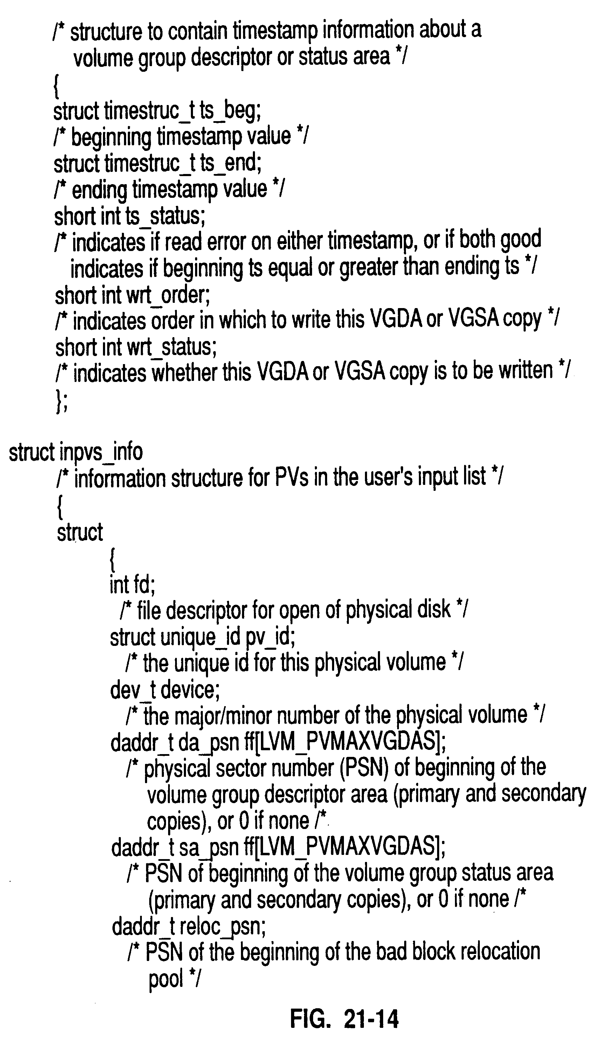

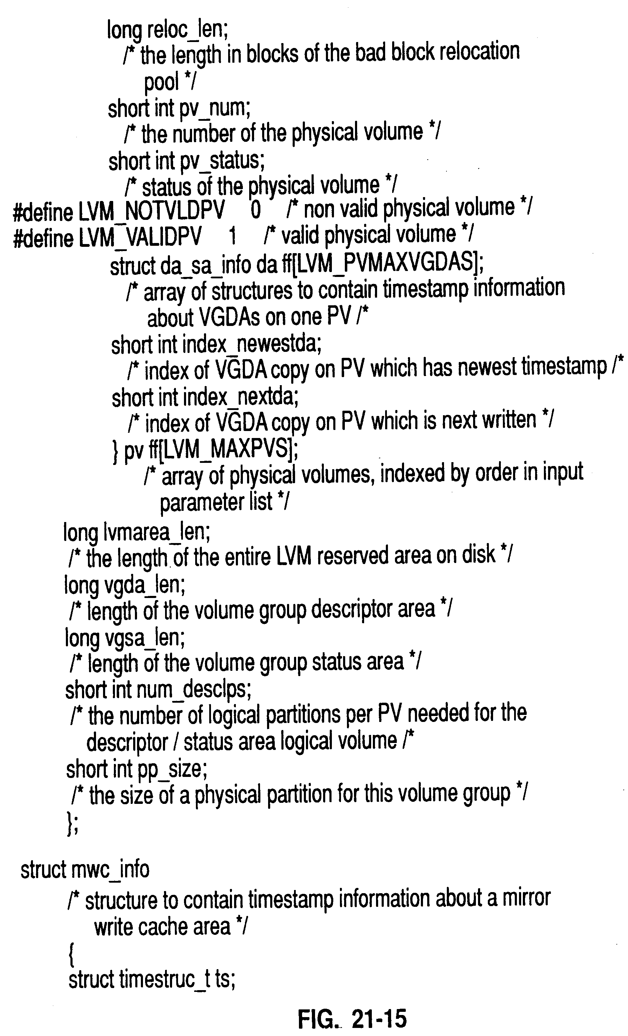

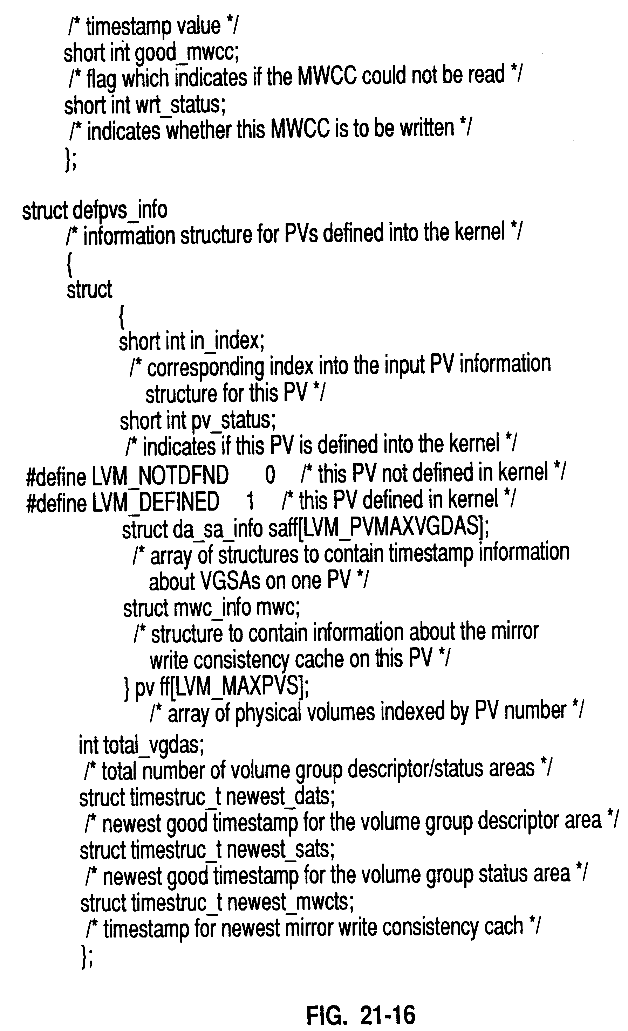

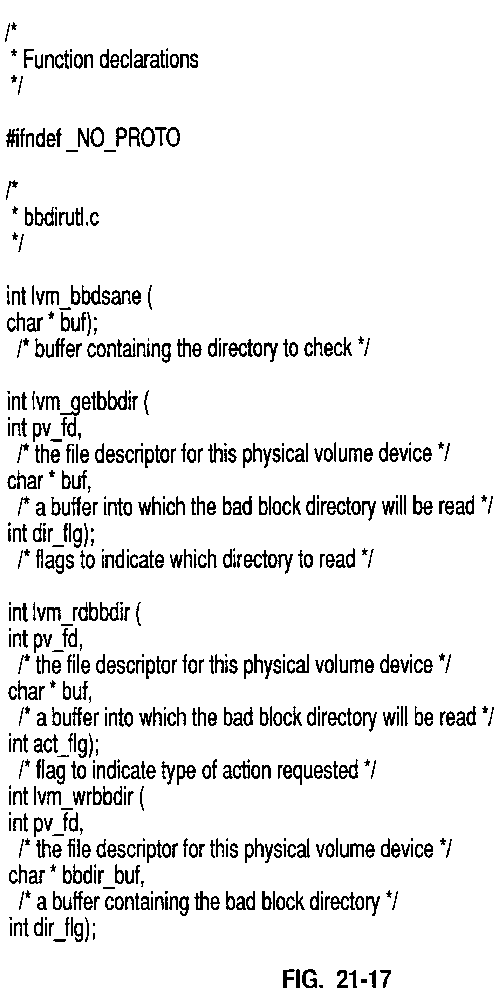

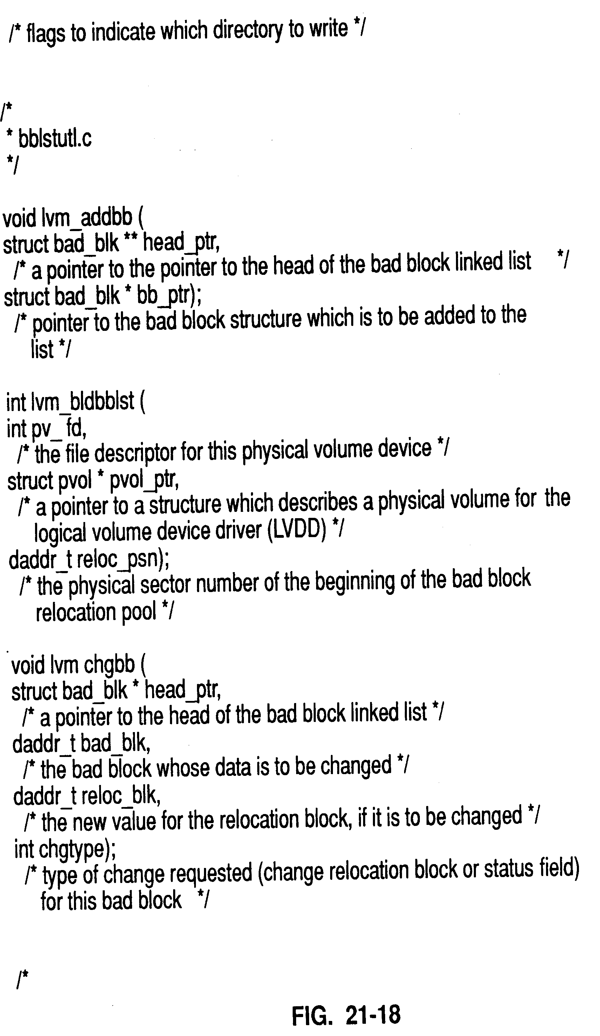

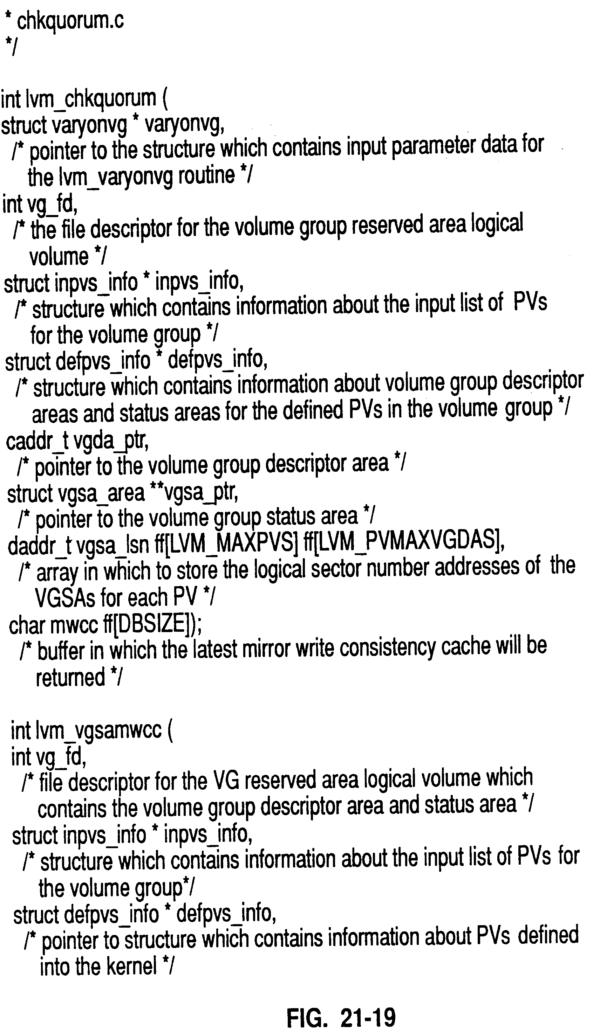

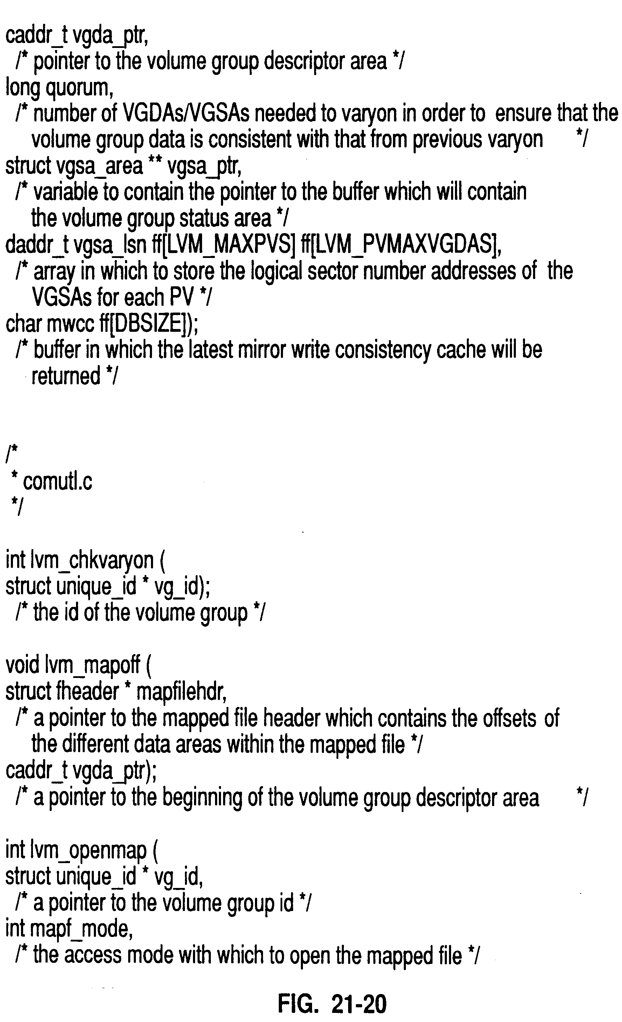

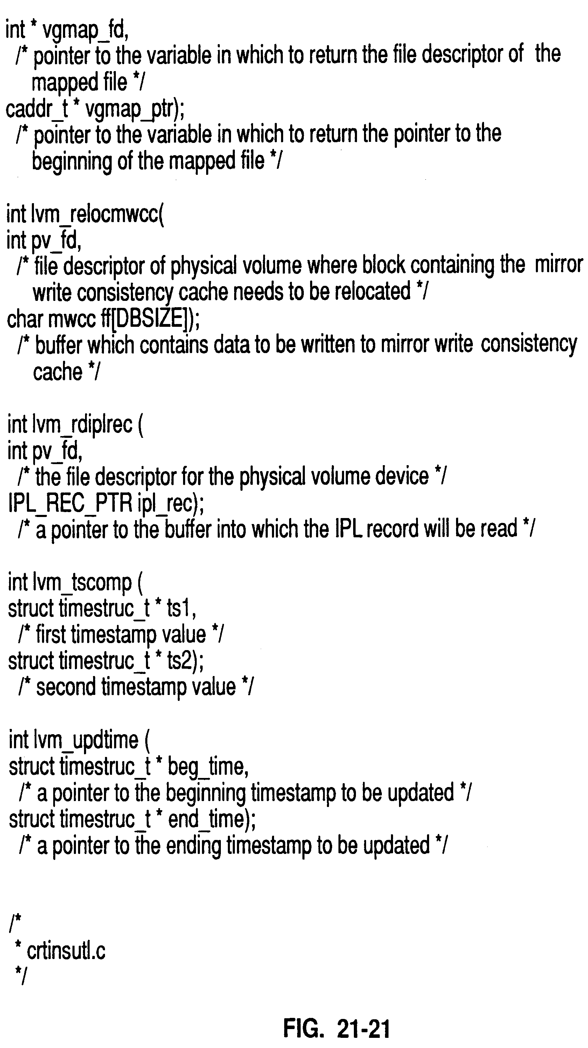

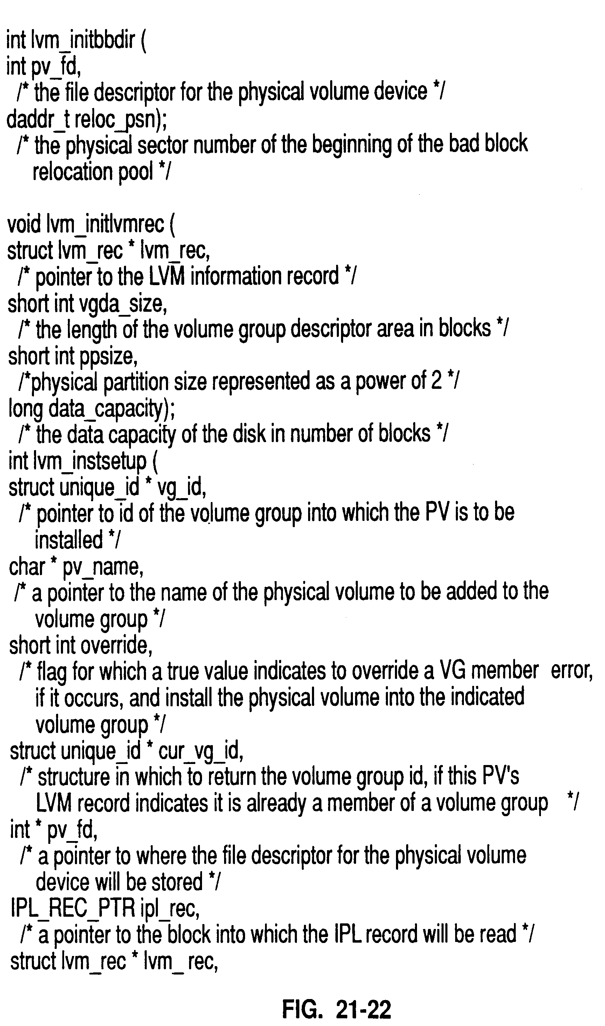

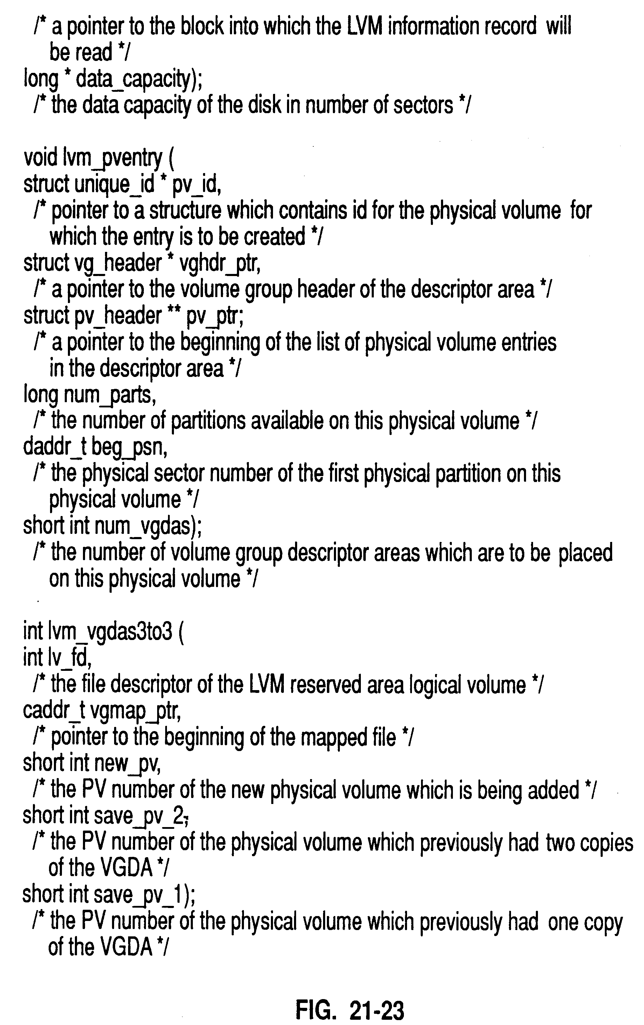

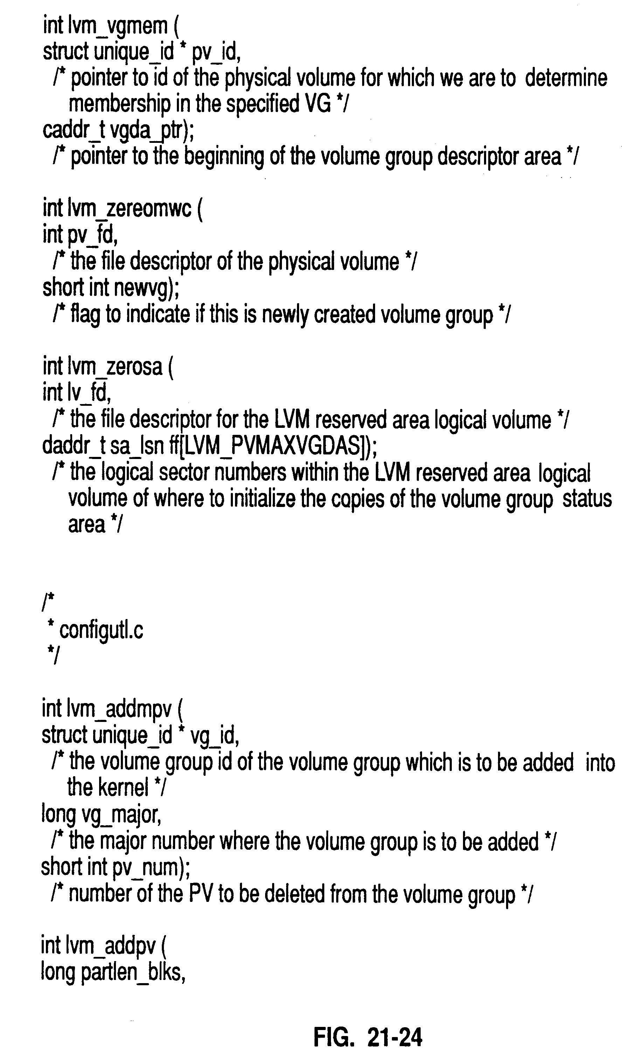

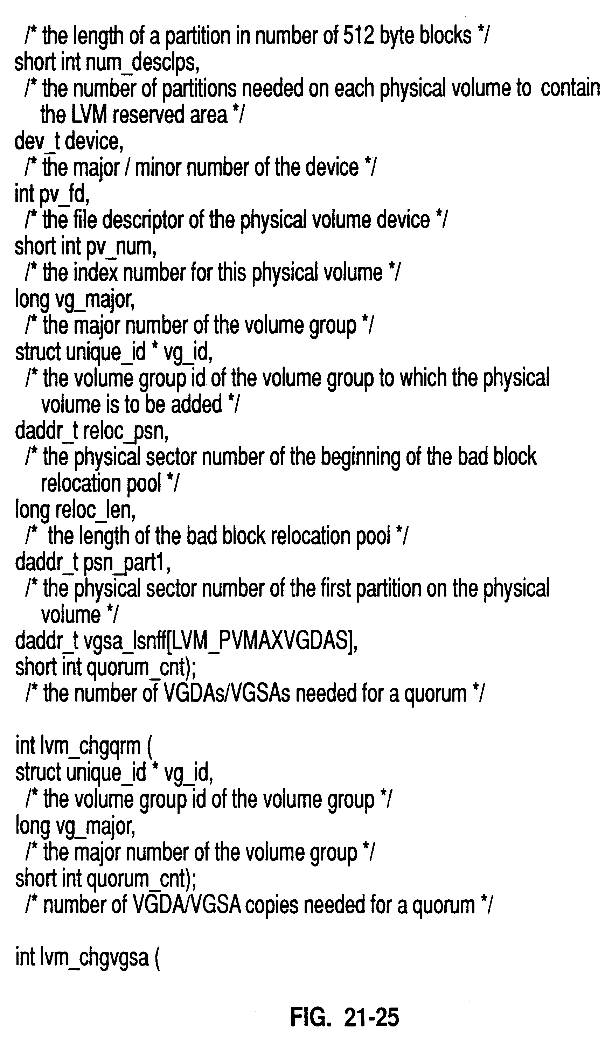

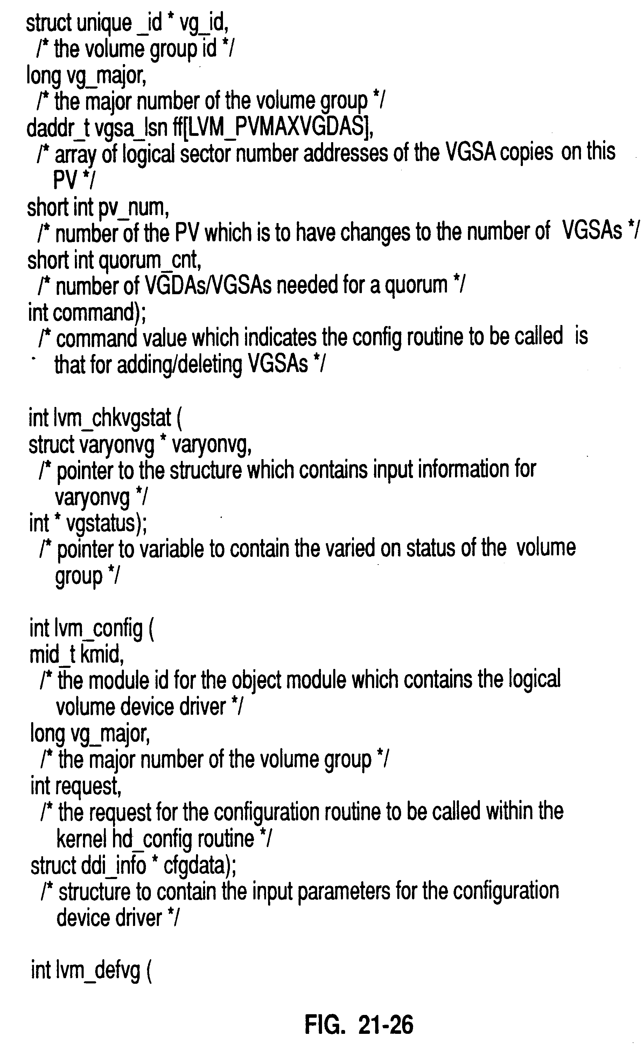

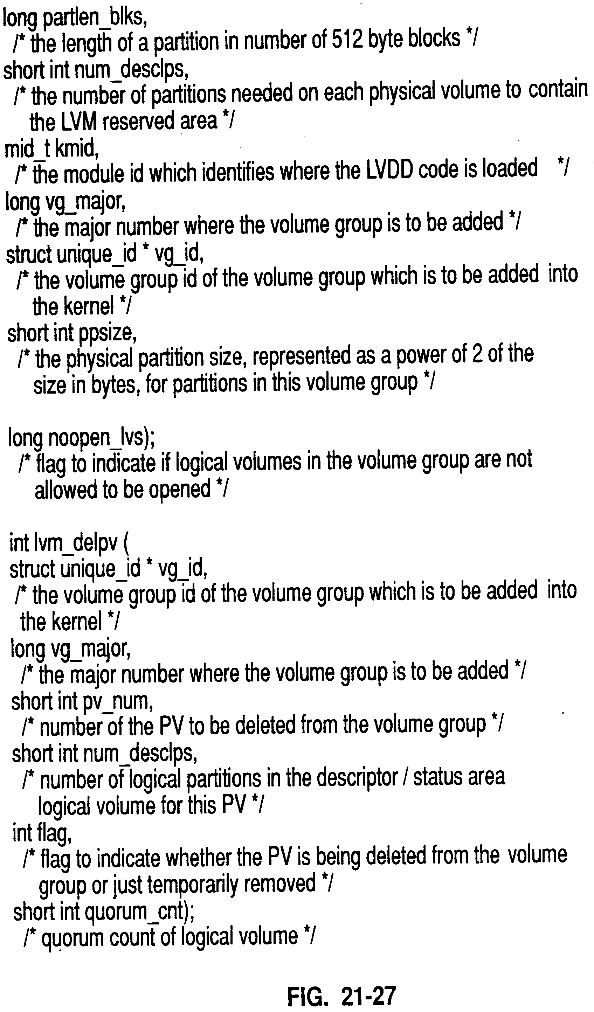

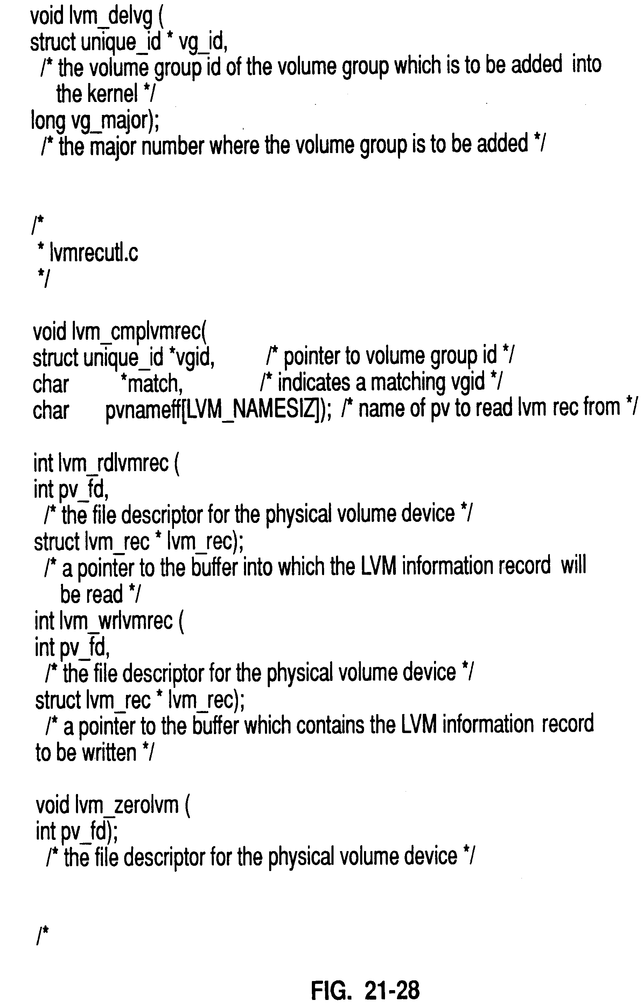

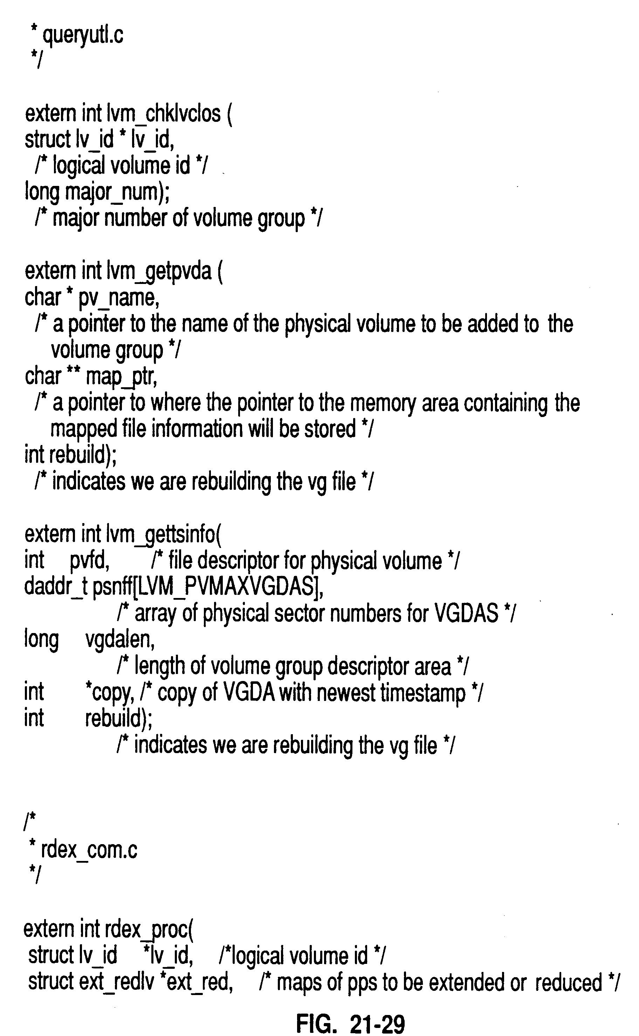

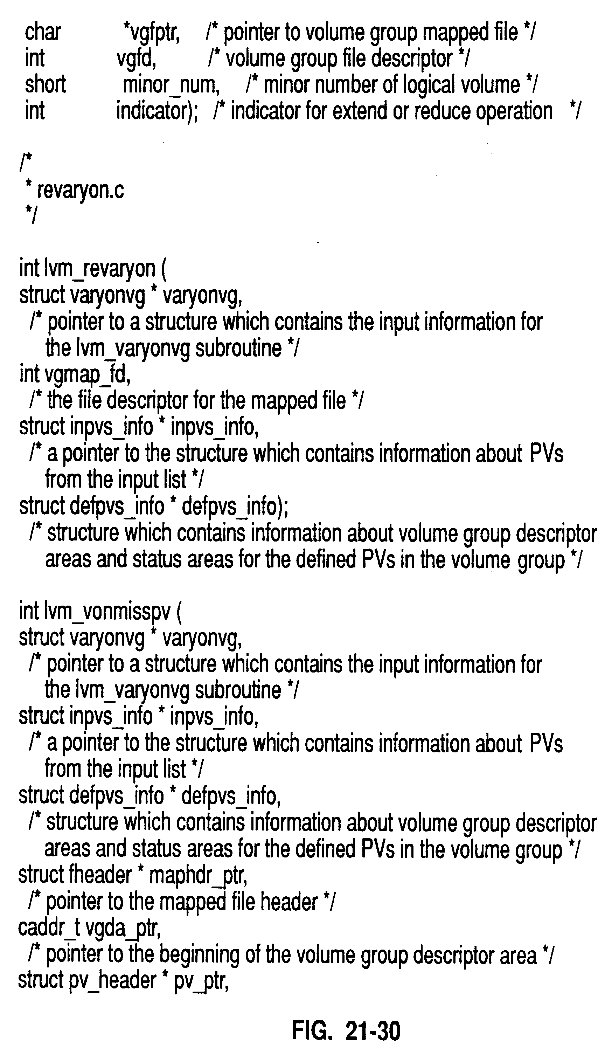

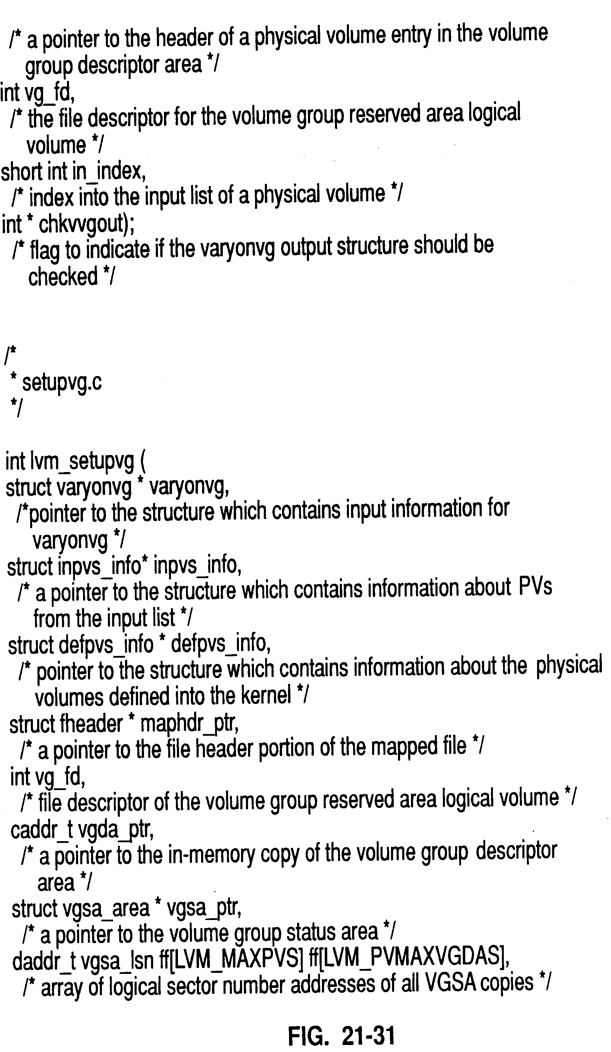

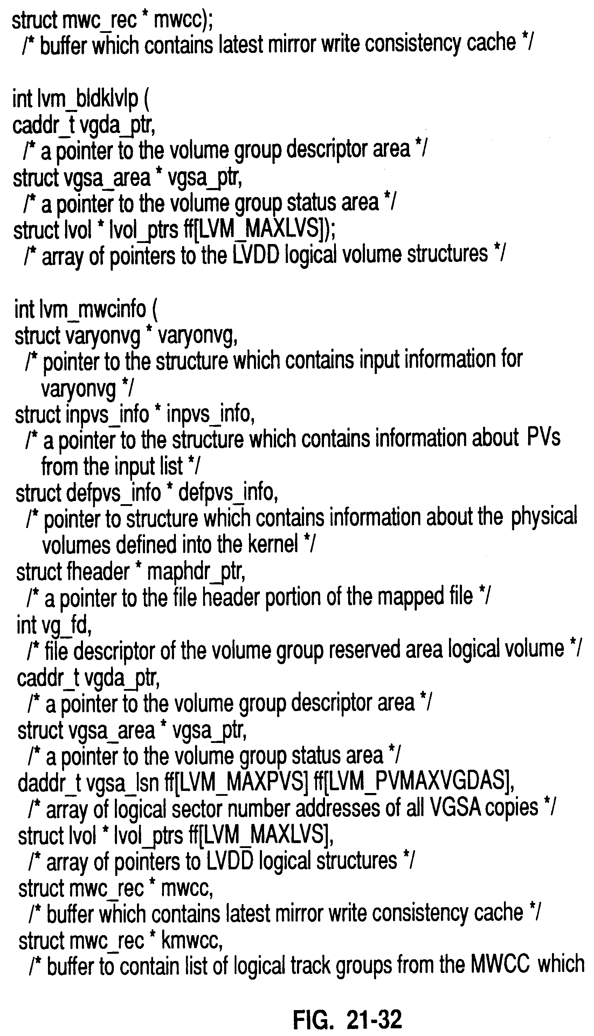

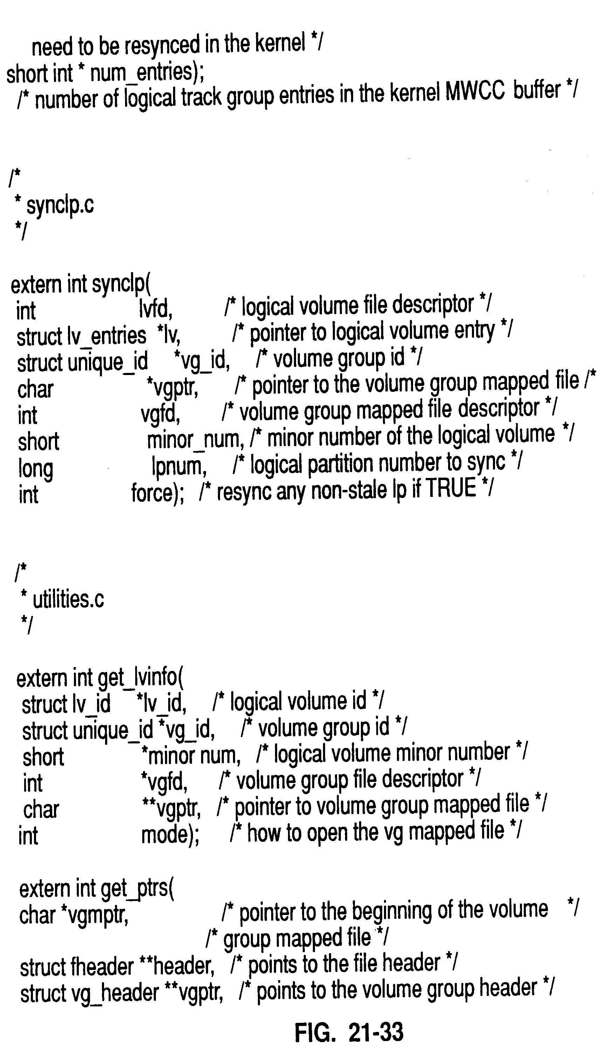

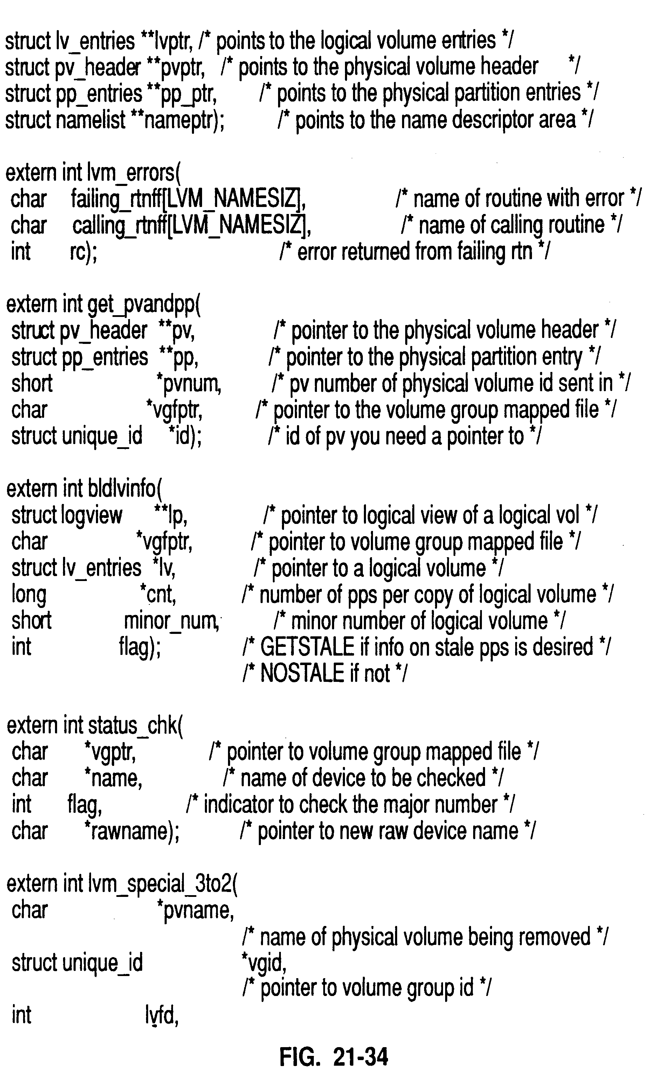

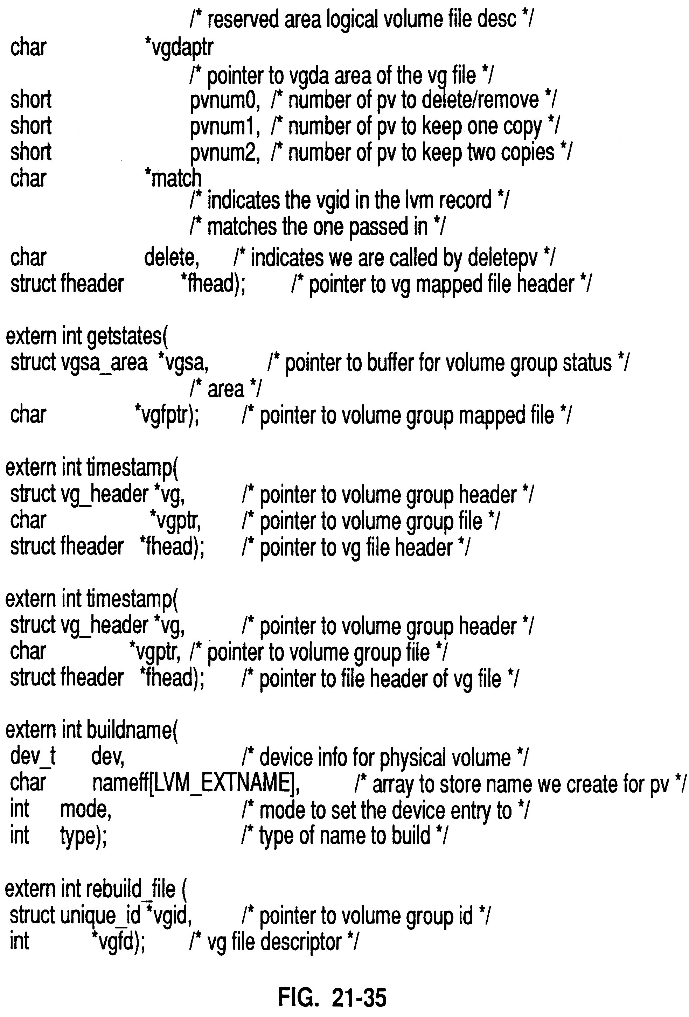

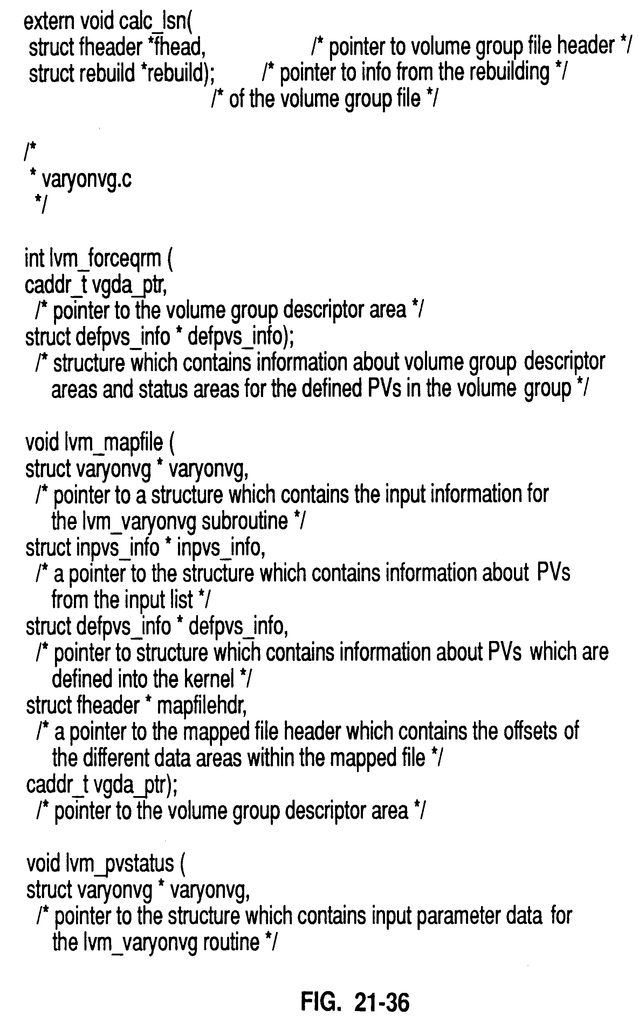

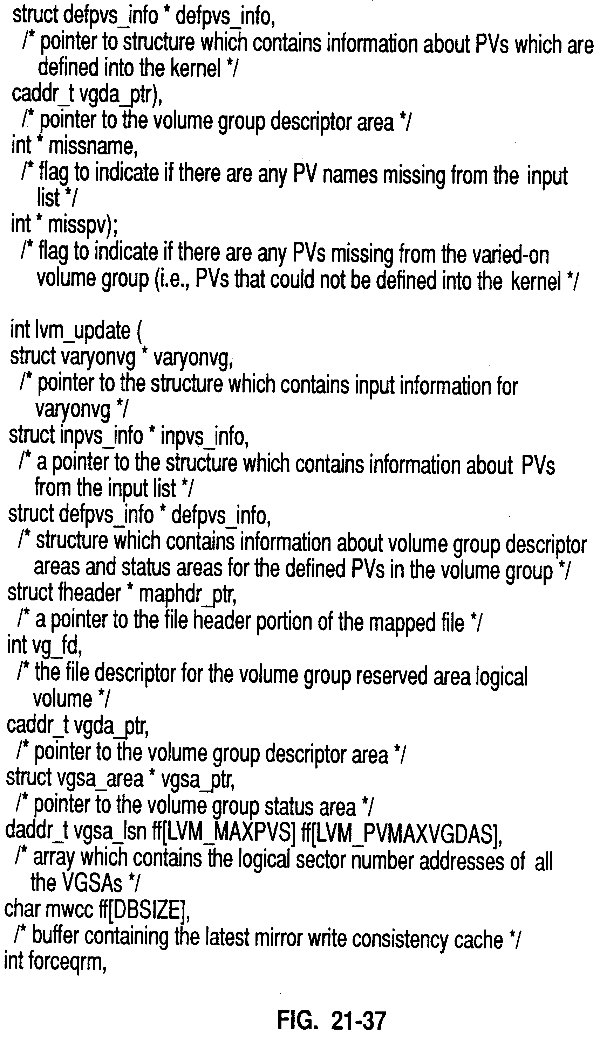

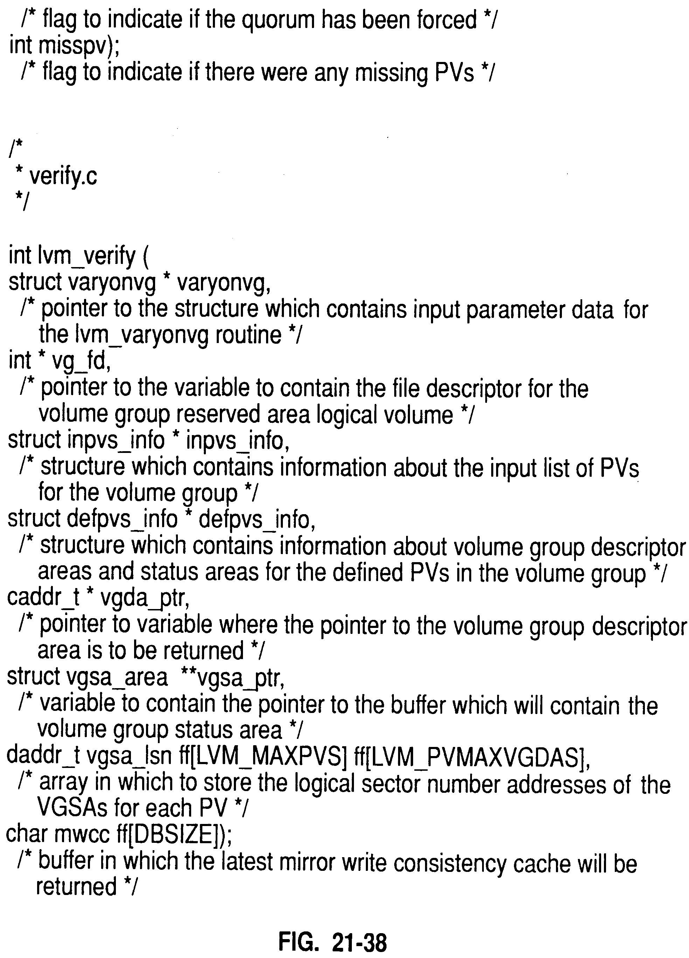

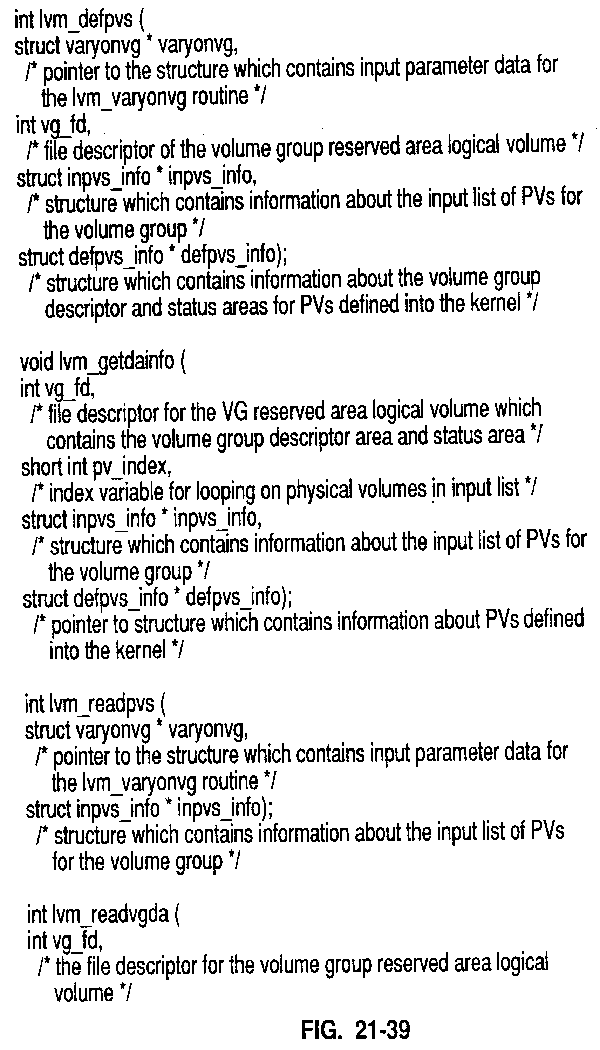

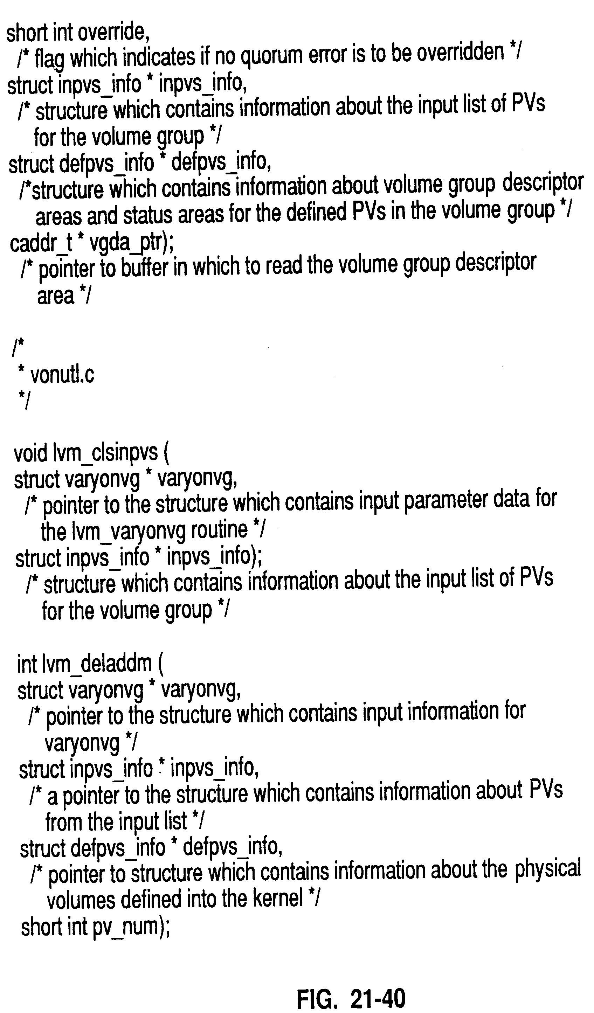

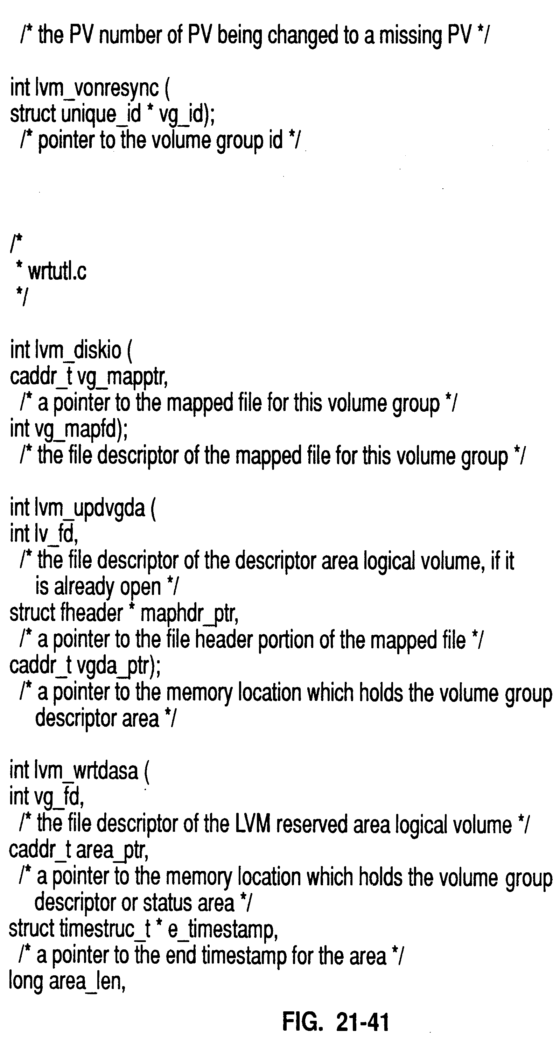

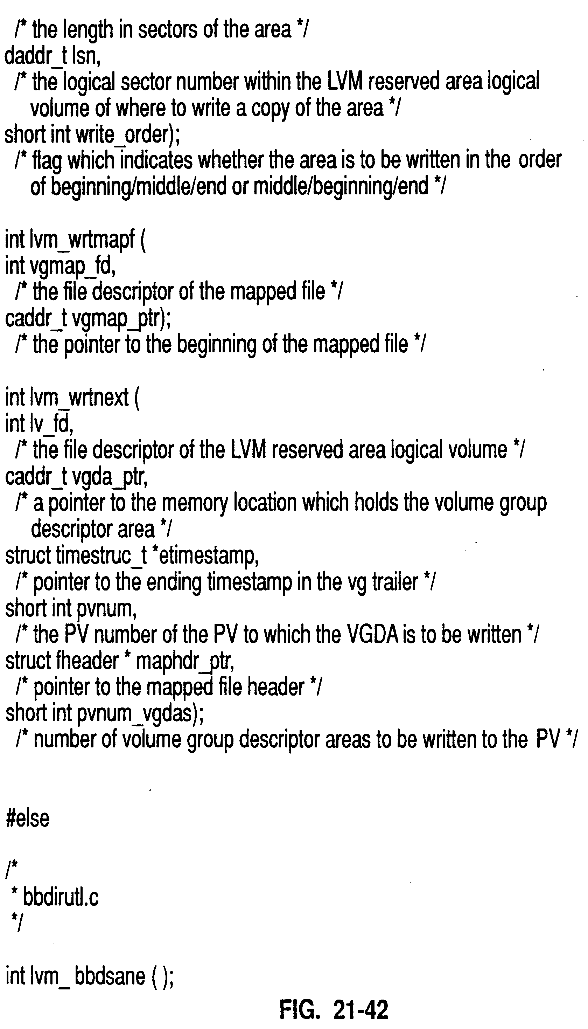

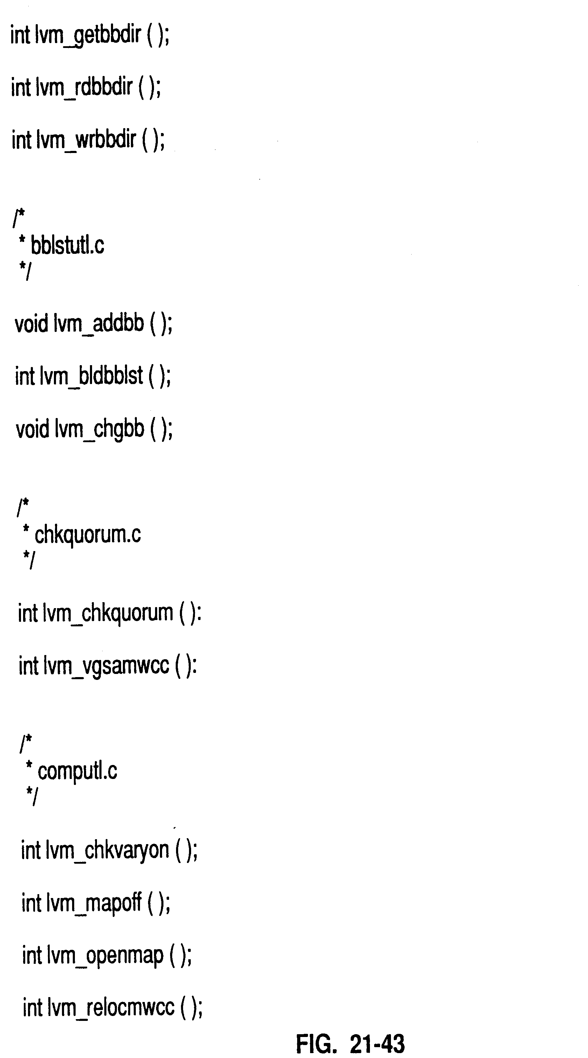

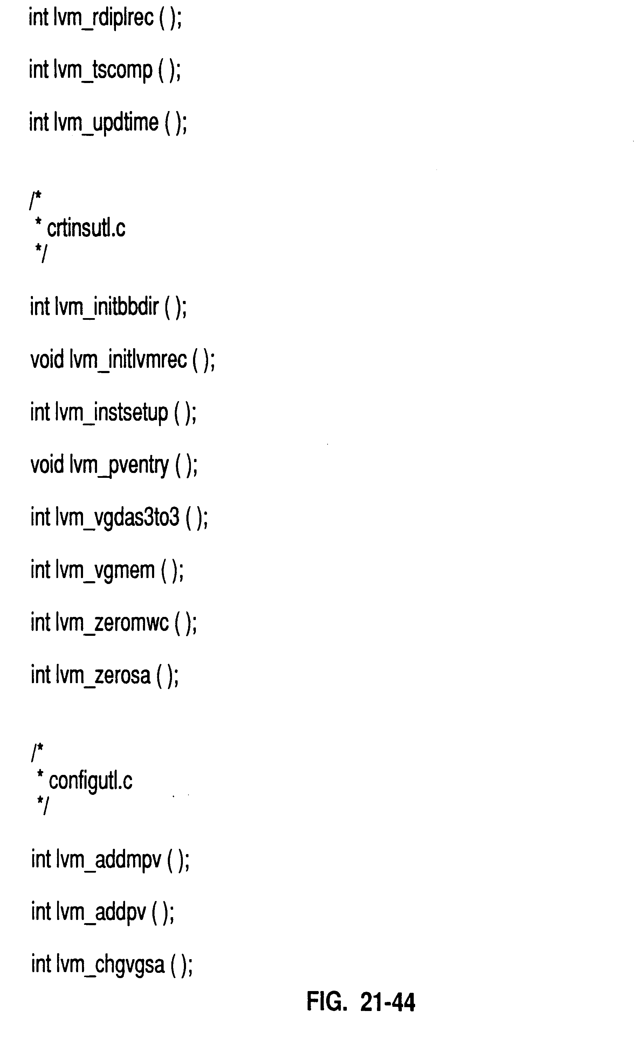

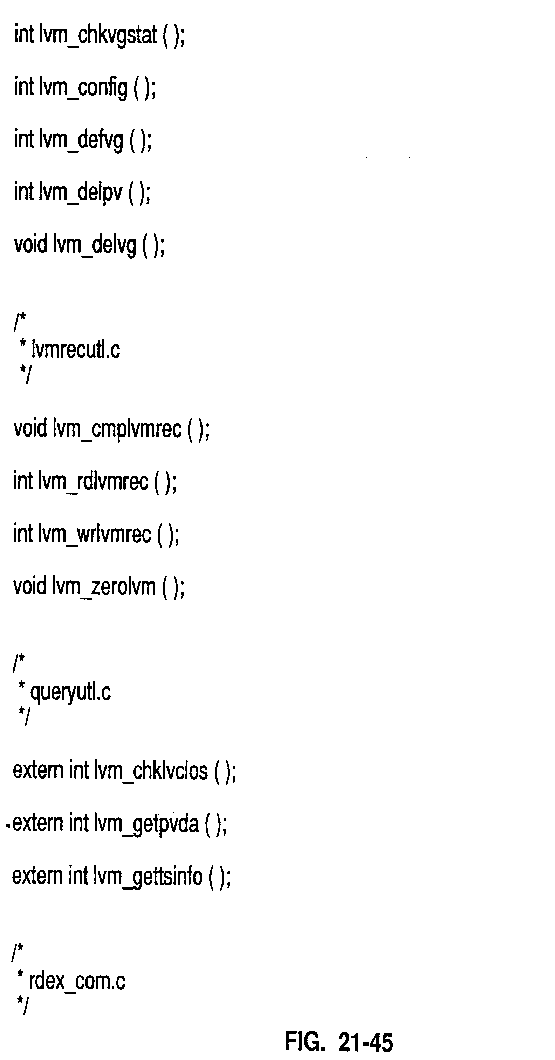

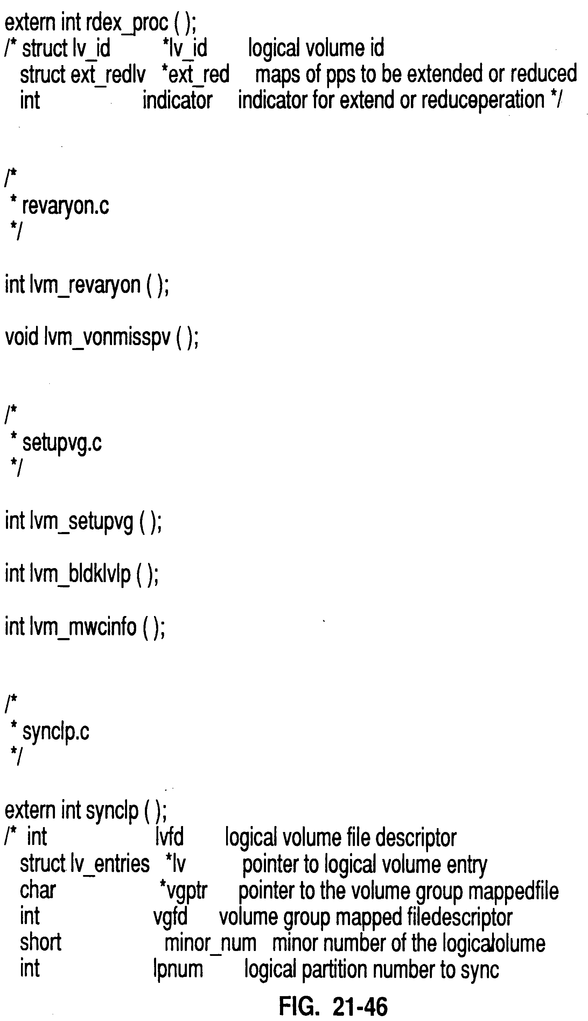

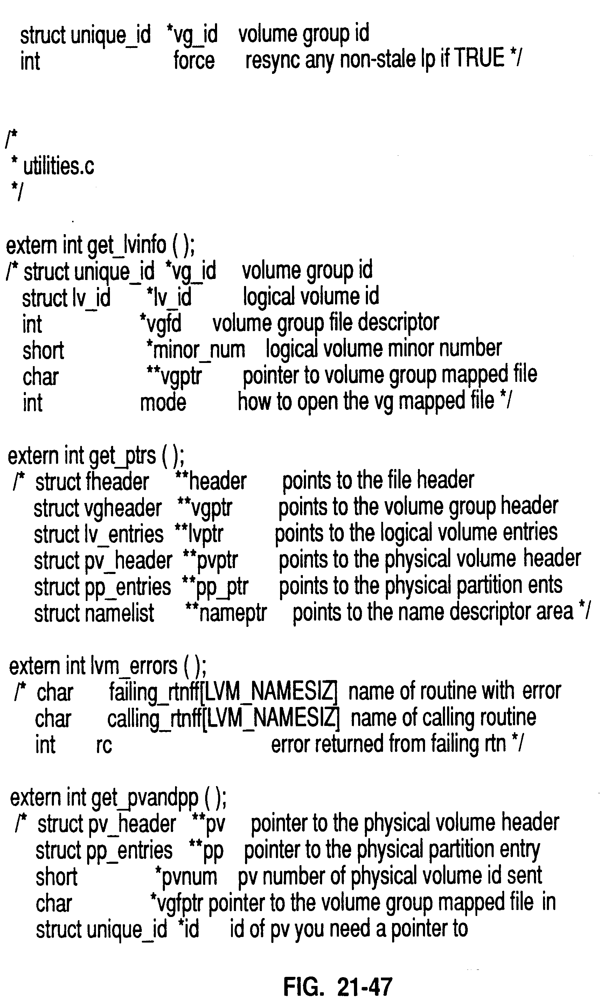

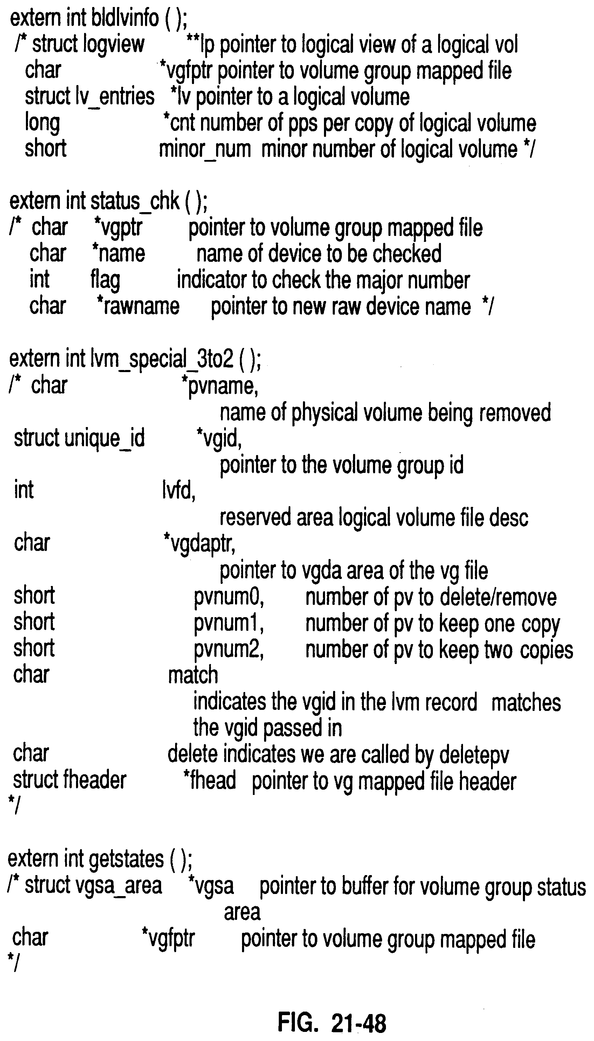

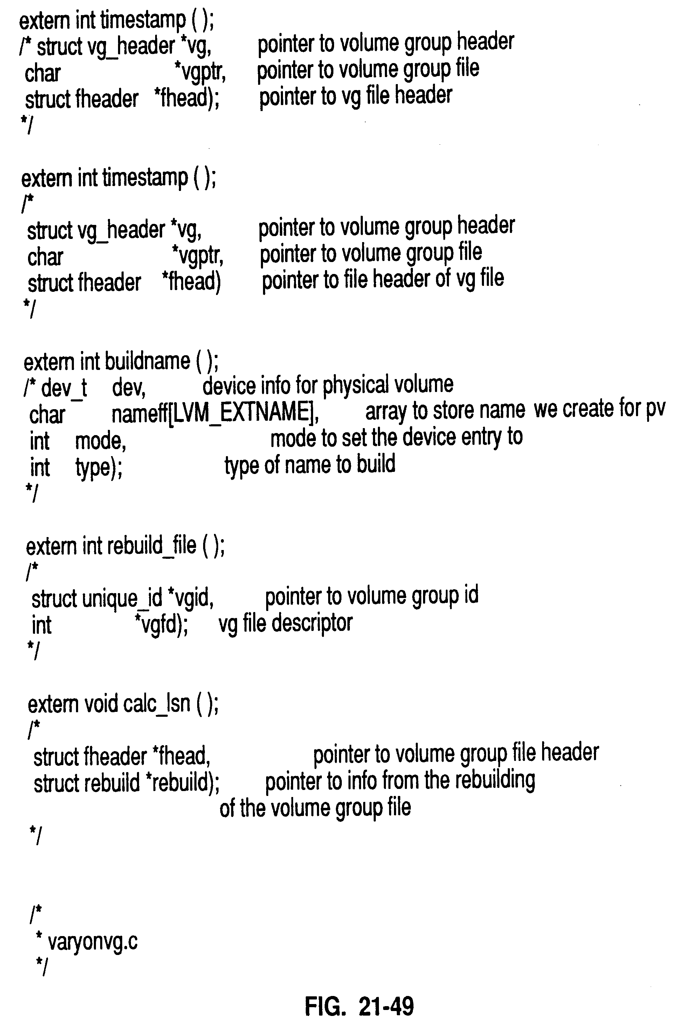

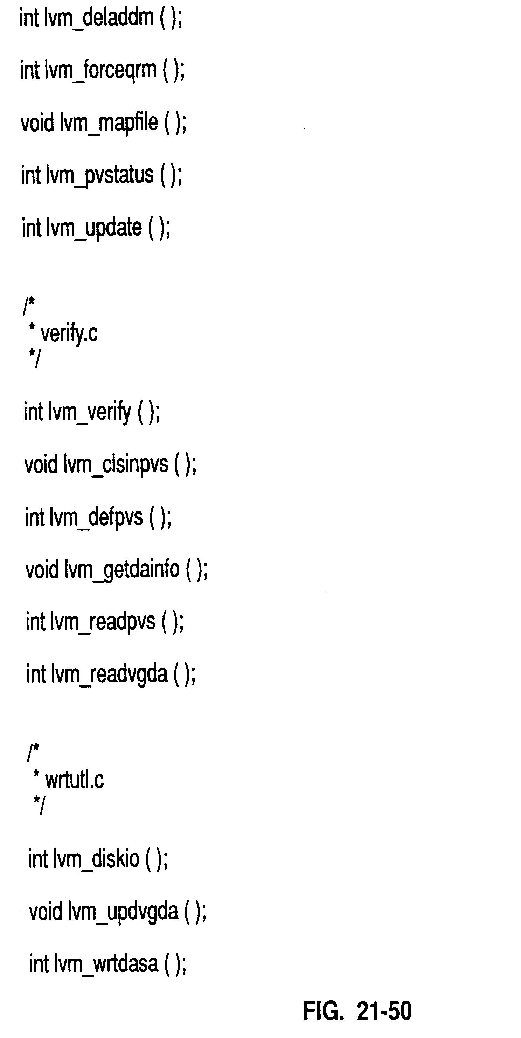

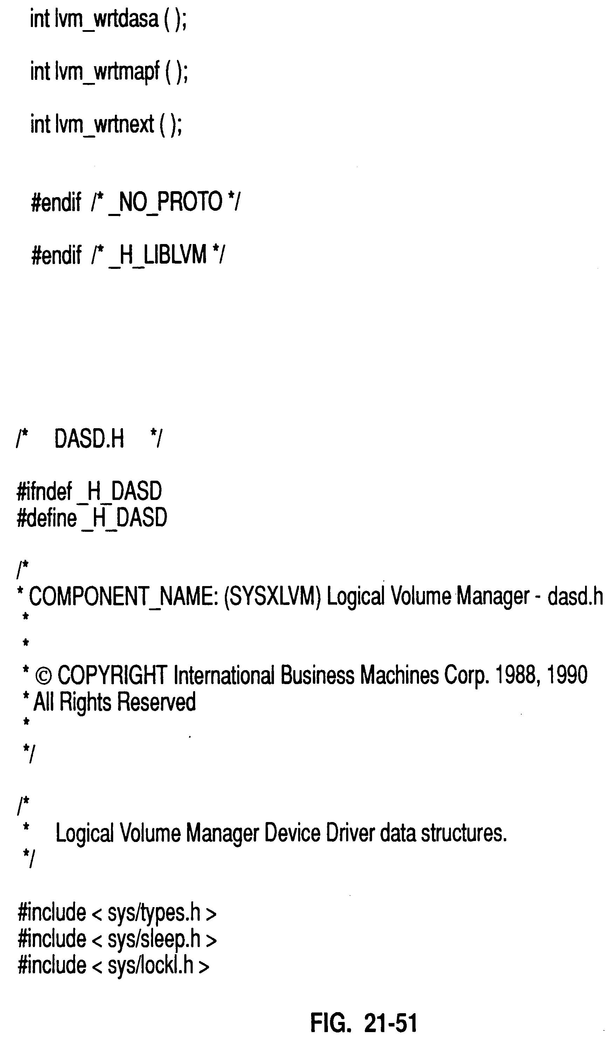

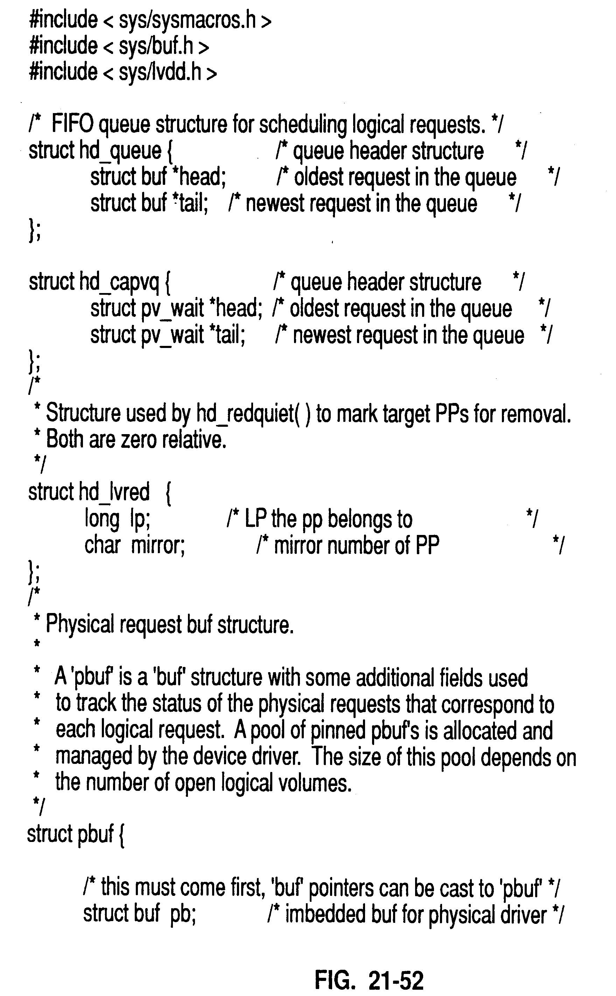

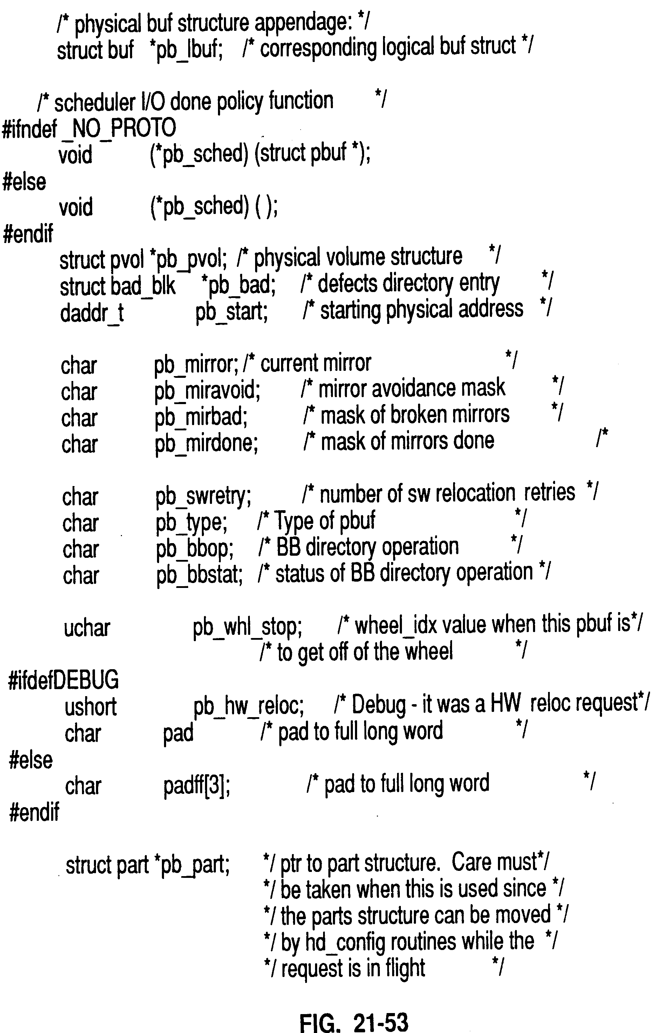

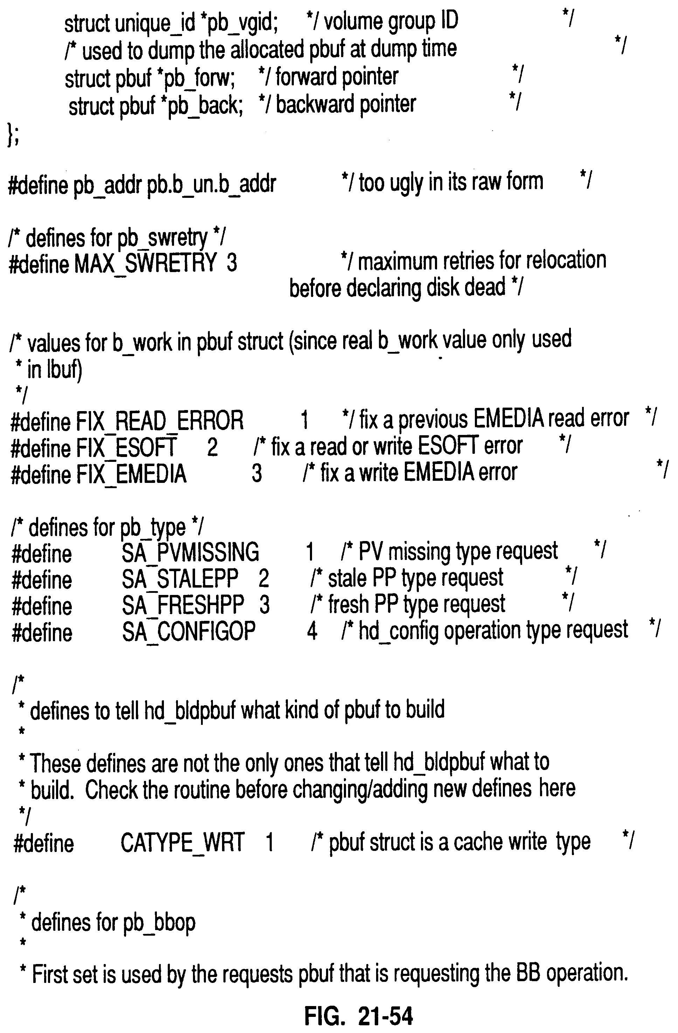

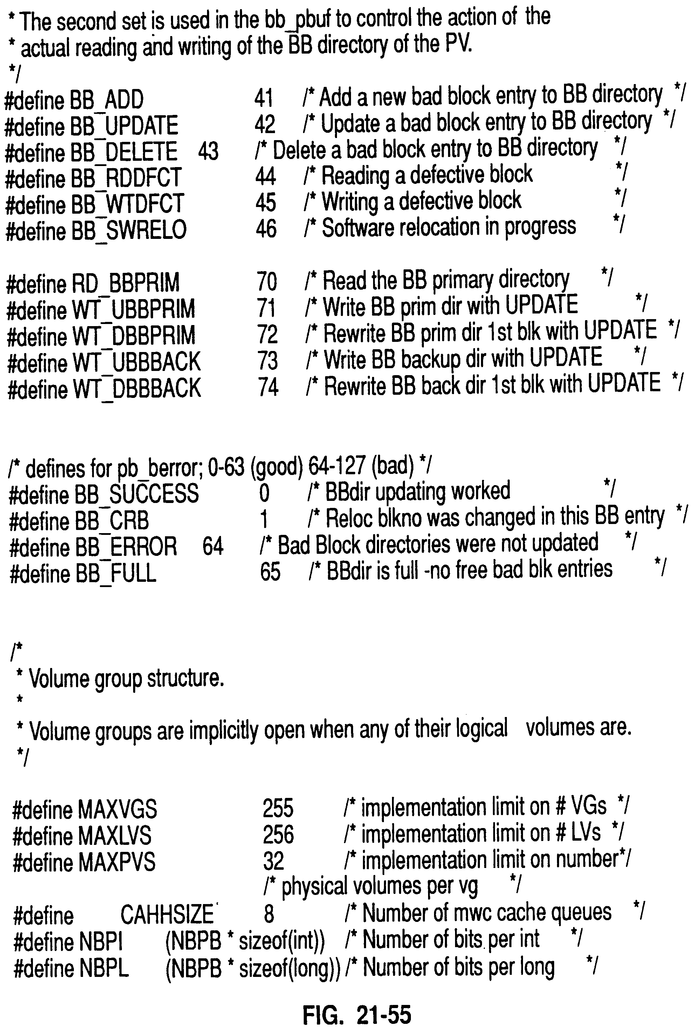

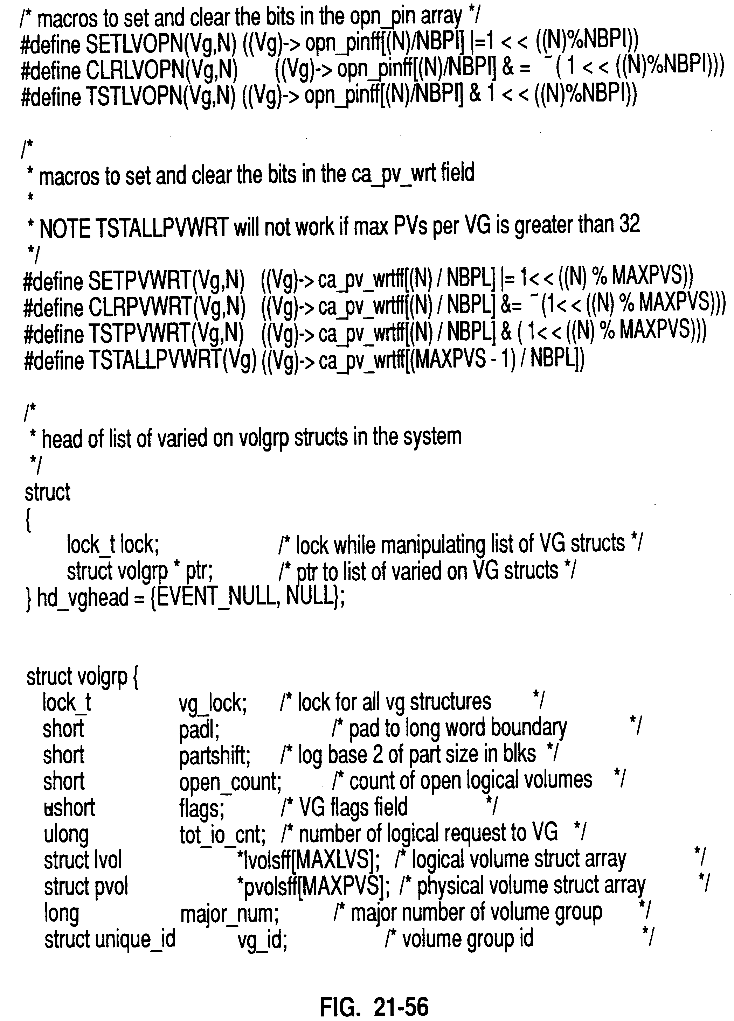

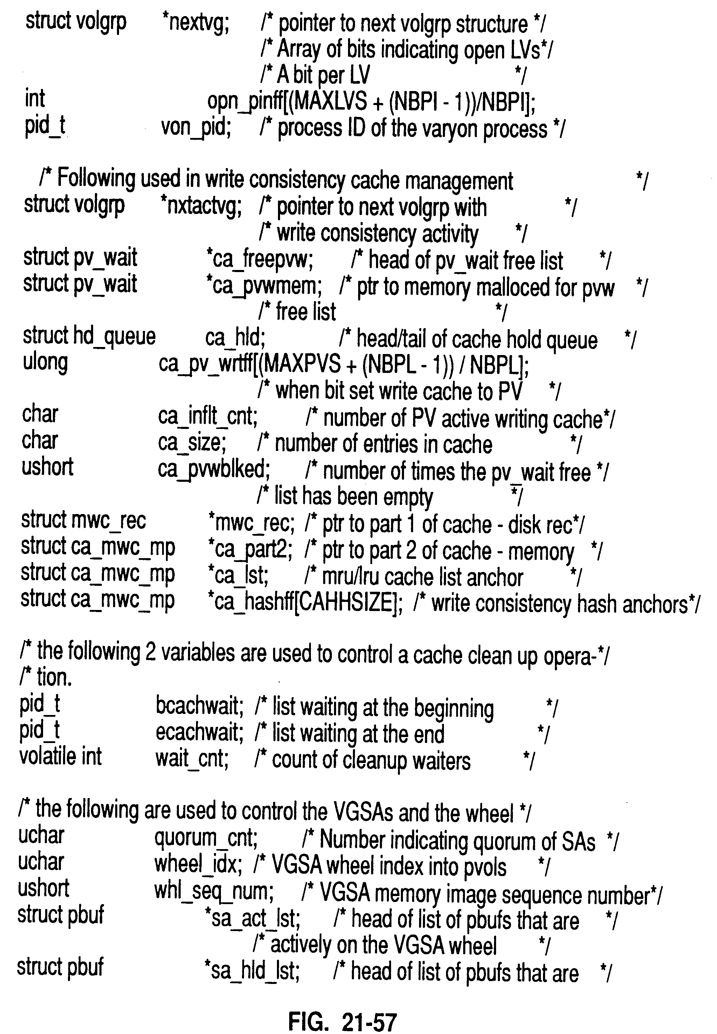

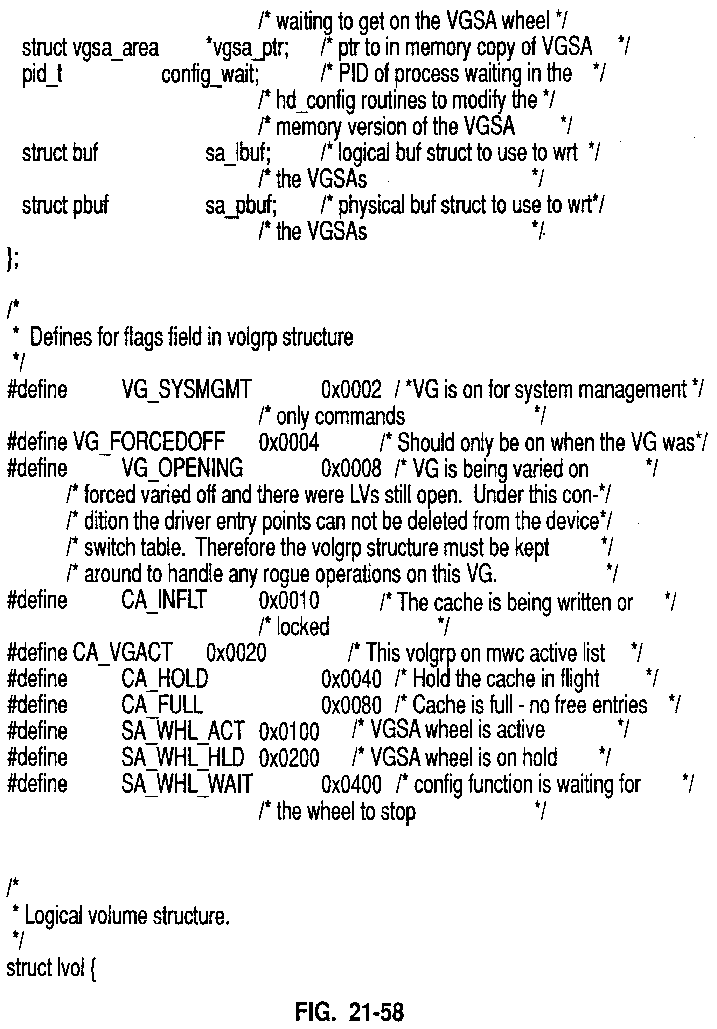

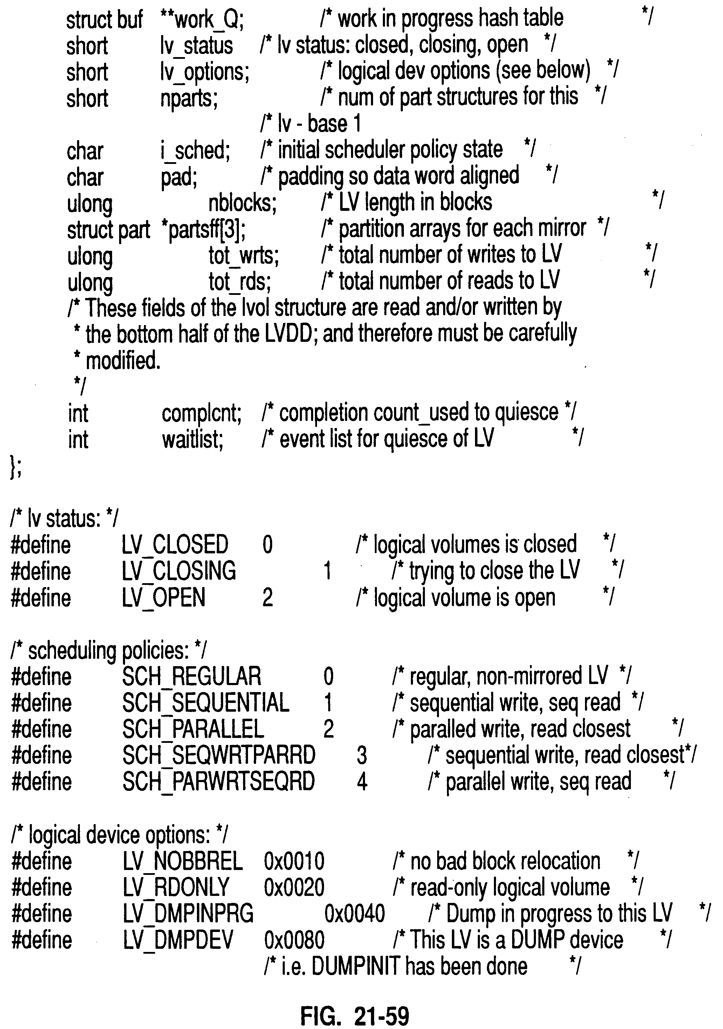

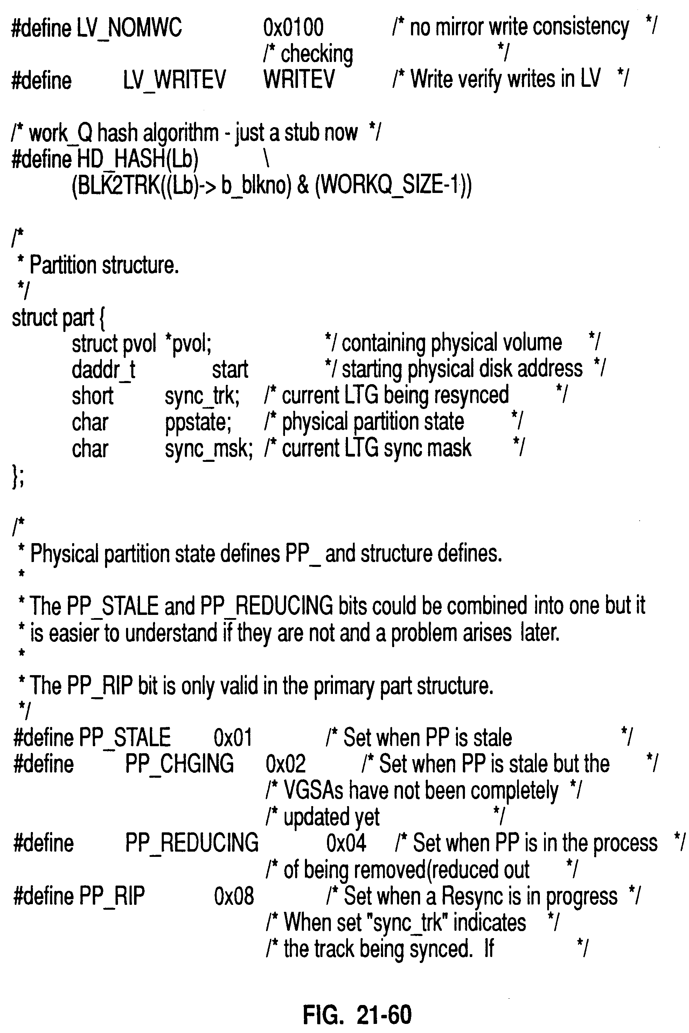

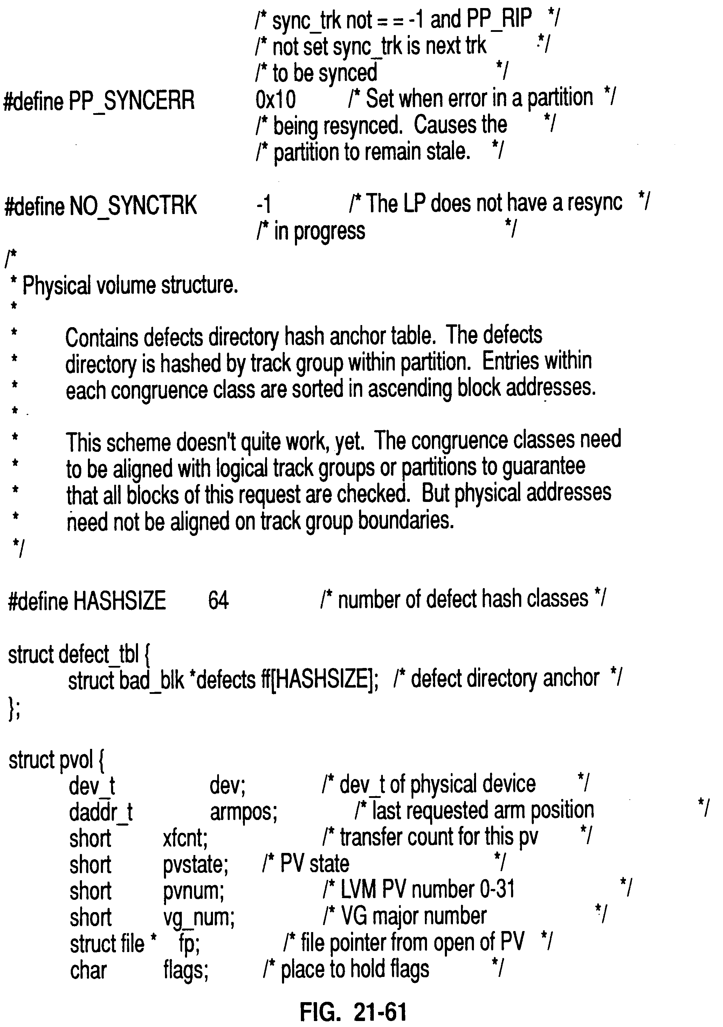

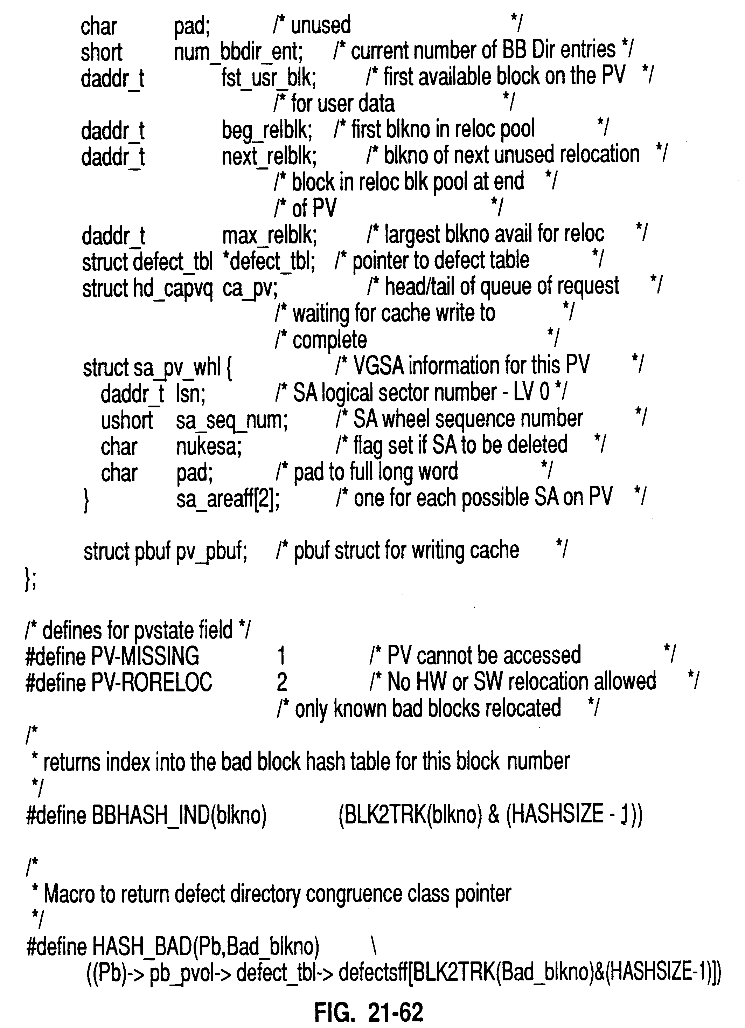

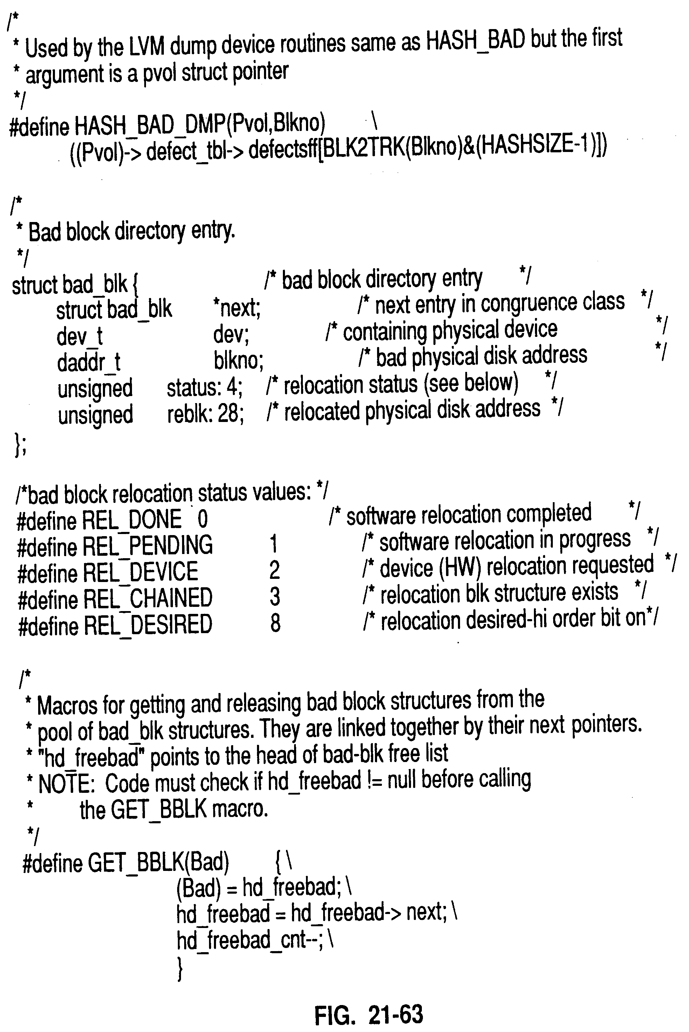

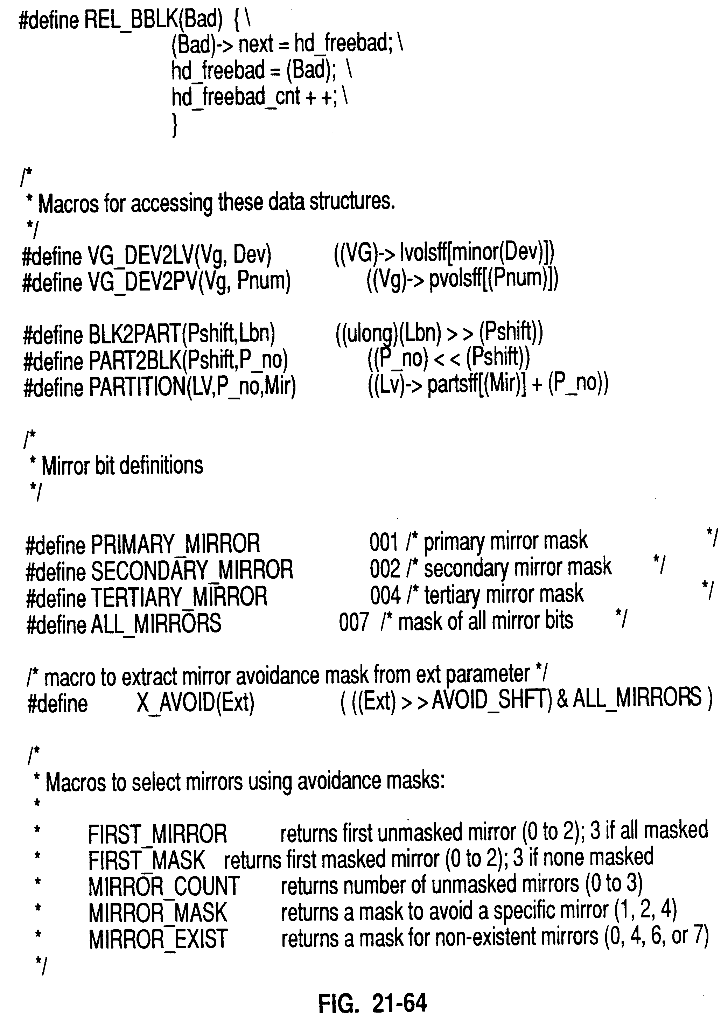

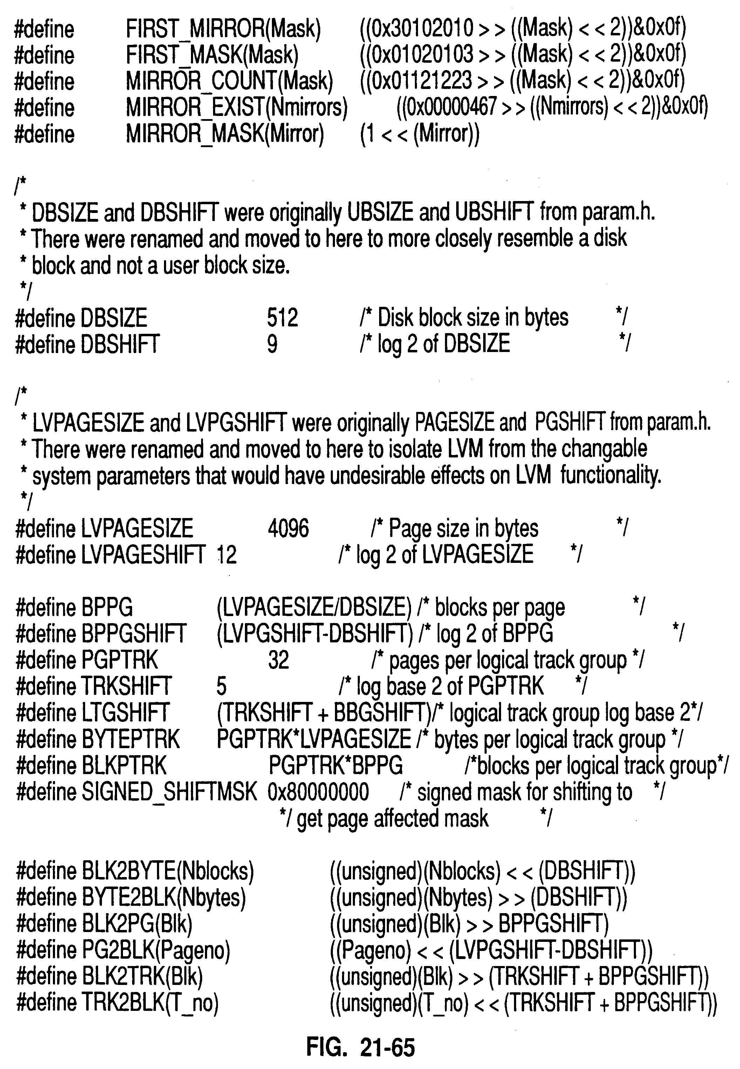

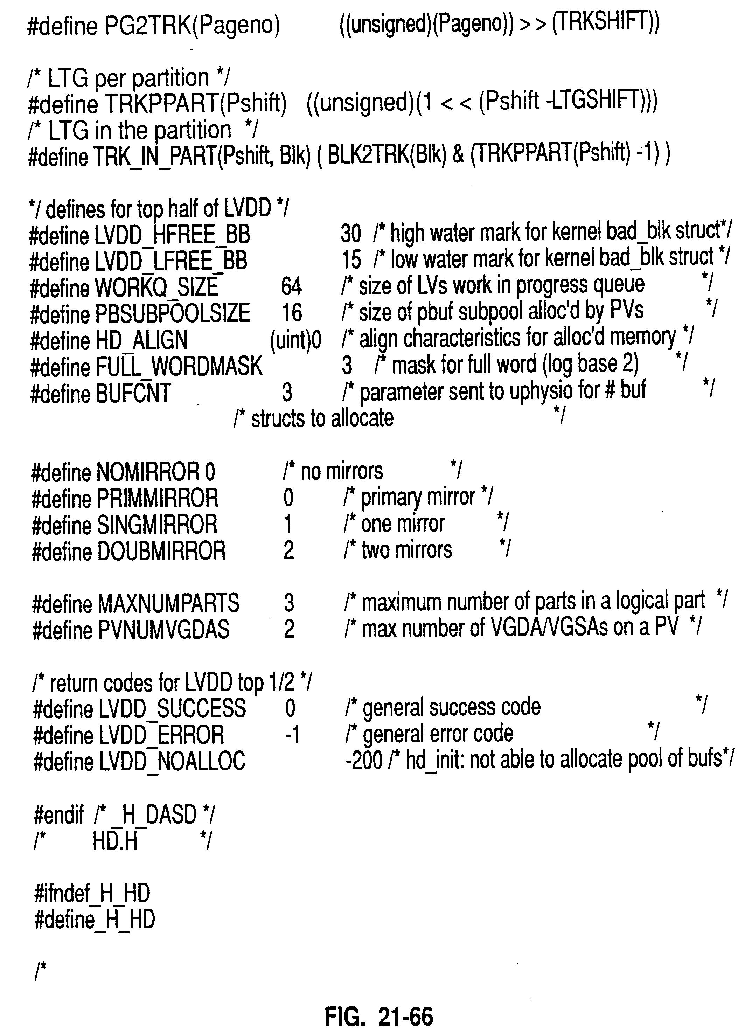

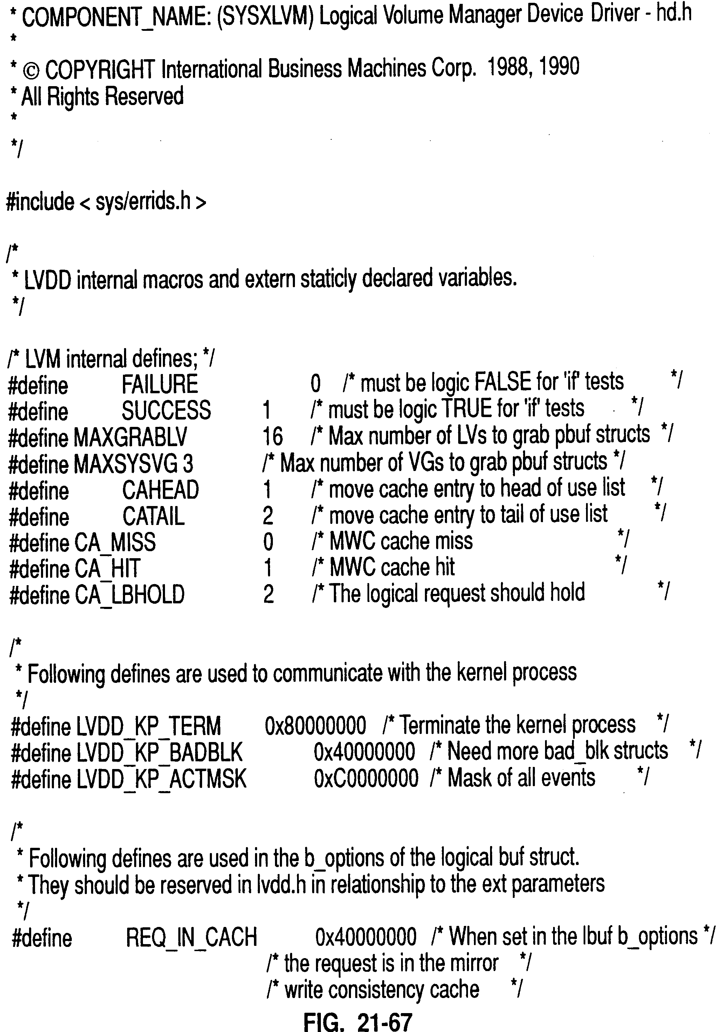

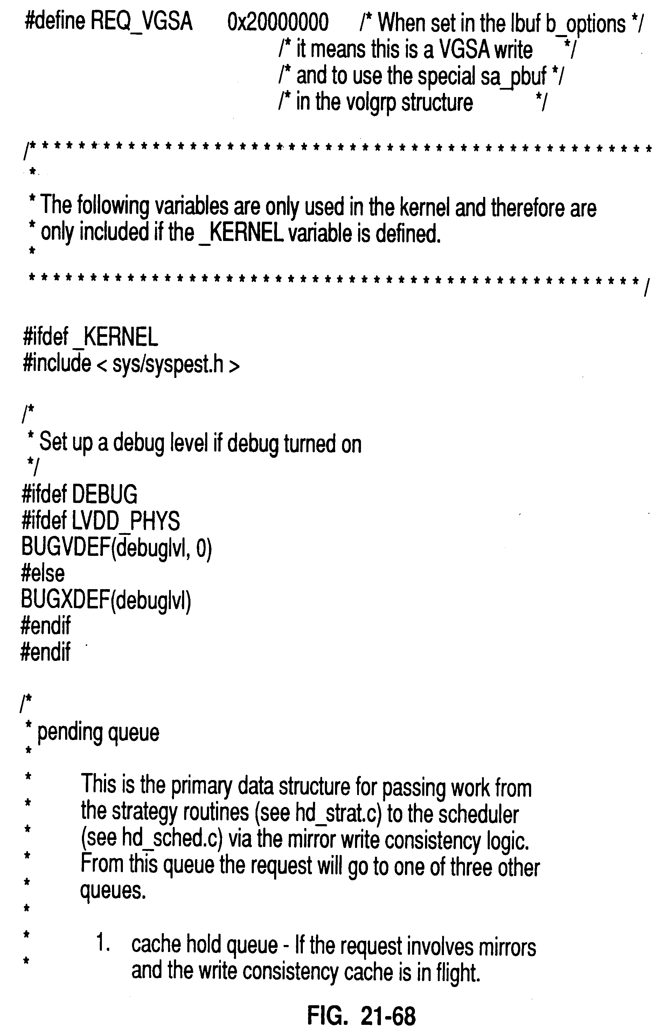

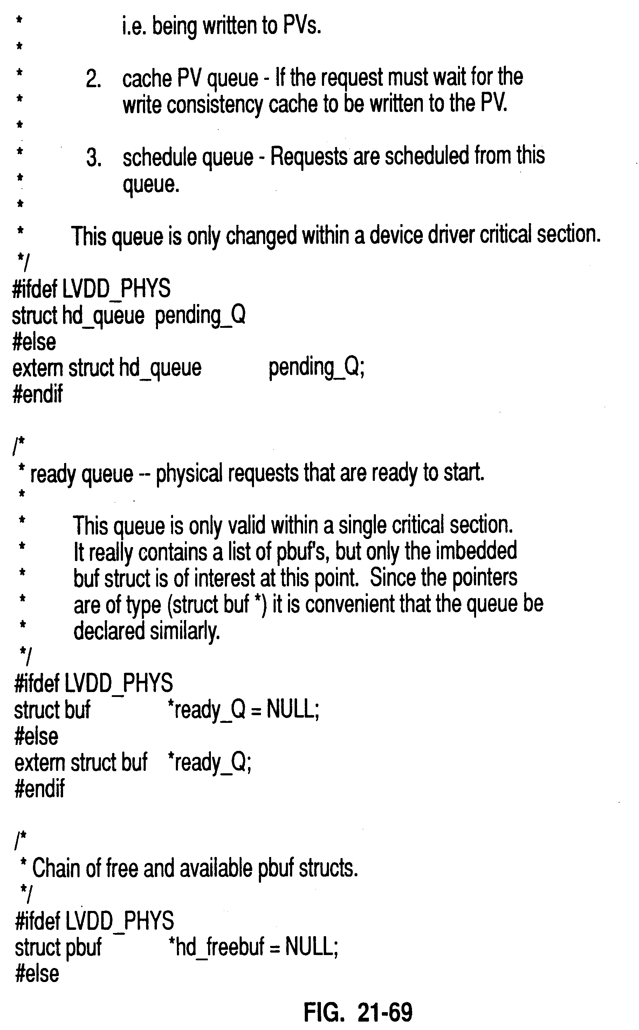

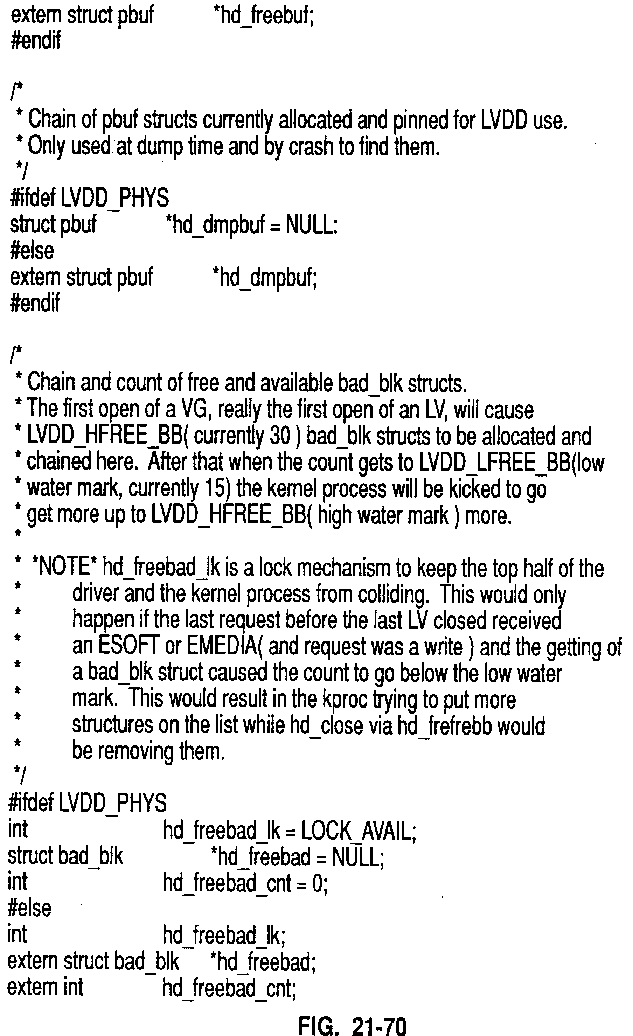

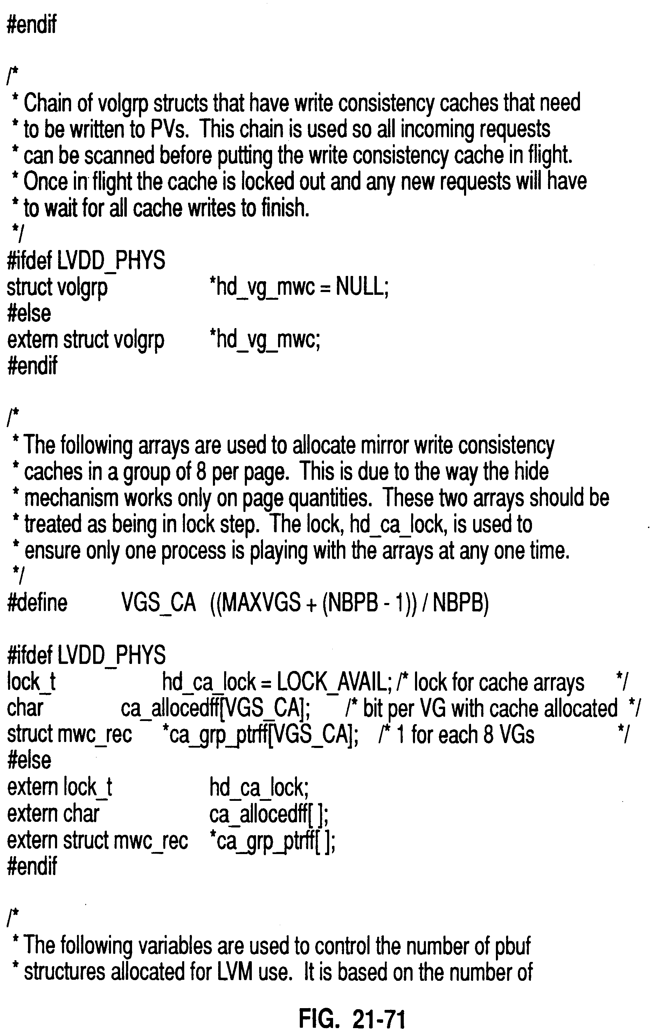

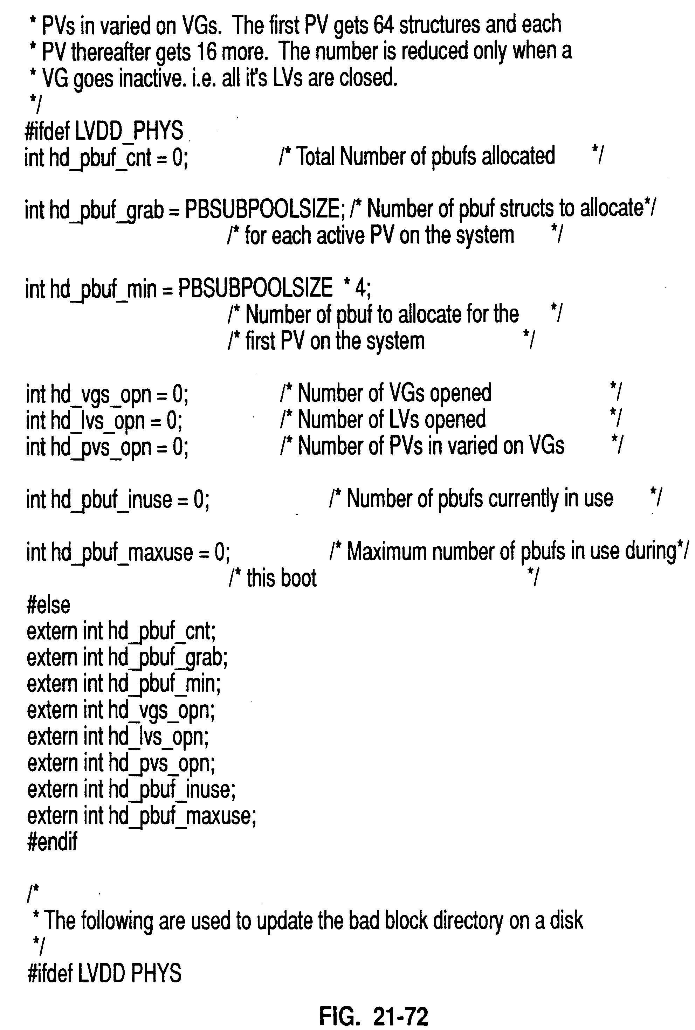

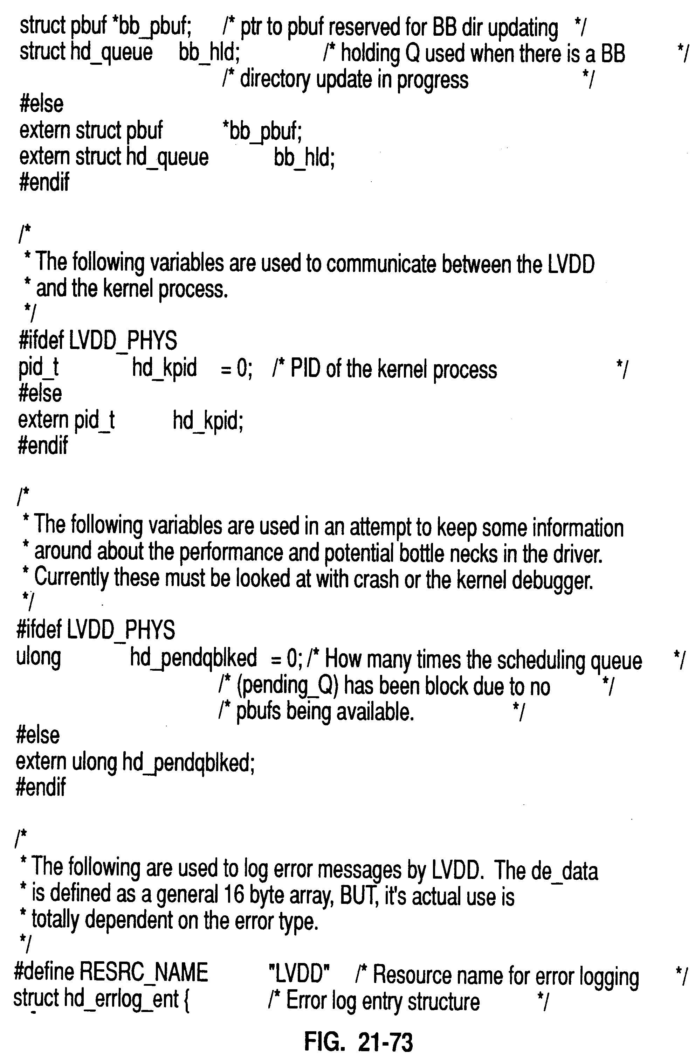

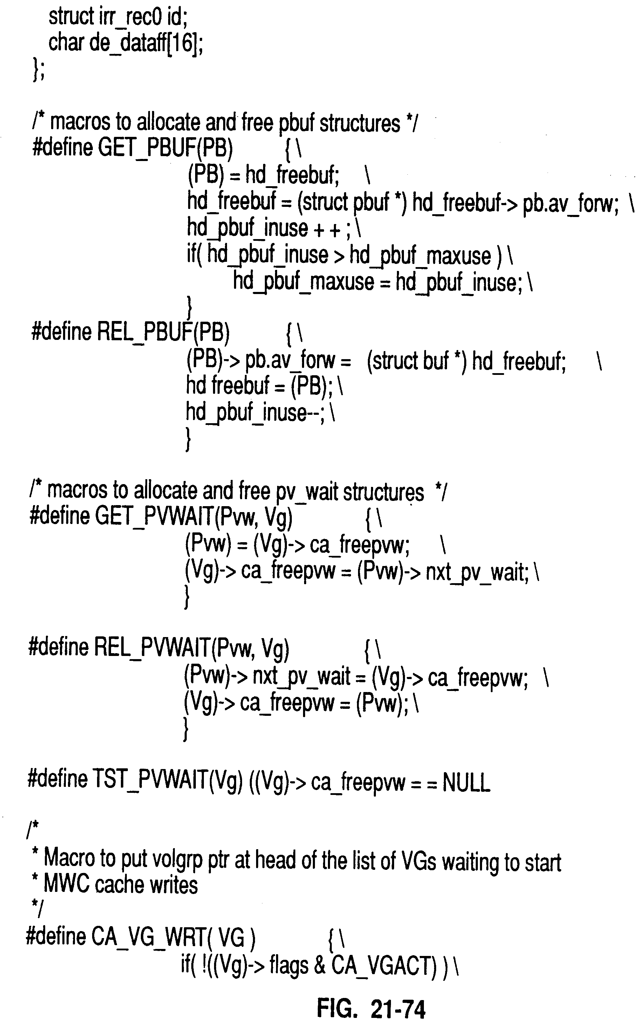

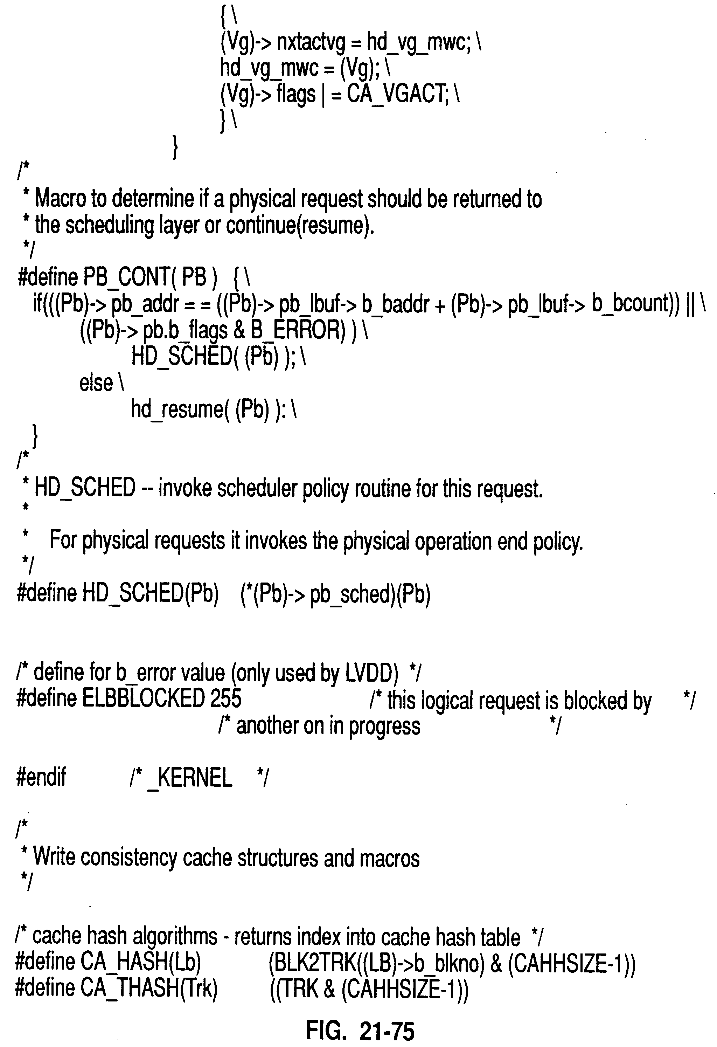

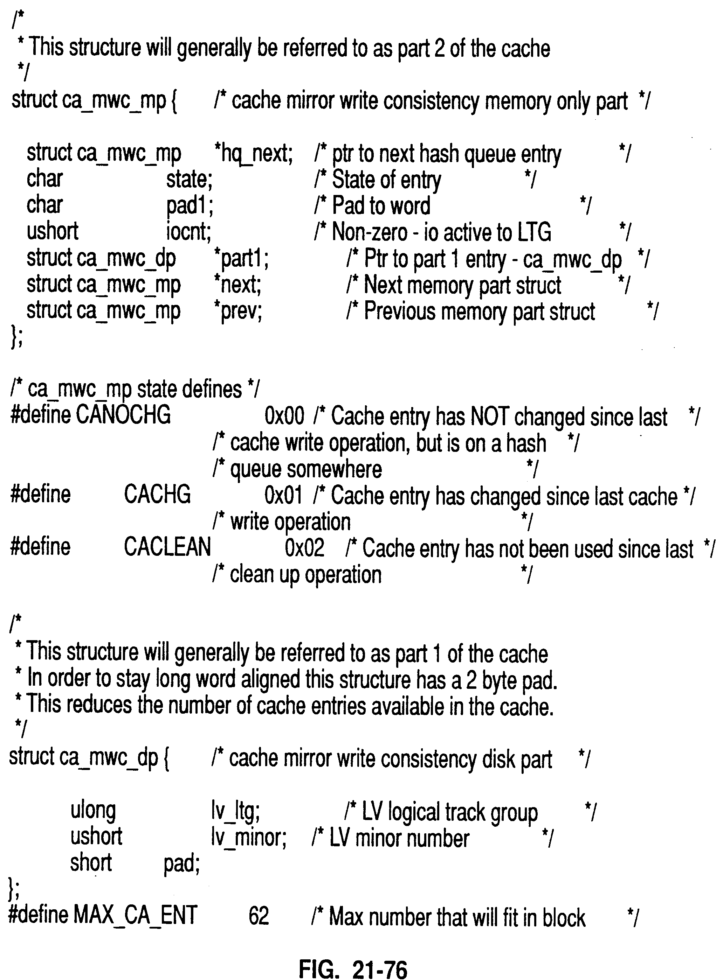

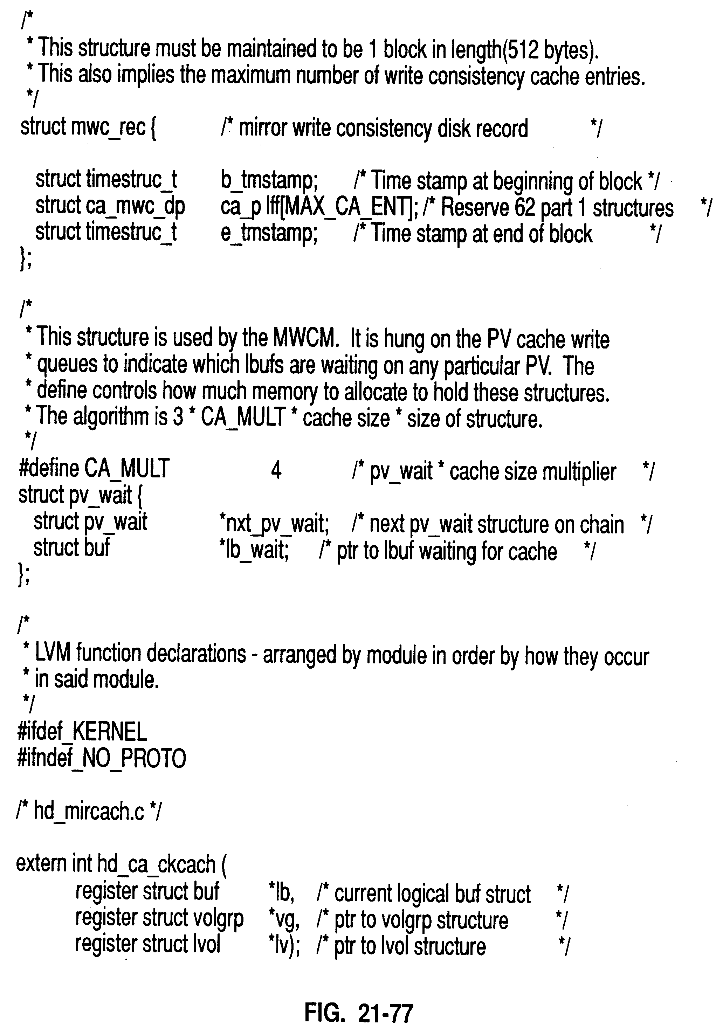

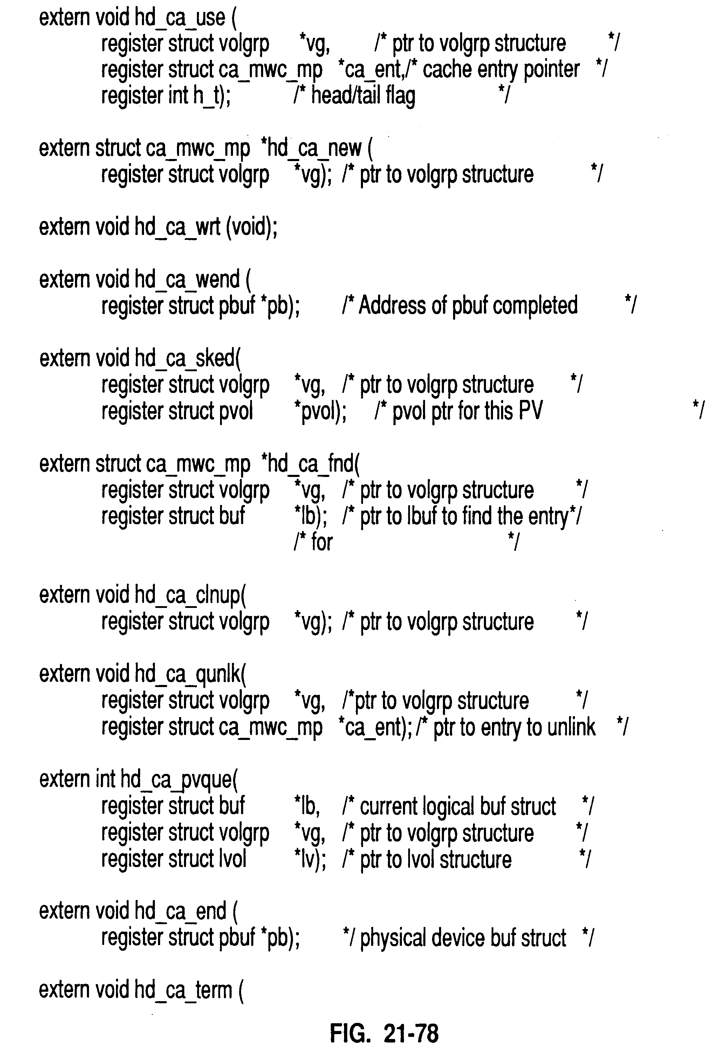

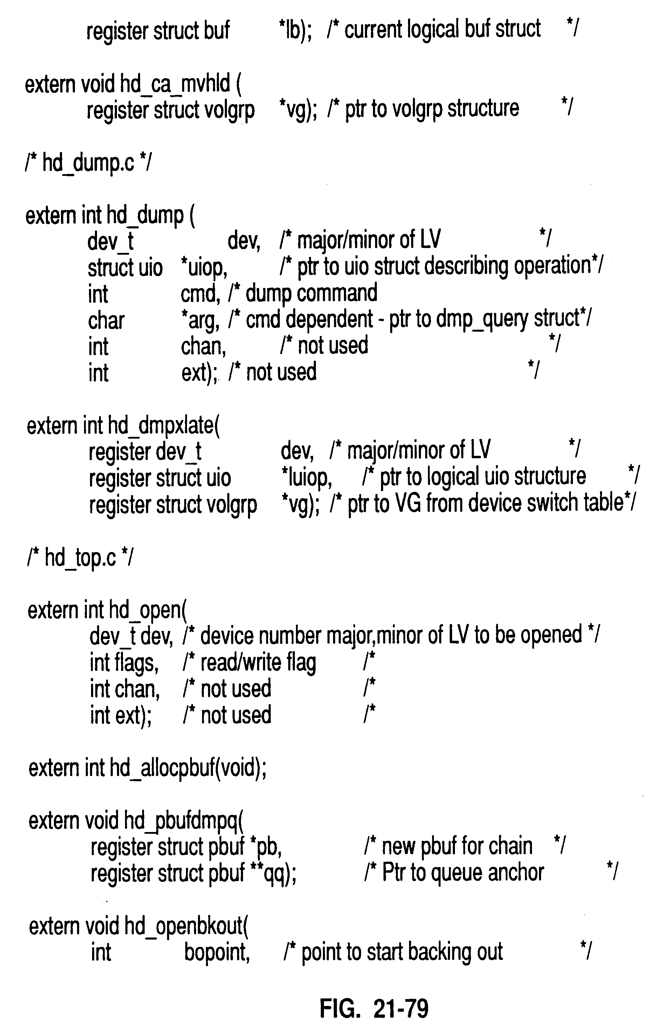

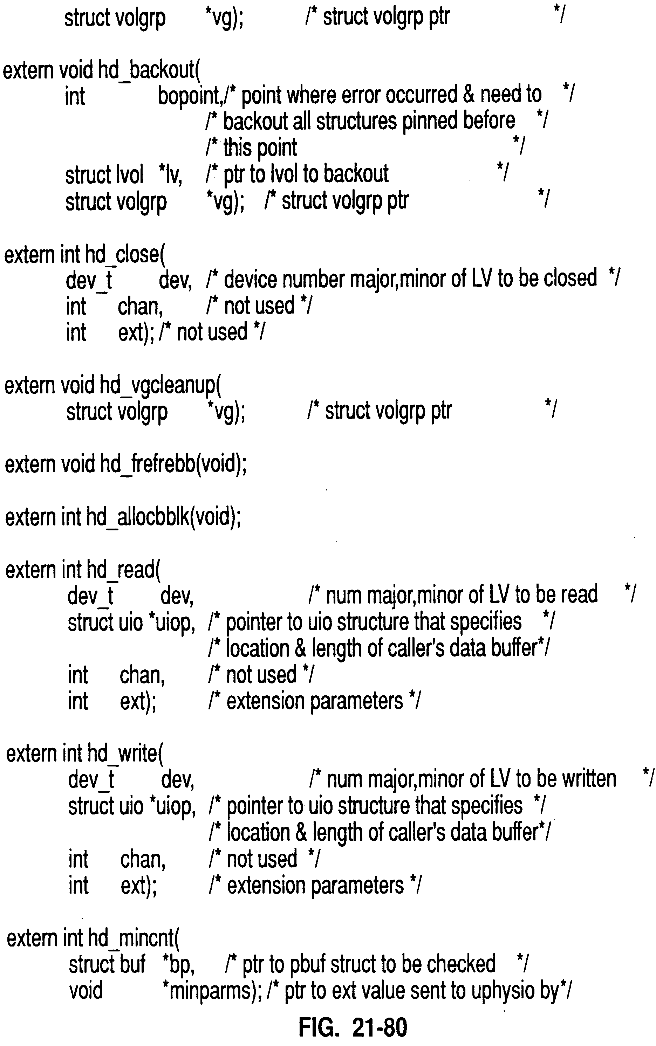

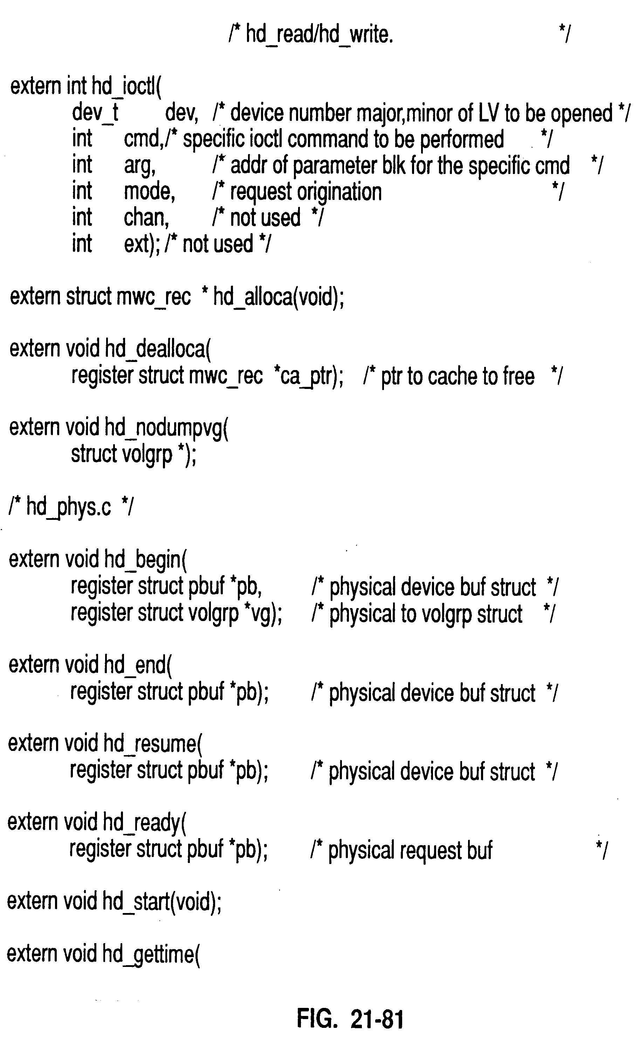

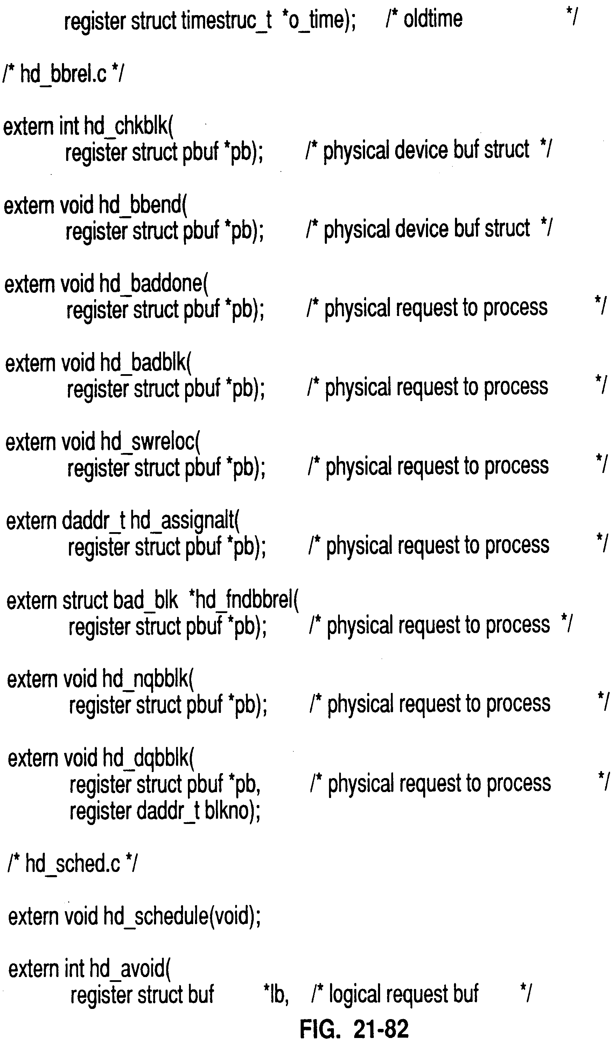

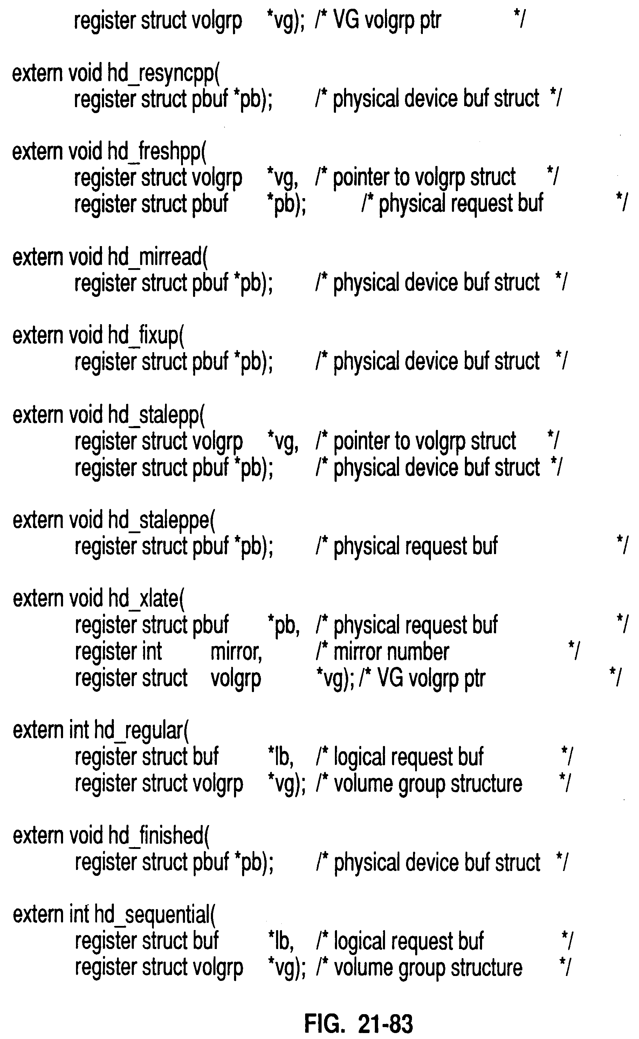

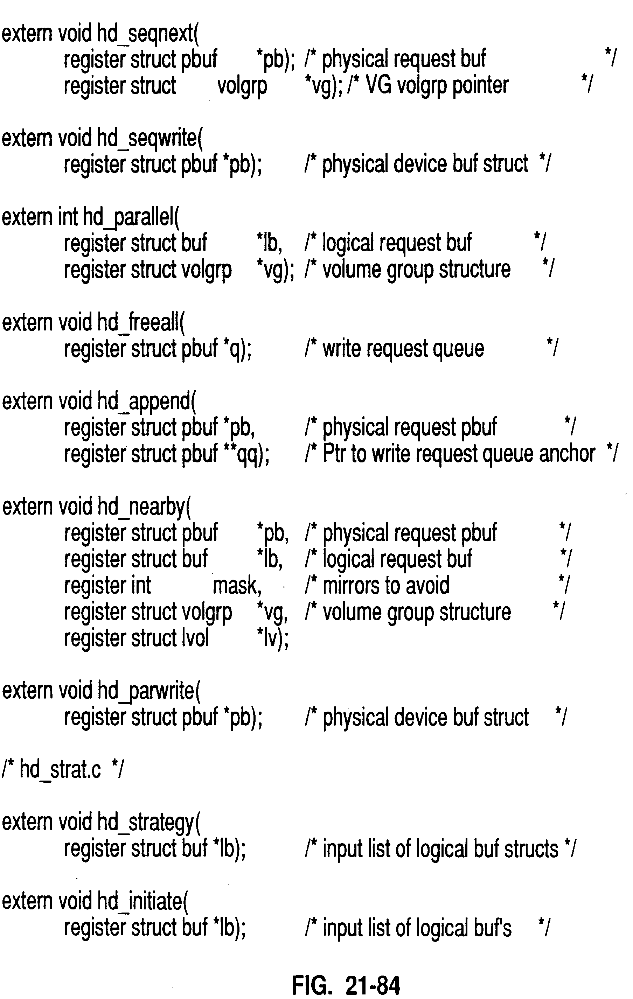

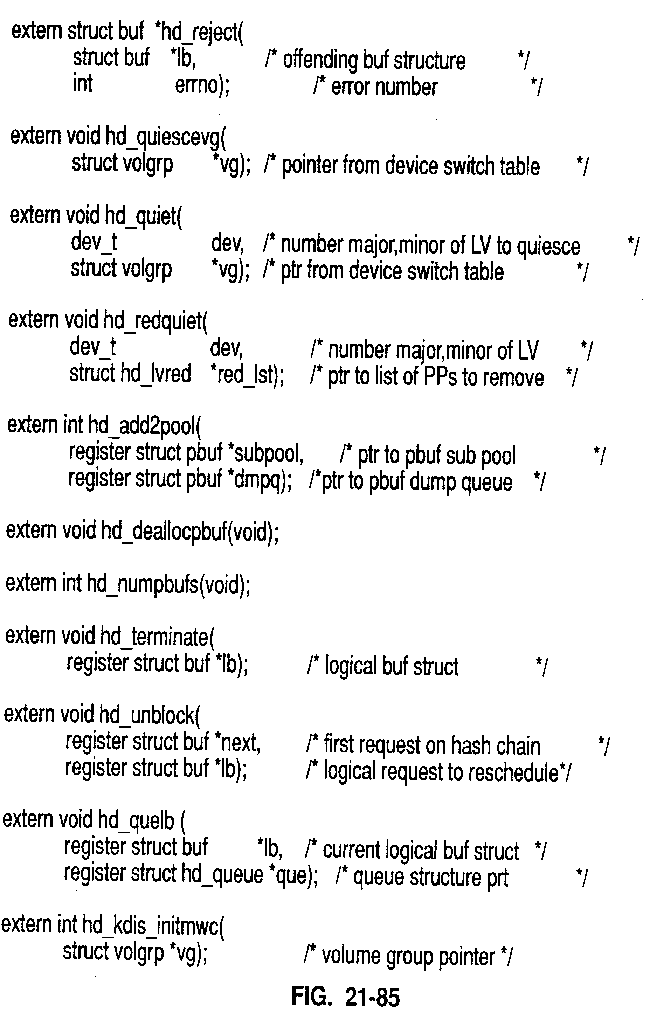

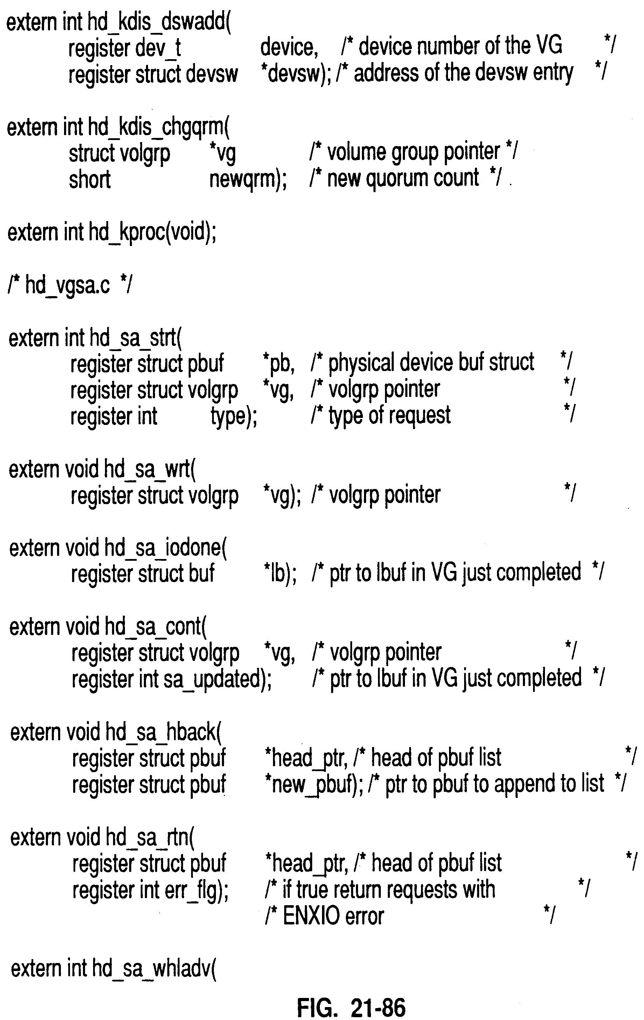

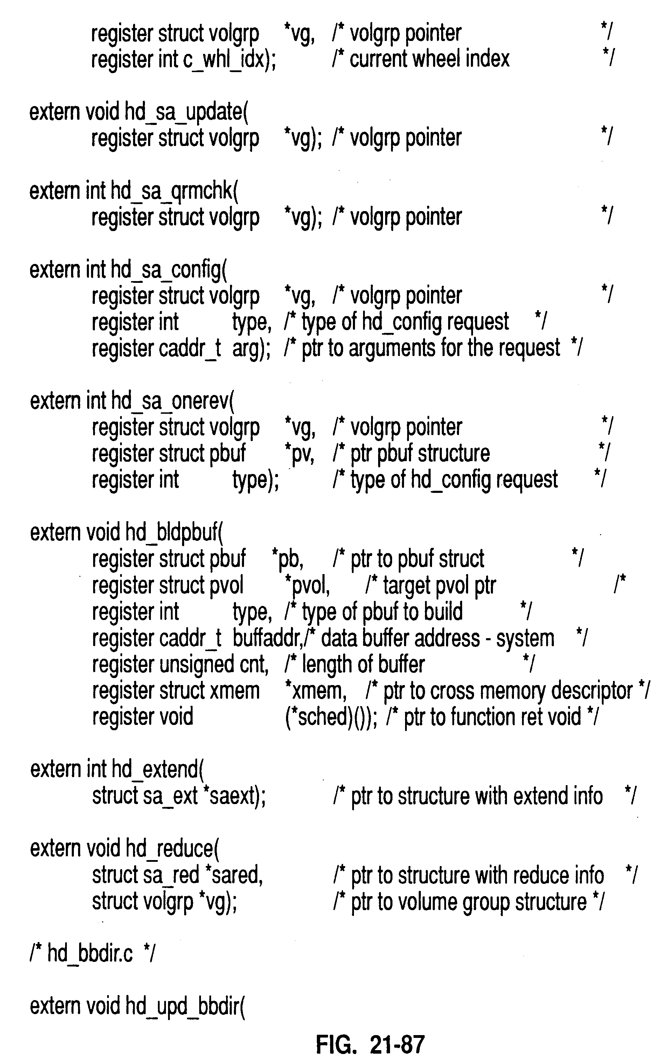

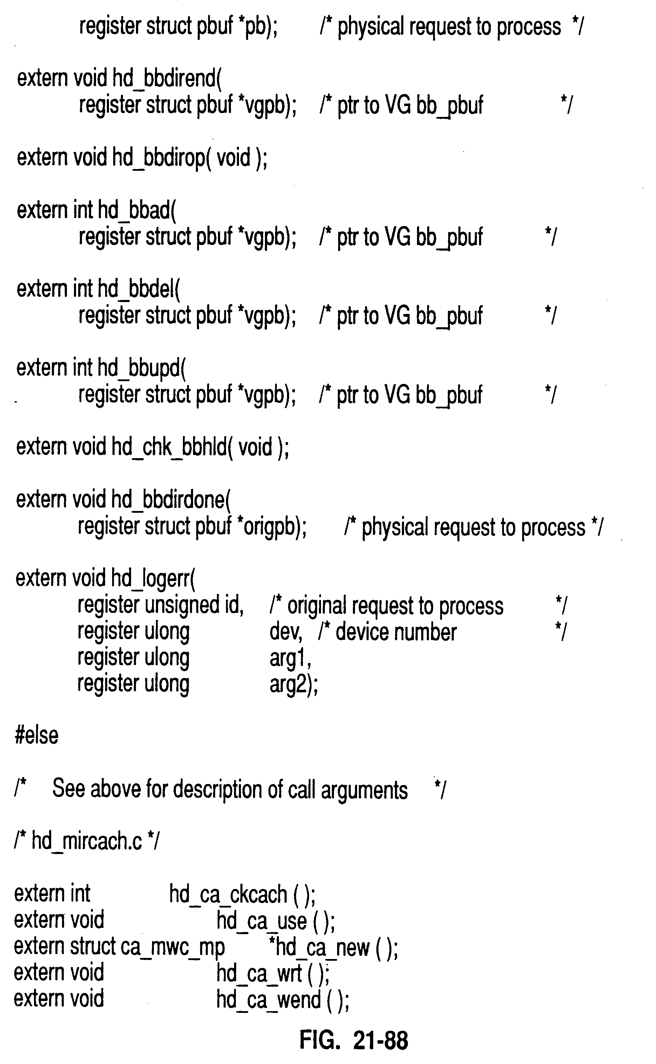

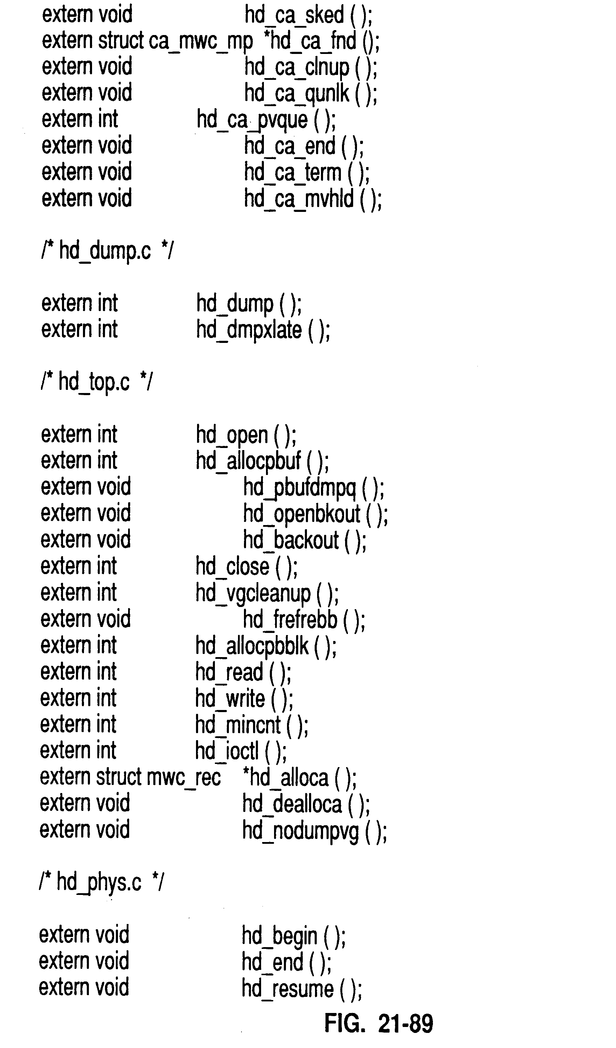

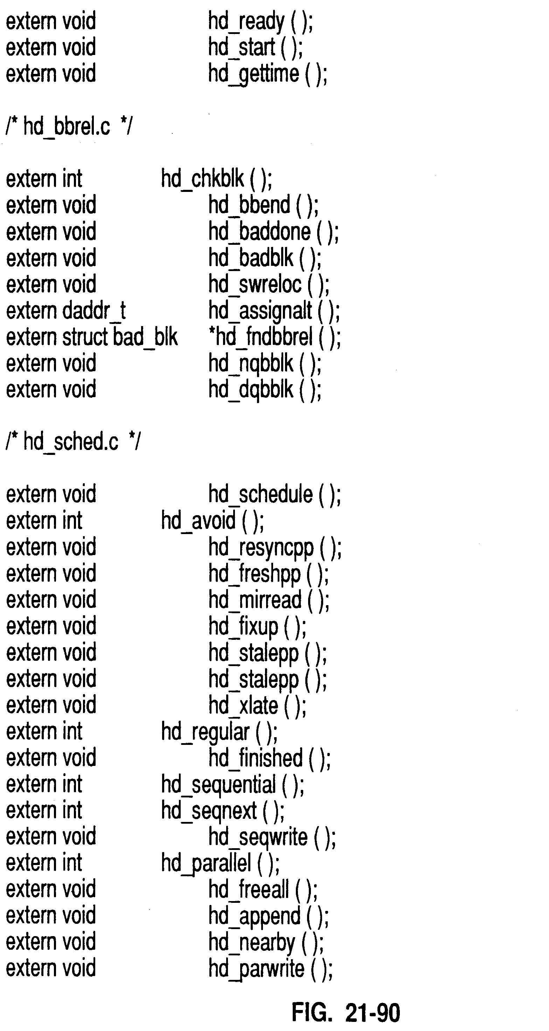

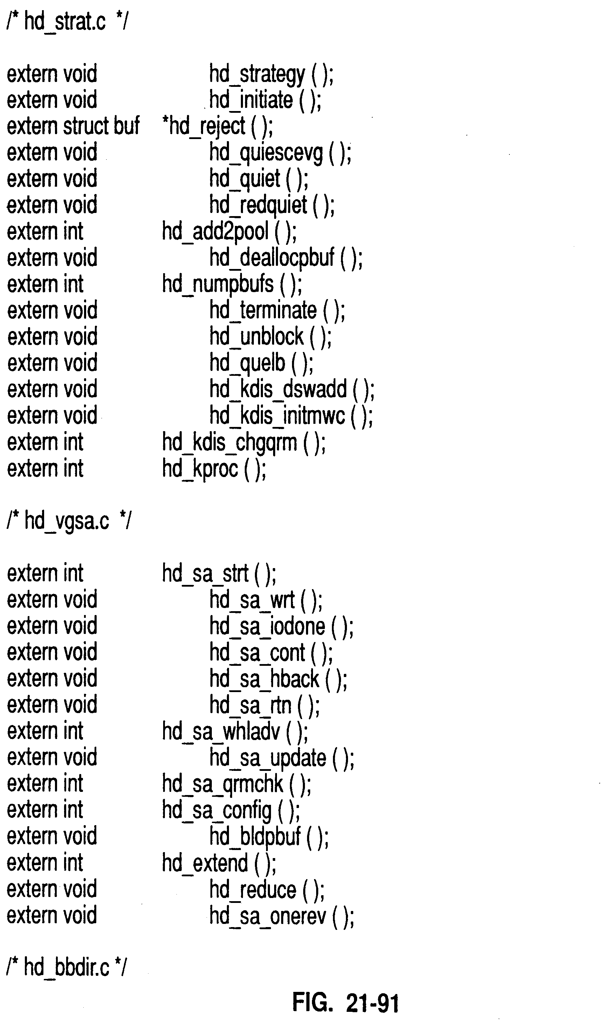

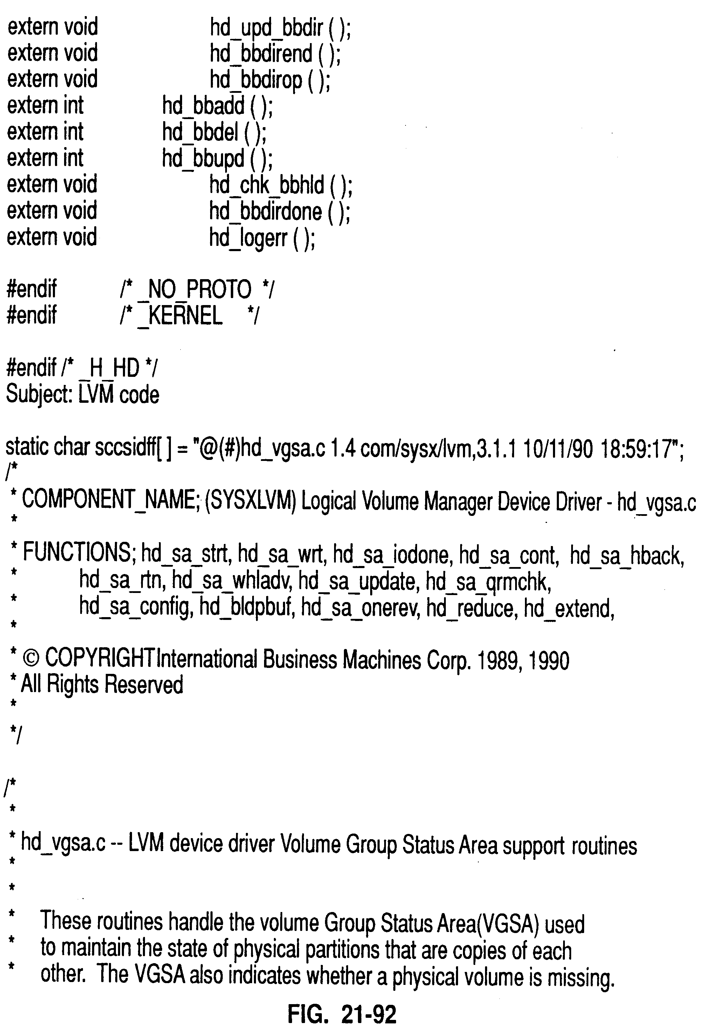

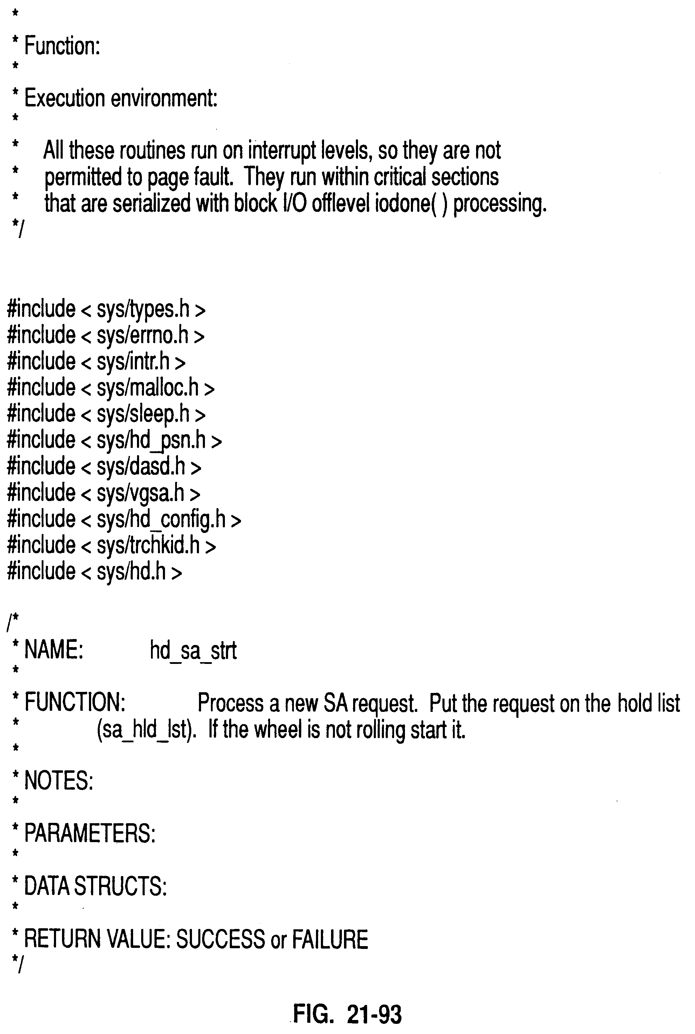

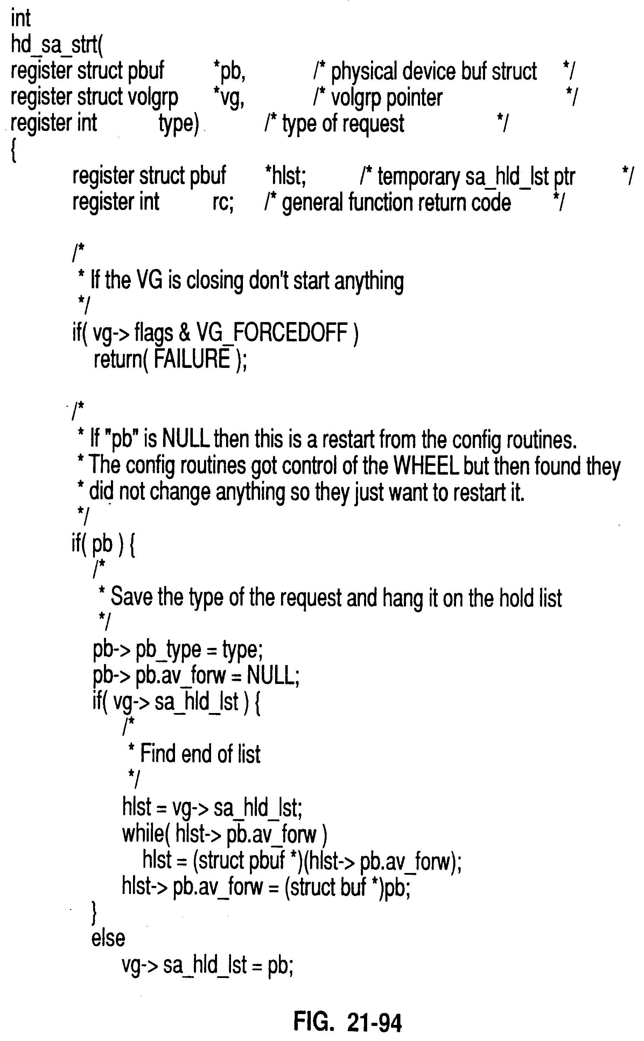

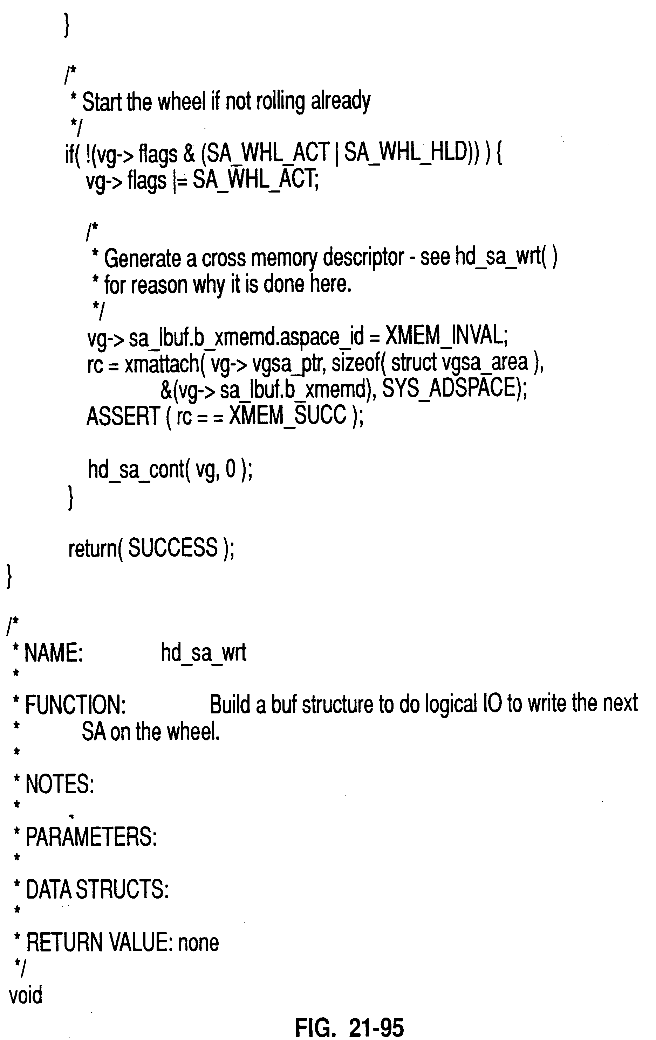

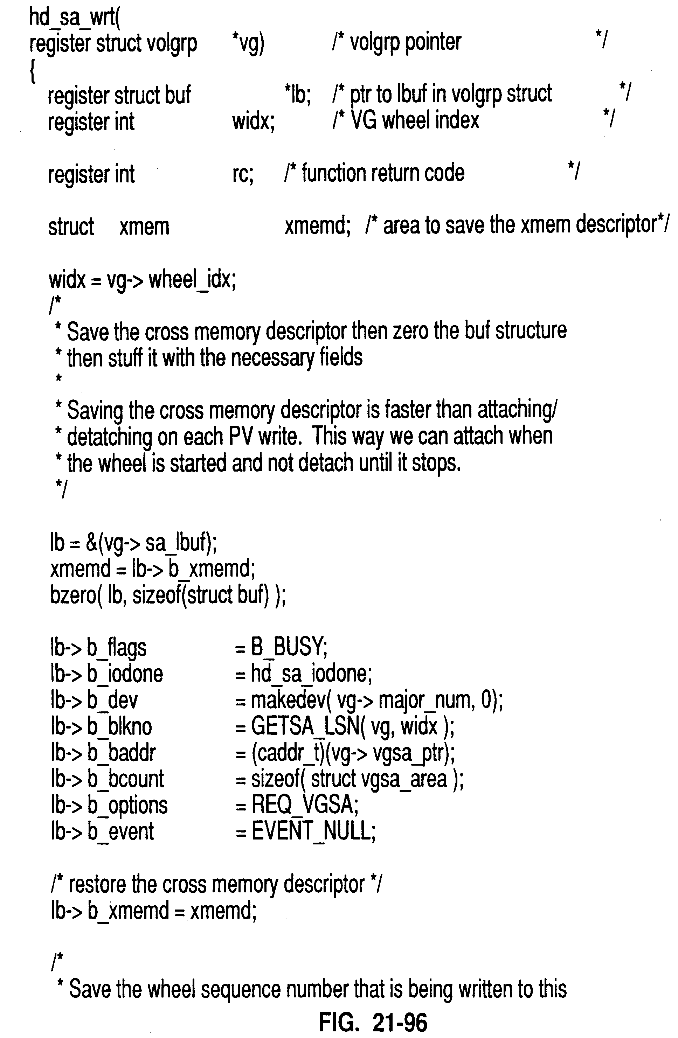

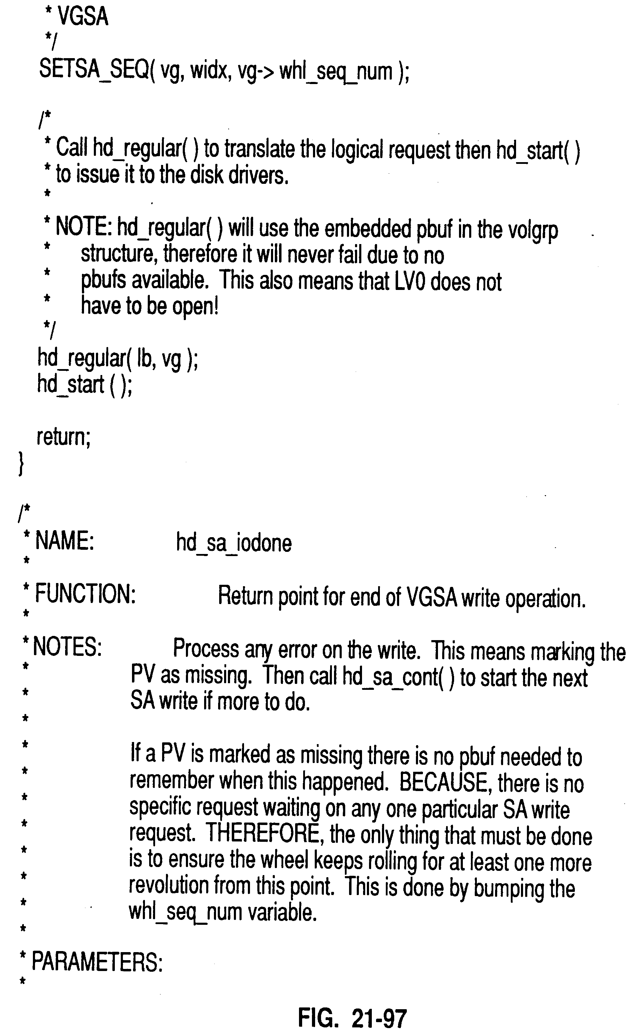

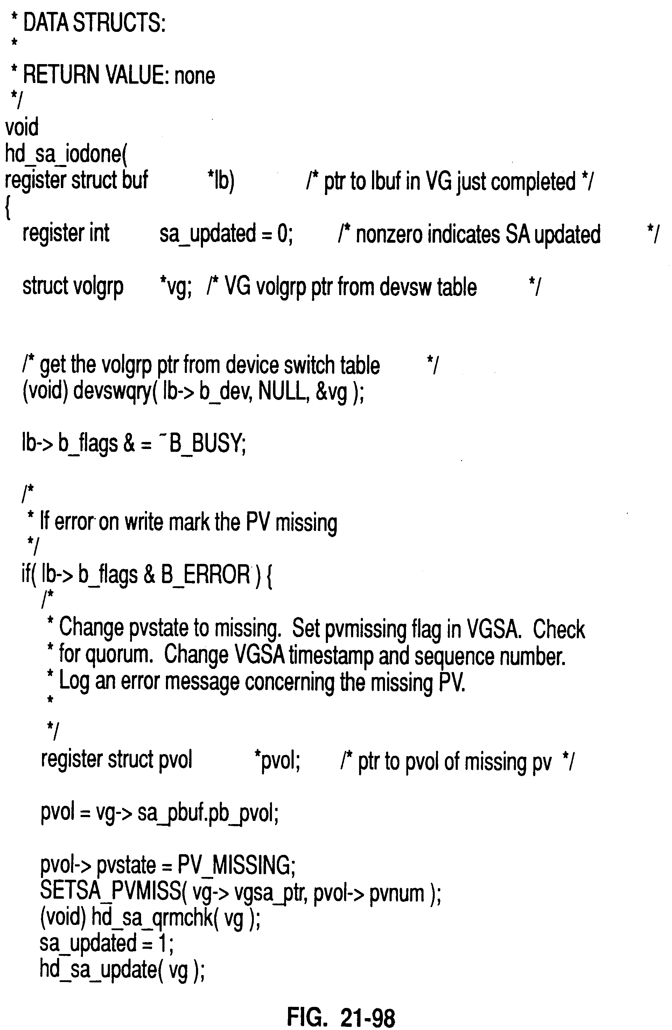

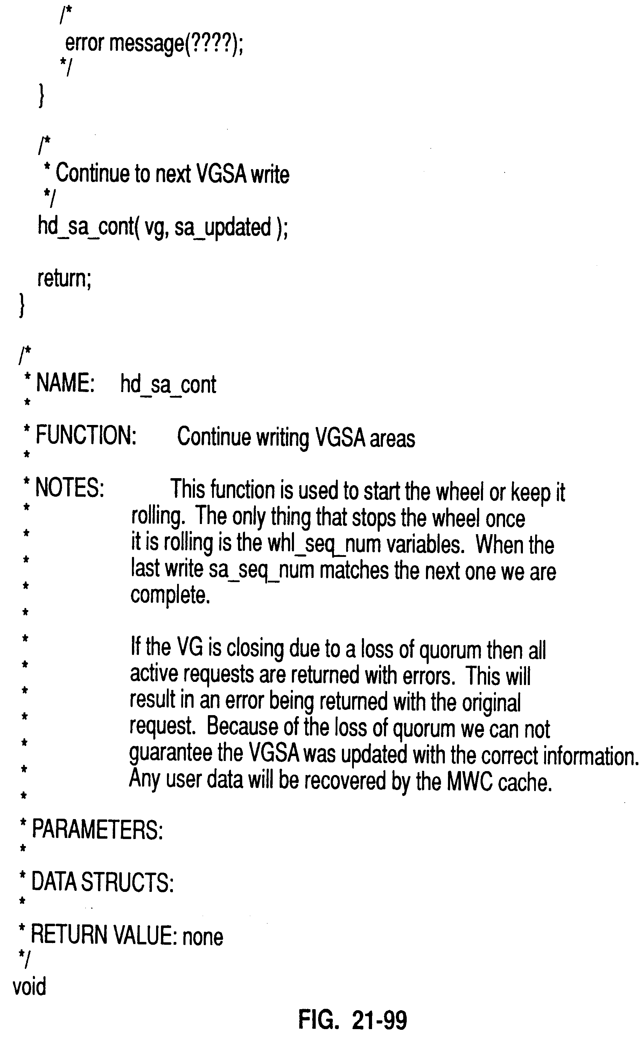

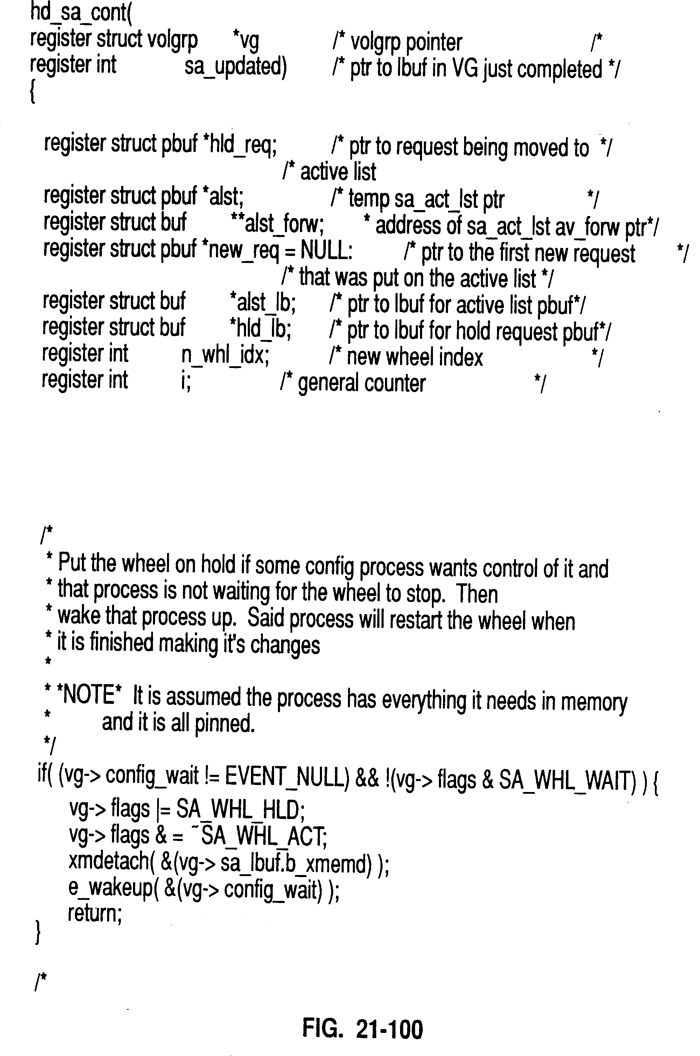

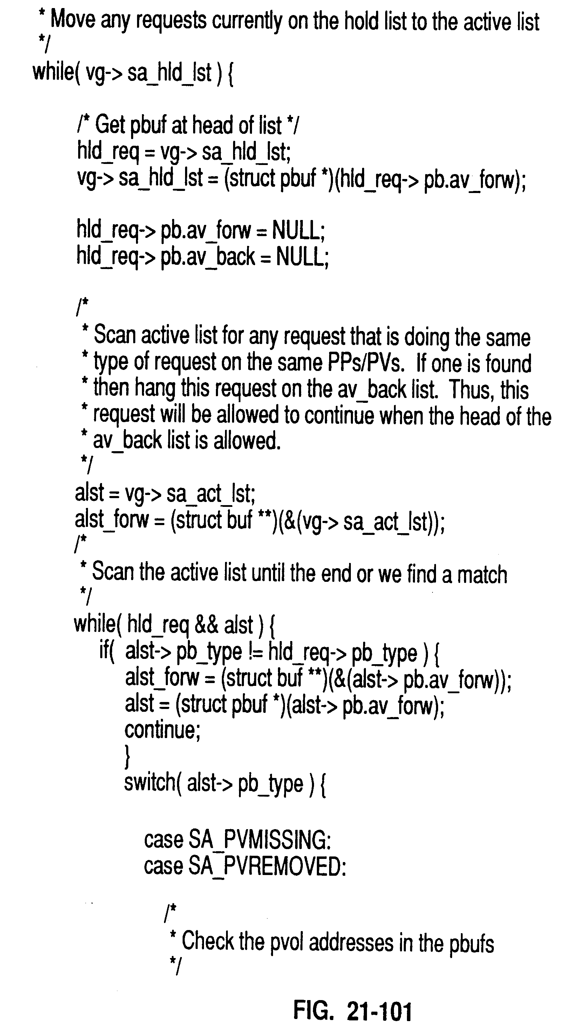

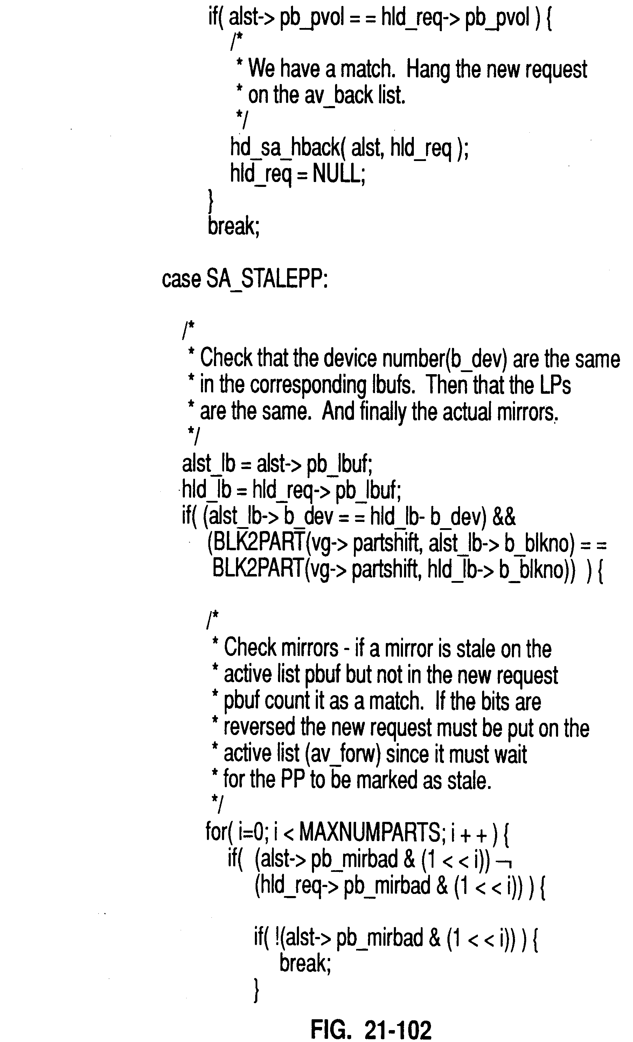

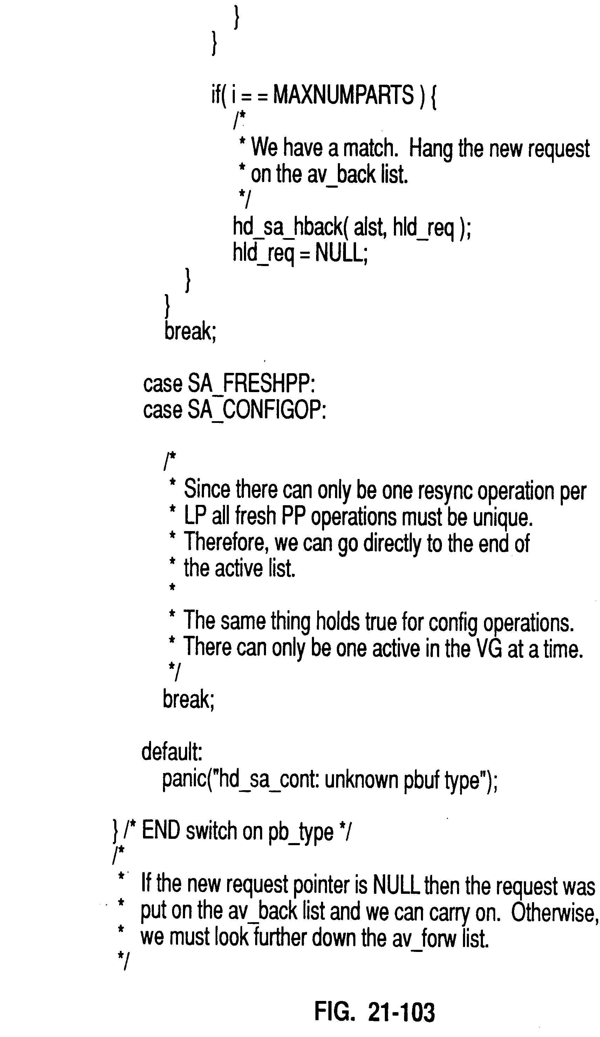

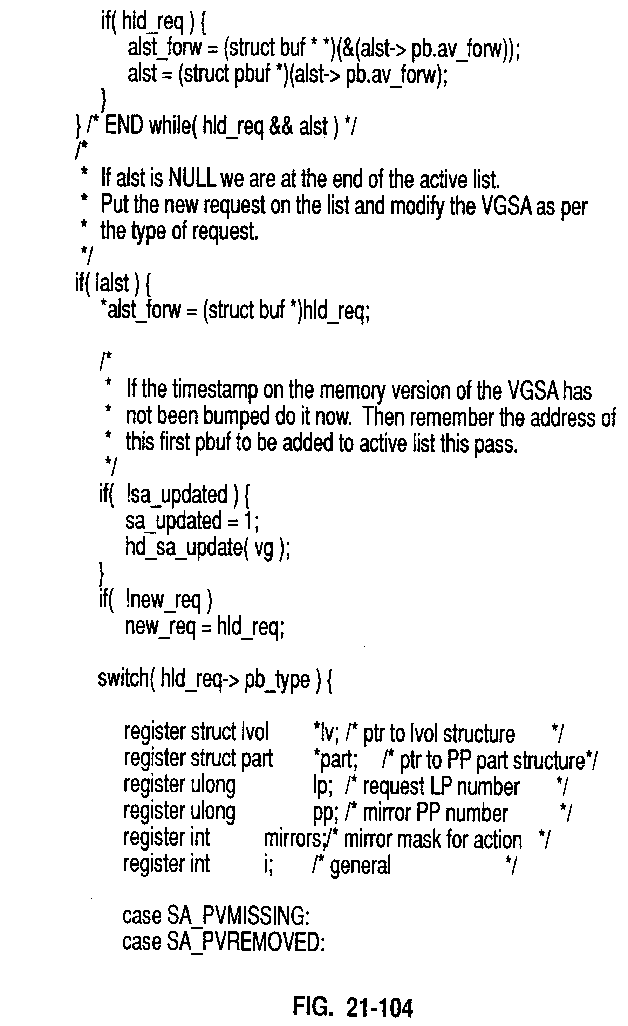

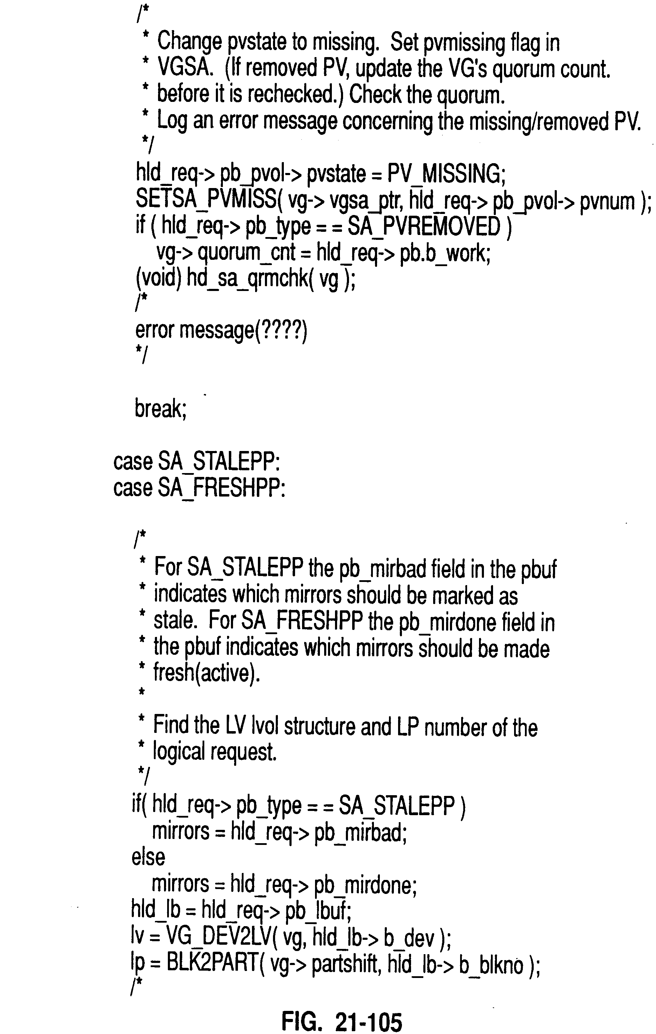

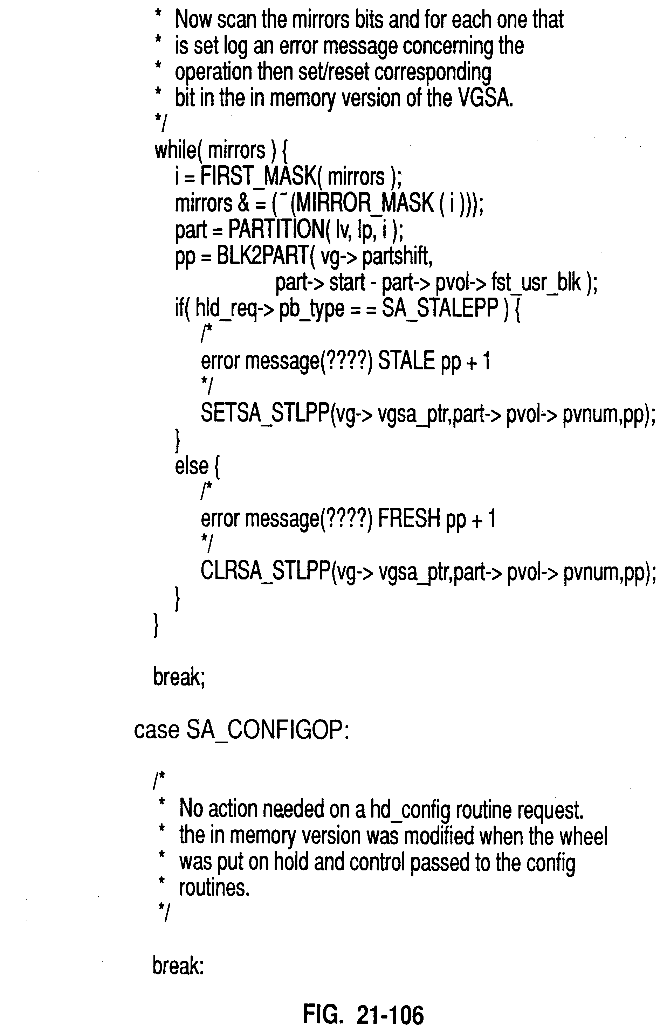

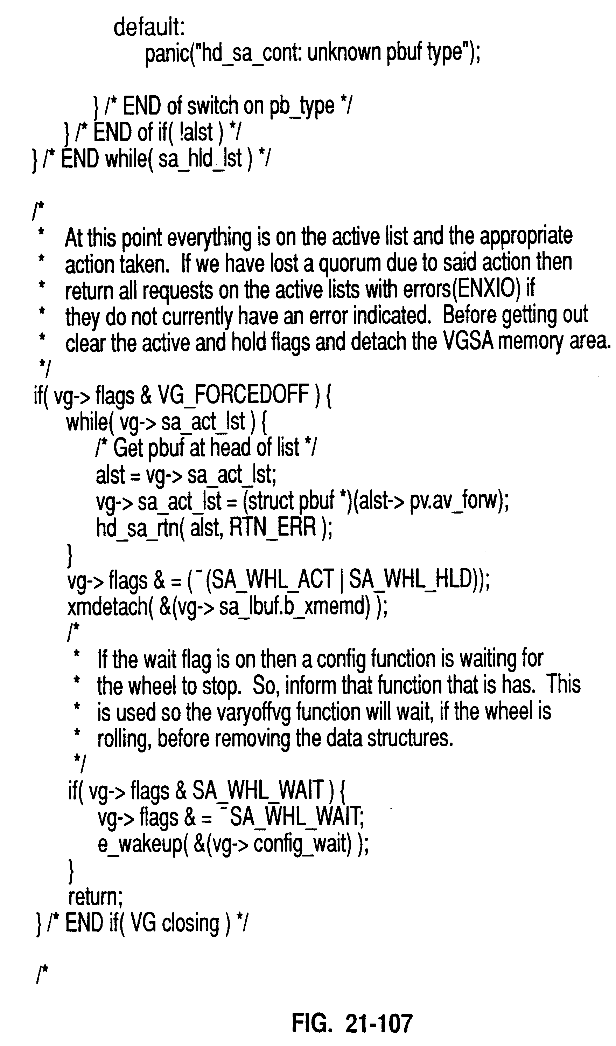

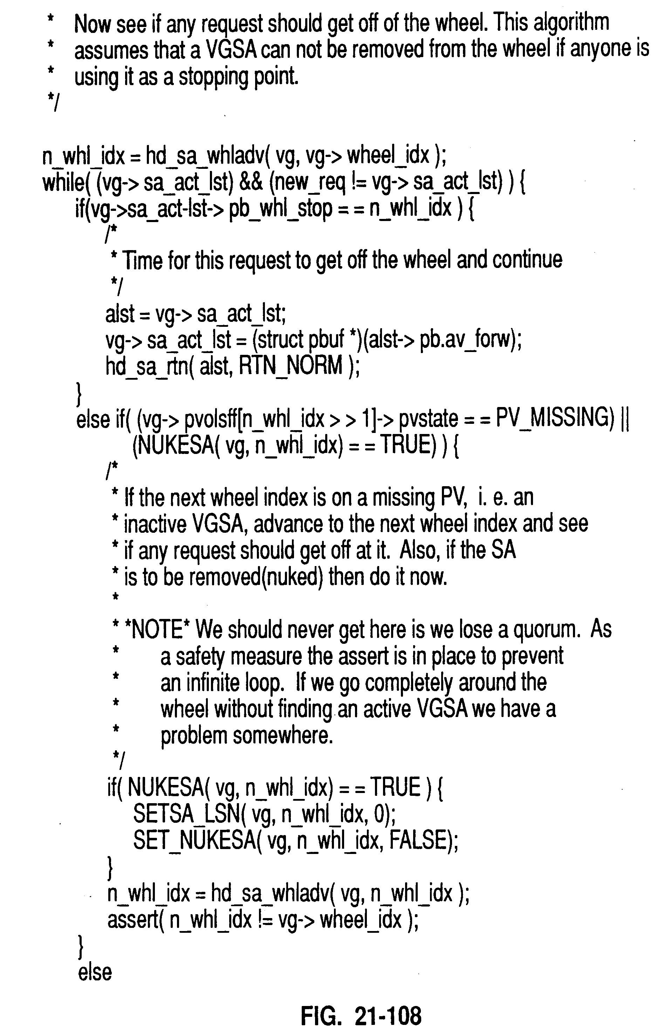

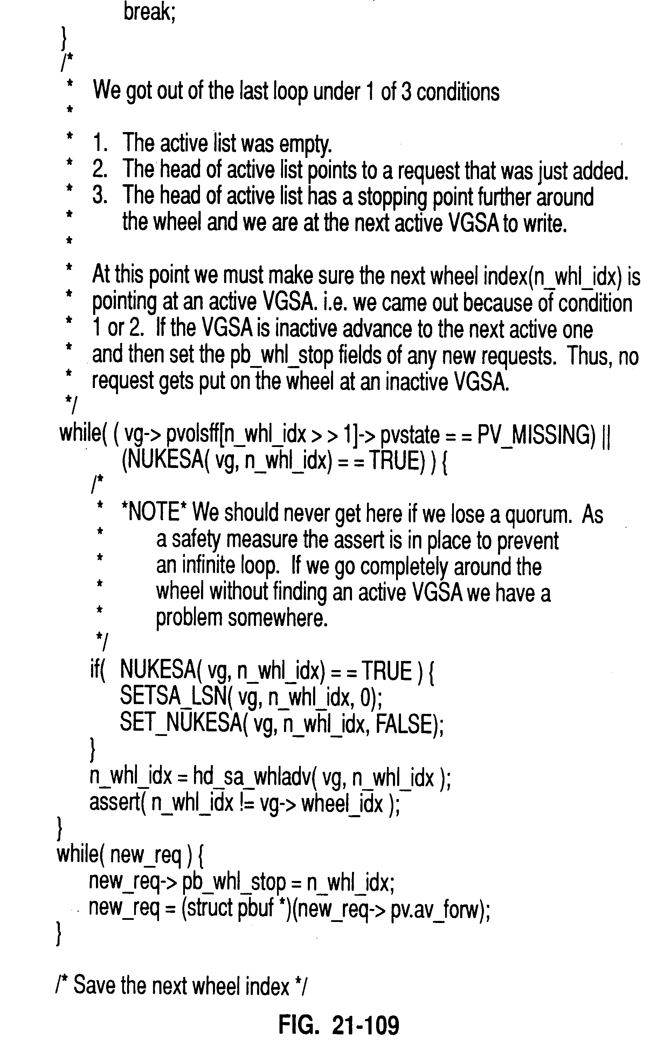

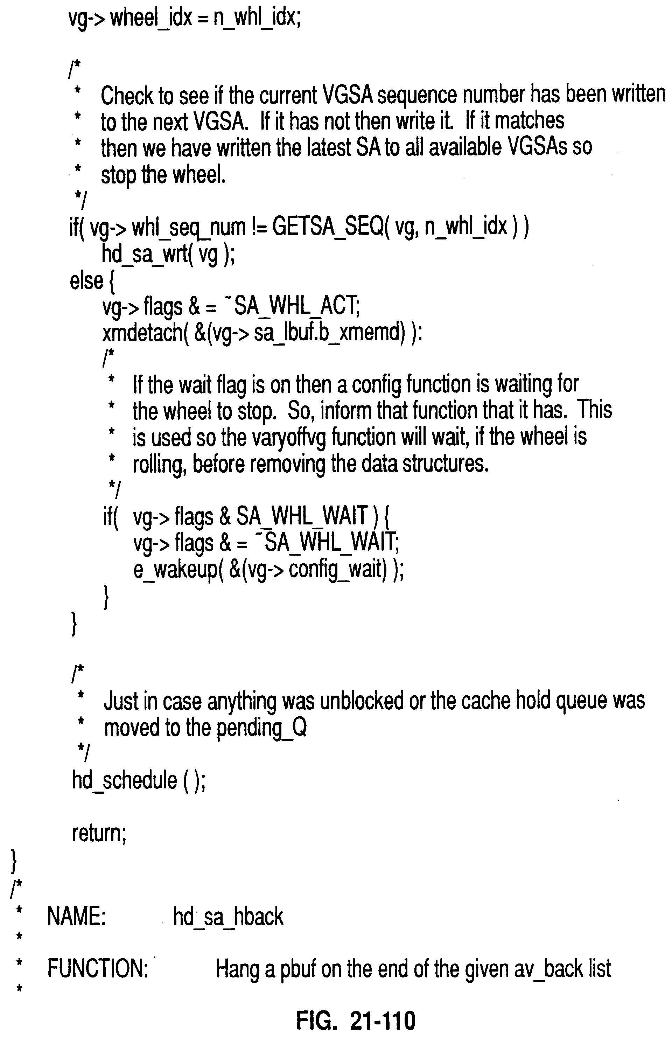

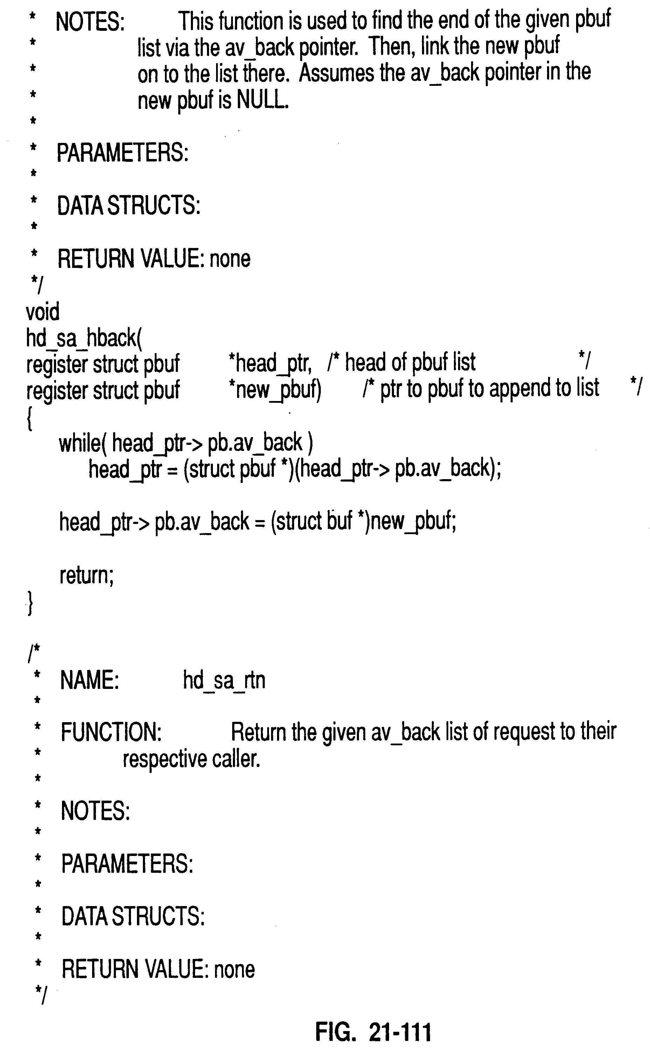

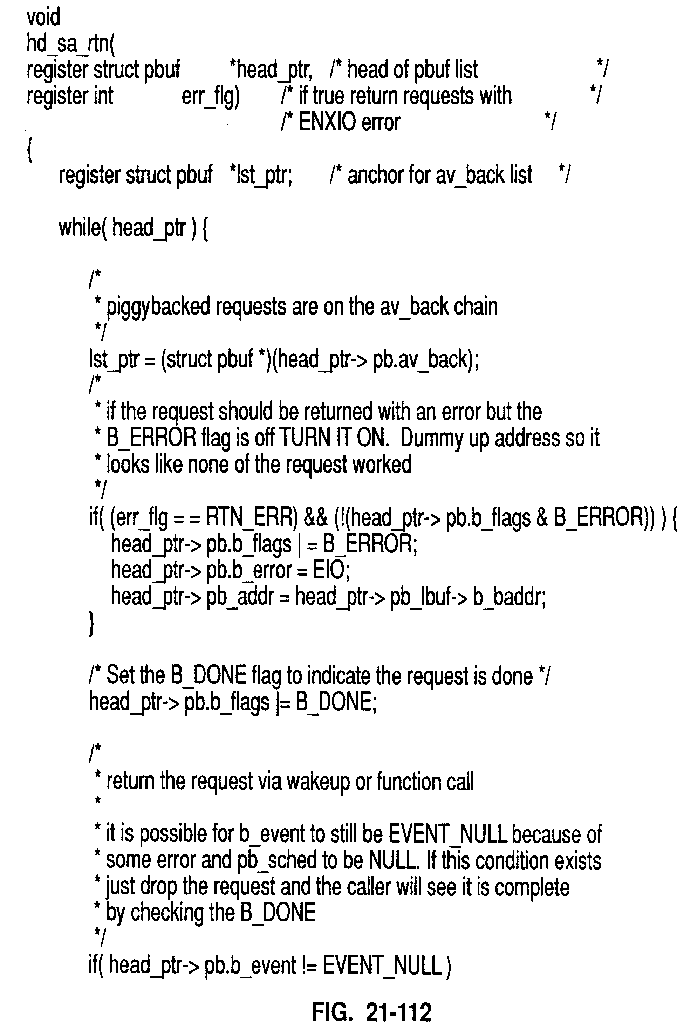

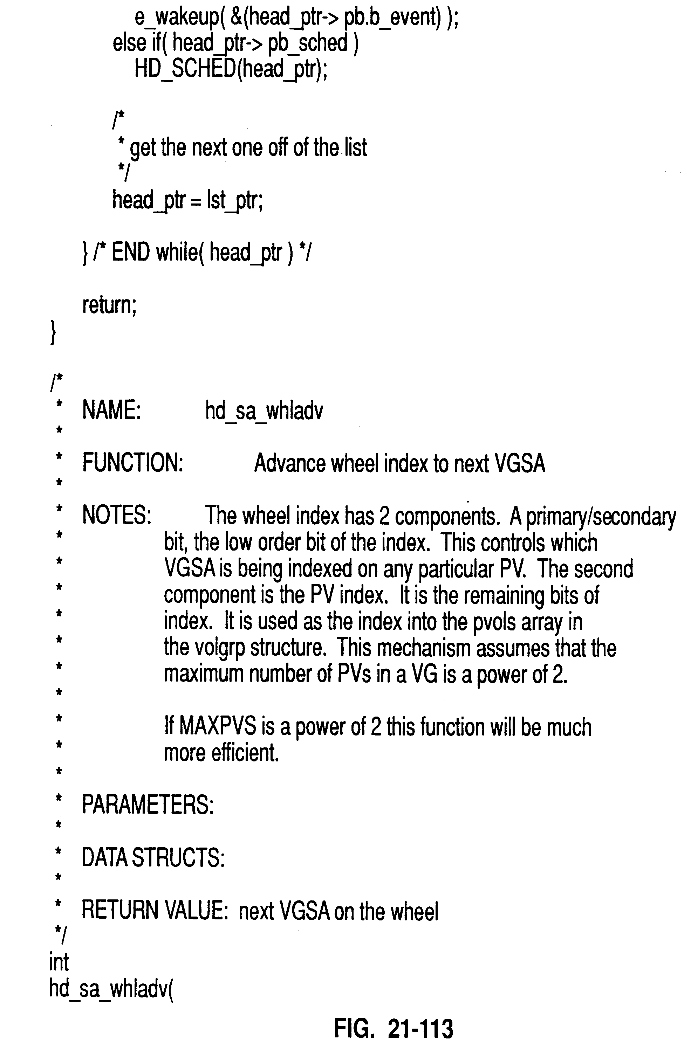

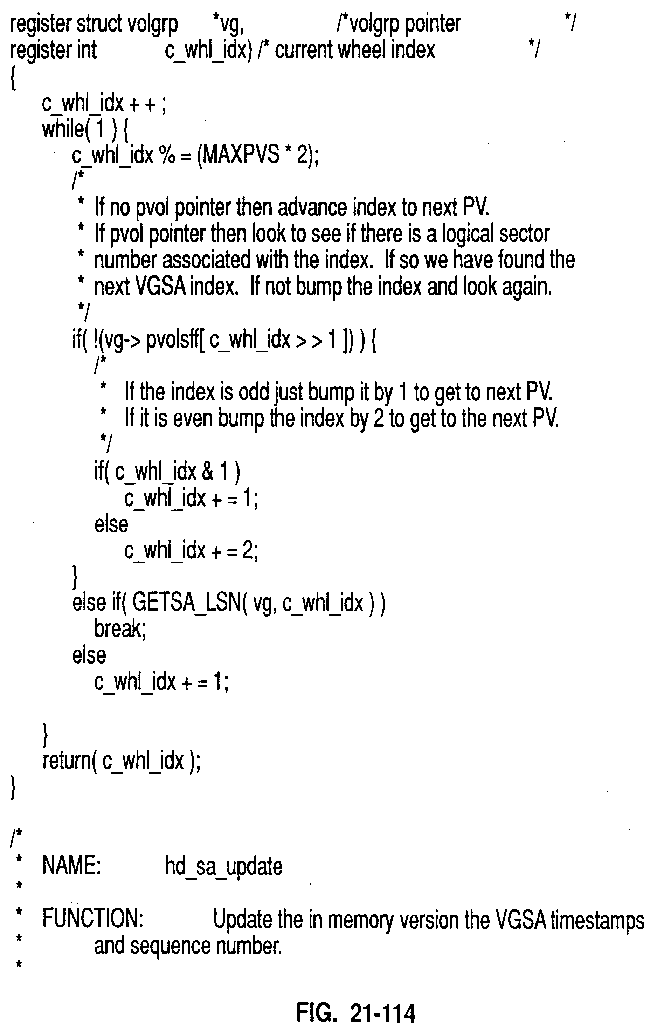

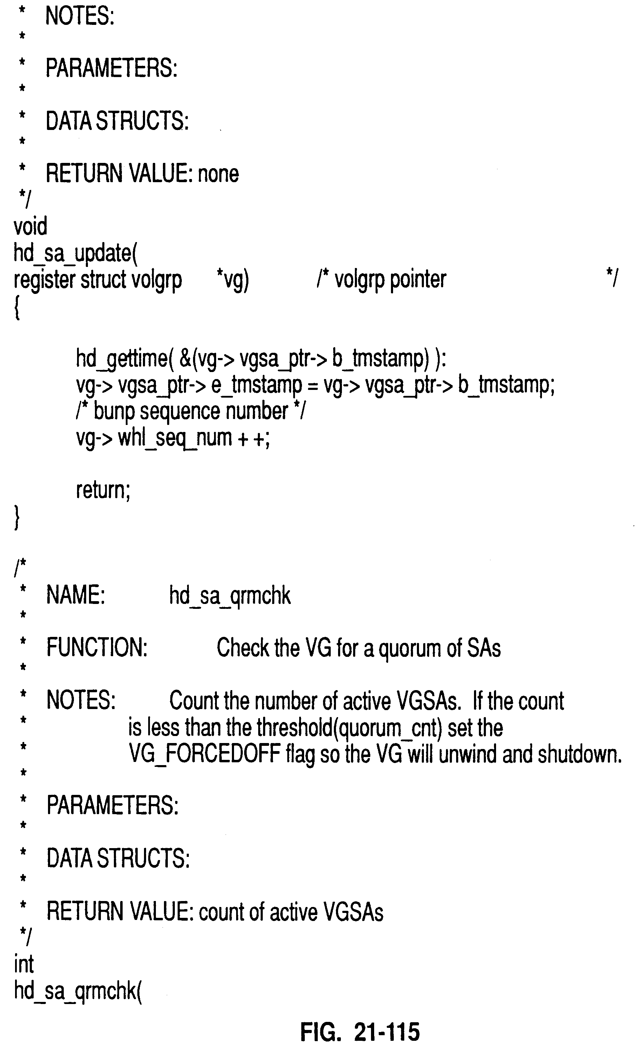

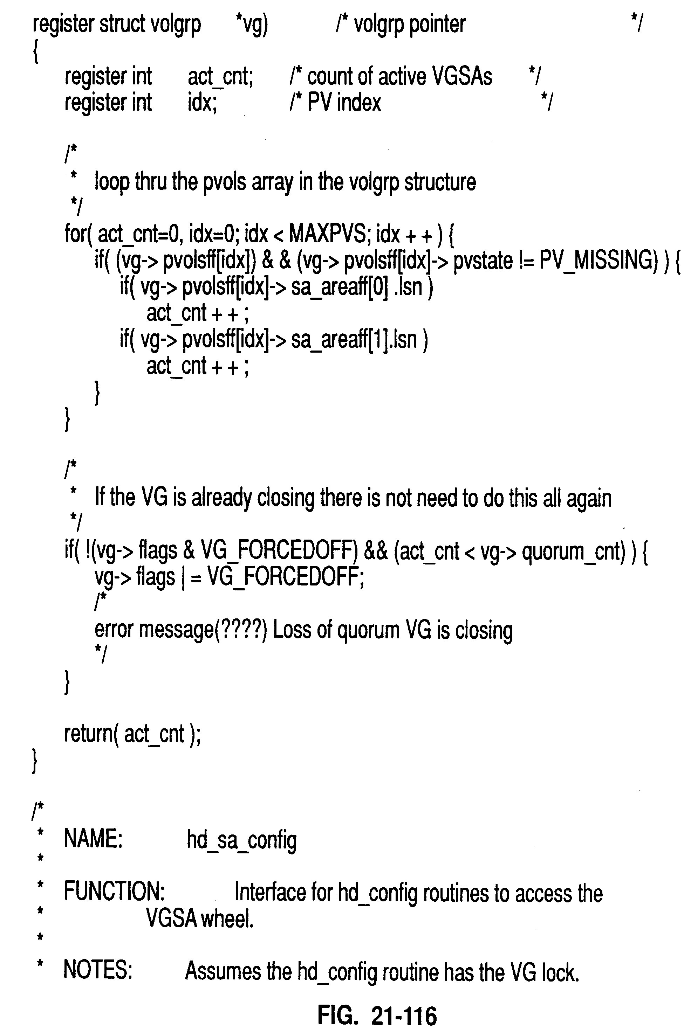

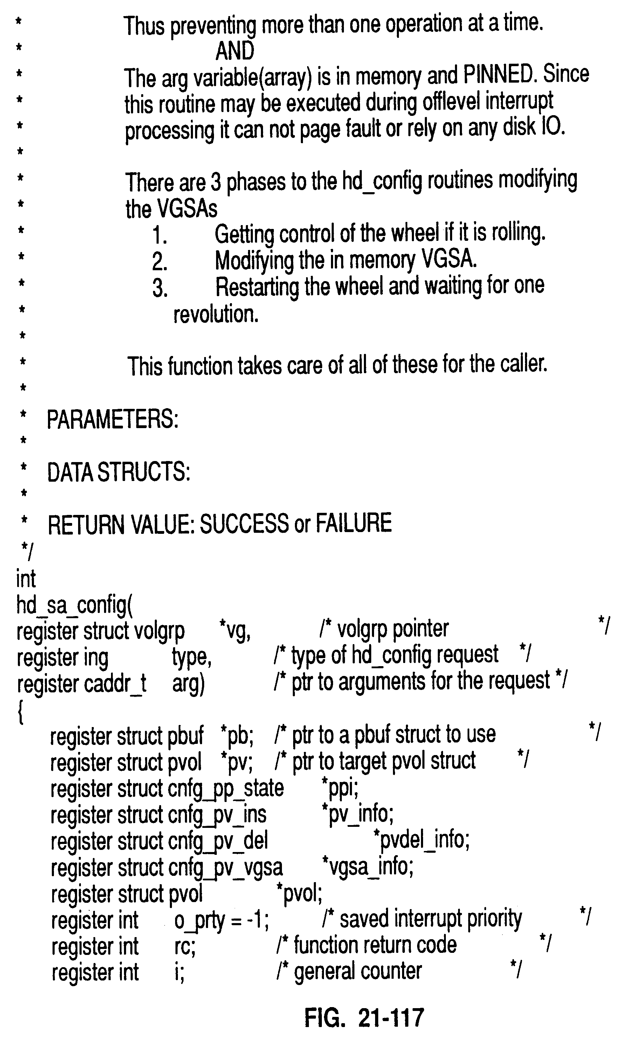

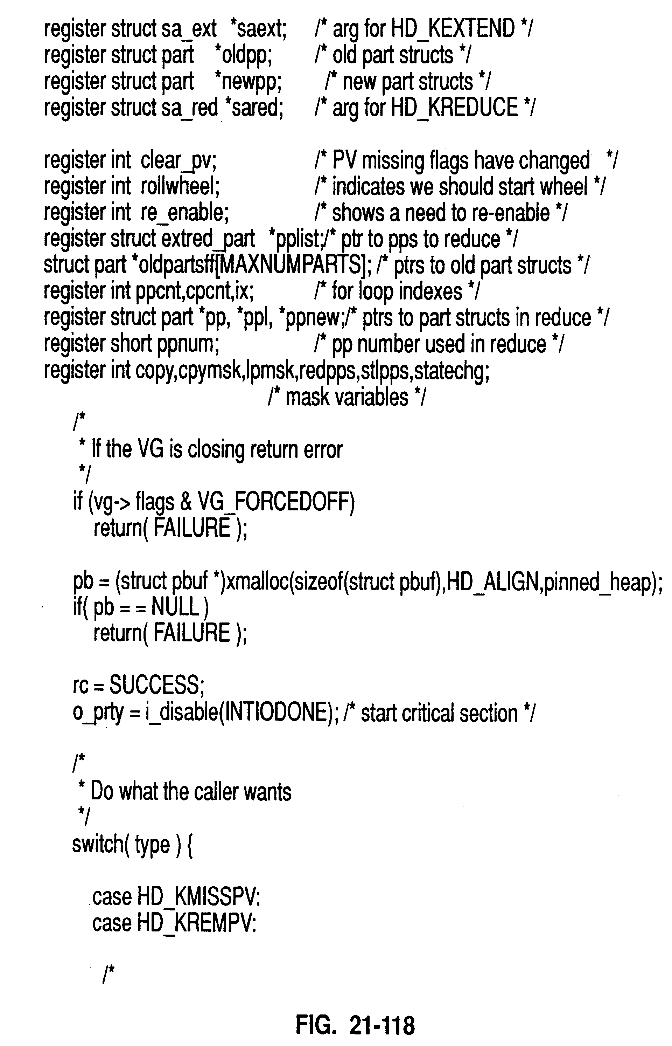

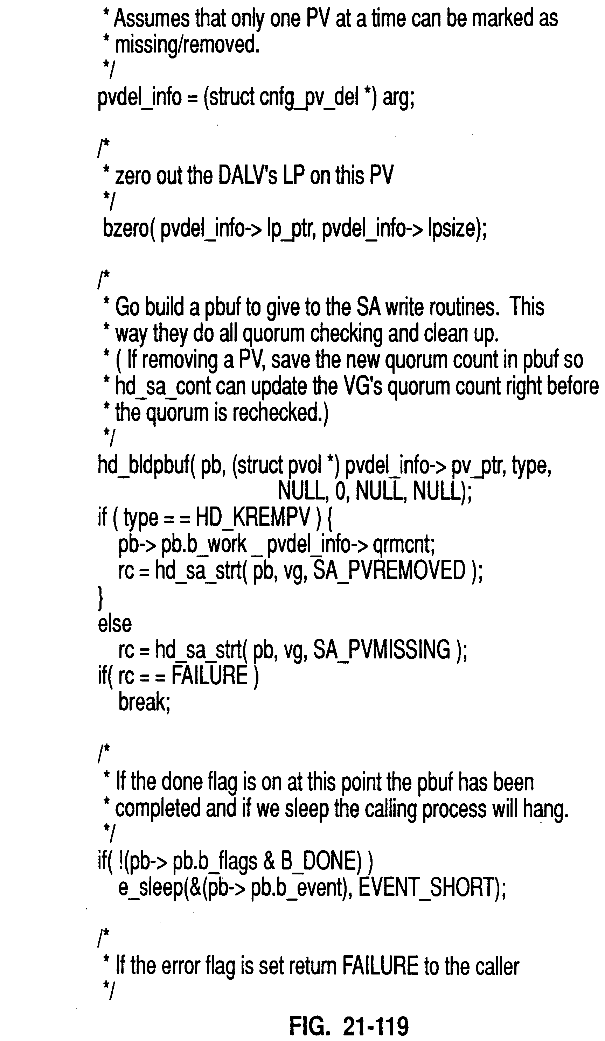

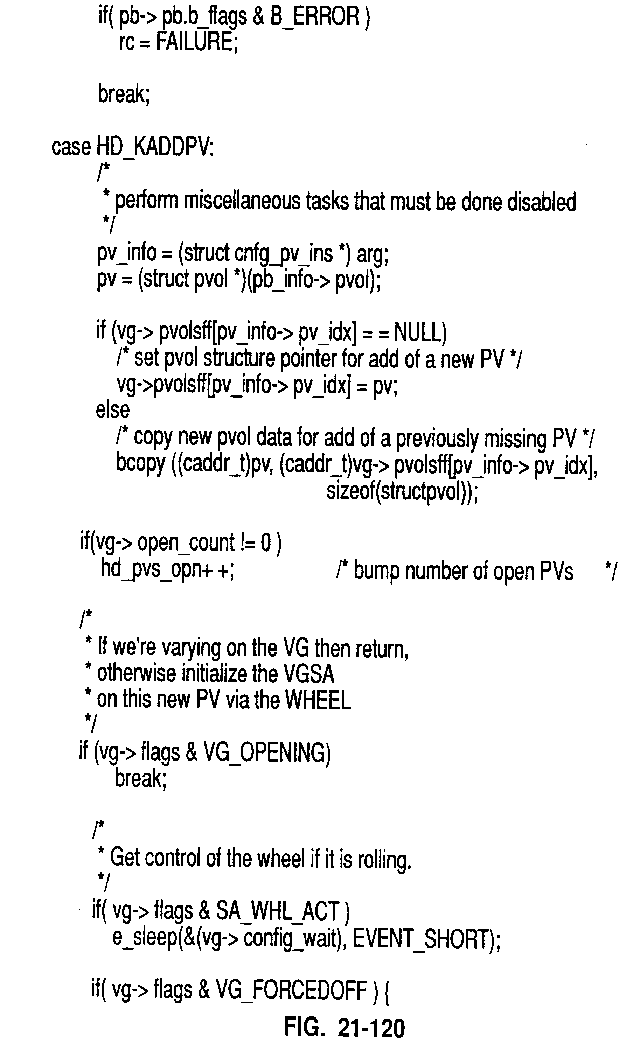

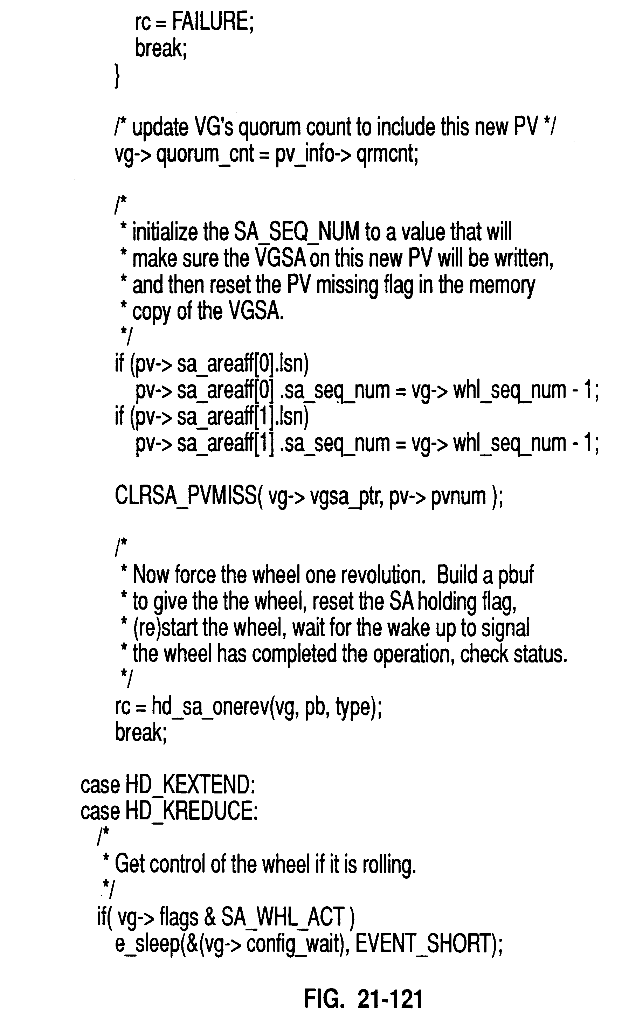

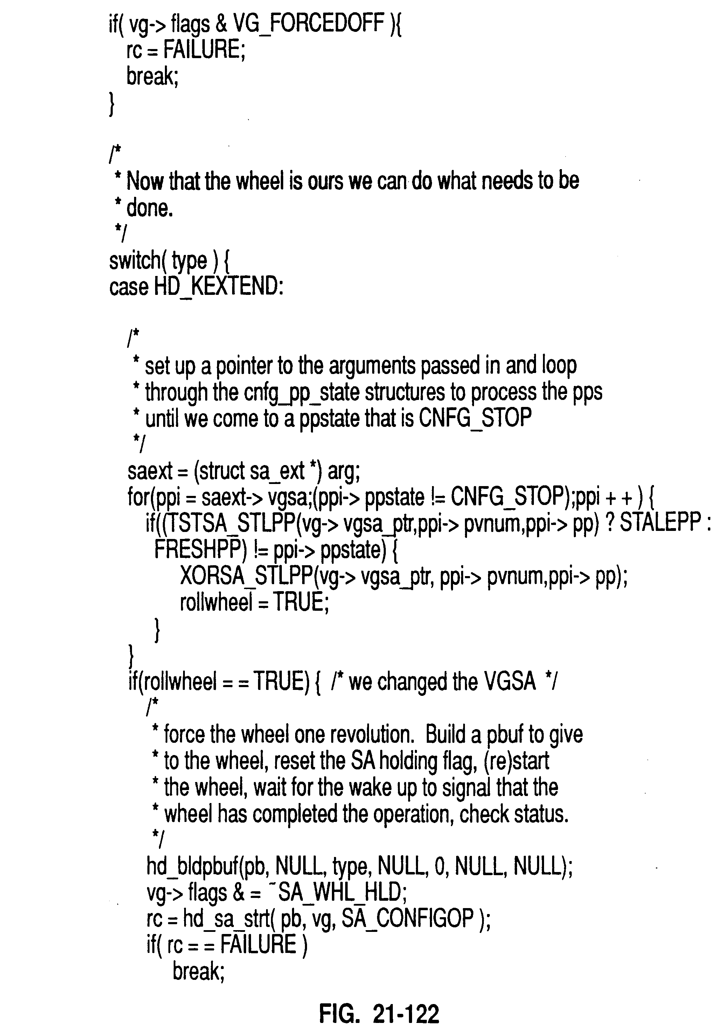

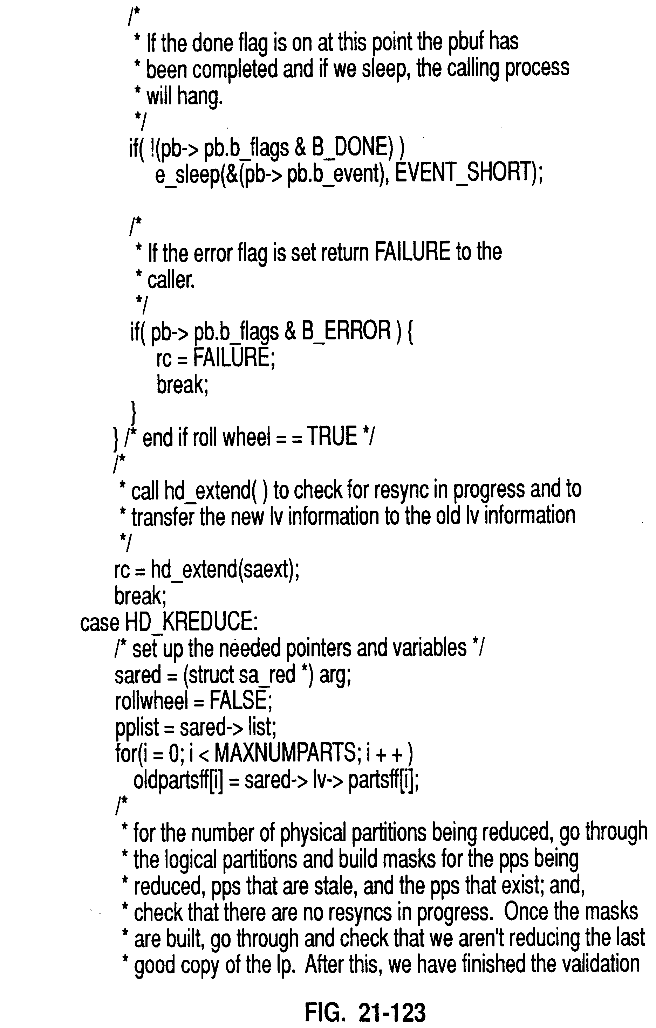

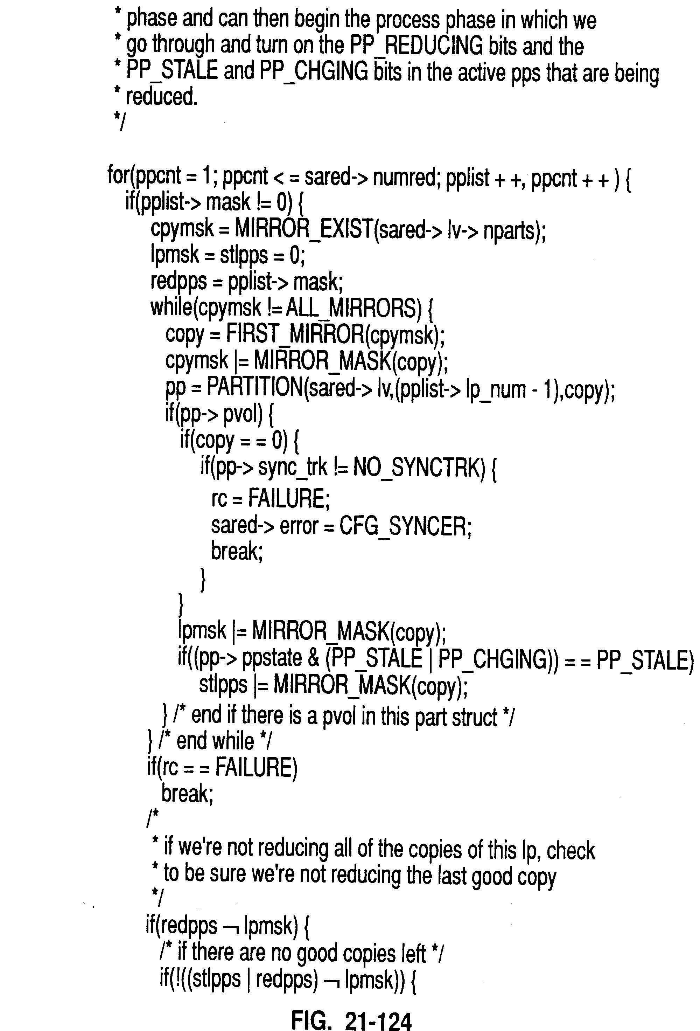

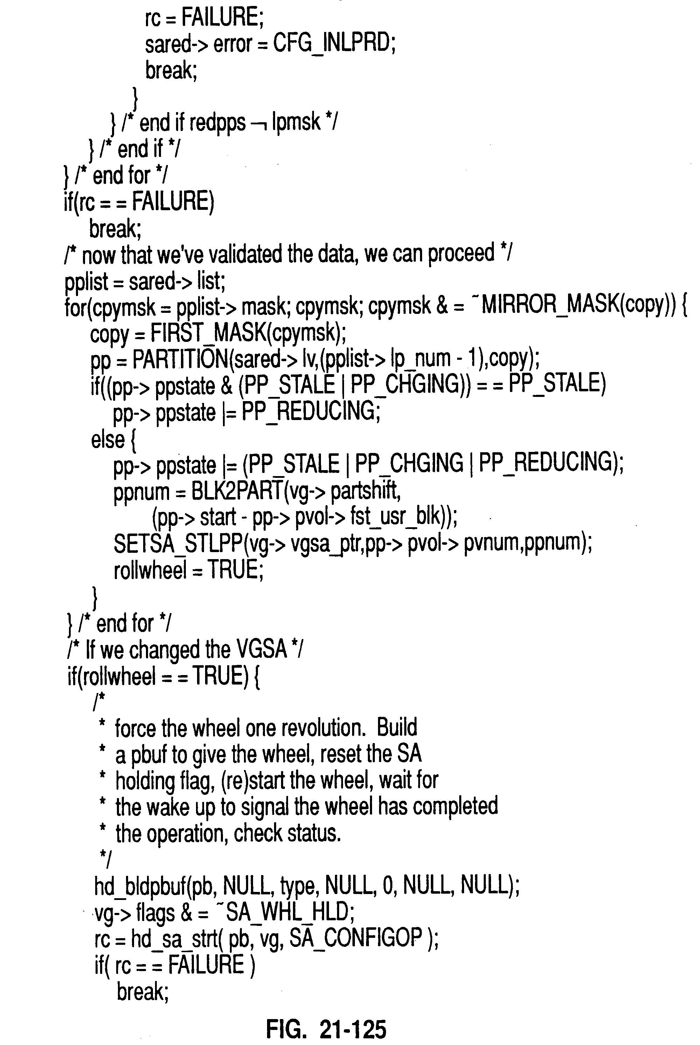

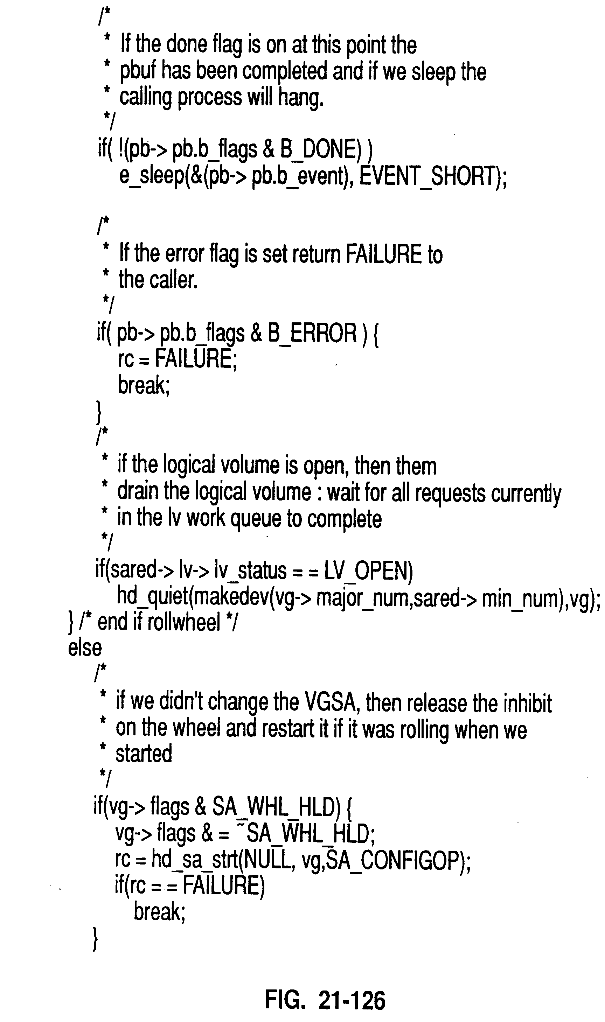

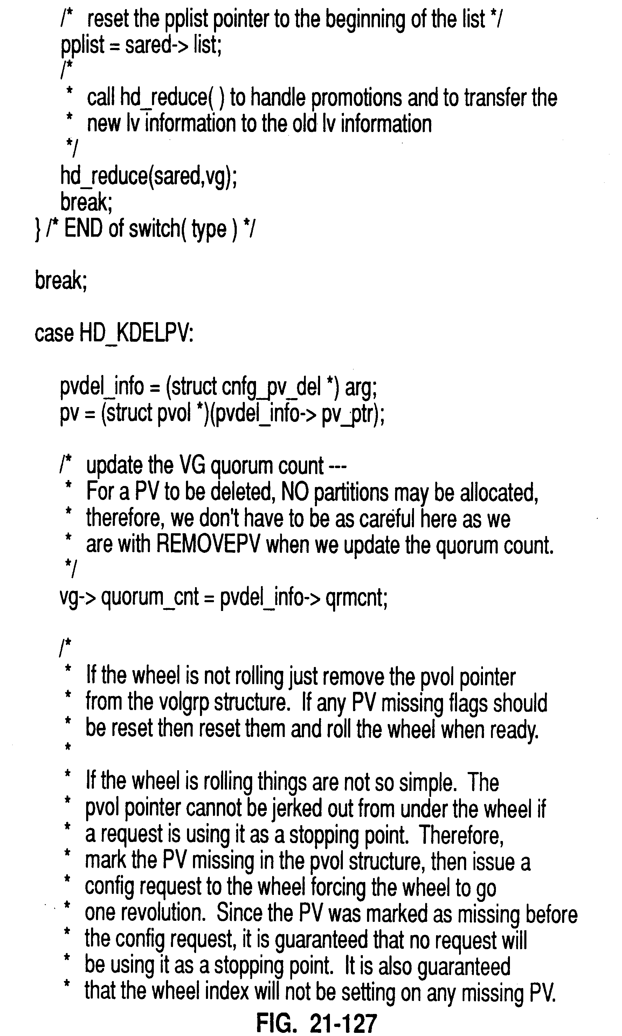

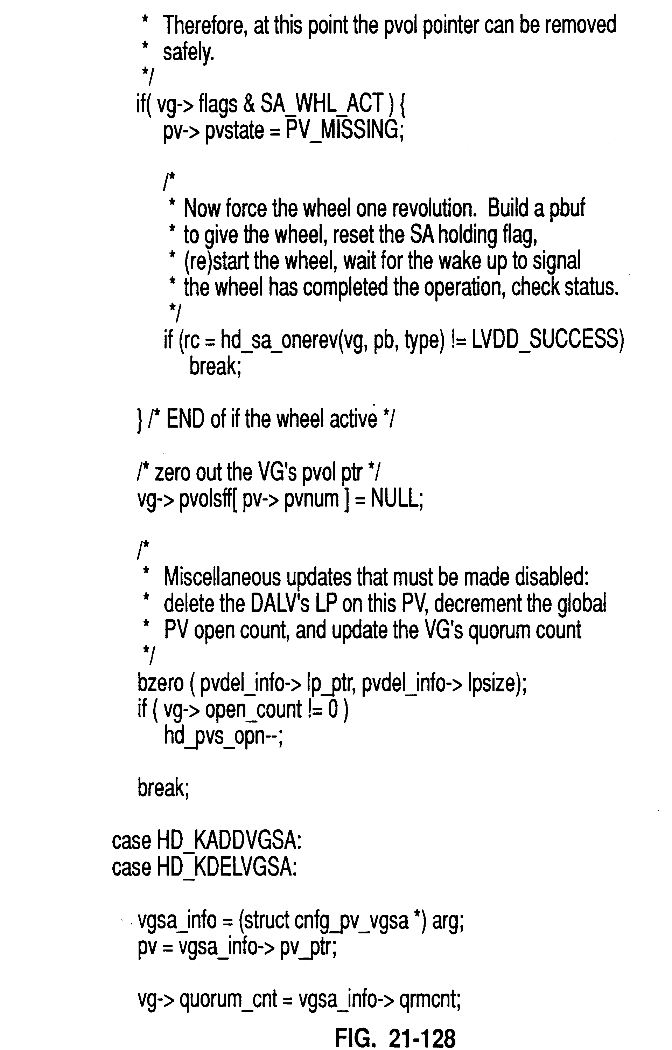

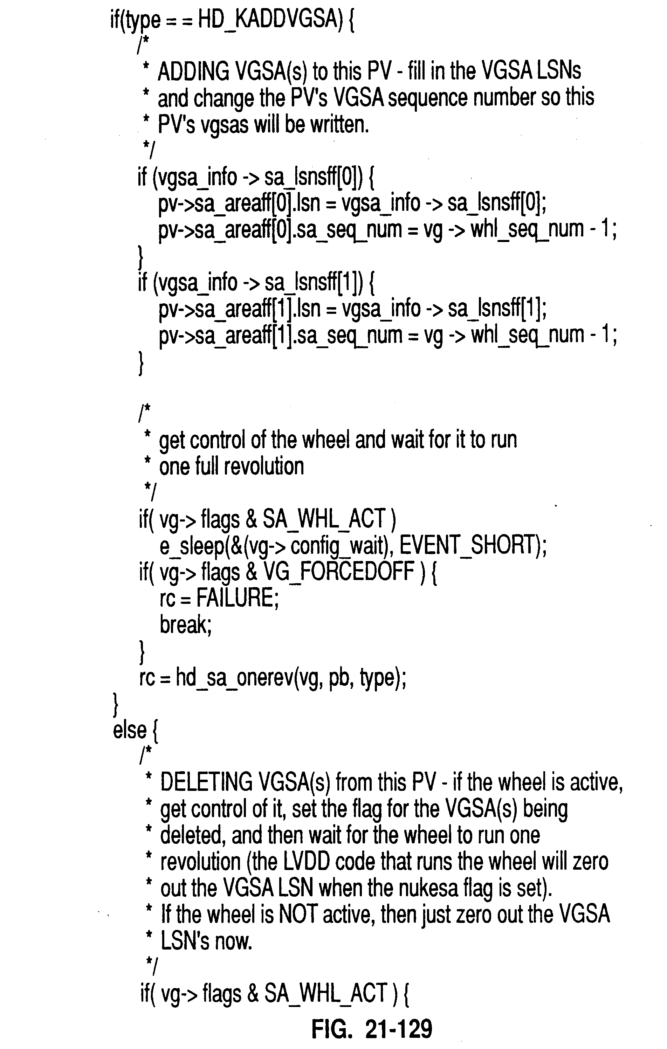

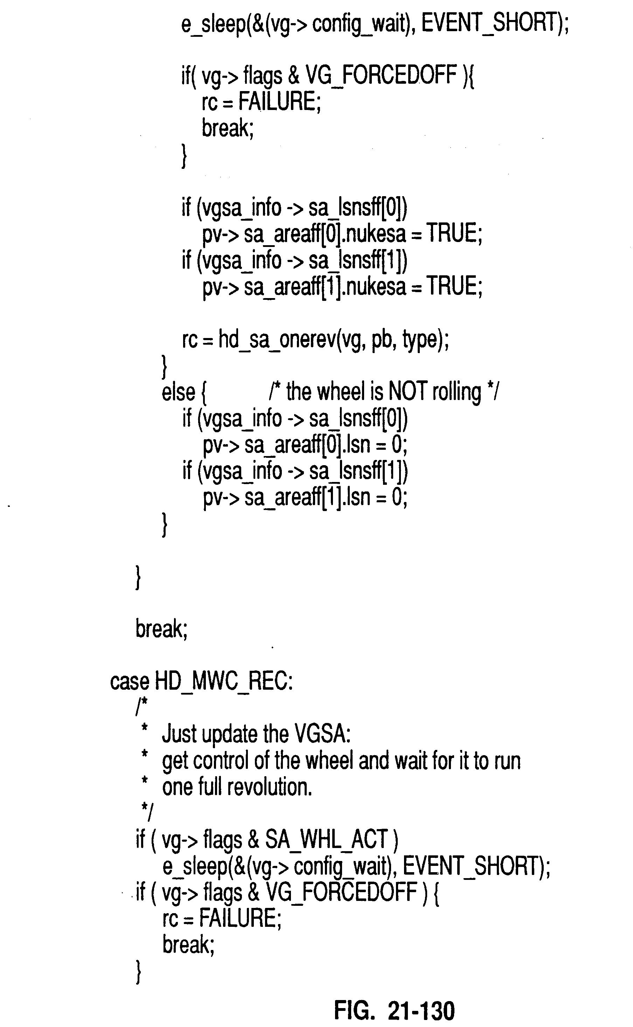

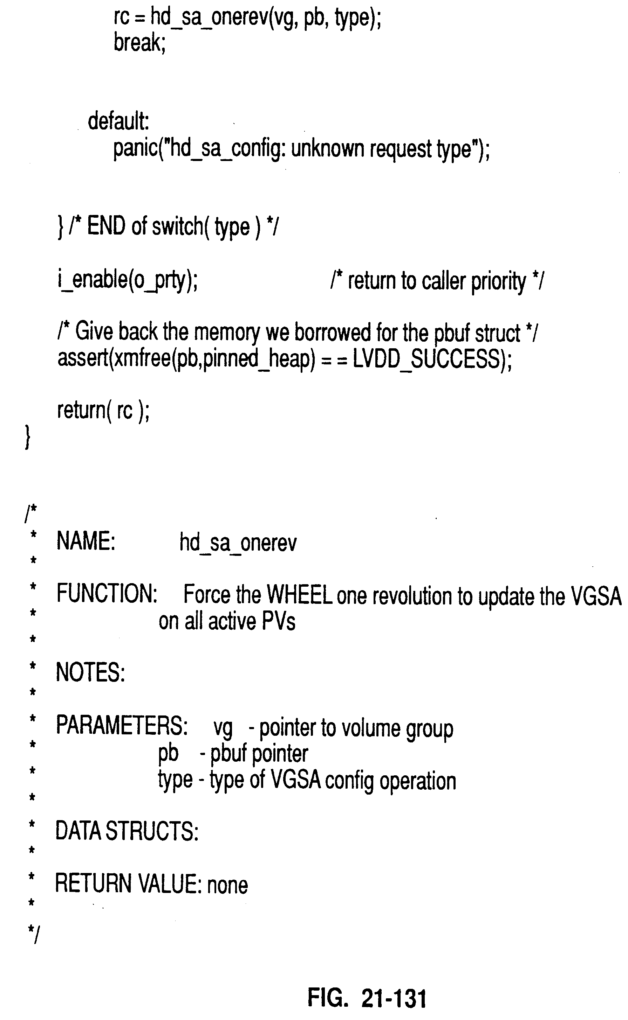

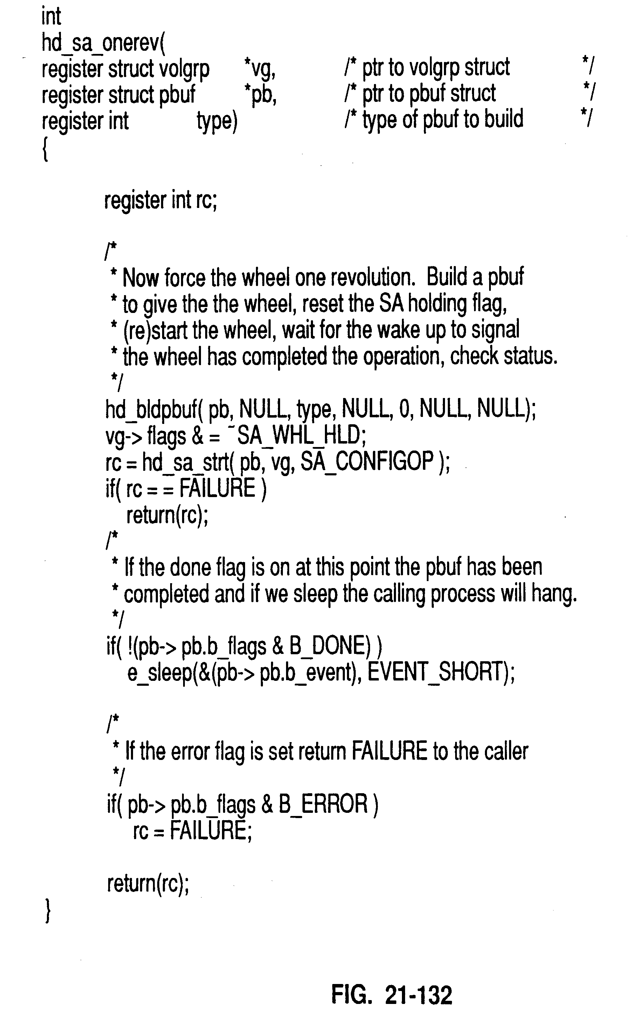

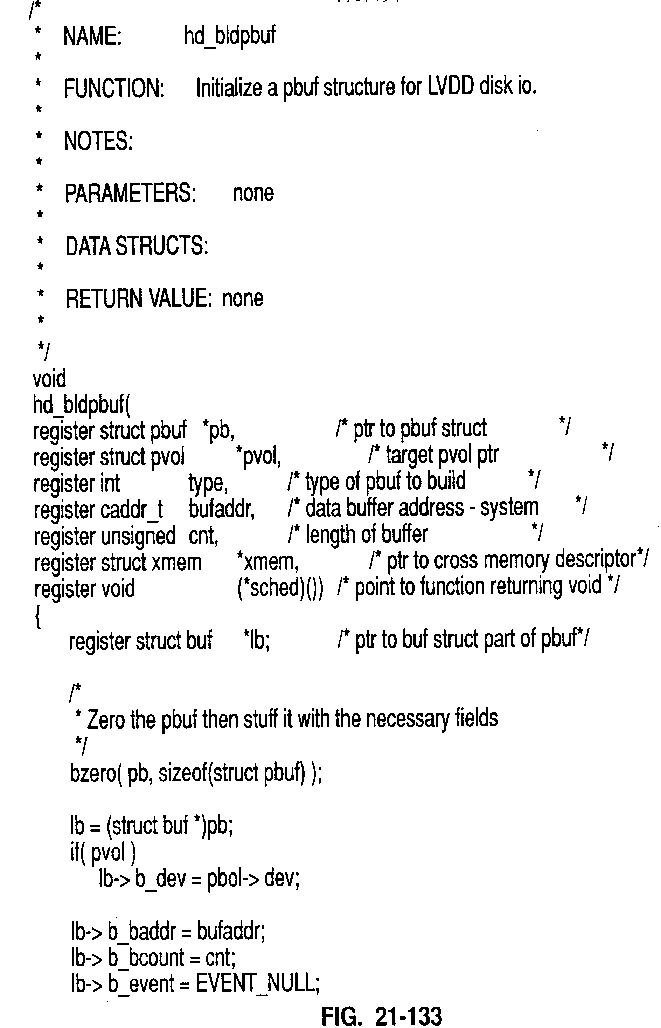

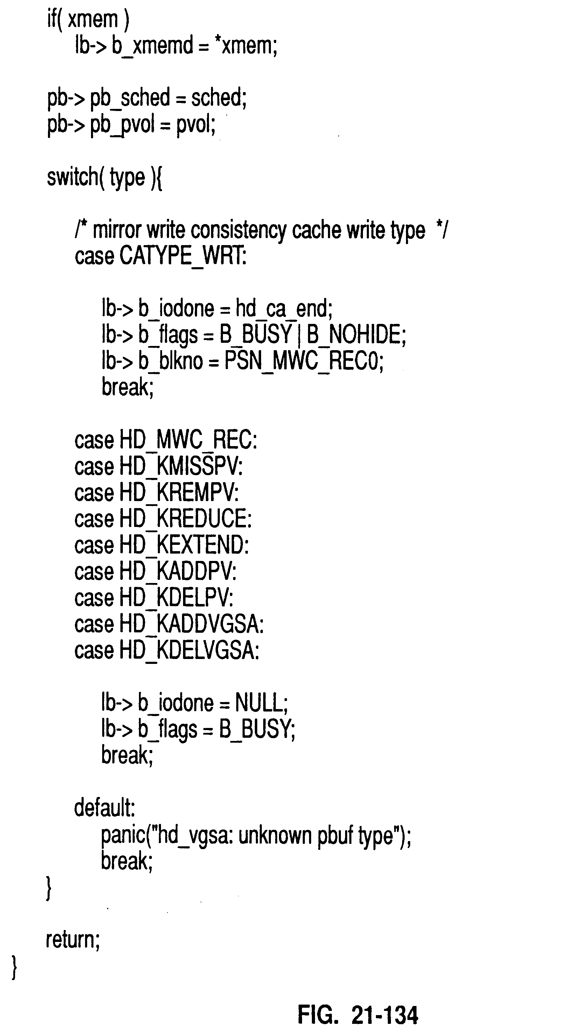

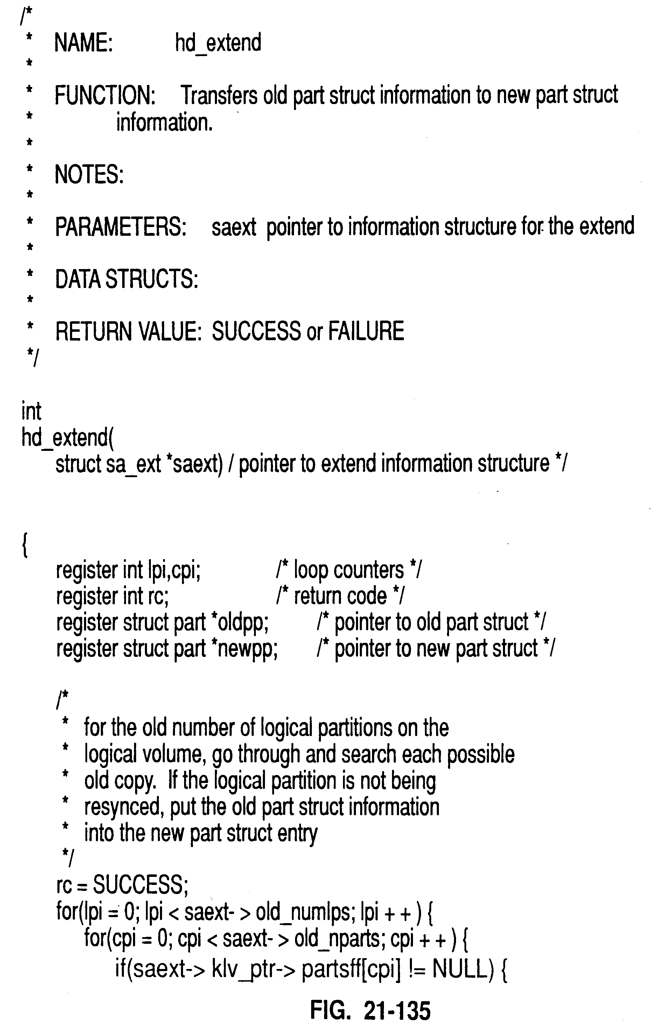

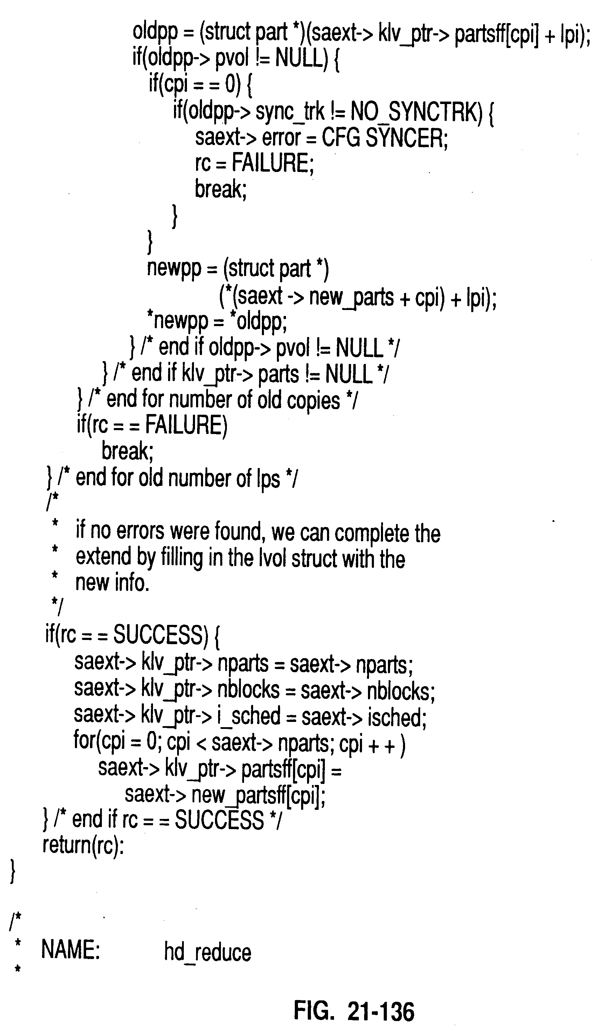

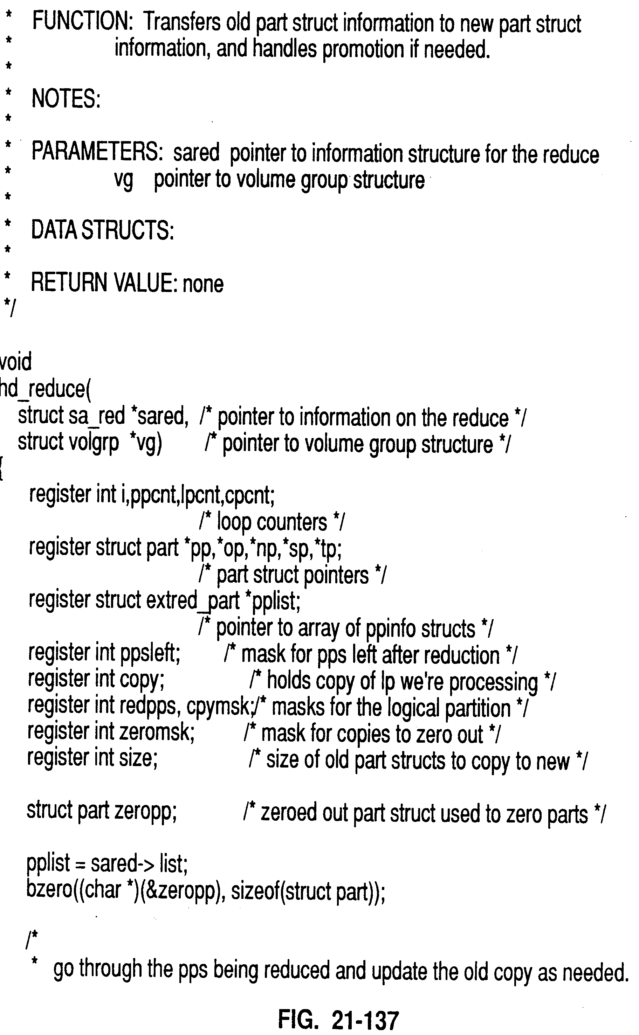

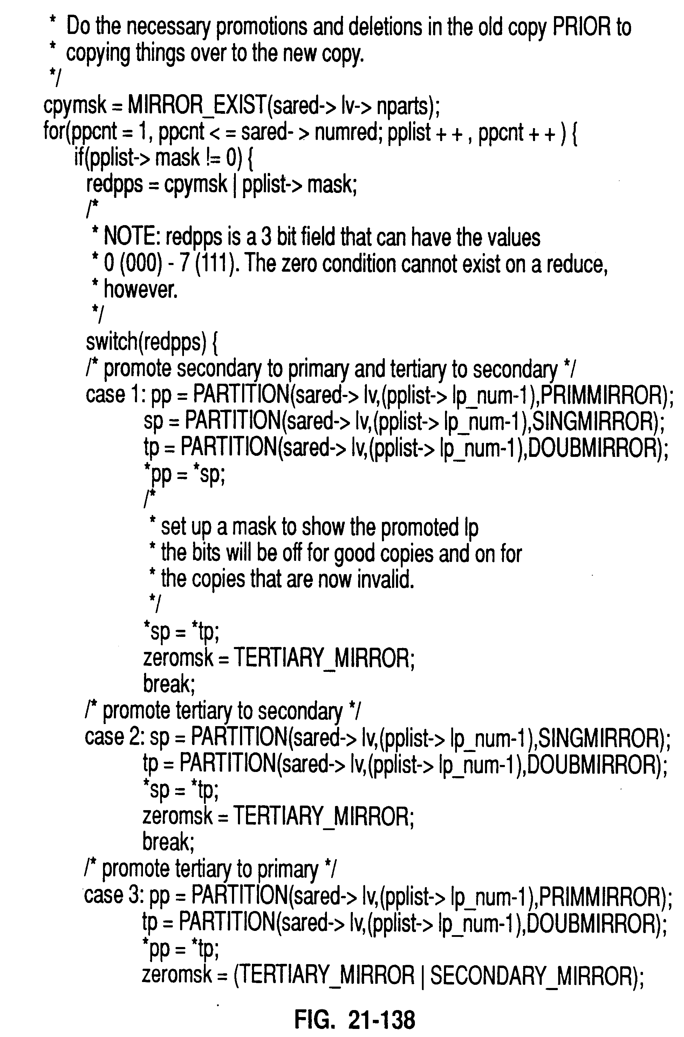

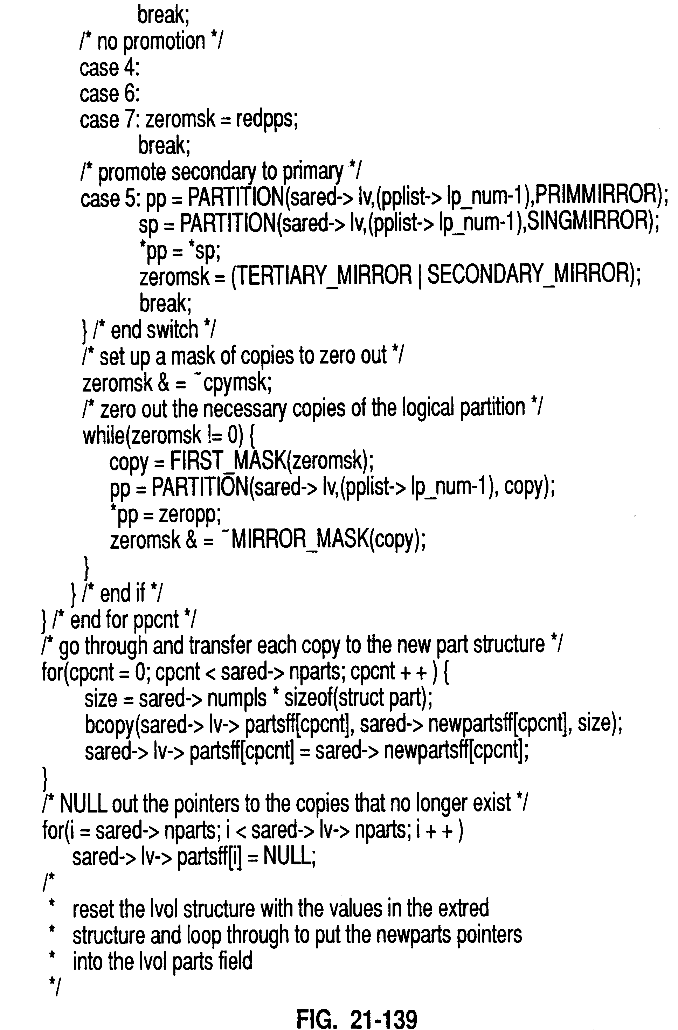

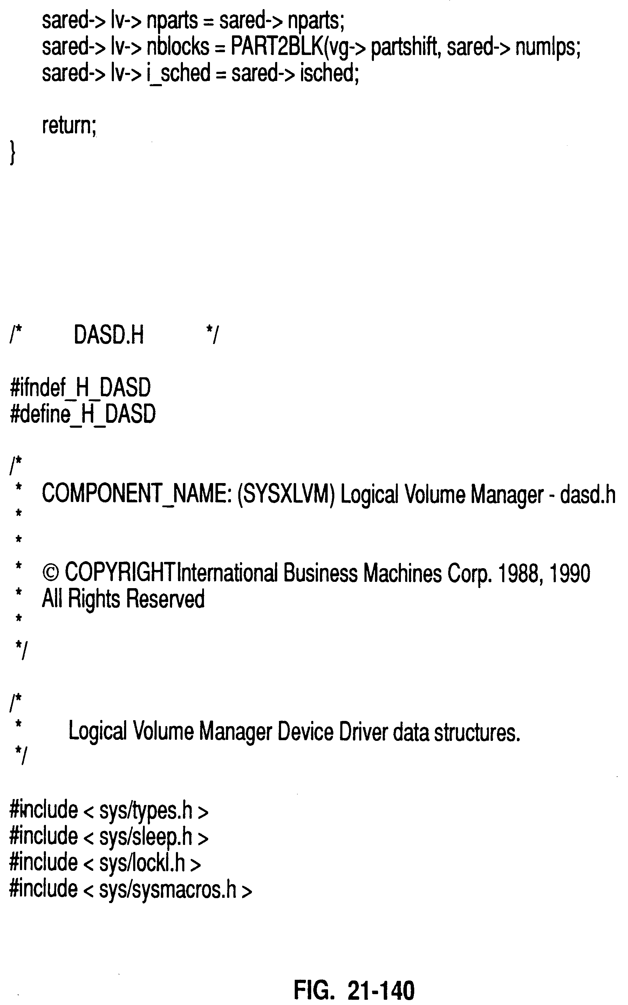

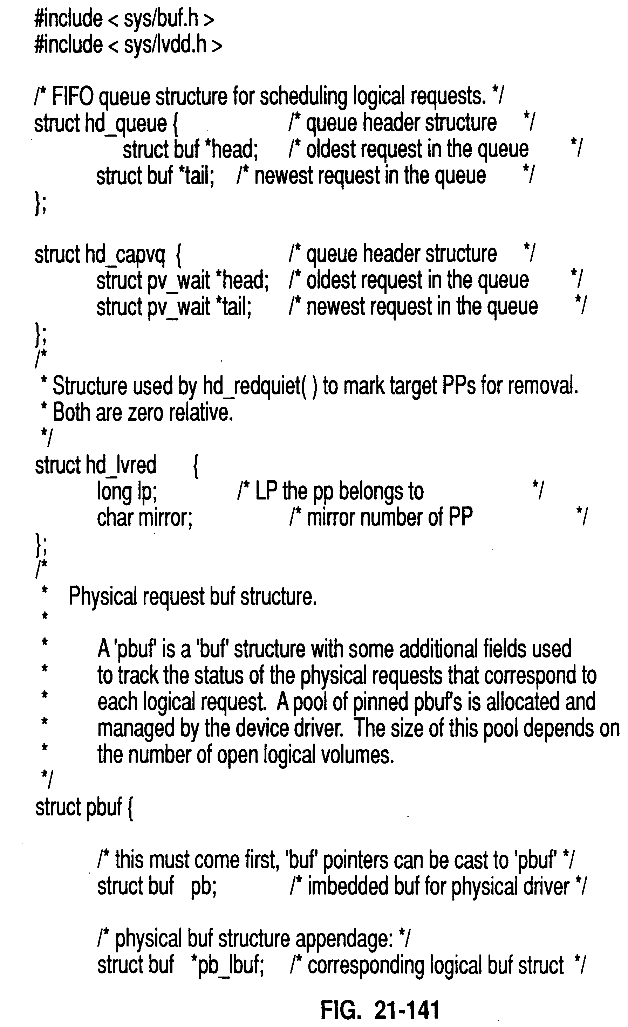

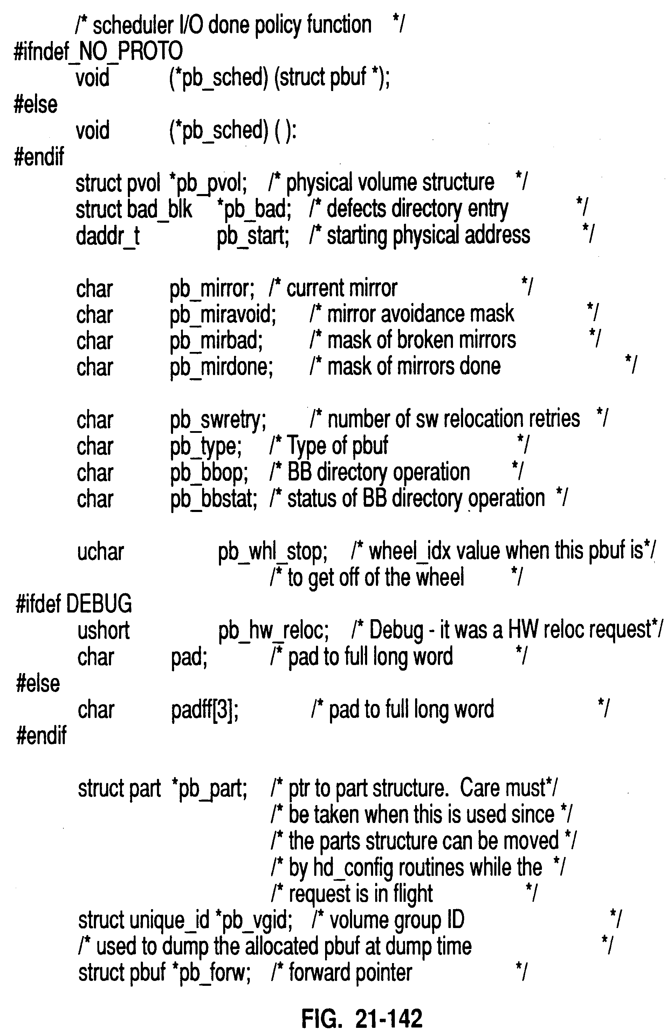

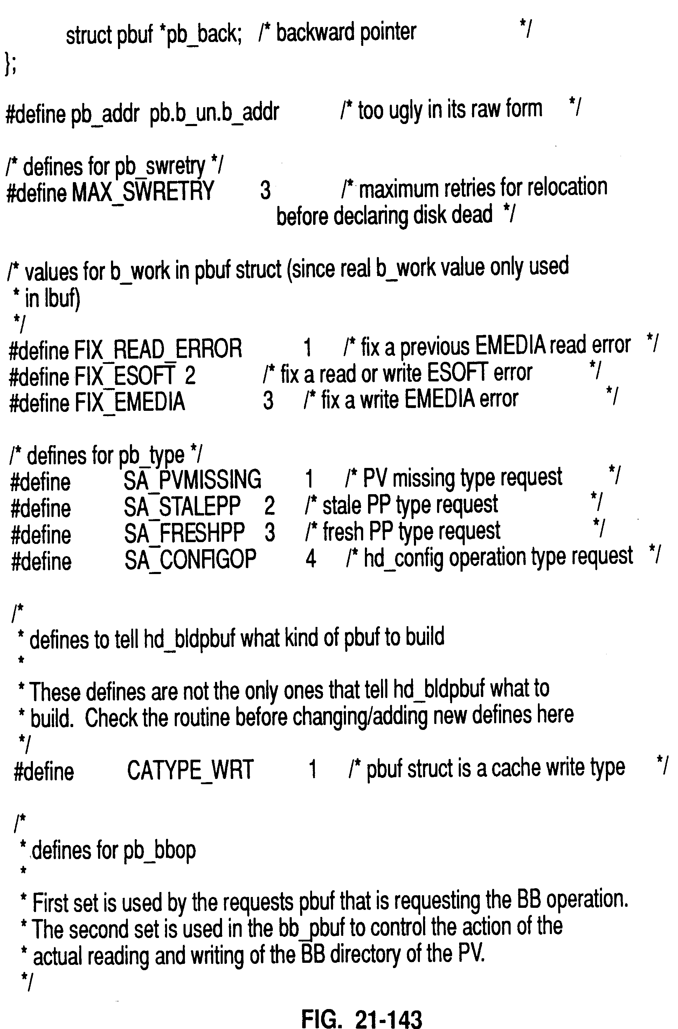

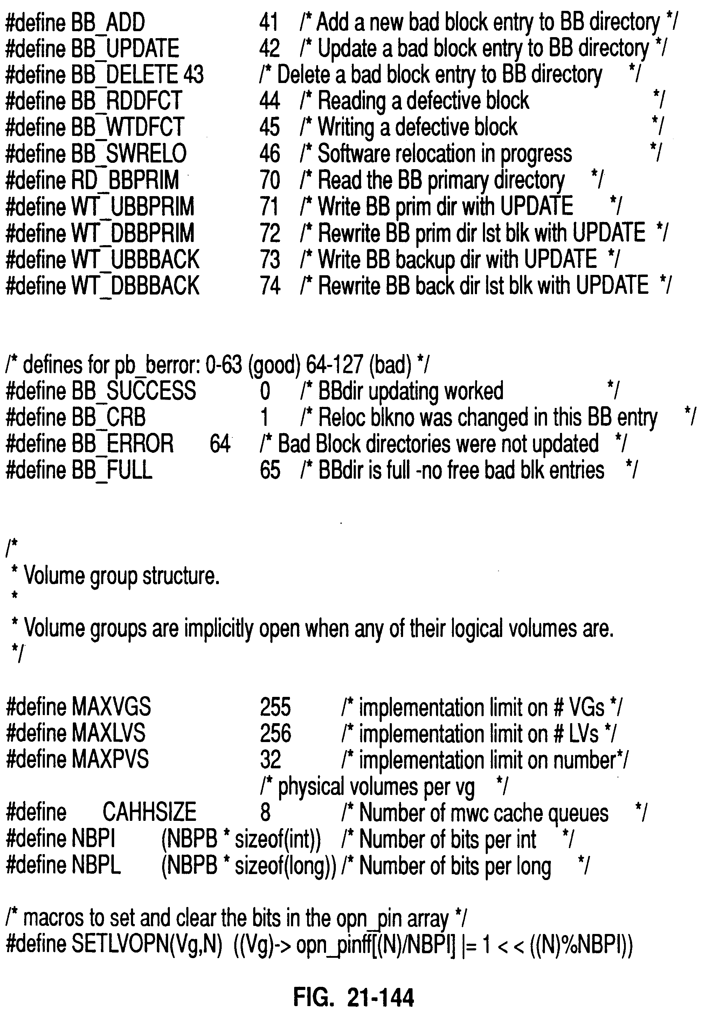

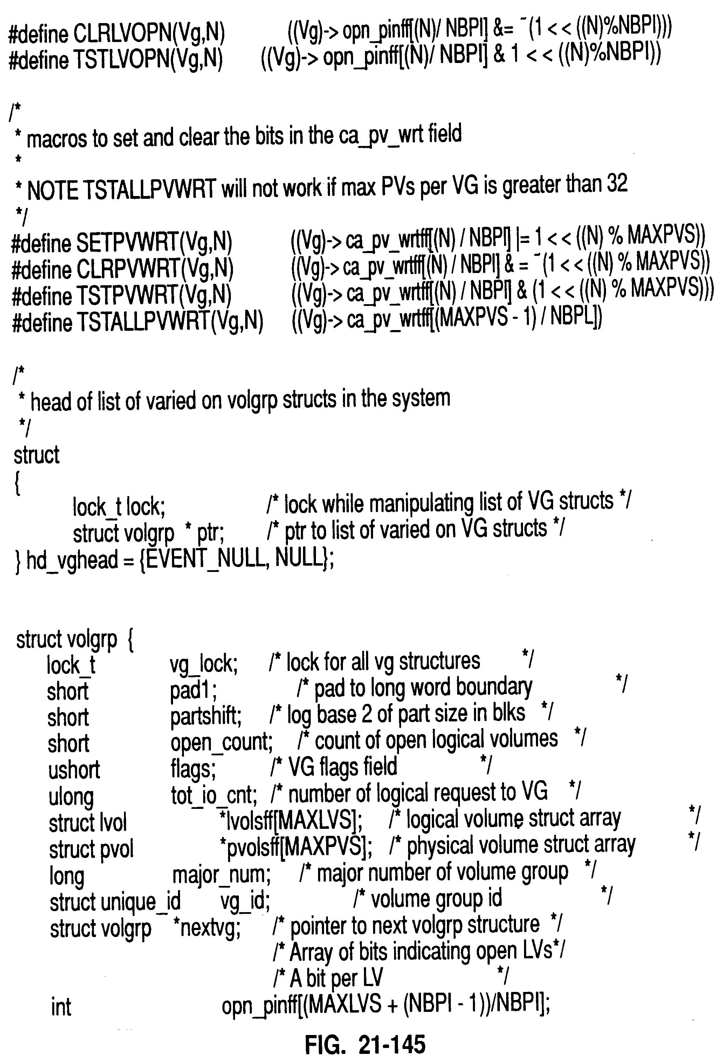

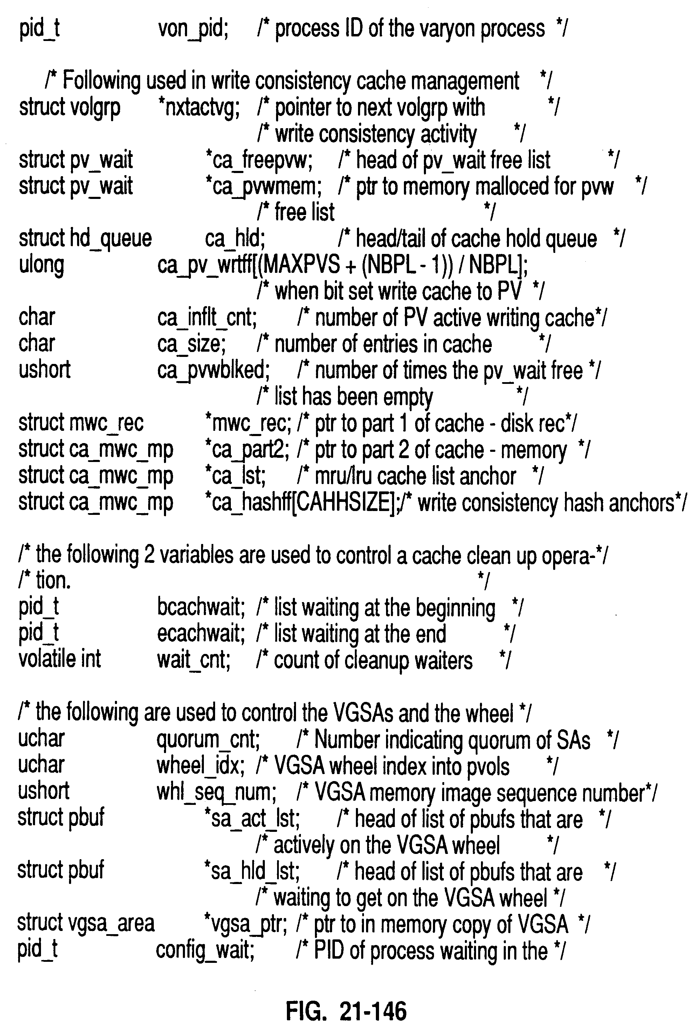

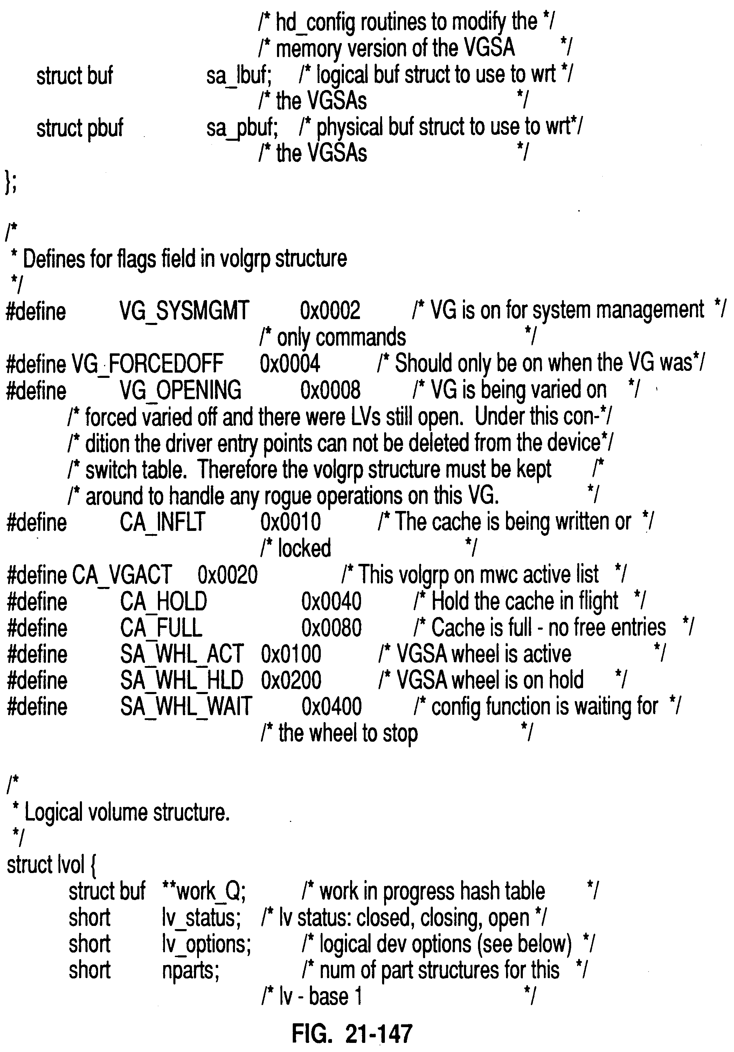

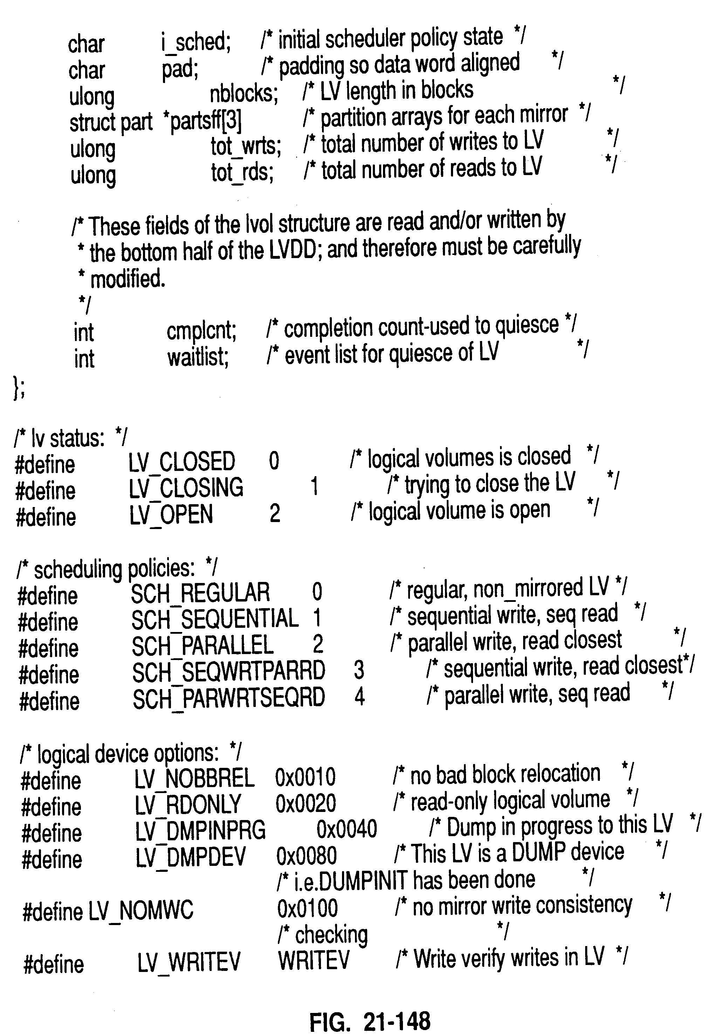

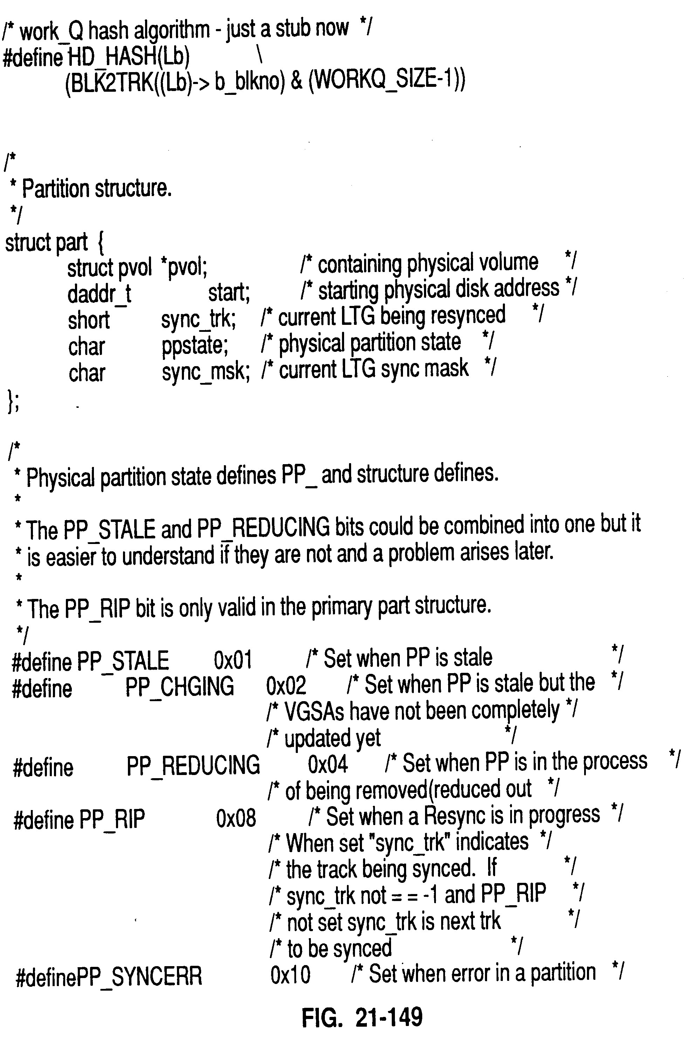

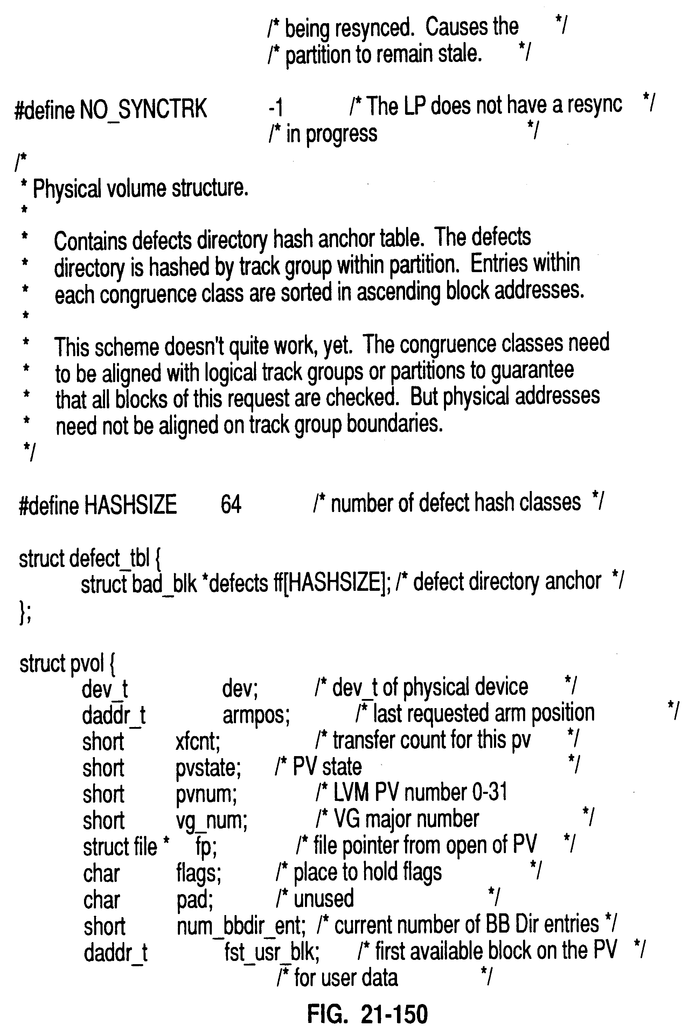

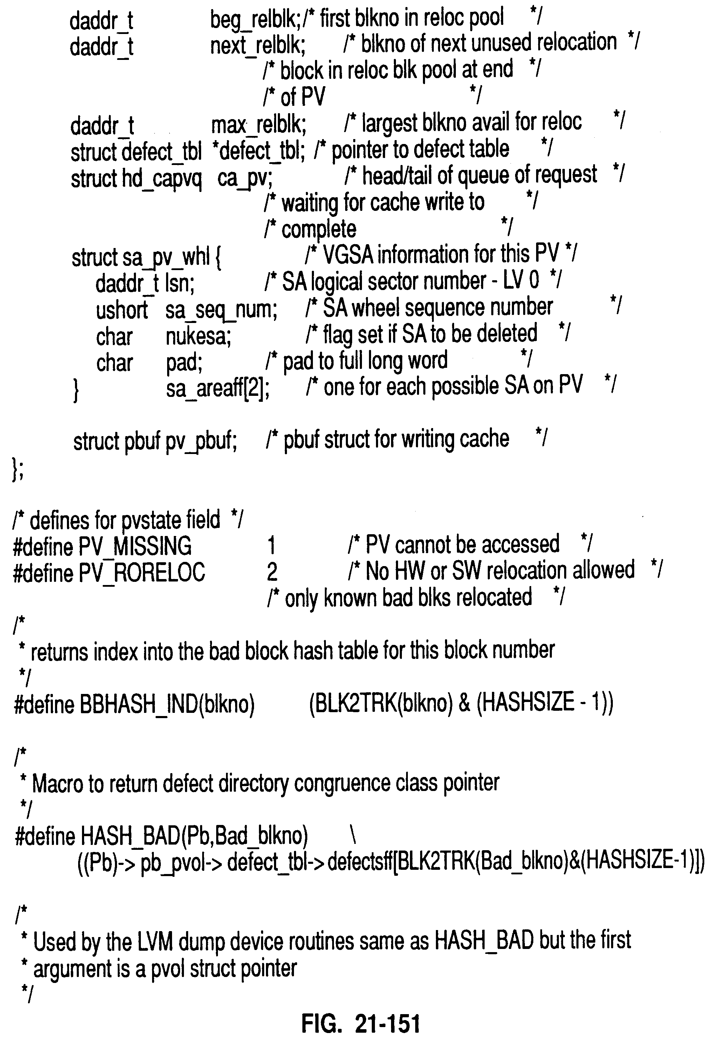

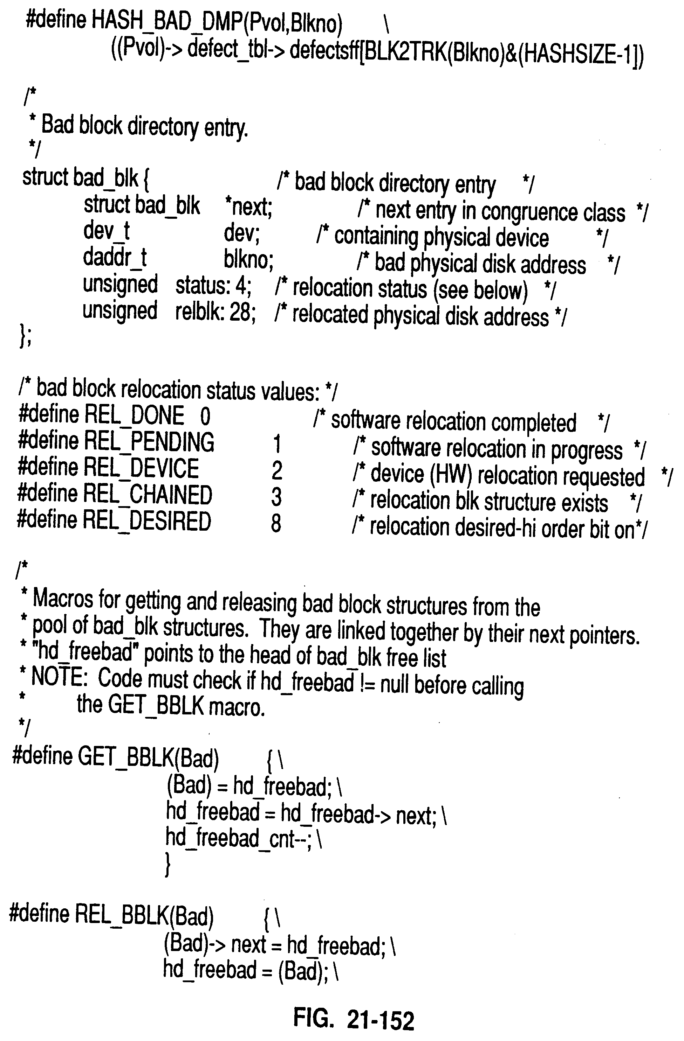

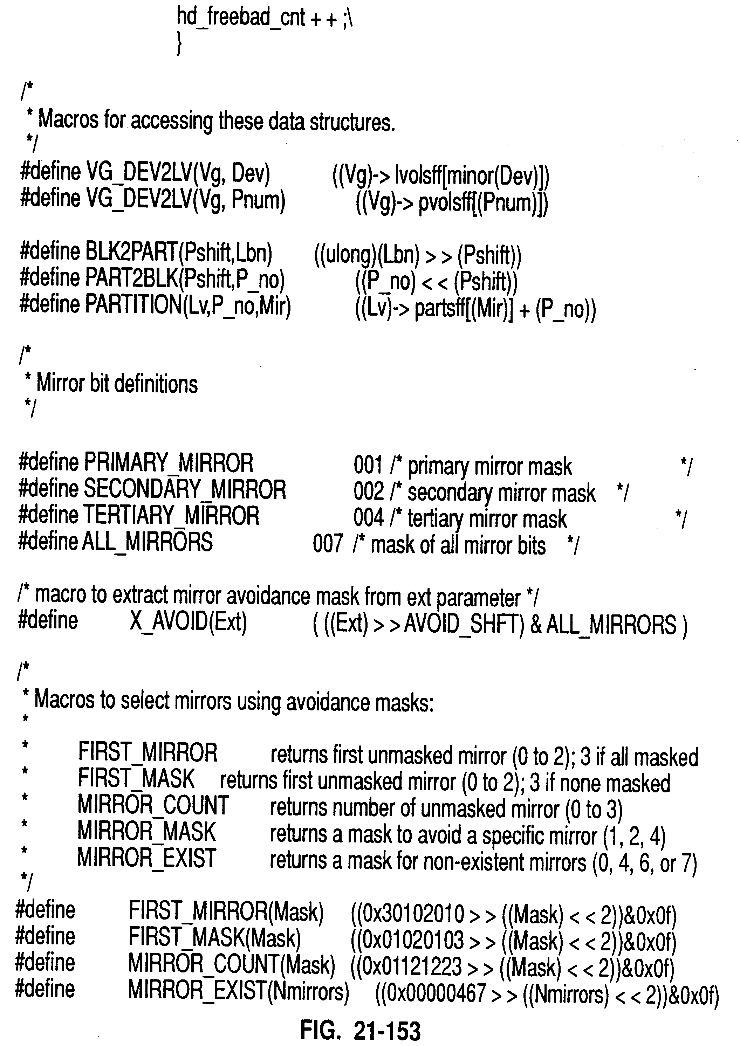

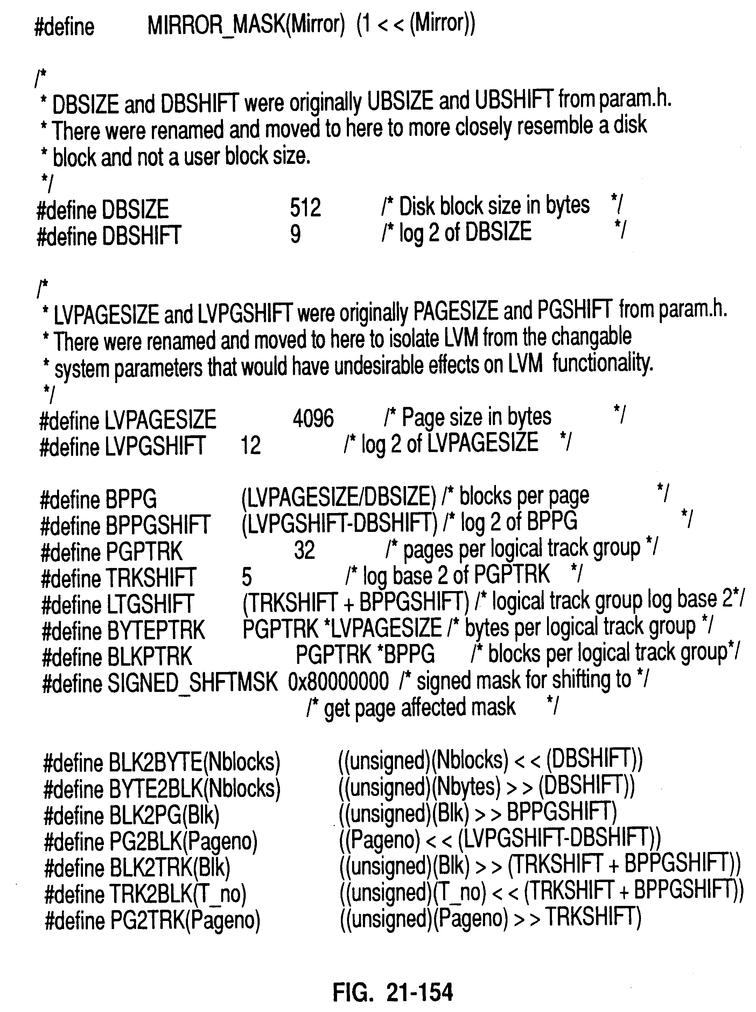

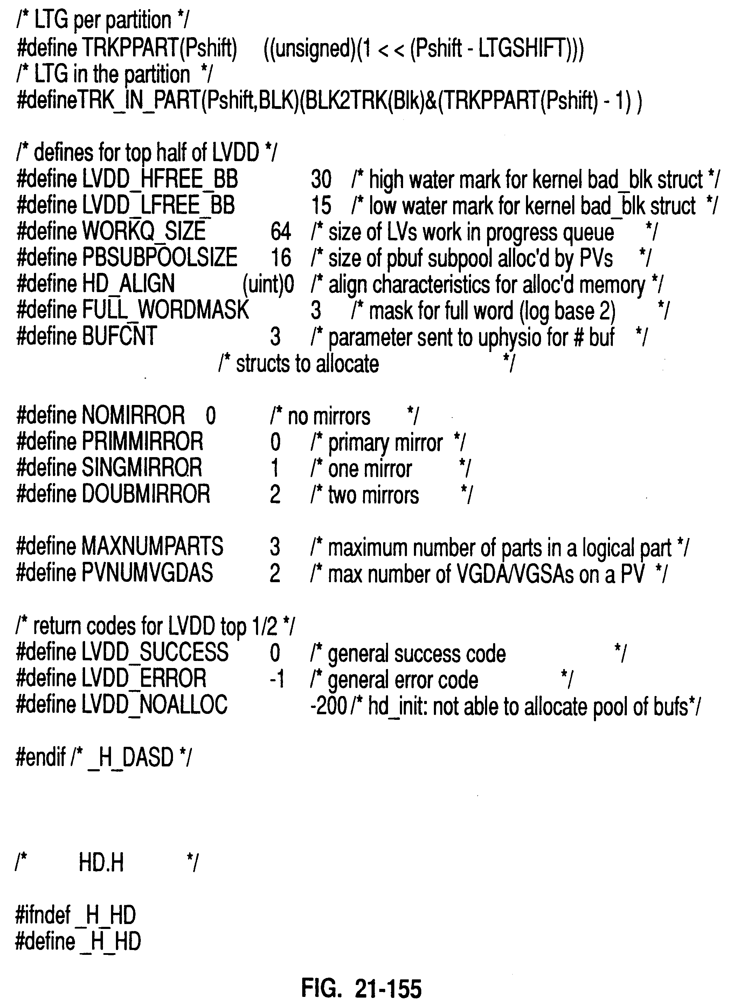

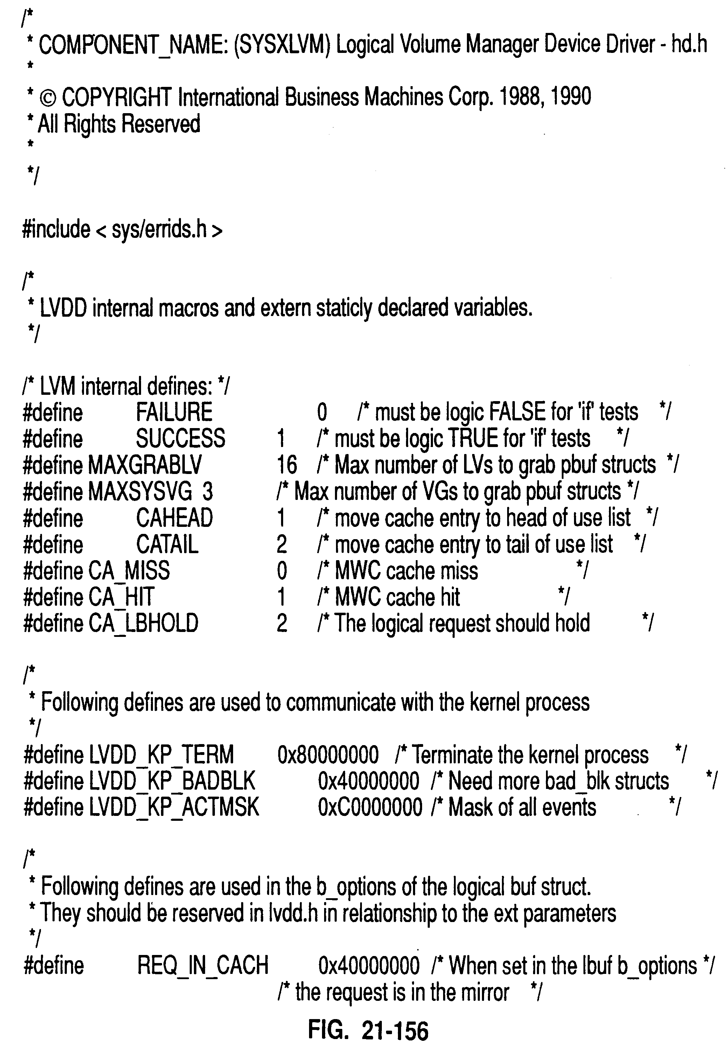

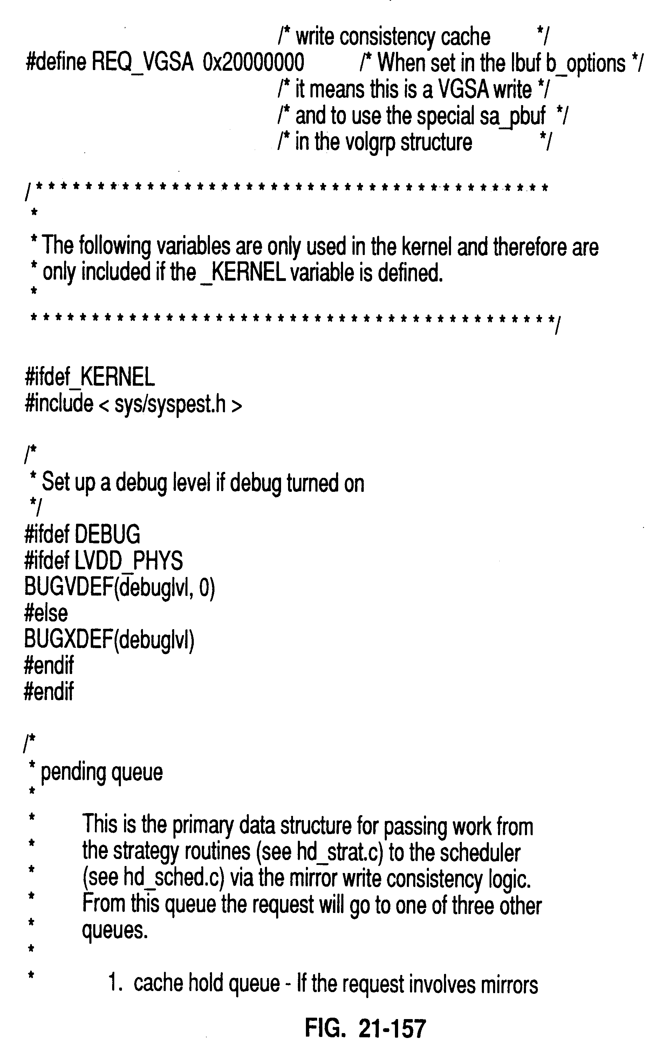

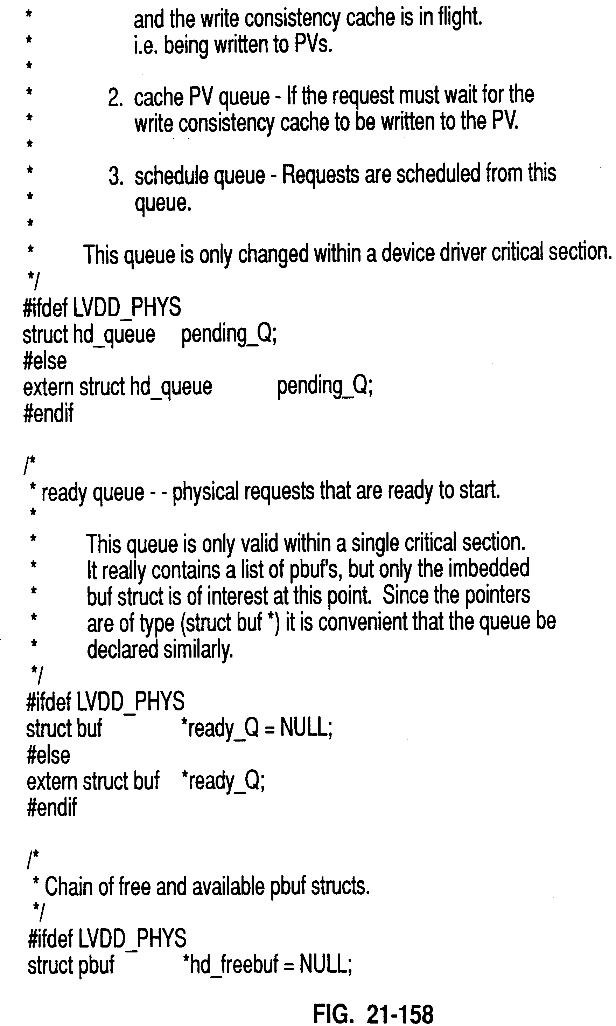

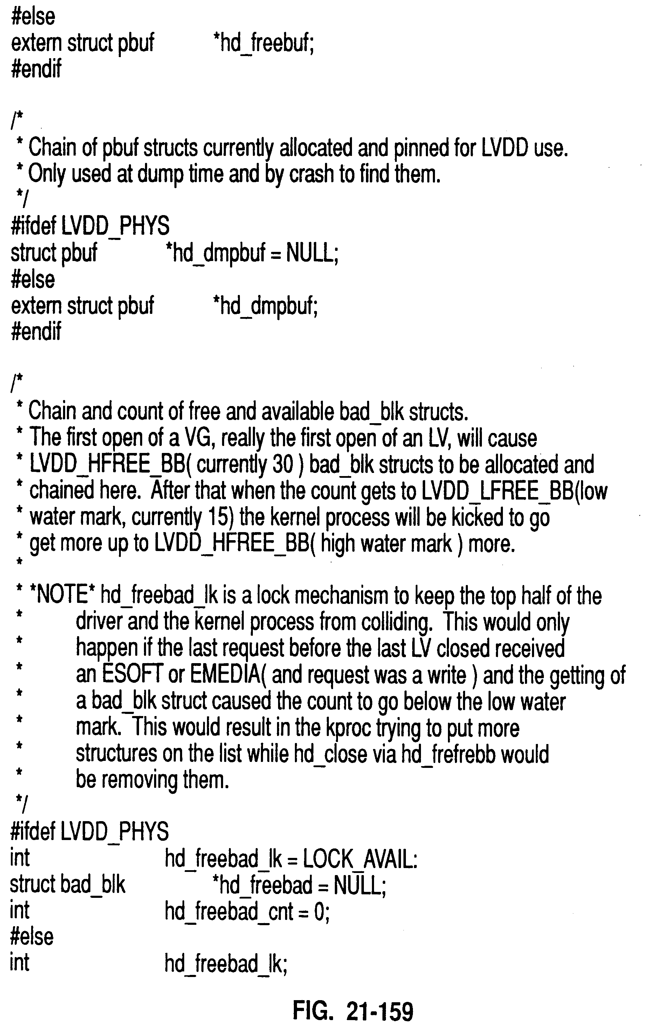

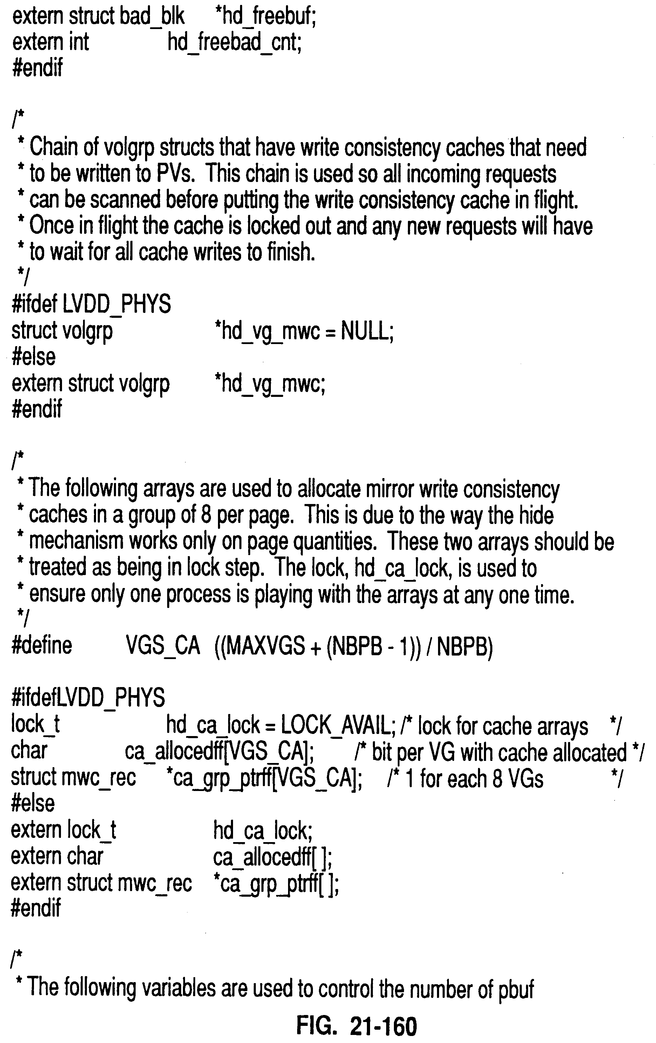

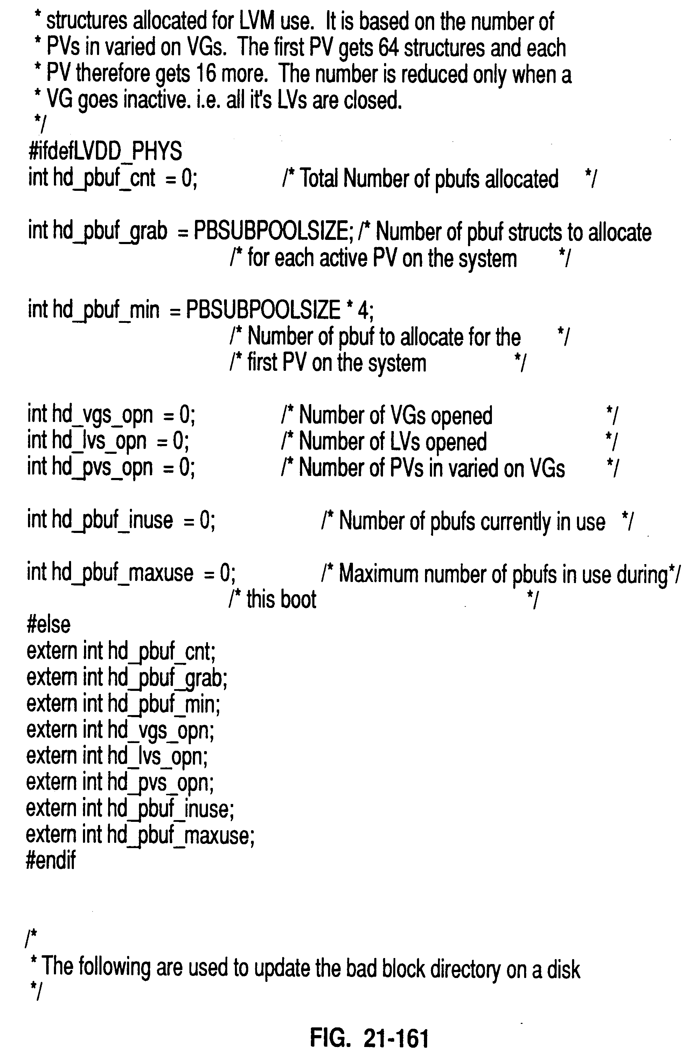

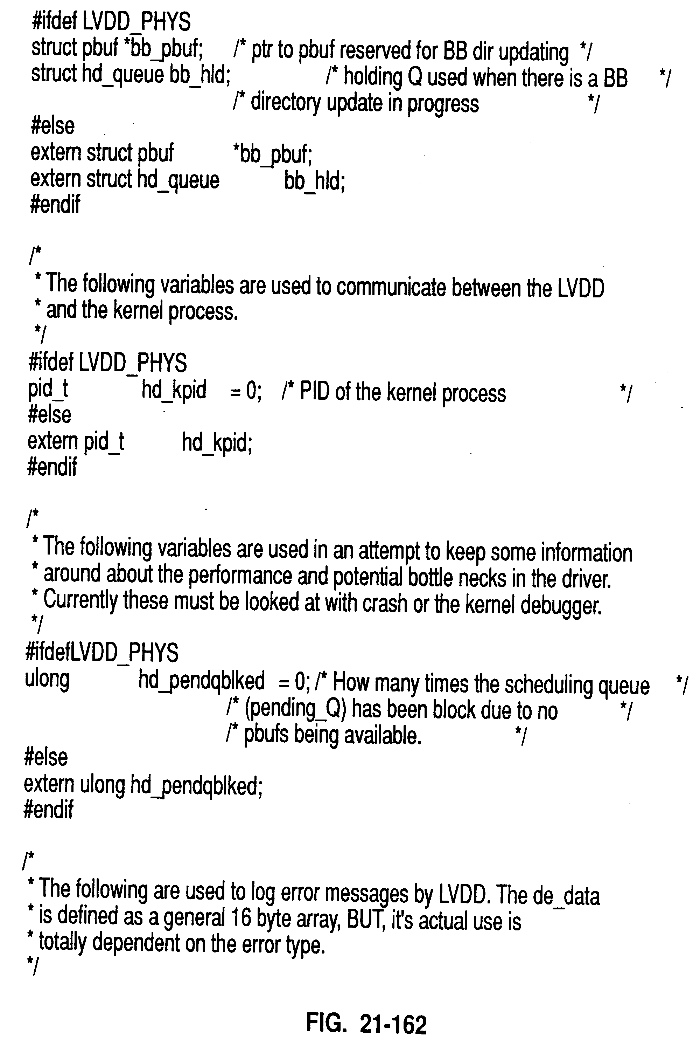

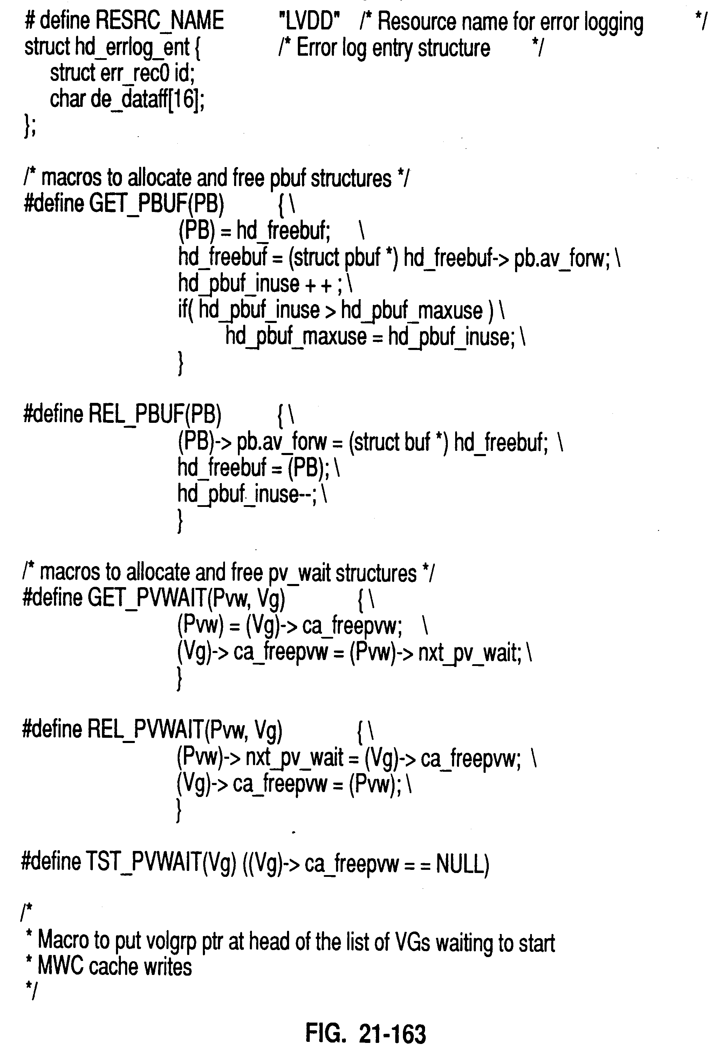

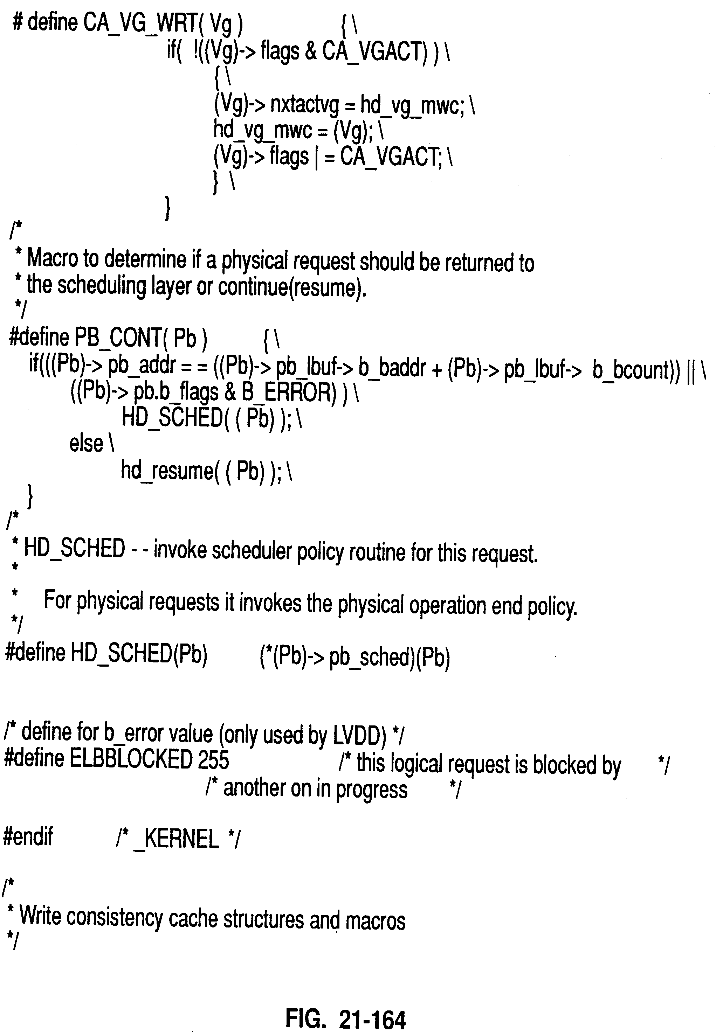

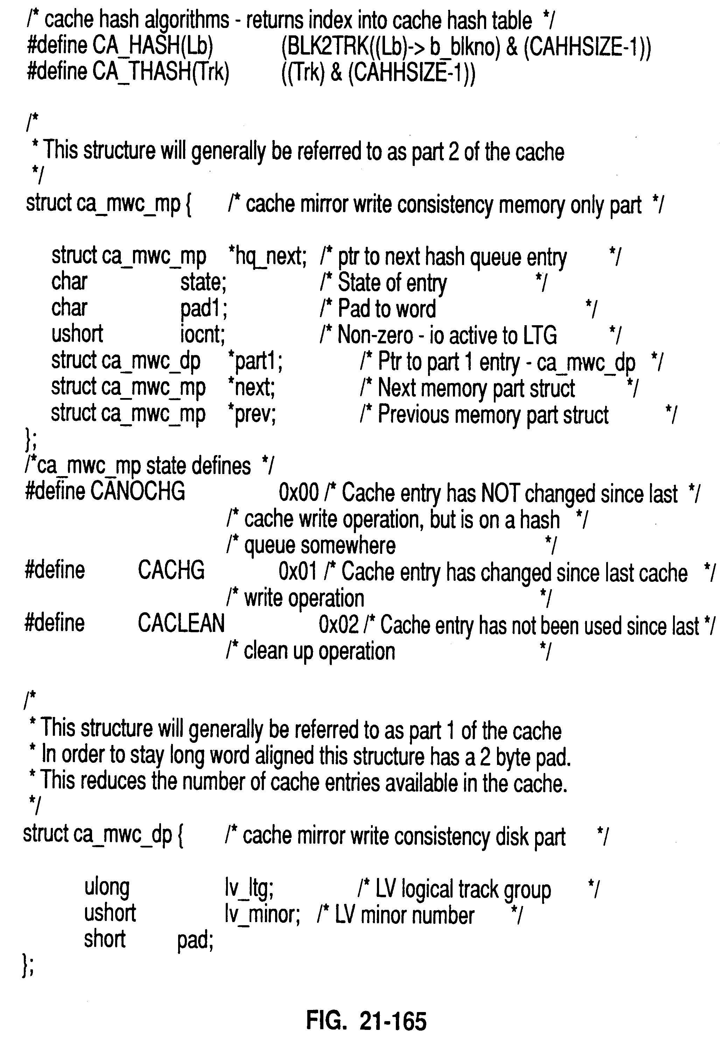

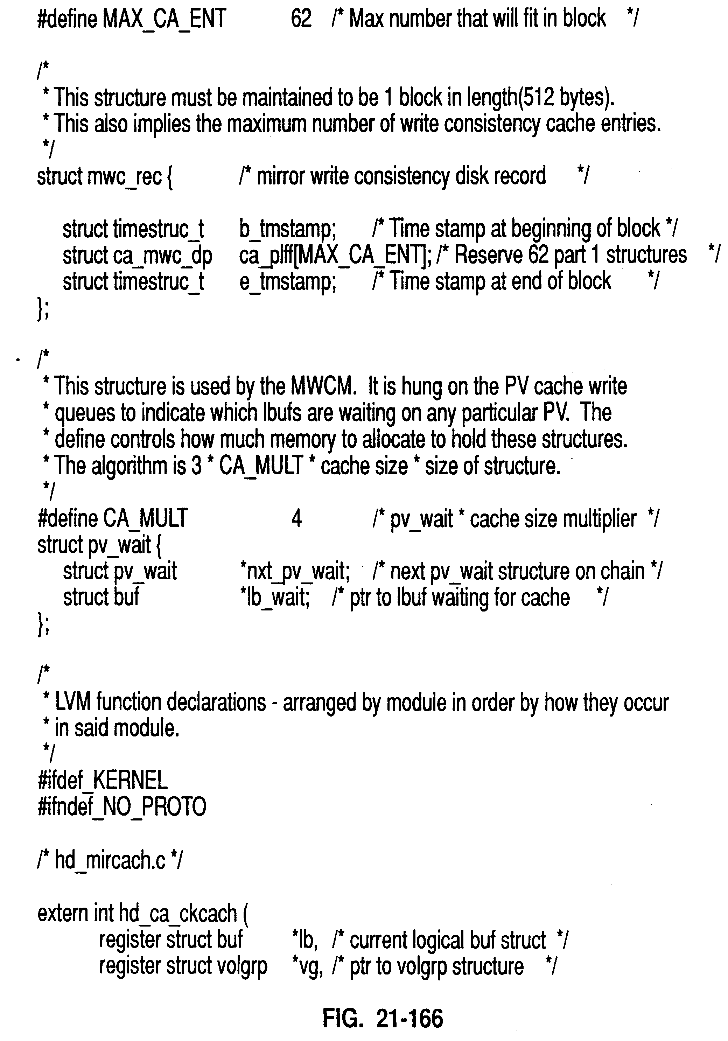

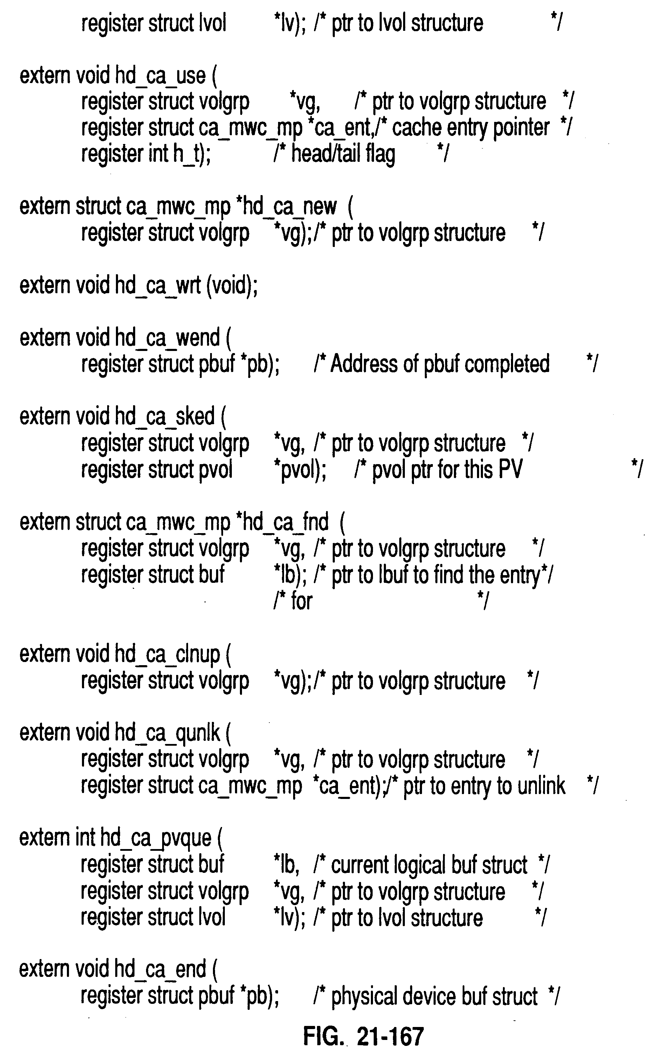

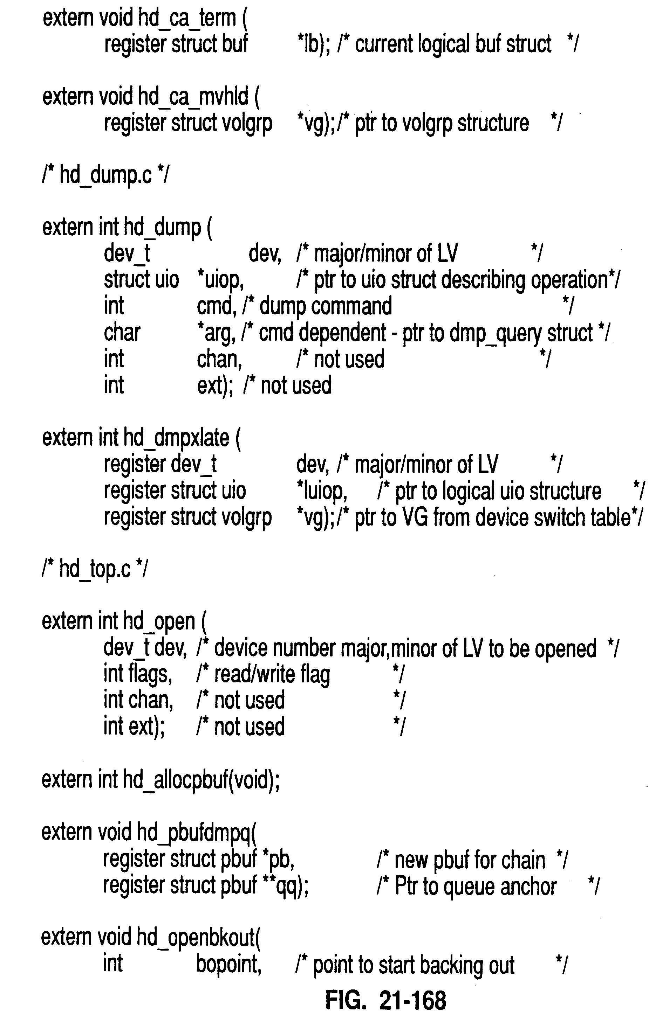

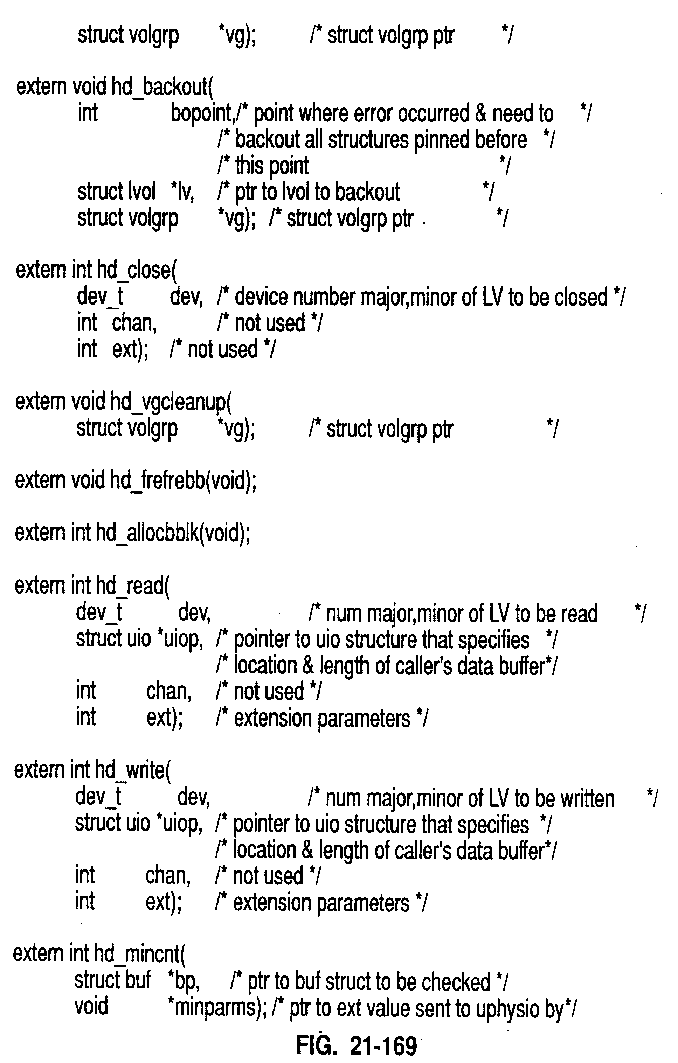

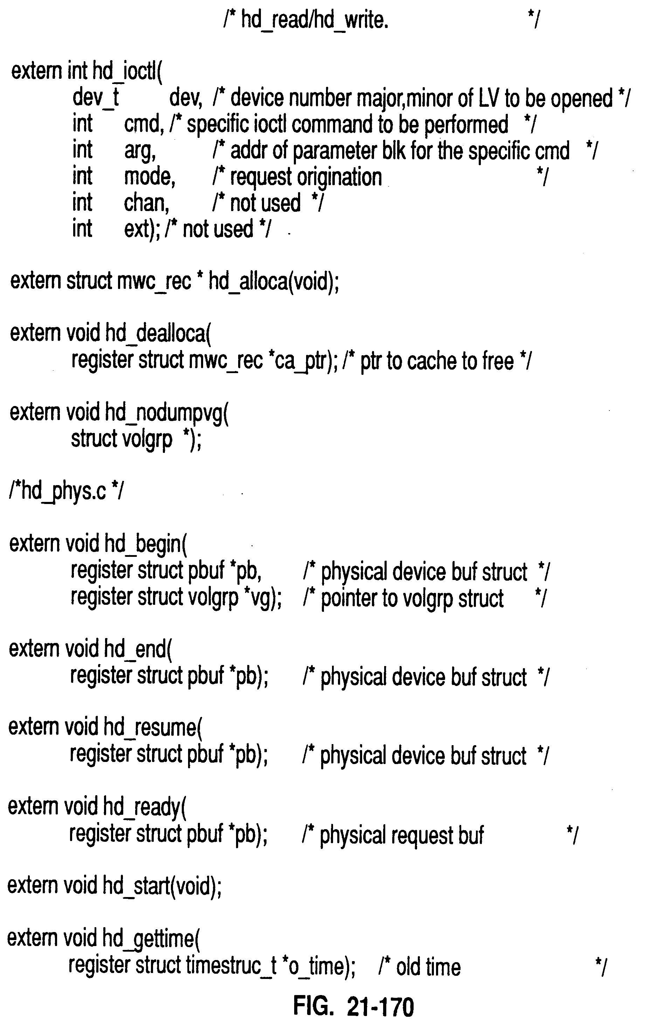

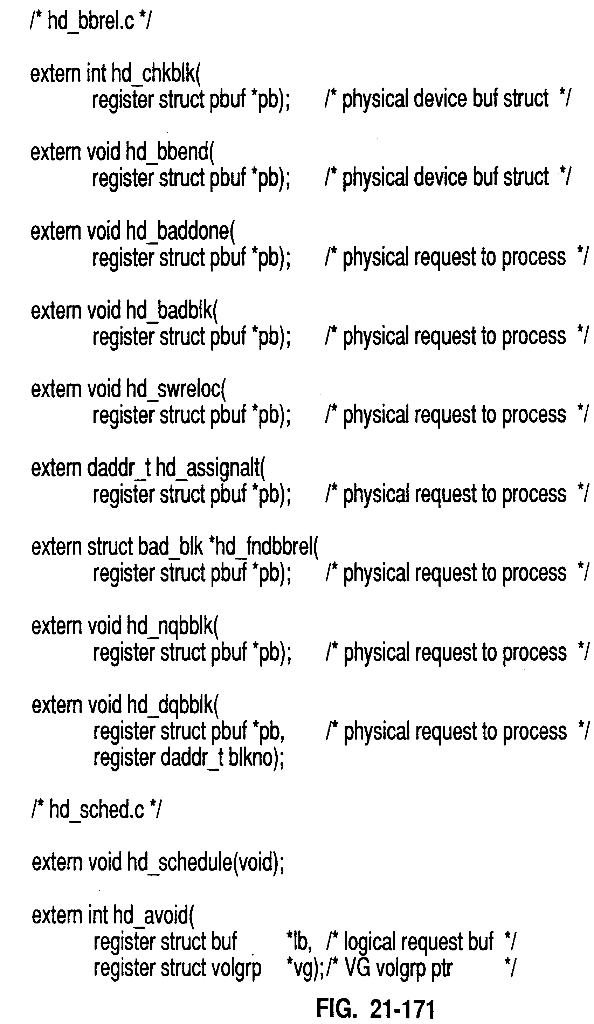

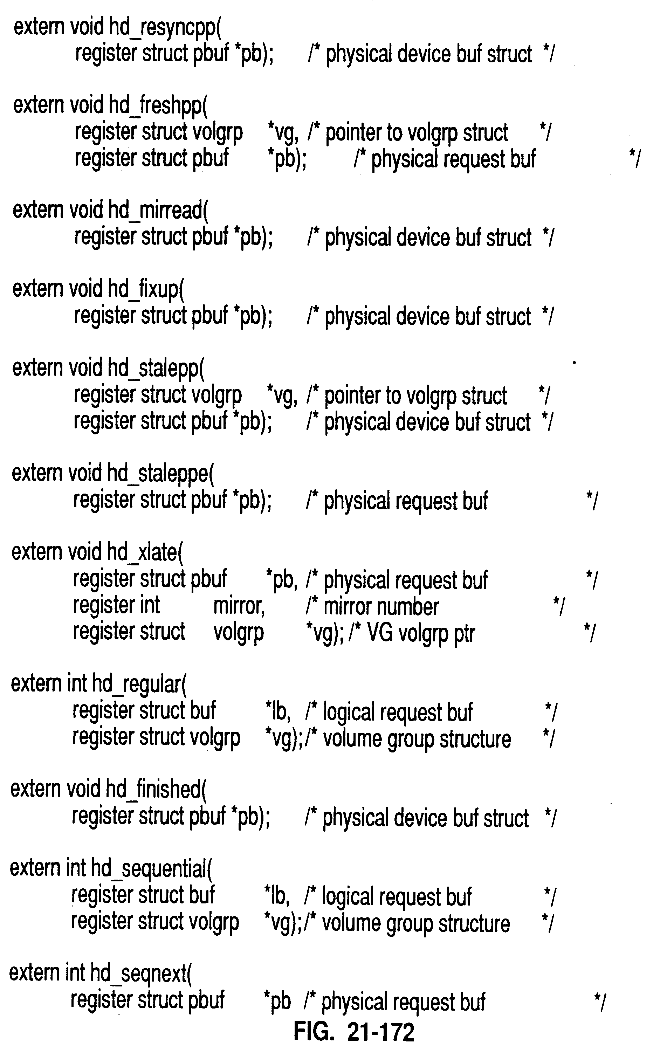

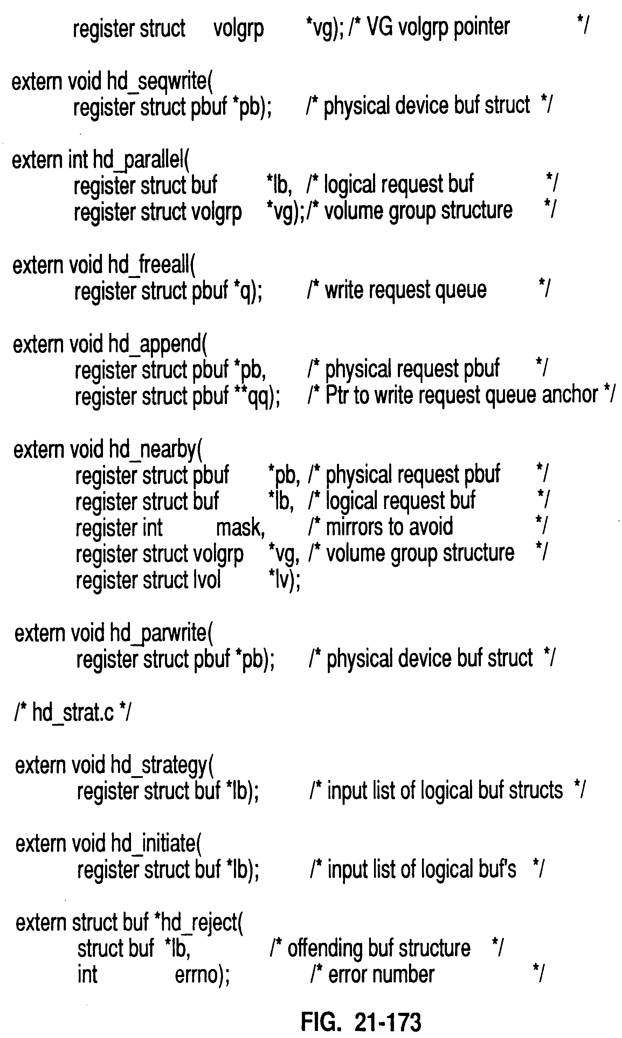

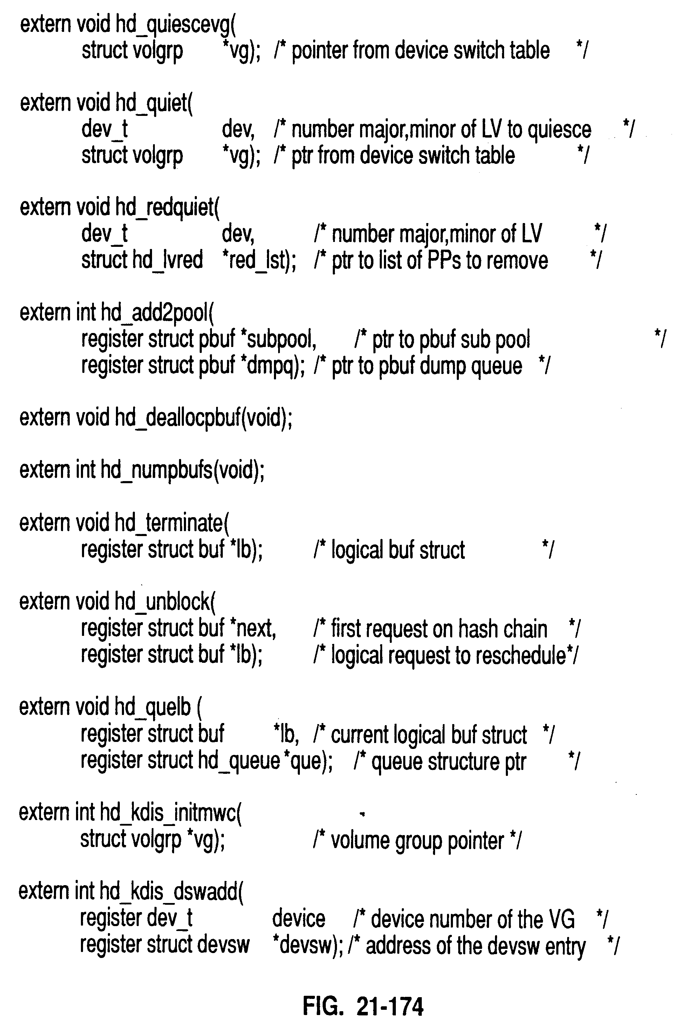

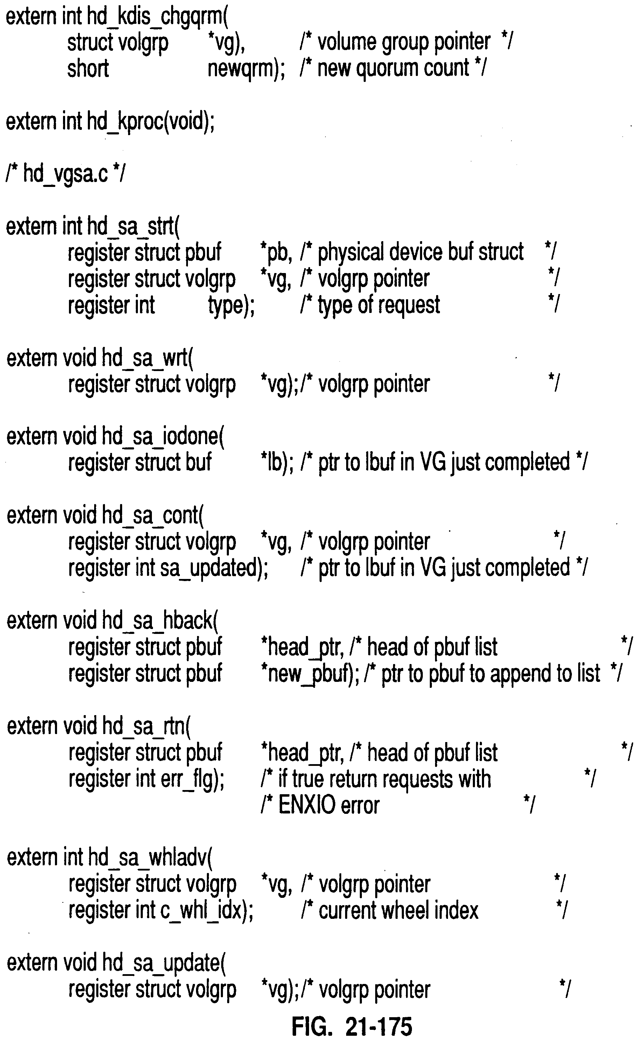

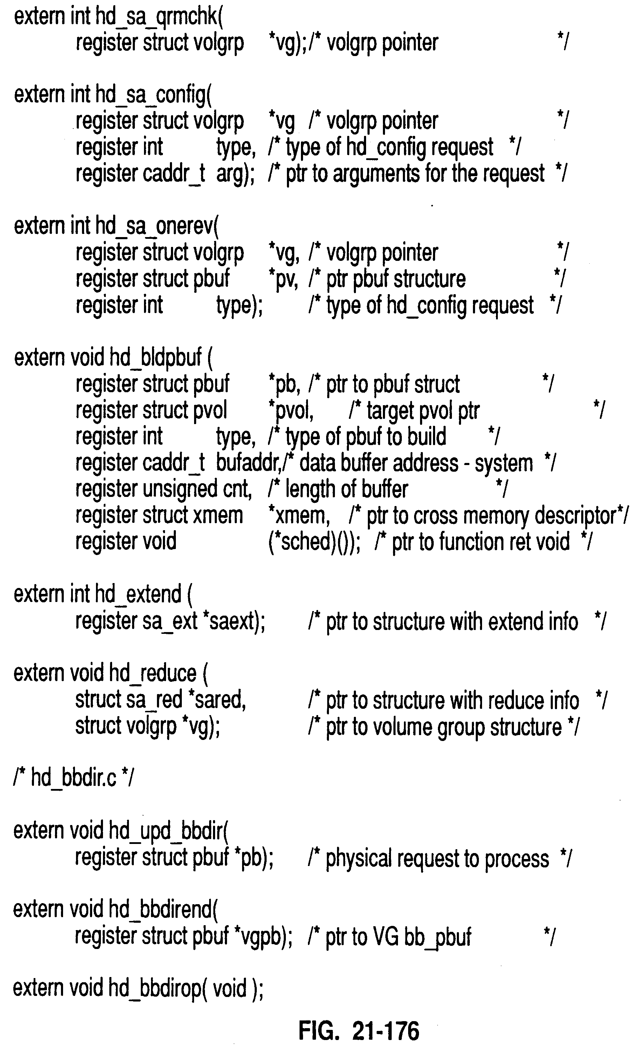

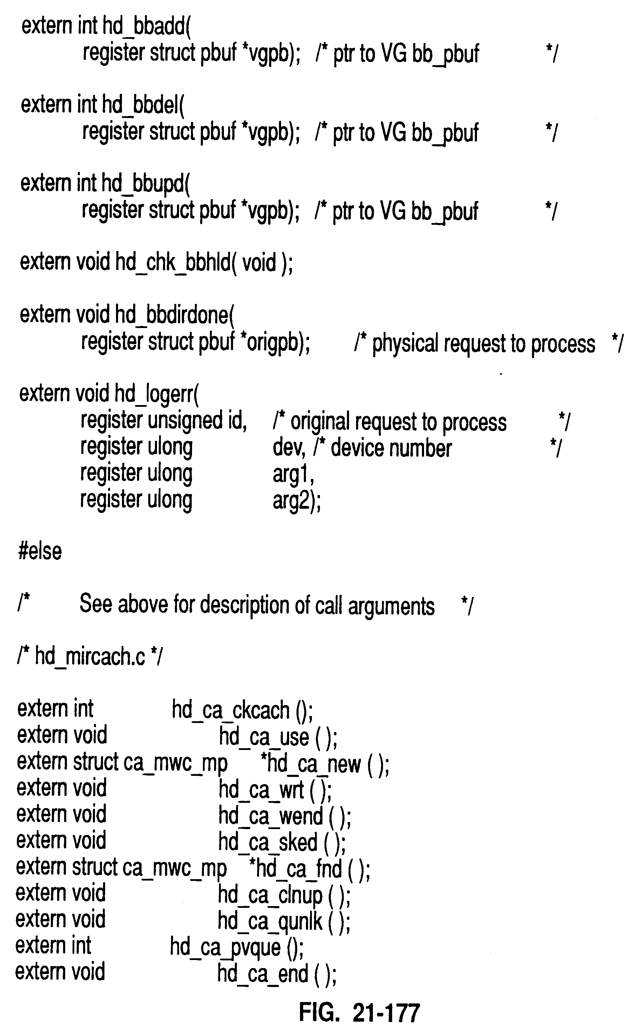

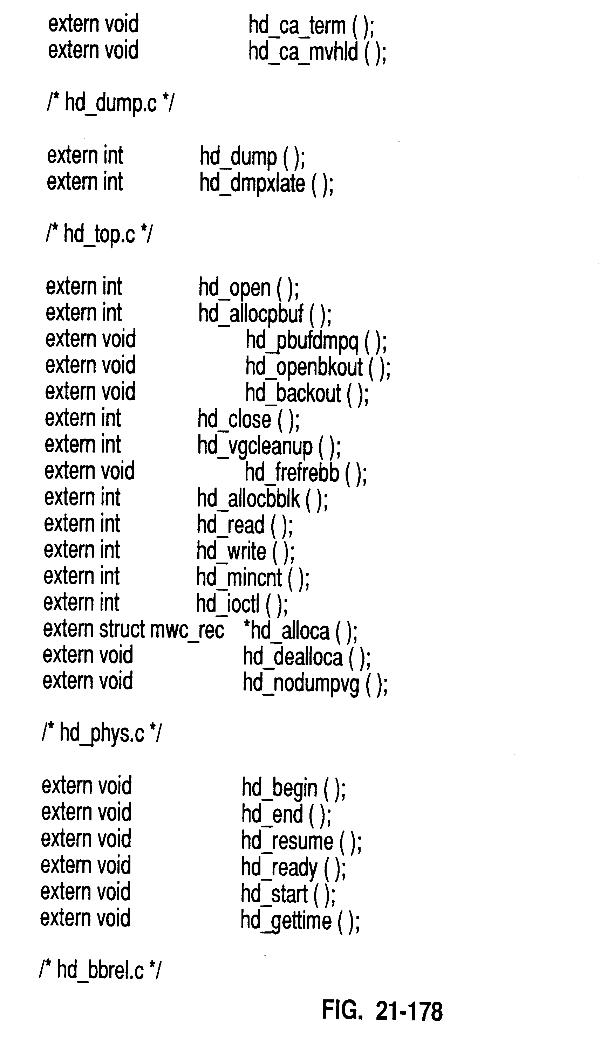

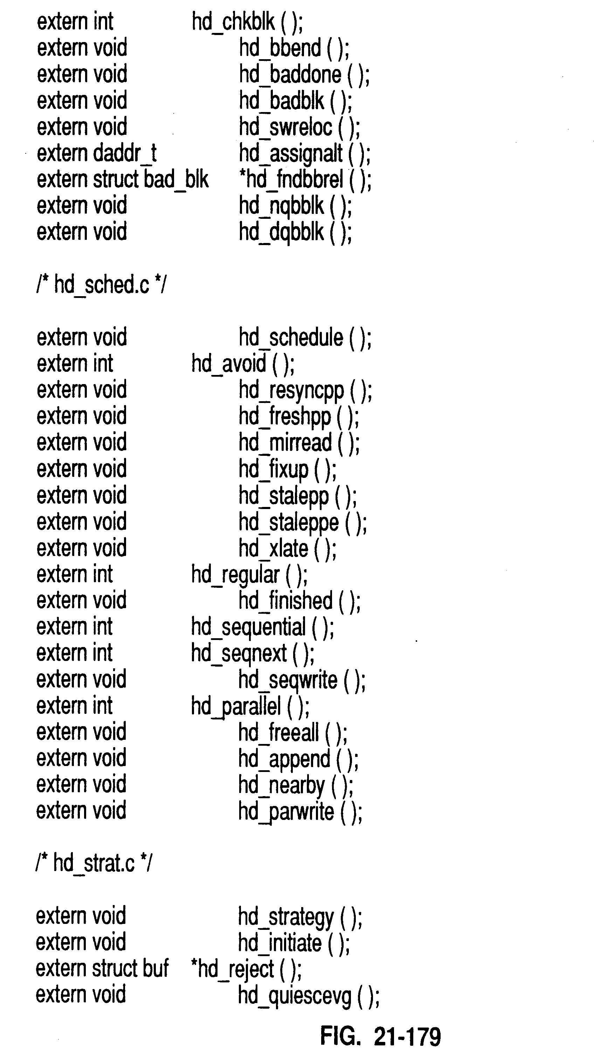

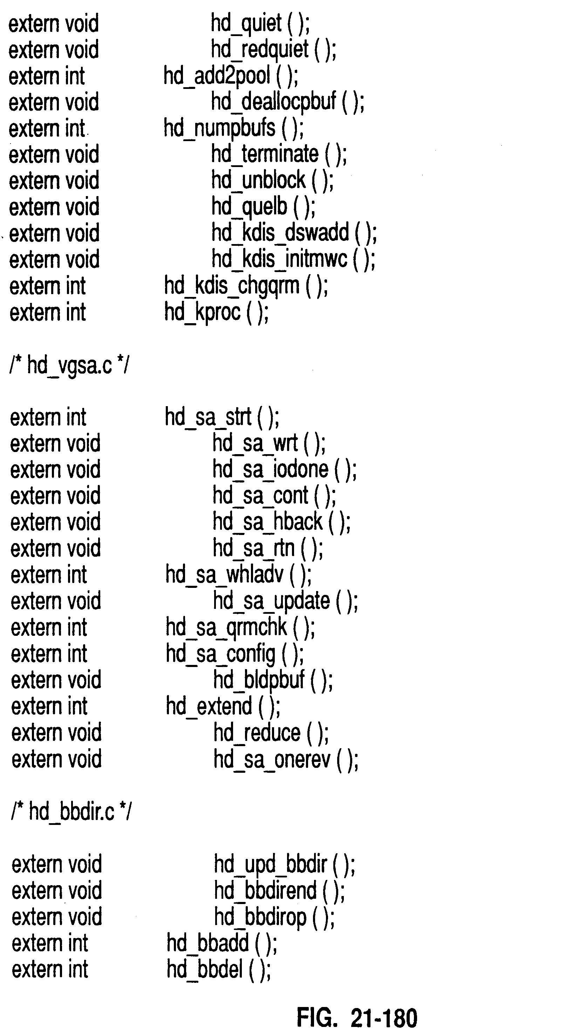

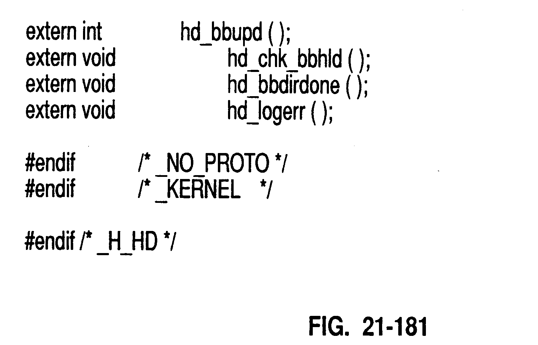

As previously mentioned, each physical volume contains a Volume Group Data Area(VGDA). The Data Area indicates the interrelationship between the logical and physical volumes and physical partitions. The Data Area can be duplicated on the same physical volume, is not contained within any physical partition, and has the format shown in Fig. 7. The Data Area should be allocated on DASD in such as way as to reduce the probability of a single failure obliterating both copies of it. The details of the Data Area are shown in Fig. 8. The various fields within the Data Area are described at pages 8 and 9 of Fig. 21. The VGDA is a variable sized object that is user defined when the Volume Group is created.

Referring again to Fig. 5, a User Area follows the Logical Volume Manager Area, and contains the normal user data area.

A bad block pool area in Fig. 5 is also provided which supplies substitution blocks for user area blocks that have been diagnosed as unusable. It will be assumed in the remaining description that there are no bad blocks on the disk or if there are they are handled by any of the well known prior art techniques.

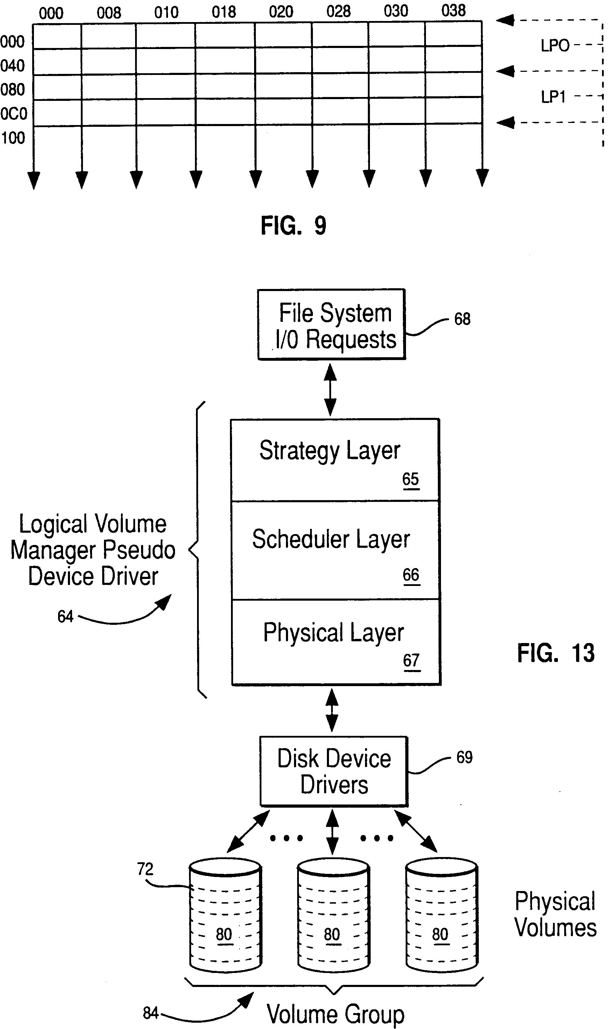

Fig. 9 indicates the layout of a logical volume where block numbers are decimal. Logical partition size shown is 64 Kilobytes (128 logical blocks).

In the preferred embodiment, the method of the present invention is implemented by a file named /dev/lum which is called the Logical Volume Manager.

The Logical Volume Manager (LVM) provides the ability to create, modify and query logical volumes, physical volumes and volume groups. The LVM automatically expands logical volumes to the minimum size specified, dynamically as more space is needed. Logical volumes can span physical volumes in the same volume group and can be mirrored for high reliability, availability, and performance. Logical volumes, volume groups and physical volumes all have IDs that uniquely identify them from any other device of their type on any system.

The LVM comprises a number of operations performed by calls to the SYSCONFIG system call. These SYSCONFIG calls including the processes for creating and maintaining internal data structures having volume status information contained therein. These system calls are more fully described in the IBM manual "AIX Version 3 for RISC System/6000, Calls and Subroutines" Reference Manual: Base Operating System, Vol. 2.

A Logical Volume Manager pseudo device driver 64 is shown if Fig. 13, and consists of three conceptual layers. A strategy layer 65 interfaces to the file system I/O requests 68, a scheduler layer 66 to be described later, and a physical layer 67 which interfaces to the normal system disk device drivers 69, both logical and physical. This pseudo device driver 64 intercepts file system I/O requests 68 destined to and from the disk device drivers 69 and performs the functions of mirroring, stale partition processing, Status Area management, and Mirror Write Consistency, all of whose operations and functions will now be described.

### Mirroring

Mirroring is used to support replication of data for recovery from media failures. Normally, users have specific files or filesystems that are essential and the loss of which would be disastrous. Supporting mirroring only on a complete disk basis can waste a considerable amount of disk space and result in more overhead than is needed.

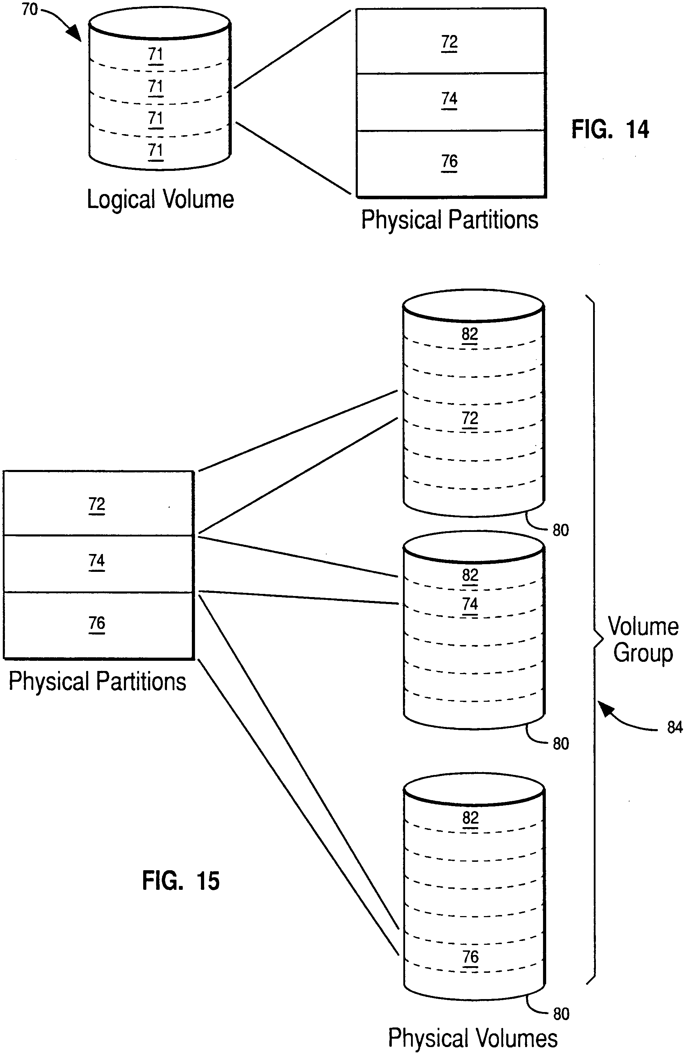

A partition is a fixed sized, physically contiguous collection of bytes on a single disk. Referring to Figure 14, a logical volume 70 is a dynamically expandable logical disk made up of one or more logical partitions 71. Each logical partition is backed up by one or more physical partitions, such as 72, 74 and 76. The logical partition is backed up by one(72) if the partition is not mirrored, by two(72 and 74) if the partition is singly mirrored, and by three(72, 74, and 76) if the partition is doubly mirrored.

Mirroring can be selected in the following ways for each logical volume: (i) none of the logical partitions in a logical volume can be mirrored, (ii) all of the logical partitions in a logical volume can be mirrored, or (iii) selected logical partitions in a logical volume can be mirrored.

### Stale Partition Processing

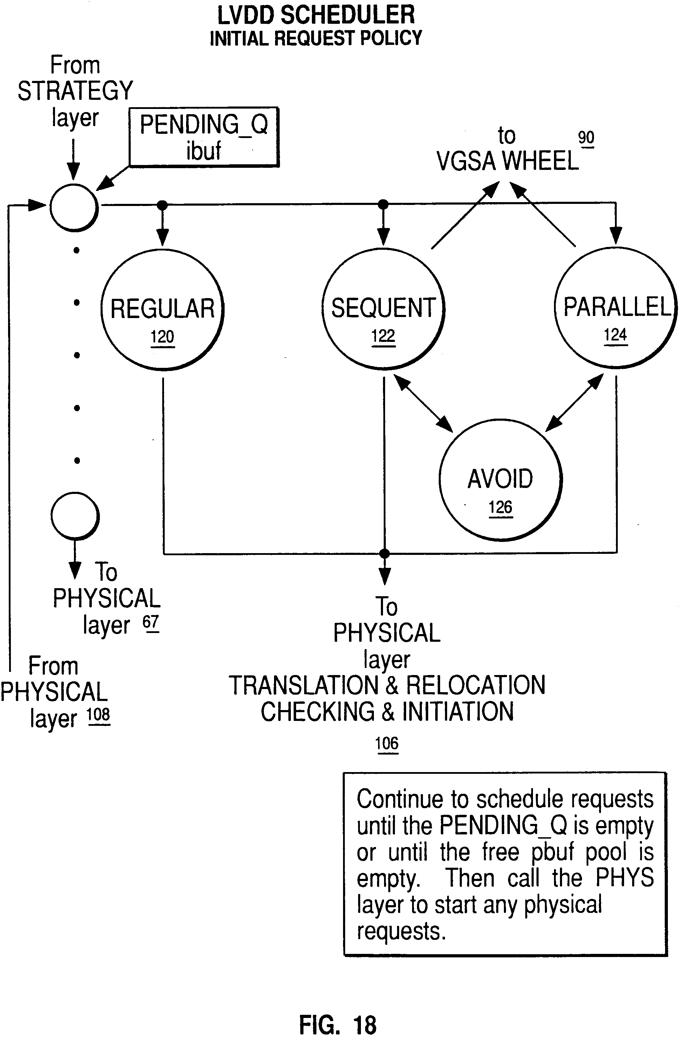

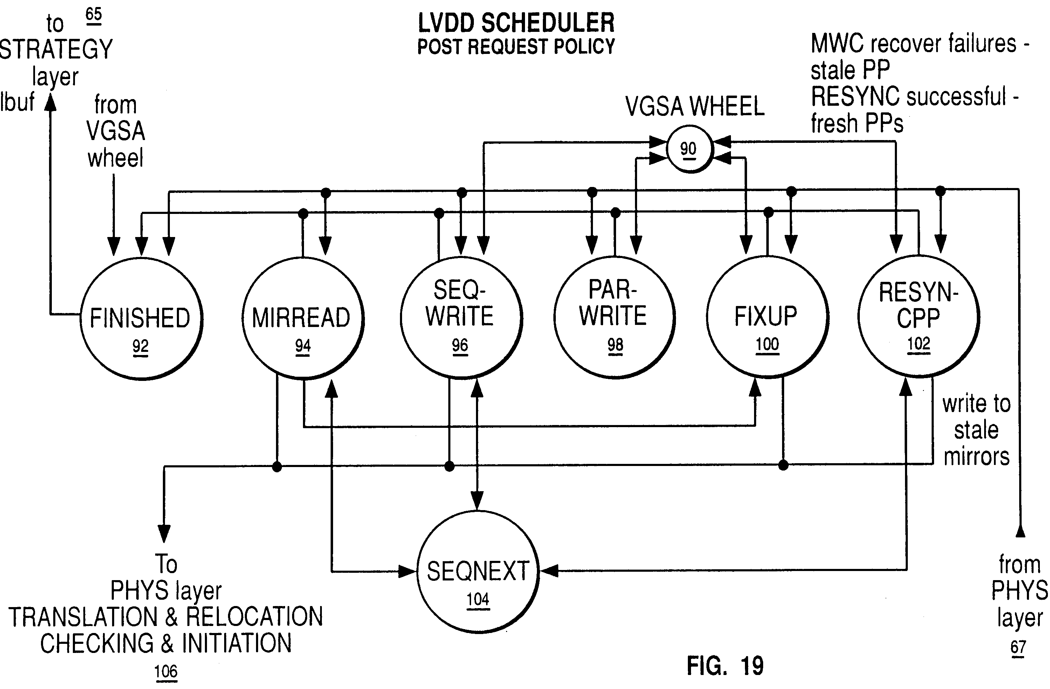

In order for mirroring to function properly, a method is required to detect when all physical partition copies of the mirrored data are not the same. The detection of stale physical partitions(PP) and initiation of stale physical partition processing is done in Fig. 13 at the scheduler layer 66 in the driver 64. This scheduler layer has two I/O request policies, initial request and post request. The initial request policy receives and processes requests from the strategy layer 65 and is illustrated in Fig. 18. The post request policy interfaces with the physical layer 67 and is illustrated in Fig. 19. A description of the functions within these policies follows.

Initial Request Policy -

REGULAR

Returns EIO for request that avoids the only copy, or the target PP is being reduced, or target PV is missing. If request is a special VGSA write, REQ_VGSA set in b_options, then a special pbuf(sa_pbuf) is used which is embedded in the volgrp structure, instead of allocating a pbuf from the free pool.

SEQUENTIAL

Returns EIO for request that avoids all active copies(mirrors). Read requests select the partition to read from in primary, secondary, tertiary order. Write requests select the first active copy and initiate the write. The remaining copies are written in sequential order, primary, secondary, tertiary, after the preceding partition has been written. Sequential only initiates the first physical operation. Any subsequent operations, due to read errors, or multiple writes are handled by the post request policy. Sequential does not write to partitions that are stale or are on PVs with a status of missing.

PARALLEL

Returns EIO for request that avoids all active copies(mirrors). Read requests read from the active partition that requires the least amount of PV head movement based on the last queued request to the PV. Write requests generate writes to all active partitions simultaneously, i.e. in parallel. PARALLEL does not write to partitions that are stale or are on PVs with a status of missing.

AVOID

Builds an avoid mask for the mirrored policies. This mask informs the scheduling policy which partitions to avoid or not use. Following is a description of when mirrors are to be avoided.
GENERAL - Applies to both read & write requests.
   i) Non-existent partitions or holes in a logical partition.
   ii) Explicitly avoided by request. There are bits(AVOID_C1,2,3) in the b_option field of the request that explicitly avoid a copy(used for read requests only).
READ - Applies to read requests only.
   i) Partitions located on PVs with a status of missing.
   ii) Partitions that are in the process of being reduced or removed.
   iii) Partitions that have a status of stale.
WRITE - Applies to write requests only.

   i) Partitions that are in the process of being reduced or removed.
   ii) Partitions that have a status of stale and that status is not in transition from active to stale.
   iii) If there is a resync operation in progress in the partition and the write request is behind the current position of the resync position then allow the write even if the partition status is stale.
If the request is a resync operation or a mirror write consistency recovery operation, the sync-mask is also set. The sync-mask informs the resyncpp post request policy which partitions are currently stale and therefore which ones to attempt to write to once good data is available.

Post Request Policy

FINISHED

Generally the exit point from the scheduler layer back to the strategy layer. Responsible for moving status from the given pbuf to the lbuf. If the pbuf is not related to a VGSA write, REQ_VGSA set in b_options, the pbuf is put back on the free list.

MIRREAD

Used by both sequential and parallel policies when the request is a read. It has the responsibility of checking the status of the physical operation. If an error is detected it selects another active mirror. It selects the first available mirror in primary, secondary, tertiary order. When a successful read is complete and there were read errors on other mirrors MIRREAD will initiate a fixup operation via FIXUP.

SEQWRITE

Used by the sequential policy on write requests. It has the responsibility of checking the status of each write and starting the write request to the next mirror. Writes are done in primary, secondary, tertiary order. When all active mirrors have been written, any mirrors that failed are marked stale by the WHEEL(to be described hereafter).

PARWRITE

Used by the parallel policy on write requests. The initial parallel policy issued physical requests to all mirrors in parallel. PARWRITE checks the status of each of the completed physical requests. PARWRITE remembers only if a write error occurred or not. PARWRITE puts the pbufs back on the free list as they complete and coalesces the status into an outstanding sibling. Therefore the last physical request to complete holds the pass/fail status of all the siblings including itself. If any write errors are detected the affected mirrors will be marked stale(by the WHEEL) only after all physical requests for a given logical request are complete.

FIXUP

Used to fix a broken mirror, one that had a read error, after another mirror was read successfully.

RESYNCPP

Used to resynchronize a logical partition, LP,. The initial policy, sequential or parallel, selects an active mirror, one not stale or on a missing PV, to read from first. RESYNCPP checks the status of the read. If an error is detected RESYNCPP will select another mirror if one is available. Once a successful read has been done RESYNCPP will write that data to any stale physical partition in the LP. RESYNCPP does not attempt to fix broken mirrors, i.e. ones that failed the initial read. RESYNCPP is also used to do MIRROR WRITE CONSISTENCY RECOVERY(MWCR) operations. During MWCR operations RESYNCPP will mark partitions stale if a write fails in the partition.

SEQNEXT

Used to select the next active mirror considering the ones already used, stale partitions, and missing PVs.

Referring now to Fig. 14, each PP 72 that is defined in the volume group has state information in the partition structure. Each PP must be in one of two permanent states. It can be active, available for all I/O, or stale, not available for all I/O. In addition, there are two intermediate states, called reducing and changing. The permanent state of each PP in the volume group 84 is also maintained in the Status Area(VGSA) 82, as shown in Fig. 6f. A copy of the VGSA 82 resides on each physical volume 80 of the volume group 84.

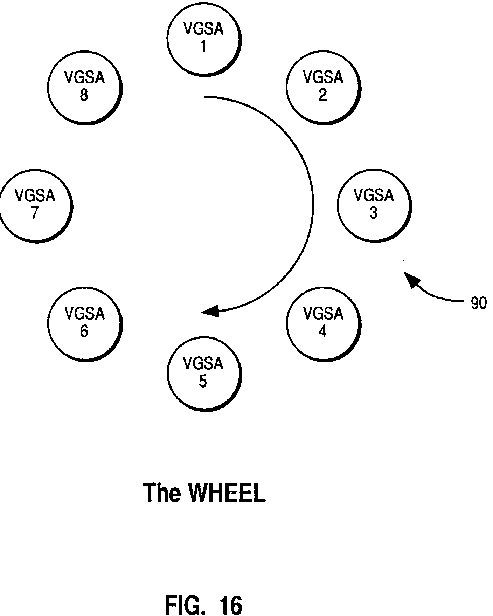

This allows the state of each partition to be retained across system crashes and when the VG is not online. The driver 64 has the responsibility of maintaining and updating the VGSA. Stale PP processing is not complete until all VGSAs have been updated. The VGSAs are updated by a mechanism hereinafter called the WHEEL, which is described hereafter, and references will be made that indicate requests will be going to or returning from the VGSA WHEEL 90 shown in Fig. 16. The VGSA WHEEL's request object is the physical request(PR) or pbuf structure. It accepts pointers to PRs and returns them via the pb_sched field of the same structure when all VGSAs have been updated.

Following is a description of each PP state.

ACTIVE

The partition is available for all I/O. Read requests for the LP can read from this PP. Writes to the LP must write to this PP.

STALE

The partition cannot be used for normal I/O. The data in the partition is inconsistent with data from its peers. It must be resynchronized to be used for normal I/O. It can be reduced or removed from the LP.

REDUCING

The partition is being reduced or removed from the LP by the configuration routines. Any reads or writes that are currently active can be completed because the configuration routines must drain the LV after putting the partition in this state. The initial request policies must avoid this PP if a read request is received when the PP is in this state. The configuration routines will also turn on the stale flag under certain conditions to control write requests that may be received. These configuration routines are further described hereafter.

CHANGING

The partition has changed states from active to stale and the initial request that caused that change has not been returned from the VGSA WHEEL. A read request to a LP that has a PP changing must avoid the PP. A write request to the LP cannot be returned until the WHEEL returns the initial request that caused the state change. This is done by actually building the PR and then handing it off to the VGSA WHEEL. The WHEEL handles duplicate operations to the same partition and will return them when the initial request is returned.

There are some general rules that apply to logical requests(LR) and PPs when they encounter stale PP processing. First, once a partition goes stale it cannot accidentally become active again due to a system crash or error. There is one exception to this, if the VG was forced on with the force quorum flag the selected VGSA may not have contained the latest PP state information. If a user forces the VG, they take their chances. Secondly, a LR will not be returned until all stale PP processing is complete. This means that all VGSAs have been updated.

It is an illegal state for all copies of a logical partition(LP) to be marked stale. There must be at least one active partition. That one active partition can be on a PV that is missing. All writes to that LP will fail until the PV is brought back online. Of course the entire LP can be reduced (removed) out of the LV.

If all copies of a LP have write failures then all but one copy will be marked stale before the LR is returned with an error. Since there is no guarantee that all the writes failed at the same relative offset in the PRs, the assumption must be made that possible inconsistencies exist between the copies. To prevent two different reads of the same logical space from returning different results (i.e. they used different copies), the number of active partitions must be reduced to one for this LP. The only exception to this is when no PR has been issued before the detection that all copies will fail, which might occur if the logical volume(LV) is using the parallel write policy, which is described hereafter.

There are three ways a PP can become stale. The first is by the system management mechanism that extends a LP horizontally when valid data already exists in at least one PP for this LP or the PP is being reduced(removed). This will be referred to as the config method.

A partition can become stale when a write to its respective LP is issued and the PV where the PP is located has a status of missing. This type of staleness is detected before the physical request is issued to the PV. This will be referred to as the missing PV method.

Finally, a PP can become stale when a write to it is returned with an error. This will be referred to as the write error method.

A more detailed discussion of action and timing for each method follows.

CONFIGURATION METHOD

The config method is really outside the normal flow of read and write requests that flow through the scheduler layer. It is important that the driver and the configuration routines stay in sync with each other when the state of the PP is changing. A set of procedures is defined later that covers how this is done.

MISSING PV METHOD

Detecting that a PR is targeted for a PV that has a status of missing must be done before the request is issued, as shown in Fig 19. All mirrored write policies 96, 100, 122 and 124 must check the target PVs status before issuing the PR to the lower levels 106. If that status is detected the PR will be sent to the VGSA WHEEL 90. The PR must have the proper post policy encoded, the B_DONE flag reset in the b_flags field and a type field that requests this PP be marked stale. The post request policy, Fig. 19, will decide what action is next for this LR when the VGSA WHEEL returns the PR. The one exception to this is in the initial request parallel policy. If it detects that all active partitions are on PVs with a status of missing, it can return the LR with an error, EIO, and not mark any partitions stale. It can do this because the data is still consistent across all copies for this request.

WRITE ERROR METHOD

When a request is returned from the physical layer 108, to the post request policy shown in Fig. 19, with an error, the policy must decide if the partition is to be marked stale. There are several factors involved when deciding to mark a mirror stale. A few are mentioned below with references to Fig. 19.

If the post policy is sequential 96 and this is the last PR for this LR and all other previous PRs failed (and their partitions marked stale), then this partition cannot be marked stale. If it were marked stale then all copies of this LP would be marked stale and that is an illegal state.

Resync operations 102 do not mark mirrors stale, but if the write portion of a resync operation fails then the failing partition cannot be put into an active state.

Mirror write consistency recovery operations will mark a mirror stale if the write to the mirror fails.

In any case, if the partition is to he marked stale the PR must be set up to be sent to the VGSA WHEEL. This entails the proper post policy be encoded, the B_DONE flag reset (in the b_flags field) and a type field be set that requests this PP be marked stale. When the PR is returned by the VGSA WHEEL the receiving post policy will decide what action is next for this PR and the parent LR.

Any post request policy that receives a PR from both the physical layer 108 and the VGSA WHEEL 90 must query the B_DONE flag in the b_flags field to determine the origin of the PR. Since the post request policy handles PRs, from both the physical layer and the VGSA WHEEL, it makes all the decisions concerning the scheduling of actions for the request and when the LR request is complete.

Now that the states of a PP have been defined, the procedures for handling a request in relationship to those states must be defined. Also defined are the procedures the configuration routines and the driver must follow for changing the states in response to system management requests.

Driver only procedures

1) State is active

Read requests may read from the partition.
Write requests in the initial request policies must write to the partition.
Write requests in the post request policies of Fig. 19 that are returned with an error must:
i) Turn on the changing flag and stale flag. The partition has just changed states.
i) Remember that the PR failed.
iii) Hand the PR off to the VGSA WHEEL 90.
iv) When the PR is returned from the WHEEL 90 the changing flag must be turned off. The partition has just changed states again.

2) State is stale

Read requests in the initial request policies must avoid the partition.

Write requests in the initial request policies will avoid the partition.

Write requests in the post request policies that are returned with an error must:

i) Remember that the PR failed. Since the changing state flag is not on, that is all the action necessary at this point. There is no need to send this request to the WHEEL 90 because the partition is already marked stale. This condition can happen because the partition was active when the request was handed off to the disk device driver, but by the time it returned another request had already failed, marked the partition stale via the VGSA WHEEL and returned from the WHEEL. Therefore, there is nothing for this request to do concerning stale PP processing.

3) State changing from active to stale.

Read requests in the initial request policies of Fig. 18 must avoid the partition altogether.

Write requests in the initial request policies of Fig. 18 must be issued to the disk drivers as if the partition was not changing states. The post request policies of Fig. 19 will handle the request when it is returned.

Write requests in the post request policies of Fig. 19 that are returned with an error must:

i) Remember that the PR failed.
ii) Hand the PR off to the VGSA WHEEL.
iii) When the PR is returned from the WHEEL the changing flag should have been turned off. This request can now proceed.

NOTE: Post request policies that find that a read request has failed just select another active partition and retry the read. Read errors do not usually cause data inconsistencies, but, as usual, there is one exception. There is a post request policy called fixup 100. This policy attempts to fix broken mirrors, i.e. ones that have had a read error. It fixes these broken mirrors by rewriting them once a successful read has been completed from another mirror. If the rewrite of a broken mirror fails this partition must be marked stale since it is now possible for the data to be inconsistent between the mirrors.

Configuration - Driver procedures

1) Partition created stale

When a LP that already contains valid data is horizontally extended, the resulting driver structures and the VGSA must indicate that the partition is stale. This means the VGSAs must all be updated before the configuration operation is considered complete. A more detailed procedure can be found in the VGSA discussion to follow.

i) Configuration routines set up the permanent state of each PP being allocated via the VGSA WHEEL. See the VGSA discussion for a more detailed breakdown of what must be done in this step.

ii) Configuration routines set up driver structures and link them into the existing driver information. If the partition is active it can he used immediately. If stale, it must be resynchronized before it will be used. This step should be done disabled to INTIODONE to inhibit any new requests from being scheduled while the configuration routines are moving driver structures around.

2) Reducing an active or stale partition

The procedure below will work for reducing both an active partition or a stale partition. It is very high level. A more detailed procedure can be found in the VGSA discussion.

i) The configuration routines set the state flag for each PP being reduced(removed) and initiates the update of the VGSAs. This is done via the configuration/VGSA WHEEL interface.
NOTE: This is not necessary if all PPs being reduced are already stale.

ii) With the state of each partition now stale and recorded permanently the LV must he drained. Draining the LV means waiting for all requests currently in the LV work queue to complete.
NOTE: This is not necessary if all PPs being reduced are already stale.

iii)Disabled to INTIODONE, the configuration routines may now remove the driver structures associated with the PPs being removed.

3) Stale PP resynchronization

Up to this point the discussion has centered on marking partitions stale. There is another side to this issue. How is the data made consistent between copies so all are available and active again? This operation is called a resync operation. The resynchronization of an entire LP is accomplished by an application process issuing, via the character device node of the LV, multiple resync requests starting at the beginning of the LP and proceeding sequentially to its end. This must be done by issuing readx system calls with the ext parameter equal to RESYNC_OP as defined in sys/lvdd.h. Each request must start on a logical track group(LTG) boundary and have a length of one LTG. A LTG is 128K bytes long. Therefore, to resynchronize a 1 MB LP a series of 8 of these requests would have to be made. After the 8th resync operation if there were no write errors in the partition by any operation, resync or normal write, the VGSA is updated to indicate that the newly synchronized partitions are now fresh and active.

Each resync request is made up of several physical operations. The first operation is a read and it is initiated by the initial request policy of Fig 18. The post request policy of RESYNCPP in Fig. 19 verifies that the read was done without errors. If an error is returned another active mirror is selected to read from. If there are no other active mirrors the resync request is returned with an error, and the resynchronization of the LP is aborted. It must be restarted from the beginning.

The next operation of the resync request is to write the data, just read, to any stale partitions using a sequential write type policy. If an error is returned the partition status is updated to indicate the partition has had a sync-error.

If all stale partitions have a status of sync-error the resynchronization of the LP is aborted. If all the LTGs of one PP are successfully resynchronized then that PP will change status from stale to active.

Following is a list of actions and decisions surrounding the resynchronization of a LP.

i) The synchronization of a LP is initiated by issuing a resync request at the first LTG in the partition and proceeding sequentially through the last LTG in the partition. The LP must have stale mirrors or this initial request will be returned with an error. The sync-error status of each PP will be cleared and the internal resync position(LTG number) maintained by the driver will be set to 0. This internal resync position is referred to as the sync track. A sync track value that is not 0xFFFF indicates that this LP is being resynchronized and what track is currently being done or was last done. There is a flag in the PP state field which qualifies the sync track value; it is called the Resync-In-Progress(RIP) flag. When the RIP flag is on, the sync track value represents the LTG currently being operated on. If the RIP flag is reset the sync track value represents the next LTG to he operated on. This is how the driver remembers the position of the resynchronization process and allows normal read/write operations to proceed concurrently with the resynchronization of the LP.

ii) A LTG will be resynced if the partition is stale and the sync-error flag is reset.

iii) Any write error in the LTG being resynced will cause that partition to have a status of sync-error. Writes in a LP that occur behind the sync track write to all PPs even though they may be stale. The exception to this is if the partition has the sync-error flag on. Consequently, any write errors cause the copies to be inconsistent again. Therefore, these write errors must turn on the sync-error flag to let the resynchronization process know that an error has occurred behind it in this partition.

iv) An individual resync request is considered successful if at least one of the LTGs currently being resynced completes with no errors.

v) If all stale partitions in a LP develop a status of sync-error the resynchronization of the LP is aborted. It must be restarted from the beginning of the LP.

Recovery of the VGSA at VG varyon time is addressed by the discussion of the VGSA and the VGSA WHEEL.

VOLUME GROUP STATUS AREA (VGSA)

Each physical partition(PP) in the volume group(VG) has two permanent states, active or stale. These states are maintained in the Status Area(VGSA). There is a copy of the VGSA on each PV in the VG, as shown in Fig. 15. Some PVs may have more than one copy. The VGSA copies on all PVs, along with a memory version, are maintained by software in the driver 64 that runs in the scheduler layer 66 in Fig. 13. This software accepts requests from the scheduling policies of Fig. 18 & Fig. 19 or the configuration routines to mark partitions stale or active. This software is called the WHEEL because of the way it controls and updates the active VGSAs in the VG. Refer to Fig. 16 for the following discussion on the WHEEL.

The basic object of the WHEEL is to ensure that all VGSAs in the VG are updated with the new state information for any given WHEEL request. It would be easy and relatively fast to issue write requests to all VGSAs at the same time. But, that would also be very dangerous since with that method it is possible to have a catastrophic error that would cause the loss of all VGSAs in the VG. That brings up the first of the general rules for the WHEEL.

General Rule 1)

Only one VGSA write can be in flight at a time.

Refer to Fig. 16. When a request is received by the WHEEL the memory version of the VGSA is updated as per the request. Then VGSA 1 is written. When it is complete a write to VGSA 2 is issued. This continues until VGSA 8 has been written. The WHEEL is now back at VGSA 1 where it started. Now the request is returned back to the normal flow of the driver, as shown in Fig. 19, so it can continue to its next step. The second general rule is:

General Rule 2)

A request cannot be returned until all VGSAs in the VG have been updated with that request's operation.

It should be obvious now why this is called the WHEEL. It should be equally obvious that any request on the WHEEL may stay there a while. In the above example the request had to wait for 8 complete disk operations. If a VG contained 32 PVs a request would have to wait for 32 disk operations. Now, assume while the request was waiting for the write to VGSA 1 to complete another request came in and wanted to update the VGSA. If the second request had to wait for the first request to get off of the WHEEL it would have to wait for 16 disk operations before it could continue. Eight disk operations for the first request and 8 for itself. This wait time could become quite large if the VG contained a large number of PVs. Luckily, the WHEEL has several conditions to reduce this wait.

The WHEEL manages the requests it receives so that no one request must wait, stay on the wheel if you will, longer than the time it takes to write the total number of VGSAs in the VG plus one. This is accomplished by allowing requests to get on the WHEEL between VGSA writes. A request then stays on the WHEEL until the WHEEL rolls back around to the position where the request got on the WHEEL. Once the WHEEL has been started it is said to be rolling. Once rolling it will continue to write the next VGSA until all VGSAs in the VG contain the same information regardless of how many requests get on and off the WHEEL or how many revolutions it takes. This is sometimes called free wheeling.

In reference to the above two request scenario, the following would happen. Request #1 comes in from the initial or post request policies, as shown in Figs. 18 and 19, and causes the WHEEL to start rolling by writing to VGSA 1. Request #2 comes in and waits for the write to VGSA 1 to complete. When that write is complete, request #2 updates the memory version of the VGSA. When that is done VGSA 2 is written. When that completes VGSA 3 is written. This continues until VGSA 1 is the next one to be written. At this point request #1 is returned to the normal flow of the driver 64 since all VGSAs reflect the status change requested by request #1. Now the write to VGSA 1 is started since that VGSA does not match the image of VGSA 8. When that write is complete request #2 is returned to the normal flow of the driver. This is done because the WHEEL has rotated back to the position where request #2 jumped on. Now, because VGSA 2, the next to be written, and VGSA 1, the last written, are identical the WHEEL stops. The next request will start the WHEEL at VGSA 2.

There is one other major WHEEL condition. It is called piggybacking. It is very likely, given the nature of disk drives, that several disk requests will fail in the same partition. This will result in all of them wanting to change the state of that partition. Depending on the length of time between these like failures it would be possible for these like state change requests to get on the WHEEL at various positions. That is where piggybacking comes in. Before a request is put on the WHEEL a check is made to see if a like request is already on the WHEEL. If one is found the new request is piggybacked to the one already there. When it comes time for the first request to get off of the WHEEL any piggybacked requests get off also. This allows the like state change requests to get off sooner and keeps the WHEEL from making any unnecessary writes.

This is not contradictory to the second general rule because it states that all VGSAs must have been updated with a request's information before it is returned. Piggybacking meets that requirement because all the piggybacked requests are doing the same thing. Therefore, they can all get off the WHEEL at the same position regardless of where they jumped on. However, the initial request policies and the post request policies must be aware of any PP that is changing states. Otherwise, they may return a request early believing a partition to be already marked stale when in fact there is a previous request on the WHEEL doing just that. This second request must be piggybacked to the one currently on the WHEEL. This additional intermediate state may be quite long, relatively. A PP is considered in a changing state from the time the decision is made to change states until the time that request gets off of the WHEEL. During that time any I/O requests that are targeted for a partition that is changing states must follow the rules stated in the stale PP processing discussion.

We have seen how the WHEEL handles individual PRs that are changing the state of a single partition. But, there is another major aspect to the partition state methodology. That is the configuration routines. These routines want to set the state of many partitions as the LV is extended or reduced while it is open and in use. To accomplish this there must be a mechanism available and procedures defined that allow the configuration routines to:

    i) pause the WHEEL if it is rolling;
    otherwise keep it from starting
    ii) set the state of multiple partitions
    iii) restart the WHEEL and wait for all the VGSAs
    to be updated

This all must be done in a way that maintains LV integrity during the life of the operation, even across system crashes.

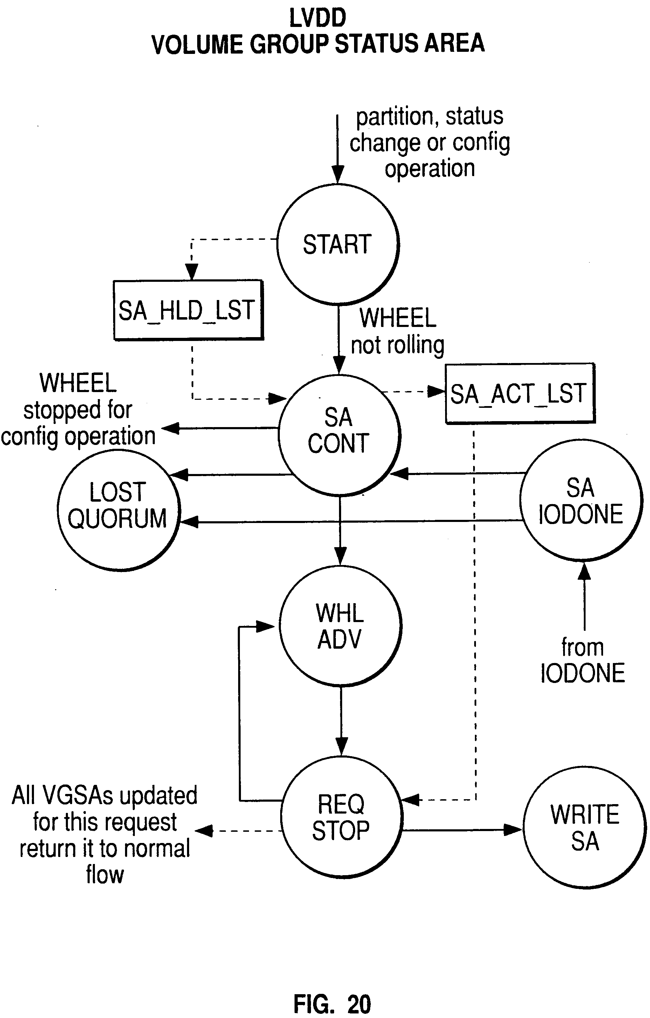

Refer now to Fig. 20 for the following WHEEL procedures.

Volume Group Status Area

START

Called to change the status of a partition. This can be caused by two different mechanisms. First, a write failure in a mirror logical partition, LP. Second, an existing LP is extended, made wider, and valid data exists in the original. In this case, the newly created partitions are stale in relationship to the original. START always puts any new request on the hold list, SA_HLD_LST. Then, if the wheel is not rolling, it will start it.

## SA CONT

This block has several responsibilities. First it checks to see if a configuration operation is pending. Since the VGSA wheel is free wheeling, once it is started, a configuration operation must wait until it, the wheel, gets to a stopping point before any changes can be made to the in-memory version of the VGSA. There is a stopping point for modifications between writes to the physical volumes. The wheel will not be started again until the update to the memory version of the VGSA by the configuration process is complete. Then the configuration process will restart the wheel. The second major function is to remove any requests on the holding list, SA_HLD_LST, scan the active list, SA_ACT_LST, for like operations. If a like operation is found, then associate this request with the previous one. This allows the new request to get off of the wheel at the same point as the request that is already on the active list. If no like operation is found on the active list, then update the memory version of the VGSA as per that request. If a loss of quorum(to be described hereafter) is detected, then flush all the requests that are on the wheel.

## WHL ADV

Advance the wheel to the next VGSA.

## REQ STOP

Starting at the head of the active list, SA_ACT_LST, check each request that has not just been put on the list. If this is the wheel position where the request was put on the wheel then remove it from the active list and return it to it's normal path. After the active list has been scanned for completed requests a check is made to see if the memory version of the VGSA has been written to the target VGSA on the PV. If the memory VGSA sequence number does not match the PV VGSA sequence number a write to the VGSA is initiated.
NOTE: Once the wheel is started it will continue to write VGSAs until the memory VGSA sequence number matches the PV VGSA that will be written next. Also, if the VGSA to be written next is on a PV that is missing the wheel will be advanced to the next VGSA and the active list is scanned again. When an active VGSA is finally found the wheel position of this VGSA is put in any new requests that were put on the active list by SA CONT. This indicates where they are to get off when the wheel comes back around to this position. Therefore, no request gets put on the wheel at an inactive VGSA. But, requests can get off at a position that has gone inactive while the request was on the wheel.

## WRITE SA

Builds request buffer and calls regular(Fig. 18), to write the VGSA to a PV.

## SA IODONE

The return point for the request generated by WRITE SA. If the write failed the PV is declared as missing and a quorum check is made. If a quorum is lost due to a write failure SA IODONE only sets a flag. The actual work of stopping the wheel and flushing the active list is done in SA CONT.

## LOST QUORUM

The volume group(VG) has lost a quorum of VGSAs. Sets flag to shutdown I/O through the VG. Return all requests on the wheel with errors.

Various modifications may be made in the details of the preferred embodiment described above.

Following are the high level procedures for the various configuration management functions used to maintain a VG when they interact with the WHEEL.

## EXTENDING A LV

When extending any LV, even when there are no mirrors in any LP, the permanent state must be initialized in the VGSA. There is a general assumption when extending a LV that any partition being allocated is not currently in use and that the VGDAs have not been updated to indicate this partition is now allocated. It is further assumed that the write of the VGDAs is near the end of the overall operation so that the LV maintains integrity if disaster recovery is needed. There are some conditions that can be implemented for this procedure and they will be mentioned.

    i) Get control of the WHEEL. That means if it is rolling, stop it. If it is not rolling, inhibit it from starting.
    ii) Modify the memory version of the VGSA.
    iii) Restart or start the WHEEL. Wait for it to complete one revolution.
NOTE: If the WHEEL was not rolling and there were no state changes in the memory version of the VGSA then there is no need to restart the WHEEL and wait for it to complete a revolution.
NOTE: If the WHEEL was rolling and there were no state changes in the memory version of the VGSA then restart the WHEEL but there is no need to wait for it to complete a revolution.
    iv) Disable to INTIODONE. Link the new partition structures into the driver hierarchy. Re-enable interrupt level. Read/write operations can now proceed on the PP if it is active.

NOTE: It is assumed the new partition structures contain the same permanent state as was just initialized in the VGSA.

## REDUCING A LV

Reducing an active LV must be done with care. In addition to the integrity issues that must be addressed there is the likelihood that there is I/O currently active in the PPs that are being removed.

i) Get control of the WHEEL. That means if it is rolling stop it. If it is not rolling inhibit it from starting.

ii) Disable to INTIODONE. For all LPs being reduced a check must be made to ensure that at least one active PP is left in the LP before the reduction of any LP can proceed. The only exception to this is if all PPs are being reduced from the LP, thereby eliminating it. If any LP will be left with no active PP, the entire reduce LV operation should fail. For each PP being reduced, turn on the reducing flag in its respective partition structure. Also, and this is a big also since it has to do with integrity in the face of disaster recovery, IF the PP is a member of a LP with multiple copies AND not all of the PPs of this LP are being removed, AND the PP being removed is not stale, THEN the changing and stale flags must be turned on also. IF the stale flag is turned on THEN the memory version of the VGSA must be updated also. THEN, re-enable the interrupt level.

This is somewhat complicated but must be done this way to ensure that a PP does not come back active after system crash if the VGDAs don't get updated before the crash and a write may have occurred in the LP before the crash. If all PPs of a LP are being removed then the reduce flag will keep any new requests out of the LP. Then if the system crashes the data will still be consistent between all copies upon recovery.

iii) IF the memory version of the VGSA was modified THEN start/restart the WHEEL AND wait for it to complete one revolution. IF the memory version of the VGSA was not modified THEN release the inhibit on the WHEEL and restart it if it was rolling when we started.

iv) Drain the LV. This means wait for all requests currently in the LV work queue to complete.

v) Disable to INTIODONE. Now remove the partition structures from the driver hierarchy for the PPs being removed. Re-enable interrupt level.

vi) The VGDAs can be written.

NOTE: If the VGDAs cannot be written and the reduce operation fails, the PPs will remain in their current state of reducing and/or removed from the driver hierarchy and, therefore, will not be available for I/O.

## ADDING A PV TO AN EXISTING VG

When a PV is added to the VG a VGSA on the PV must be added to the WHEEL. Since a PV that is being added cannot have any active PPs the activation of the VGSA becomes easy. The only real concern is disaster recovery and even that is simplified.

i) The configuration routines must initialize the disk VGSA that will be activated. The configuration routines have two options they can lay down a VGSA with a content of binary zeros or they can get the current image of the memory version of the VGSA via the IOCTL. The only critical issue is that the timestamps must be zero to insure that this new VGSA will not be used by varyonvg if the system crashes before adding the PV is complete.

ii) Get control of the WHEEL. That means if it is rolling stop it. If it is not rolling inhibit it from starting.

iii) Disable to INTIODONE. Insert physical volume structure into volume group structure.

IF the WHEEL was rolling THEN make it rotate at least back to the position just added. This may cause some extra writes to PVs that already have current VGSAs but, this will be so infrequent it should not cause any noticeable delays.

If the WHEEL was not rolling THEN re-position the WHEEL controls to the position just before the newly added position. This is so we won't spin the WHEEL one whole revolution. The controls should be set up to make the WHEEL believe the new position is the last position to be written on this revolution. This way only the new VGSA is written and all the others currently on the WHEEL are not rewritten with the same data they already have. Since the memory version of the VGSA has not changed due to the addition it is only important that the current version be written to the new disk. It is not important to rewrite the same information on all the other disk VGSAs.

iv) Re-enable to interrupt level.

Start/re-start the WHEEL.

NOTE: When the WHEEL stops or the requests from the configuration routines gets off the WHEEL the VGSA is now active and will be updated if a PP changes state. It is assumed the VGDAs will be written sometime after the VGSA is activated. Even if the writing of the VGDA on the new PV fails the VGSA will remain active unless there is a defined mechanism to come back down into the kernel part of LVM and remove it.

v) Increment the quorum count in the volume group structure.

## DELETING A PV FROM AN EXISTING VG

Deleting a VGSA from the WHEEL is probably the simplest operation of them all. This is due to the fact the PV has no active PPs.

i) The VGDAs should be updated to indicate the PV is no longer in the VG.

ii) Get control of the WHEEL. That means if it is rolling stop it. If it is not rolling inhibit it from starting.

iii) Disable to INTIODONE. Check the position of the WHEEL. If it is resting on the position to be removed then advance the controls and remove the physical volume structure from the volume group structure. If the WHEEL is rolling and the next position to be written is the position to be removed adjust the WHEEL controls to skip it then remove the physical volume structure from the volume group structure. If the WHEEL was not rolling or the position was not in any of the described situations then just remove the physical volume structure from the volume group structure.

iv) If the WHEEL was rolling then restart it. If it was not rolling then remove the inhibit.

There is no need to wait for one revolution of the WHEEL since no information in the VGSA has changed. This same procedure should be followed when deleting a PV with a status of missing.

## REACTIVATING A PV

Reactivating a PV really means a defined PV is changing states from missing to active. This will happen when a PV is returned or by a re-varyonvg operation. The same procedure that is used for adding a PV can be used here. It is mentioned here just to recognize that the condition exists and that it needs no special processing, outside the defined add PV procedure, to reactivate the VGSA.

## VARYING ON A VG

Varying on a VG is really a configuration and recovery operation as far as the WHEEL is concerned. Both of these are discussed later. But it is important to note at this point that the WHEEL should not become active until a regular LV has been opened in the VG. This means the WHEEL does not become active until after the varyonvg operation is complete.

## VARYING OFF A VG

There is only one way to varyoff a VG but, there are two modes, normal and forced. The only real difference between them should be that the forced mode sets the VGFORCED flag. This flag tells the driver this VG is being forcefully shutdown. A force off will stop any new I/O from being started. In addition the WHEEL will stop, if it is rolling, at the completion of the next VGSA write and return all requests on the WHEEL with errors. If it is not rolling it will be inhibited from starting. The same procedure should be followed for a normal varyoff but it should not encounter any problems. This is because a normal varyoff enforces a NO OPEN LV strategy in the VG before it continues. So, if there are no open LVs in the VG there can be no I/O in the VG. If there is no I/O in the VG the WHEEL cannot be rolling. Only one procedure has been designed to handle both instances.

i) If this is a normal varyoff then enforce NO OPEN LVs. If this is a force off then set the VGFORCED flag.

ii) Quiesce the VG. This will wait until all currently active requests have been returned. This really only applies to the force off mode since it may have I/O currently active in the VG.

NOTE: During this time any write requests that have failures in any mirrored LP partition will have to he returned with an error, even if one partition worked correctly. This is because the VGSA cannot be updated to indicate a PP is now stale. Because the VG is being forced off the mirror write consistency cache (described hereafter) has been frozen just like the VGSA. Therefore, the disk versions of the mirror write consistency cache remember that this write was active. Now, when the VG is varied back on, the mirror write consistency recovery operation will attempt to resynchronize any LTG that had a write outstanding when the VG was forced off. Since a mirror write consistency recovery operation just chooses a mirror to make the master, it may pick the one that failed at the time of the forced varyoff. If this is so, and it is readable, the data in that target area of the write will revert back to the state it was before the write. Therefore, an error is returned for a logical request that gets an error in any of its respective physical operations when the VG is being forced off and the VGSA cannot be updated to indicate a PP is now stale. See the discussion on mirror write consistency for more details concerning correctness versus consistency.

iii) The driver hierarchy for this VG can now be removed and the system resources returned to the system.

There are just a few more areas yet to cover concerning the VGSA. They are initial configuration, VGSA recovery, and, finally, a quorum of VGSAs. Initial configuration will be covered first.

The driver assumes the configuration routines will allocate memory for the memory copy of the VGSA and put a pointer to it in the volume group structure. The configuration routines will select a valid VGSA and load an image of the selected VGSA into that memory VGSA before any mirrored LVs are opened. In addition, there are several other fields in the volume group structure that will need to be initialized since there is a reserved buf structure and pbuf structure embedded in the volume group structure. These structures are reserved for VGSA I/O operations only.

This guarantees that there is a buf structure used by logical requests and a pbuf structure used by physical requests for any VGSA operation and therefore eliminates dead lock conditions possible if no pbuf structures were available from the general pool. The configuration routines also control what PVs have active VGSAs and where they are located on the PV. These fields are in the physical volume structure and must be set up also.

The next topic concerning the VGSA is its recovery and/or validity at VG varyon time. It is the configuration routines' responsibility to select a VGSA from the ones available on the PVs in the VG. This selection process is exactly like the selection process for selecting a valid VGDA. It uses the timestamps of Fig. 7 that are present at the beginning and end of the VGSA. Each time the memory version of the VGSA is changed, those timestamps are updated to reflect the system time. The configuration routines must select a VGSA where the beginning and ending timestamps match and they are later in time than any other VGSA available. It goes without saying that the entire VGSA must be read without errors. Once a VGSA is selected the configuration routines must use the state flags to initialize the driver partition structures. If the configuration routines find a VGSA that is out of date, relative to the selected one, or has read errors the configuration routines will rewrite(recover) the VGSA before the VG is allowed to have normal I/O activity. If the VGSA cannot be rewritten without errors the PV must not be used and declared missing.

The last VGSA issue to address is the quorum of VGSAs. Like the VGDAs there must be a quorum of VGSAs for the volume group to stay online. If a VGSA write fails, the PV is declared missing, and all active VGSAs on that PV are therefore missing also. At this time a count is made of all currently active VGSAs and if that count is below the quorum count set up by the configuration routines, the VG is forcefully taken offline. If the VG is forced offline all requests currently on the WHEEL are returned with an error(SIO) if they did not have an error already. The WHEEL is stopped and will not accept any new requests. In order to reactivate the VG it must be varied off and then varied back online.

For the enabling code which implements the WHEEL, see Fig. 21.

## MIRROR WRITE CONSISTENCY

By far the largest problem with any system that has multiple copies of the same data in different places is ensuring that those copies are mirror images of each other. In the preferred embodiment, with LVM there can be up to three copies of the same data stretched across one, two or even three physical volumes. So when any particular logical write is started it is almost guaranteed that from that point on the respective underlying copies will be inconsistent with each other if the system crashes before all copies have been written. Unfortunately, there is just no way to circumvent this problem given the nature of asynchronous disk operations. Fortunately, all is not lost since LVM does not return the logical request until all the underlying physical operations are complete. This includes any bad block relocation or stale PP processing. Therefore, the user cannot assume any particular write was successful until that write request is returned to him without any error flags on. Then, and only then can that user assume a read will read the data that was just written. What that means is, LVM will concentrate on data consistency between mirrors and not data correctness. Which in turn means, upon recovery after a system crash any data a logical write was writing when the system went down may or may not be reflected in the physical copies of the LP. LVM does guarantee that after a system crash the data between all active PPs of a LP will be consistent. It may be the old data or it may be the new data, but all copies will contain the same data. This is referred to as Mirror Write Consistency or MWC.

There is one restriction on the guarantee of consistency. The volume group cannot have been brought online without a quorum. The user has the ability to force a VG online even if a quorum of VGDAs and VGSAs are not available. If this forced quorum is used then the user accepts the fact that there may be data inconsistencies between copies of a LP.

Since the PPs may not be stale the normal resync could not be used. Alternatively, a simple function to read from the LP followed directly by a write to the same logical address would be sufficient to make all copies consistent. It could run in the background or foreground, but in either case it would be time consuming.

Mirror write consistency is accomplished by remembering that a write has started and where it is writing to. It is very critical to remember that the write was started and where it was writing but less critical when it completes. This information is remembered in the mirror write consistency cache or MWCC. So, if the system crashes, recovery of the PPs within the LPs being written becomes a function of interpreting the entries in the MWCC and issuing a mirror write consistency recovery(MWCR) I/O operation through the LV character device node to the affected area of the LP. These MWCR operations must be done before the LV is available for general I/O. The details of MWCC will now be described.

There is one MWCC per VG and it is made up of two parts. The first part, sometimes referred to as the disk part and sometimes just part 1, is the part that is written to the physical volumes. Therefore it is the part that is used to control the MWCR operations during recovery. Details of part 1 is discussed later. The second half of the MWCC is the memory part or part 2.

Part 2 of the MWCC is memory resident only. It comes into being when the VG is brought online. There are many aspects to controlling a cache such as hashing, ordering, freeing entries, etc, that have nothing to do with the recovery of the data in the mirrors and therefore does not need to be written to disk or permanent storage. That is why there are two parts to the MWCC. Part 1 or the disk part is written to the disk while part 2 is not. Each PV holds one copy of the MWCC. A more detailed breakdown of each part of the MWCC follows.

PART 1 - DISK PART

Part 1 of the MWCC is 512 bytes long, a disk block. PV disk block 2 is reserved for the copy. Part 1 has 3 basic parts.
i) A beginning timestamp
ii) Cache entries
iii) An ending timestamp
The timestamps are used during recovery to validate the MWCC and select the latest copy from all the available PVs in the VG. The timestamps are 8 bytes long each. There are 62 cache entries between the timestamps though they might not all be actively being used by the VG. The size of the active cacbe is variable between 1 and 62 entries. The size of the active cache is directly proportional to the length of time it will take to recover the VG after a system crash. This recovery time will be discussed later. The system is currently implemented to use 32 cache entries. Alternate embodiments could provide a command line option so it is tuneable.
Each part 1 cache entry has 2 fields.
i) Logical Track Group(LTG) number
The cache line size is a LTG or 128K bytes. It is aligned to LTG boundaries. For example, if the number of active cache entries in the MWCC were 32, there could be no more than 32 different LTGs being written to at any point in time in the VG.
ii) LV mirror number
The mirror number of the LV that the LTG belongs in.

PART 2 - MEMORY PART

Each part 2 entry of the MWCC is made of several fields. Since part 2 is memory resident it's size is not important here. It is important to know that there is a direct one to one correspondence with the cache entries of part 1. Therefore if there are 32 cache entries being used in part 1, part 2 has 32 entries also.
i) Hash queue pointer
Pointer to the next cache entry on this hash queue. Currently 8 hash queue anchors exist in the volume group structure.
ii) State flags

NO CHANGE - Cache entry has NOT changed since last cache write operation.
CHANGED - Cache entry has changed since last cache write operation.
CLEAN - Entry has not been used since the last clean up operation.
iii) Pointer to the corresponding part 1 entry
Pointer to the part 1 entry that corresponds to this part 2 entry.
iv) I/O count
A count of the number of active I/O requests in the LTG that this cache entry represents.
v) Pointer to next part 2 entry
Pointer to the next part 2 entry on the chain.
vi) Pointer to previous part 2 entry
Pointer to the previous part 2 entry on the chain.
It is important to know that there are two parts to each cache entry, but, from this point a reference to a cache entry means the entity formed by an entry from part 1 and the corresponding entry from part 2.

The concept of the MWCC is deceivingly simple, but the implementation and recovery is not. Part of this complexity is caused by the fact that a VG can be brought online without all of its PVs. In fact, after a system crash the VG can be brought online without PVs that were there when the system went down.

There are two major areas of discussion concerning the MWCC. There is the function of maintaining, updating, and writing the cache as the driver receives requests from the various system components. This is the front side of the operation. It is done so it is known what LTGs may be inconsistent at any one point in time. Then there is the backside of the operation. That is when there has been a system crash or non-orderly shutdown and the MWC caches that reside on the PVs must be used to make things consistent again. So for now the focus of this discussion will be on the front side of the operation, which also happens to be the first step.

The driver will allocate memory and initialize it for both parts of the cache when the first LV is opened in the VG. The driver assumes the MWCC that reside on the disks have already been used by the recovery process to make LTGs consistent and that those disk blocks can be written over without loss of data. The MWCR(mirror write consistency recover) operation is really a read followed by writes. Since the MWCC is watching for writes the MWCR operations done at varyon time slip by without modifying the disk copy of the MWCC.

As MWCC is an entity that must be managed as requests are received there is a Mirror Write Consistency Manager(MWCM). The MWCM sits logically at the top of the scheduler layer between the scheduler and the strategy layer. It does not have a whole layer by itself since it's only concern is with mirrored partition requests but it is easier to understand if you view it there.

As the initial request policies receive requests they will make some initial checks to see if the request should be handed off to the MWCM. Following is a list of conditions that would cause a request not to be handed off to the MWCM. This does not mean every request that does get handed off to the MWCM is cached. The term cached is used rather loosely here. A request is not cached in the classical sense but in the sense it must wait for information concerning it's operation to be written out to permanent storage before the request is allowed to continue. So the MWCM may return the request to the policy to indicate this request may proceed.

i) The request is a read.

ii) The LV options has the NO mirror write consistency flag turned on.

iii) The request specifically requests NO mirror write consistency via the ext parameter.

iv) There is only one active partition in this LP and no resync is in progress in the partition. That could mean there is only one copy or all the others are stale.

As mentioned earlier, each PV has a block reserved for the MWCC. But also mentioned was the fact that they may all be different. The memory image of the MWCC is a global view of the LTGs in the VG that have writes currently active. But, the disk copies of the MWCC are really only concerned with the information in the cache that concerns writes to LPs that have PPs on that PV. For any given logical write request the MWCC will be written to the PVs where the PPs are located for that logical write request.

As an example, if a LP has 3 copies, each on a different PV, a copy of the MWCC will be written to each PV before the actual data write is started. All the writes to the disk copies of the MWCC will be done in parallel. Even if one of the PPs is stale the MWCC on that disk must be written before the write is allowed to proceed on the active partitions. The MWCC must be written to PV with a stale mirror in case the PVs that contain the active mirrors are found to be missing during a varyon. Of course if a PV is missing the MWCC can not be written to it. This is more of a recovery issue and will be discussed later.

Once the MWCM receives a request there are several other test that have to be made before the final disposition of the request. The MWCM will do one of the following for each request:
NOTE: Remember these decisions are hased on the cache line size of a LTG or 128K and not the size of the physical partition. Also, the term cache here deals exclusively with the memory version and is therefore global to any LV in the VG.

IF (the target LTG is not in the cache) OR (the target LTG is in the cache AND it is changing) THEN
    i) Modify the cache - either add it to the cache or bump the I/O count
    ii) Move the cache entry to the head of the used list
    iii) Initiate writing the cache to the PVs if needed
    iv) Put the request on the queues waiting for cache writes to complete
    v) When all cache writes complete for this request then return the request to the scheduling policy
IF (the target LTG is in the cache AND it is not changing ) THEN
    i) Bump the I/O count
    ii) Move the cache entry to the head of the used list
    iii) Return the request to the scheduling policy

There are some exceptions to the above logic, however. Since the cache is a finite entity it is possible to fill it up. When that happens the request must go to a holding queue until a cache entry is available. Due to the asynchronous nature of the driver and lengthiness of disk I/O operations, which includes MWCC writes, a special feature was added to the disk drivers to help, but not eliminate, the problem. This feature allows the driver to tell the disk drivers to not HIDE the page. This means the driver can reference the MWCC even if the hardware is currently getting data from memory. Because of this the driver must take care to maintain hardware memory cache coherency while the MWCC is in flight to any PV.

Therefore, in the first test if either condition is true and the MWCC is in flight, being written, the request will have to go to a holding queue until the MWCC is no longer in flight. When the last MWCC write completes, i.e. the MWCC is no longer in flight, the requests on this holding queue can proceed through the MWCM. Remember, that the hardware will transfer the MWCC data to the adapter hardware buffer long before the actual write takes place. If the information in the cache is changed after this hardware transfer and before receiving an acknowledgment that the data has been written, then a window exists where what is acknowledged to be on the disk is different from what is really there. In this case, if the request continues, the disk version of the MWCC may or may not know that this write is active. This uncertainty can not be allowed.

In the first test if the second condition is true and the MWCC is in flight then some might wonder why not just bump the I/O count and put the request on a queue waiting for cache writes. This condition comes about because an earlier request has caused the entry to be put in the cache and it has started cache writes but all of them have not completed, as indicated by the changing state still being active. The problem is that when the first request started the cache writes, an association was make between it and all the PVs that needed to have their caches updated. At the point in time the second request enters the MWCM there is no way to know how many, if any, of these cache writes are complete. Therefore, it is not known how many associations to make for this second request so that it can proceed when those cache writes are complete. So, this request is put on the cache hold queue also. This does not cause the request to lose much time because when all the cache writes are complete this hold queue is looked at again. When this is done, this request will get a cache it and proceed immediately to be scheduled.

In the above 2 test conditions, a statement indicated the cache entry would be moved to the head of the list. As with all cache systems, there is an algorithm for handling the things in the cache. The MWCC uses a Most Recently Used/Least Recently Used(MRU/LRU) algorithm. When the MWCC is initialized the cache entries are linked together via pointers in part 2. These pointers refer to the next and previous cache entry. This is a doubly linked circular list with an anchor in the volume group structure. The anchor points to the first cache entry or the most recently used or modified. That entries next pointer points to the entry modified before the first one. This goes on until you get to the last entry in the cache, the least recently used or modified, and its next pointer points back to the first entry, i.e. the same one the anchor points to. Now the previous pointer does the same thing but in reverse. So, the first entries previous pointer points to the last entry in the list, i.e. the least recently used entry.

By using this type of mechanism several things are gained. First there is no free list. When a cache entry is needed the last one (LRU) on the list is taken. If its I/O count is non-zero, then scan the cache entries, via the LRU chain, to find an entry with a zero I/O count. If none are found the cache is full. This eliminates the need for counters to maintain the number of entries currently in use.

Note, however, that when the I/O count is non-zero in the LRU entry, the cache cannot be assumed to be full. Although the LRU entry is known to have been in the cache the longest, that is all that is known. If a system has multiple disk adapters or the disk drivers do head optimizations on their queues the requests may come back in any order. Therefore, a request that may have been started after the LRU entry could finish before the LRU requests, thereby making a cache entry available in the middle of the LRU chain. It is therefore desirable to have a variable that would count the number of times a write request had to hold due to the cache being full.

If the MWCM is scanning the hold queue when the cache fills up, the MWCM should continue to scan the hold queue looking for any requests that may be in the same LTG as any requests just added from the hold queue. If any are found they can be removed from the hold queue and moved to the cache write waiting queue after incrementing the appropriate I/O count.

As mentioned earlier, there are hash queue anchors(8) in the volume group structure. In order to reduce cache search time, the entries are hashed onto these anchors by the LTG of the request. This hashing is accomplished by methods commonly known in the prior art. The entries on any particular hash queue are forwardly link via a hash pointer in part 2 of the cache entry.

There are certain times when a cache clean up operation should be done. The most obvious is at LV close time. At that time the cache should be scanned for entries with a zero I/O count. When an entry is found, it should be cleared and moved to the end of the LRU chain. Once the entire cache has been scanned, the PVs that this entry belongs to should also be written. Another time for a cache cleanup operation might be at the request of system management via an IOCTL.

One other thing deserves to be mentioned here. What if the MWCC block on the disk goes bad due to a media defect? The MWCM will attempt to do a hardware relocation of that block if this condition is found. If that relocation fails or an non-media type error is encountered on a MWCC write, the PV is declared missing.

## MWCC RECOVERY

We now know how the front side of the MWCC works. Remember the whole purpose of the MWCC is to leave enough bread crumbs lying around so that in the event of a system crash the mirrored LTGs that had write requests active can be found and made consistent. This discussion will focus on the backside of the MWCC or the recovery issues.

Recovery will be done only with the initial varyon operation. This is due to the need to inhibit normal user I/O in the VG while the recovery operations are in progress.

The recovery operations are the very last phase of the VG varyon operation. This is because the entire VG must be up and configured into the kernel before any I/O can take place, even in recovery operations where care must be taken to not allow normal I/O in the VG until all the LTGs in flight have been made consistent.

The first step in the recovery process is selecting the latest MWCC from all the PVs available. Once this is done, the recovery of the LTGs in the selected MWCC becomes a simple task of issuing mirror write consistency recovery(MWCR) I/O requests to the LVs/LPs/LTGs that have an entry in the cache. This method is referred to as the fast path method because, the maximum number of recovery operations is limited to the size of the MWCC. This in effect sets what the maximum recovery time for the VG is. In other words, using the selected MWCC do recovery on the LTG(s) if the parent LP has more than one non-stale PP copy.

During these MWCR requests, if a mirror has a write failure or is on a missing PV it will be marked stale by the driver, via the WHEEL.

Missing PVs do not add time to the recovery operation at varyon time, but it may make mirrors stale that will need to be resynchronized later when the PVs come back online. There are 3 types of missing PVs. The first type is previously missing PVs, which are the PVs that are marked as missing in the VGSA. These previously missing PVs could have been missing at the last varyon, or the driver could have found and declared them missing while the VG was online. It makes no difference. The second type of missing PVs is the newly found missing PVs. These PVs were found by the varyon operation to be not available at this time, but the PV status in the VGSA indicates they were online the last time the VG was online. This could be caused by the drive or adapter failure that caused a loss of quorum and the VG was forcefully taken offline. Another cause of newly found missing PVs is when the PV was not included in the list of PVs to varyon when the varyonvg command was issued. There is one other way for a PV to fall into the newly found missing category, and that is when the MWCC cannot be read due to a read error of any kind, but the PV does respond to VGDA reads and writes.

The previously missing PVs and the newly found missing PVs are combined into the final type of missing PVs, the currently missing PVs. The currently missing PVs are the ones of importance to the current discussion. After the first phase of the recovery scenario, i.e. select a MWCC from the available PVs and do fast path recovery, the second phase is done. The second phase is done only if there are any currently missing PVs.

Actual recovery of LTGs on missing PVs may be impossible for a couple of reasons. The biggest of these reasons is the PV is missing and therefore will not accept any I/O. Another concern of missing PVs is when all copies of a LP/LTG are wholly contained on the missing PVs. This is a problem because there is no information about these LTGs available to the recovery process. It is not known if write I/O was in flight to these LPs/LTGs.

Therefore, it must be assumed there was I/O outstanding and the recovery process must do the right thing to insure data consistency when the PVs are brought back online. The correct thing to do in this case is mark all but one non-stale mirror stale, i.e., for each LP in the VG, if the LP is wholly contained on the currently missing PVs, then mark all but one of the mirrors stale. When the PVs come back online the effected LPs will have to be resynchronized.

A data storage system has been described which has an improved system throughput.

A storage hierarchy for managing a data storage system has also been described.

A method of improved system throughput in a computer system where multiple copies of data are stored to aid in error recovery has also been described.

cribed.

**Claims**

1. A method for managing a plurality of data storage devices associated with a computer system and having a first physical volume and subsequent physical volumes and being partitioned into one or more logical volumes, each of said logical volumes being further partitioned into one or more logical partitions each of which comprises one or more physical partitions of said storage devices, said method comprising the steps of:

    determining status information for each of said physical partitions and recording said status information in a memory of said computer system;

    recording said status information in a status area existing on each of said data storage devices;

    creating updated status information when a write request is generated for any of said physical partitions;

    updating said status area on said first physical volume with said updated status information; and

    updating said status area of each subsequent physical volume within said storage devices in succession with said updated status information, wherein if a second or subsequent write request is received prior to completing an update of each of said storage device status areas as a result of a prior write request, said status information is updated in said computer memory and used in updating said next succeeding physical volume status area.

2. A method as claimed in claim 1 wherein each of said physical partitions corresponding to a given logical partition contains duplicate data information.

3. A method as claimed in claim 2 wherein if a subsequent request to change status information is received prior to completing an update of each of said storage device status areas as a result of a prior status change, said subsequent status change is recorded while recording status information resulting from said prior status change.

4. A computer system including means for managing a plurality of data storage devices associated with said computer system and having a first physical volume and subsequent physical volumes and being partitioned into one or more logical volumes, each of said logical volumes being further partitioned into one or more logical partitions each of which comprises one or more physical partitions of said data storage devices, said managing means comprising:

means for maintaining status information for each of said physical partitions in a memory of said computer system;

recording means for recording said status information in a status area existing on each of said data storage devices;

means for creating updated status information when a write request is generated for any of said physical partitions;

first update means for updating said status area on said first physical volume with said updated status information; and

subsequent update means for updating said status area of each subsequent physical volume within said data storage devices in succession with said updated status information, wherein if a second or subsequent write request is received prior to completing an update of each of said data storage device status areas as a result of a prior write request, said status information is updated in said computer memory and used in updating said next succeeding physical volume status area.

| APPLICATIONS | 22 |
| --- | --- |
| APPLICATION DEVELOPMENT PRODUCTS | 23 |
| KERNEL | 24 |

11

PROCESSOR 12

MEMORY MANAGER UNIT 13

SYSTEM RAM 14

15

10

I/O CHANNEL CONTROLLER 16

DISPLAY TERMINAL 18

CO-PROCESSOR 19

21

DISK DRIVE 17

OTHER I/O 20

FIG. 1

/ | (ROOT)

00A

00B  00C  00D  00E

00A2  00A1

00D1  00D2  00D3  00D4

00A21  00A22

00D42  00D41

DIRECTORY FILES ARE NOT UNDERLINED

**FIG. 2**

MOTOR
32

17

CARRIAGE 38

ACTUATOR 37

ADDRESS 36

35

36

30
31
33
34

**FIG. 3**

31 ⌐ 32

| DISK | DISK | DISK | DISK | DISK | DISK | DISK | DISK | DISK |

33 ⌐ SURFACE 1 | SURFACE 2 ⌐ 34

| TRACK 0 | TRACK 1 | TRACK 2 | TRACK 3 | ◄──────► | TRACK N |

42  42  42  42  42

| SECTOR 1 | SECTOR 2 | ◄──────► | SECTOR N |

41  41  41

| BYTE 1 | BYTE 2 | ◄──────► | BYTE N |

40  40  40

**FIG. 4**

| RESERVED AREA |
| LOGICAL VOLUME MGR AREA |
| USER AREA |
| BAD BLOCK POOL |

**FIG. 5**

## Logical Volume Mgr Area

| 8 blks | ◄── 64 blks ──► |

| VGSA | VGDA | vgsa | vgda |

VGSA = Volume Group Status Area (Primary Copy)
VGDA = Volume Group Data Area (Primary Copy)
vgsa = Volume Group Status Area (Secondary Copy)
vgda = Volume Group Data Area (Secondary Copy)

**FIG. 6**

EP 0 482 853 A2

| Beginning Timestamp | PV$_0$ State Flags | PV$_1$ State Flags | PV$_2$ State Flags | • • • | PV$_n$ State Flags | Unused | Ending Timestamp |
|---|---|---|---|---|---|---|---|

←— 127 bytes

|←— 8 bytes

8 bytes —→|

←——————————————— 4096 bytes ———————————————→

PV = Physical Volume

**FIG. 7**

| Header | Logical Volume Entries | Physical Volume Information | Name List | Trailer |
|---|---|---|---|---|

←— 512 bytes

512 bytes —→|

| PV$_0$ Header | PP$_0$ Entries | PV$_1$ Header | PP$_1$ Entries | • • • | PV$_n$ Header | PP$_n$ Entries |
|---|---|---|---|---|---|---|

**FIG. 8**

**FIG. 9**

**FIG. 13**

Logical Volume

Physical Partitions

FIG. 14

Physical Partitions

Volume Group

Physical Volumes

FIG. 15

28

The WHEEL

FIG. 16

**PBUF Structure**

Field Length
(# Bytes)

| | |
|---|---|
| flags | 4 |
| pointers<br>•<br>• | 4 each |
| iodone | 4 |
| •<br>•<br>• | |
| device # | 4 |
| disk block # | 4 |
| memory address | 4 |
| transfer count | 4 |
| error type | 1 |
| residual transfer count | 4 |
| ptr to original request | 4 |
| ptr to scheduling routine | 4 |
| mirror | 1 |
| mirror avoid | 1 |
| mirror bad | 1 |
| mirror done | 1 |
| SWretry | 1 |
| type | 1 |
| bad block operation | 1 |
| bad block status | 1 |
| wheel stop | 1 |
| •<br>• | |

FIG. 17

Flags - Basic information - READ/WRITE, Buffer Busy, Error Indicator.

Pointers - Used to link these PBUFs onto various chains to control the flow.

IODONE - PTR to a function to hand the PBUF to when request is complete, i. e. the lower level disk device drivers call the function pointed to by this field to return the request back to LVM when they are finished with the request.

Device - Physical Device where the transfer will be done.

Disk block # - Disk Block # where the transfer is to start from.

Memory Address - Memory Address where the data is to be transferred to or from.

Xfercount - Number of bytes to transfer. In the case of LVM this must be a multiple of disk blocks (512 bytes).

Error Type - When the error indicator is on (True) in the flags field. This field indicates the type of error. Example Media Error, Invalid Request ... .

Residual Xfercount - If an error occurred on a Xfer. This field contains the number of bytes that were NOT transferred.

PTR to Original Request - LVM receives requests from layers above the strategy layer. These logical requests are translated into one or more physical requests (PBUFs). When all physical requests for a given logical request are complete the logical requests can be returned to its originator. This is a backward link to the originating logical request.

PTR to Scheduling Routine - Physical Requests are returned from the disk drivers, via the IODONE field, to the physical

**FIG. 17a**

layer of LVM. The physical layer has responsibility for bad block processing. If the request is finished the physical layer will return the request to the scheduling layer via this pointer. The scheduling layer makes decisions concerning what must be done next to compute the logical request.

Mirror - Mirror number associated with this PBUF, 0, 1, or 2.

Mirror Avoid - Bit mask (3 bits) indicating which mirrors are to be avoided or not used to satisfy the logical request, i. e. the mirror is broken, or on a physical volume that is not available.

Mirror Bad - Bit mask (3 bits) that indicate which mirrors have had failures or are broken.

Mirror Done - Bit mask (3 bits) that indicate which mirrors have completed the transfer.

SW Retry - Software Retry count; how many times this block has had a software relocation attempted, 1 or 2.

Type - Type of PBUF, used in error processing by the WHEEL and Bad Block Processing. Tells the WHEEL if this is a Make Stale PP Request, Mark PV Missing, or Make PP Fresh.

Bad Block Operation - Used to control updating the bad Block directory that reside in the reserved area of all physical volumes.

WHEEL Stop - The position this PBUF is to get off of the WHEEL when it is on the WHEEL.

## FIG. 17b

## LVDD SCHEDULER
### INITIAL REQUEST POLICY

From
STRATEGY
layer

PENDING_Q
ibuf

to
VGSA WHEEL 90

REGULAR
120

SEQUENT
122

PARALLEL
124

AVOID
126

To
PHYSICAL
layer 67

From
PHYSICAL
layer 108

To
PHYSICAL
layer
TRANSLATION & RELOCATION
CHECKING & INITIATION
106

Continue to schedule requests
until the PENDING_Q is empty
or until the free pbuf pool is
empty.   Then call the PHYS
layer to start any physical
requests.

FIG.  18

**LVDD SCHEDULER**
POST REQUEST POLICY

FIG. 19

# LVDD
# VOLUME GROUP STATUS AREA

partition, status
change or config
operation

START

SA_HLD_LST

WHEEL
not rolling

WHEEL
stopped for
config operation

SA_ACT_LST

SA
CONT

LOST
QUORUM

SA
IODONE

WHL
ADV

from
IODONE

All VGSAs updated
for this request
return it to normal
flow

REQ
STOP

WRITE
SA

## FIG. 20

```
/*    VGSA. H    */

#ifndef _H_VGSA
#define _H_VGSA

/*
 * COMPONENT_NAME: (SYSXLVM) Logical Volume Manager Device Driver - vgsa.h
 *
 *
 *
 *
 */


#include < sys/param.h >
#include < sys/dasd.h >

/*
 * LVDD internal macros and defines used by Volume Group Status
 * Area(VGSA) logic
 */

#define      RTN_ERR              1          /* Return requests from the VGSA*/
                                             /* wheel with ENXIO errors      */
#define      RTN_NORM     0          /* Return requests from the VGSA*/
                                             /* wheel without explicitly   */
                                             /* turning on the B_ERROR flag */

#define      VGSA_BLK     8          /* VGSA length in disk blocks         */
#define      VGSA_SIZE    (VGSA_BLK * DBSIZE) /* VGSA length in bytes     */
#define      VGSA_BT_PV   127     /* VGSA bytes per PV                    */

/*
 * This structure limits the number of Physical Partitions(PP) that can be
 * present in the VG to 32,512.  The stalepp portion is divided equally
 * between the 32 possible PVs of the VG.  This gives each PV 127 bytes
 * or 1016 PPs.
 *
 */
```

FIG. 21-1

```
struct vgsa_area {

    struct timestruc_t   b_tmstamp;           /* Beginning time stamp        */
                    /* Bit per PV        */
        ulong           pv_missingff[(MAXPVS + (NBPL - 1)) / NBPL];
                    /* Stale PP bits   */
        uchar           staleppff[MAXPVS]ff[VGSA_BT_PV];
        char            pad2ff[12]; /* Padding        */
        struct timestruc_t    e_tmstamp;          /* Ending time stamp           */
};

/*
 * Macros used to set/clear/test pv_missing and stalepp bits in a vgsa_area
 * struct.  The ptr argument is assumed to be a ptr to the vgsa_area
 * structure.  All other arguments are assumed to be zero relative.
 * This allows LVM library functions to use these macros.
 *
 * NOTE these macros will not work if the max number of PVs per VG is
 * greater than 32.
 */

#define     SETSA_PVMISS(Ptr, Pvnum)    \
            ((Ptr)-> pv_missingff[(Pvnum)/NBPL] |= (1 < < (Pvnum)))
#define     CLRSA_PVMISS(Ptr, Pvnum)    \
            ((Ptr)-> pv_missingff[(Pvnum)/NBPL] &= (~(1 < < (Pvnum))))
#define     TSTSA_PVMISS(Ptr, Pvnum)    \
            ((Ptr)-> pv_missingff[(Pvnum)/NBPL] & (1 < < (Pvnum)))

#define     SETSA_STLPP(Ptr, Pvnum, Pp) \
            ((Ptr)-> staleppff[(Pvnum)]ff[(Pp)/NBPB] |= (1 < < ((Pp) % NBPB)))

#define     CLRSA_STLPP(Ptr, Pvnum, Pp)    \
            ((Ptr)-> staleppff[(Pvnum)]ff[(Pp)/NBPB] &= (~(1 < < ((Pp) % NBPB))))

#define     XORSA_STLPP(Ptr, Pvnum, Pp)    \
            ((Ptr)-> staleppff[(Pvnum)]ff[(Pp)/NBPB] ¬ = (1 < < ((Pp) % NBPB)))
```

FIG. 21-2

```
#define       TSTSA_STLPP(Ptr, Pvnum, Pp) \
              ((Ptr)-> staleppff[(Pvnum)]ff[(Pp)/NBPB] &= (1 < < ((Pp) % NBPB)))
/*
 * Macros used to set/retrieve the logical sector number and sequence number
 * associated with each VGSA.
 */

#define       GETSA_LSN(Vg, Idx)        \
              ((Vg-> pvolsff[(Idx) > > 1]-> sa_areaff[(Idx)&1].lsn)

#define       SETSA_LSN(Vg, Idx, Newlsn)        \
              ((Vg-> pvolsff[(Idx) > > 1]-> sa_areaff[(Idx)&1].lsn = (Newlsn))

#define       GETSA_SEQ(Vg, Idx)        \
              ((Vg-> pvolsff[(Idx) > > 1]-> sa_areaff[(Idx)&1].sa_seq_num)

#define       SETSA_SEQ(Vg, Idx, Seq)        \
              ((((Vg-> pvolsff[(Idx) > > 1]-> sa_areaff[(Idx)&1].sa_seq_num) = (Seq))

#define       NUKESA(Vg, Idx)        \
              ((Vg-> pvolsff[(Idx) > > 1]-> sa_areaff[(Idx)&1].nukesa)

#define       SET_NUKESA(Vg, Idx, Flag)        \
              ((Vg-> pvolsff[(Idx) > > 1]-> sa_areaff[(Idx)&1].nukesa = (Flag))

/*
 * The following structures are used by the config routines to pass
 * information to the hd_sa_config() function for stale/fresh PP and
 * install/delete PV processing.  A pointer to an array of these
 * structures is passed as an argument.
 */

/*
 * An array of these structures is terminated with both the pvnum and pp
 * equalling -1.
 */
```

**FIG. 21-3**

```
struct cnfg_pp_state{
    short     pvnum;              /* PV number the PP is on           */
    short     pp;          /* PP number to mark stale/fresh */
    int         ppstate;   /* state to mark PP stale/fresh */
};


/*
 * passed in as arg when a CNFG_EXT request is done.
 */
struct sa_ext{
    struct lvol *klv_ptr;          /* ptr to lvol struct being extended */
    short     nparts;              /* number of copies of the lv */
    char      isched;              /* scheduling policy for the lv */
    char      res;        /* padding */
    ulong     nblocks;   /* length in blocks of the lv */
    struct part **new_parts;      /* ptr to new part struct list */
    int              old_numlps;       /* old number of logical partitions on lv */
    int         old_nparts;    /* previous number of partitions on lv */
    int         error          /* error to return to library layer */
    struct cnfg_pp_state *vgsa;     /* ptr to pp info structure */
};


/*
 * passed in as arg when a CNFG_RED request is done
 */


struct sa_red {
    struct lvol *lv;          /* ptr to lvol struct being reduced */
    short     nparts;              /* number of copies of the lv */
    char            isched;              /* scheduling policy for the lv */
    char      res;        /* reserved area */
    ulong     nblocks;   /* length in blocks of the lv */
    struct part        **newparts;       /* ptr to new part struct list */
    unsigned short min_num;    /* minor number of logical volume */
    int         numlps;        /* number of lps on lv after reduction */
    int         numred;        /* number of pps being reduced */
```

FIG. 21-4

39

```
        int         error;                  /* error to return to library layer */
        struct extred_part *list;      /* list of pps to reduce */
};


/*
 * install PV information for VGSA config routine
 */
struct confg_pv_ins{
        struct pvol *    pvol;       /* PV to install or remove        */
        short            qrmcnt:          /* new VG quorum count          */
        short            pv_idx;          /* index into vg's pvol array        */
};


/*
 * delete PV information for VGSA config routine.  Also used for remove PV
 * and missing PV. (qrmcnt will not be used for missing PV)
 */
struct cnfg_pv_del {
        struct pvol *    pv_ptr; /* pointer to pvol struct to remove */
        struct part *    lp_ptr; /* pointer to DALV's LP struct to zero */
        short            lpsize; /* size of DALV's LP */
        short            qrment; /* VG's new quorum cnt once this PV is deleted */
};


/*
 * information to add/delete a VGSA from a PV
 */
struct confg_pv_vgsa {
        struct pvol *    pv_ptr; /* pointer to pvol struct to remove */
        daddr_t                  sa_lsnsff[2]; /* LSNs for VGSAs added or 0 if deleted or
                                        if a copy not being added */
        short            qrment; /* VG's new quorum cnt once this PV is deleted */
};


/*
 * The following defines are used by the VGSA write operations. These
 * defines indicate what action the pbuf is requesting.  It is stored
```

FIG. 21-5

```
 * in the pb_type field of the pbuf.
 */
#define      SA_PVMISSING     1    /* PV missing type pbuf              */
#define      SA_STALEPP   2    /* Stale PP type pbuf           */
#define      SA_FRESHPP   3    /* Fresh PP type pbuf           */
#define      SA_CONFIGOP      4    /* hd_config function type pbuf   */
#define      SA_PVREMOVED   5    /* PV removed type pbuf        */

/*
 *The following defines are used by the config routines to set up
 * the cnfg_pp_state fields
 */


#define STALEPP        1
#define FRESHPP        0
#define CNFG_STOP        -1
#define CNFG_NEWCOPY        -1


#endif /* _H_VGSA */



/*       LIBLVM.H
 *
 * COMPONENT_NAME: (liblvm) Logical Volume Manager
 *
 * © COPYRIGHT International Business Machines Corp. 1988, 1990
 * All Rights Reserved
 *
 */

  #ifndef _H_LIBLVM
  #define _H_LIBLVM

  #include < lvm.h >
  #include < sys/dasd.h >
  #include < sys/bootrecord.h >

  #ifndef TRUE
```

FIG. 21-6

```
#define TRUE            1
#endif
#ifndef FALSE
#define FALSE           0
#endif

#ifndef NULL
#define NULL            ((void *) 0)
#endif
```

```
/*
 * Error codes used internally by the library.  These are not returned
 * to the user.  NOTE that these values start at 500 so they will not
 * conflict with the error values in lvm.h which are returned to the
 * user.
 */
```

```
#define LVM_BBRDERR     -500    /* read error on bad block directory  */
#define LVM_BBWRERR     -501    /* write error on bad block directory  */
#define LVM_PVRDRELOC   -502     /* put PV in read only relocation      */
#define LVM_BBINSANE    -503    /* bad block directory is not sane    */
```

```
/*
 * General defines
 */
```

```
#define LOCK_ALL        0
#define CHECK_MAJ       1
#define NOCHECK         0
#define FIRST_INDEX     0
#define SEC_INDEX       1
#define THIRD_INDEX     2
#define NO_COPIES       0
#define ONE_COPY        1
#define LVM_FNAME       72
```

FIG. 21-7

42

```
#define LVM_NOLPSYET        0
#define LVM_REDUCE     1
#define LVM_EXTEND     2
#define LVM_FIRST      1
#define LVM_SEC      2
#define LVM_THIRD      3
#define LVM_LASTPV      0
#define LVM_CASEGEN     1
#define LVM_CASE2TO1     2
#define LVM_CASE3TO2     3
#define LVM_GETSTALE     1
#define LVM_NOSTALE     2
#define LVM_PVNAME     1
#define LVM_VGNAME     2
#define LVM_LVDDNAME        "hd_pin"
#define LVM_KMIDFILE "/etc/vg/lvdd_kmid"
#define LVM_STREAMRD        "r"
#define LVM_STREAMWR        "w"
#define MAPNOTOPEN     -1          /* Mapped file is not open*/


/*
 * GENERAL LV VALUES
 */
#define LVM_INITIAL_LPNUM 0




#define LVM_LVMID        0x5F4C564D /* LVM id field = "_LVM" */
#define LVM_SLASH        0x2F      /* hex value for ASCII slash */
#define LVM_NULLCHAR        '\0'      /* null character */
#define LVM_DEV       "/dev/"   /* concatenate to device names */
/*
#define LVM_EXTNAME     (sizeof (LVN_NAMESIZ) + sizeof(LVM_DEV) + 1)
*/

            /* size of extended device names */
#define LVM_EXTNAME     72
```

<p style="text-align:center"><strong>FIG. 21-8</strong></p>

```
#define LVM_ETCVG        "/etc/vg/vg"
                         /* concatenate to VG id for map filename */
#define LVM_RELOC_LEN   256      /* length in blocks of BB reloc pool */
#define LVM_RELOCMASK   0x8       /* mask value to check BB relocation */
#define LVM_FROMBEGIN   0        /* seek value is offset from beginning */
#define LVM_NOVGDALSN   -1        /* no desc LSN defined for this entry */
#define LVM_FILENOTOPN  -1       /* file is not currently open */
#define LVM_WRITEDA    1        /*write VGDA for this PV */
#define LVM_DALVMINOR   0       /* minor number of descriptor area LV */
#define LVM_PRMRY   0        /* index for primary VGDA/VGSA LSN */
#define LVM_SCNDRY   1        /* index for secondary VGDA/VGSA LSN */
#define LVM_MAPFPERM   0664      /* permissions for open of mapped file */
#define LVM_1STPV    1        /* PV number of first physical volume */
#define LVM_BEGMIDEND   0       /* write order of beginning/middle/end */
#define LVM_MIDBEGEND   1       /* write order of middle/beginning/end */
#define LVM_ZEROETS   2       /* zero end timestamp, then write b/m/e */
#define LVM_GREATER   1       /* first timestamp greater than second */
#define LVM_EQUAL   2       /* first timestamp equals second */
#define LVM_LESS   3       /* first timestamp less than second */
#define LVM_TSRDERR   4       /* read error on timestamp */
#define LVM_BTSEQETS   LVM_EQUAL       /* begin timestamp = end ts */
#define LVM_BTSGTETS   LVM_GREATER       /* begin timestamp > end ts */
#define LVM_DAPVS_TTL1   1      /* total of 1 PV with VGDA copies */
#define LVM_TTLDAS_1PV   2      /* total number VGDA copies on 1 PV */
#define LVM_DAPVS_TTL2   2      /* total of 2 PVs with VGDA copies */
#define LVM_TTLDAS_2PV   3      /* total number VGDA copies on 2 PVs */
#define LVM_DASPERPVGEN   1       /* number VGDAs per PV for general case */
#define LVM_BBCHGRBLK   1       /* change relocation block of bad block */
#define LVM_BBCHGSTAT   2       /* change status field of bad block */
#define LVM_STRCMPEQ   0       /* string compare result of equal */
#define LVM_BBRDONLY   1       /* read a bad block directory */
#define LVM_BBRDINIT   2       /* read and initialize a bad block directory */
#define LVM_BBRDRECV   3       /* read and recover bad block directories */
#define LVM_BBPRIM   1       /* use the primary bad block directory */
#define LVM_BBBACK   2       /* use the backup bad block directory */
/*
 * Macros
 */
```

FIG.  21-9

44

```
#define LVM_SIZTOBBND(Size)  ((((Size) + DBSIZE - 1) / DBSIZE) * DBSIZE)

#define LVM_BBDIRLEN(Bb_hdr) (LVM_SIZTOBBND(sizeof(struct bb_hdr) + \
        (Bb_hdr->num_entries * sizeof(struct bb_entry))))

#define LVM_MAPFN(Mapfn, Vgid) \
        (sprintf ((Mapfn), "%s%8.8X%8.8X", LVM_ETCVG,       \
                (Vgid) -> word1, (Vgid) -> word2))

#define LVM_BUILDNAME(name,maj,min) \
        (sprintf((name),"%s%c%c%s%d%c%d",LVM_DEV,'_','_',"pv",(maj),'.',(min)))

#define LVM_BUILDVGNAME(name,maj) \
        (sprintf((name),"%s%c%c%s%d",LVM_DEV,'_','_',"vg",(maj)))

#define LVM_PPLENBLKS(Ppsize)  (1 << ((Ppsize) - DBSHIFT))

#define LVM_PSNFSTPP(Lvmareastart, Lvmarealen)         \
        (TRK2BLK (BLK2TRK (Lvmareastart + Lvmarealen - 1) + 1))


/*
 * The following is the file header structure that gives indexes and
 * general information about the volume group descriptor area  structures
 */

struct da_info {
    daddr_t dalsn;          /* logical sector number of VGDA copy */
    struct timestruc_t ts;  /* timestamp of this VGDA copy */
    };

struct fheader {
    long vginx;         /* byte offset for vg header */
    long lvinx;         /* byte offset for lv entries */
    long pvinx;         /* byte offset for pv entries */
    long endpvs;         /* byte offset for end of last PV entry */
    long name_inx;        /* offset for the name area */
    long trailinx;        /* byte offset for the vg trailer */
```

## FIG. 21-10

```
    long major_num;        /* major number of volume group */
    long vgda_len;         /* length in blocks of the VGDA */
    char vgnameff[LVM_NAMESIZ]; /* name of volume group */
    long quorum_cnt;       /* number of vgdas needed for varyon */
    long pad1;             /* pad */
    short int num_desclps; /* number of LPs per PV for the VGDA LV */
    struct pvinfo {
       char pvnameff[LVM_NAMESIZ]; /* PV name */
       struct unique_id pv_id;  /* id of physical volume */
       long pvinx;            /* byte offset to PV header */
       dev_t device;         /* major/minor number */
       short pad2;            /* pad */
       short pad3;            /* pad */
       struct da_info da ff[LVM_PVMAXVGDAS]; /* info on this VGDA copy */
       } pvinfoff[LVM_MAXPVS]; /* information about each PV */
};


/* II.Volume Group Descriptor Area */

struct vg_header
{
    struct timestruc_t    vg_timestamp; /* time of last update */
    struct unique_id      vg_id;      /* unique id for volume group */
    short       numlvs;        /* number of lvs in vg */
    short       maxlvs;        /* max number of lvs allowed in vg */
    short       pp_size;      /* size of pps in the vg */
    short       numpvs;        /* number of pvs in the vg */
    short       total_vgdas; /* number of copies of vg */
                    /* descriptor area on disk */
    short       vgda_size;   /* size of volume group descriptor */
                    /* area */
};
```

FIG. 21-11

```
struct lv_entries
{
      short       lvname;      /* name of LV */
      short       res1;        /* reserved area */
      long        maxsize      /* maximum number of partitions allowed */
      char        lv_state;    /* state of logical volume */
      char        mirror;      /*none,single, or double */
      short       mirror_policy; /* type of writing used to write */
      long        num_lps;     /* number of logical partitions on the lv */
                               /* base 1 */
      char        permissions;      /* read write or read only */
      char        bb_relocation; /* specifies if bad block */
                               /* relocation is desired */
      char        write_verify;  /* verify all writes to the LV */
      char        mirwrt_consist; /* mirror write consistency flag */
      long        res3;     /* reserved area on disk */
      double      res4;        /* reserved area on disk */
};


struct pv_header
{
      struct unique_id   pv_id;    /* unique identifier of PV */
      unsigned short     pp_count;  /* number of physical partitions */
                               /* on PV */
      char               pv_state; /* state of physical volume */
      char               res1;       /* reserved area on disk */
      daddr_t            psn_part1; /* physical sector number of lst  pp */
      short              pvnum_vgdas; /* number of vg descriptor areas */
                               /* on the physical volume*/
      short              pv_num;   /* PV number */
      long               res2;     /* reserved area on disk */
};

struct pp_entries
{
```

**FIG. 21-12**

```
        short       lv_index;      /* index to lv pp is on */
        short       res_1;         /* reserved area on disk */
        long        lp_num;        /* log. part. number */
        char        copy;          /* the copy of the logical partition */
                                   /* that this pp is allocated for */
        char        pp_state;   /* current state of pp */
        char        fst_alt_vol;/* pv where partition allocation for*/
                                   /* first mirror begins */
        char        snd_alt_vol;/* pv where partition allocation for*/
                                   /* second mirror begins */
        short       fst_alt_part;/* partition to begin first mirror */
        short       snd_alt_part; /* partition to begin second mirror */
        double      res_3;         /* reserved area on disk */
        double      res_4;         /* reserved area on disk */
    };

struct namelist
{
    char    nameff[LVM_MAXLVS]ff[LVM_NAMESIZ];
};

struct vg_trailer
{
        struct timestruc_t  timestamp;  /* time of last update */
        double              res_1;      /* reserved area on disk */
        double              res_2;      /* reserved area on disk */
        double              res_3;      /* reserved area on disk */
};



/*
 * The following structures are used in lvm_varyonvg
 */

struct da_sa_info
```

FIG. 21-13

```
/* structure to contain timestamp information about a
    volume group descriptor or status area */
{
struct timestruc_t ts_beg;
/* beginning timestamp value */
struct timestruc_t ts_end;
/* ending timestamp value */
short int ts_status;
/* indicates if read error on either timestamp, or if both good
    indicates if beginning ts equal or greater than ending ts */
short int wrt_order;
/* indicates order in which to write this VGDA or VGSA copy */
short int wrt_status;
/* indicates whether this VGDA or VGSA copy is to be written */
};

struct inpvs_info
    /* information structure for PVs in the user's input list */
    {
    struct
            {
            int fd;
              /* file descriptor for open of physical disk */
            struct unique_id pv_id;
              /* the unique id for this physical volume */
            dev_t device;
              /* the major/minor number of the physical volume */
            daddr_t da_psn ff[LVM_PVMAXVGDAS];
                /* physical sector number (PSN) of beginning of the
                    volume group descriptor area (primary and secondary
                    copies), or 0 if none /*
            daddr_t sa_psn ff[LVM_PVMAXVGDAS];
                /* PSN of beginning of the volume group status area
                    (primary and secondary copies), or 0 if none /*
            daddr_t reloc_psn;
                /* PSN of the beginning of the bad block relocation
                    pool */
```

FIG. 21-14

```
        long reloc_len;
            /* the length in blocks of the bad block relocation
                pool */
        short int pv_num;
            /* the number of the physical volume */
        short int pv_status;
            /* status of the physical volume */
#define LVM_NOTVLDPV    0    /* non valid physical volume */
#define LVM_VALIDPV     1    /* valid physical volume */
        struct da_sa_info da ff[LVM_PVMAXVGDAS];
            /* array of structures to contain timestamp information
                about VGDAs on one PV /*
        short int index_newestda;
            /* index of VGDA copy on PV which has newest timestamp /*
        short int index_nextda;
            /* index of VGDA copy on PV which is next written */
        } pv ff[LVM_MAXPVS];
            /* array of physical volumes, indexed by order in input
                parameter list */
    long lvmarea_len;
    /* the length of the entire LVM reserved area on disk */
    long vgda_len;
    /* length of the volume group descriptor area */
    long vgsa_len;
    /* length of the volume group status area */
    short int num_desclps;
    /* the number of logical partitions per PV needed for the
        descriptor / status area logical volume /*
    short int pp_size;
    /* the size of a physical partition for this volume group */
    };

struct mwc_info
    /* structure to contain timestamp information about a mirror
        write cache area */
    {
    struct timestruc_t ts;
```

FIG. 21-15

```
        /* timestamp value */
       short int good_mwcc;
        /* flag which indicates if the MWCC could not be read */
       short int wrt_status;
        /* indicates whether this MWCC is to be written */
       };

struct defpvs_info
       /* information structure for PVs defined into the kernel */
       {
       struct
              {
              short int in_index;
               /* corresponding index into the input PV information
                   structure for this PV */
              short int pv_status;
               /* indicates if this PV is defined into the kernel */
#define LVM_NOTDFND     0    /* this PV not defined in kernel */
#define LVM_DEFINED     1    /* this PV defined in kernel */
              struct da_sa_info saff[LVM_PVMAXVGDAS];
               /* array of structures to contain timestamp information
                   about VGSAs on one PV */
              struct mwc_info mwc;
               /* structure to contain information about the mirror
                   write consistency cache on this PV */
              } pv ff[LVM_MAXPVS];
               /* array of physical volumes indexed by PV number */
       int total_vgdas;
        /* total number of volume group descriptor/status areas */
       struct timestruc_t newest_dats;
        /* newest good timestamp for the volume group descriptor area */
       struct timestruc_t newest_sats;
        /* newest good timestamp for the volume group status area */
       struct timestruc_t newest_mwcts;
        /* timestamp for newest mirror write consistency cach */
       };
```

FIG. 21-16

51

```
/*
 * Function declarations
 */

#ifndef _NO_PROTO

/*
 * bbdirutl.c
 */

int lvm_bbdsane (
char * buf);
  /* buffer containing the directory to check */

int lvm_getbbdir (
int pv_fd,
  /* the file descriptor for this physical volume device */
char * buf,
  /* a buffer into which the bad block directory will be read */
int dir_flg);
  /* flags to indicate which directory to read */

int lvm_rdbbdir (
int pv_fd,
  /* the file descriptor for this physical volume device */
char * buf,
  /* a buffer into which the bad block directory will be read */
int act_flg);
  /* flag to indicate type of action requested */
int lvm_wrbbdir (
int pv_fd,
  /* the file descriptor for this physical volume device */
char * bbdir_buf,
  /* a buffer containing the bad block directory */
int dir_flg);
```

FIG. 21-17

/* flags to indicate which directory to write */


```
/*
 * bblstutl.c
 */


void lvm_addbb (
struct bad_blk ** head_ptr,
    /* a pointer to the pointer to the head of the bad block linked list    */
struct bad_blk * bb_ptr);
    /* pointer to the bad block structure which is to be added to the
        list */


int lvm_bldbblst (
int pv_fd,
    /* the file descriptor for this physical volume device */
struct pvol * pvol_ptr,
    /* a pointer to a structure which describes a physical volume for the
        logical volume device driver (LVDD) */
daddr_t reloc_psn);
    /* the physical sector number of the beginning of the bad block
        relocation pool */


void lvm chgbb (
struct bad_blk * head_ptr,
    /* a pointer to the head of the bad block linked list */
daddr_t bad_blk,
    /* the bad block whose data is to be changed */
daddr_t reloc_blk,
    /* the new value for the relocation block, if it is to be changed */
int chgtype);
    /* type of change requested (change relocation block or status field)
        for this bad block   */


/*
```

FIG. 21-18

```
* chkquorum.c
*/

int lvm_chkquorum (
struct varyonvg * varyonvg,
    /* pointer to the structure which contains input parameter data for
      the lvm_varyonvg routine */
int vg_fd,
    /* the file descriptor for the volume group reserved area logical
      volume */
struct inpvs_info * inpvs_info,
    /* structure which contains information about the input list of PVs
      for the volume group */
struct defpvs_info * defpvs_info,
    /* structure which contains information about volume group descriptor
      areas and status areas for the defined PVs in the volume group */
caddr_t vgda_ptr,
    /* pointer to the volume group descriptor area */
struct vgsa_area **vgsa_ptr,
    /* pointer to the volume group status area */
daddr_t vgsa_lsn ff[LVM_MAXPVS] ff[LVM_PVMAXVGDAS],
    /* array in which to store the logical sector number addresses of the
      VGSAs for each PV */
char mwcc ff[DBSIZE]);
    /* buffer in which the latest mirror write consistency cache will be
      returned */


int lvm_vgsamwcc (
int vg_fd,
    /* file descriptor for the VG reserved area logical volume which
      contains the volume group descriptor area and status area */
struct inpvs_info * inpvs_info,
    /* structure which contains information about the input list of PVs for
      the volume group*/
struct defpvs_info * defpvs_info,
    /* pointer to structure which contains information about PVs defined
      into the kernel */
```

FIG. 21-19

```
caddr_t vgda_ptr,
   /* pointer to the volume group descriptor area */
long quorum,
   /* number of VGDAs/VGSAs needed to varyon in order to  ensure that the
      volume group data is consistent with that from previous varyon      */
struct vgsa_area ** vgsa_ptr,
   /* variable to contain the pointer to the buffer which will contain
      the volume group status area */
daddr_t vgsa_lsn ff[LVM_MAXPVS] ff[LVM_PVMAXVGDAS],
   /* array in which to store the logical sector number addresses of  the
      VGSAs for each PV */
char mwcc ff[DBSIZE]);
   /* buffer in which the latest mirror write consistency cache will be
      returned */



/*
 * comutl.c
 */

int lvm_chkvaryon (
struct unique_id * vg_id);
   /* the id of the volume group */

void lvm_mapoff (
struct fheader * mapfilehdr,
   /* a pointer to the mapped file header which contains the offsets of
      the different data areas within the mapped file */
caddr_t vgda_ptr);
   /* a pointer to the beginning of the volume group descriptor area      */

int lvm_openmap (
struct unique_id * vg_id,
   /* a pointer to the volume group id */
int mapf_mode,
   /* the access mode with which to open the mapped file */
```

FIG. 21-20

```
int * vgmap_fd,
  /* pointer to the variable in which to return the file descriptor of the
    mapped file */
caddr_t * vgmap_ptr);
  /* pointer to the variable in which to return the pointer to the
    beginning of the mapped file */


int lvm_relocmwcc(
int pv_fd,
  /* file descriptor of physical volume where block containing the mirror
    write consistency cache needs to be relocated */
char mwcc ff[DBSIZE]);
  /* buffer which contains data to be written to mirror write consistency
    cache */


int lvm_rdiplrec (
int pv_fd,
  /* the file descriptor for the physical volume device */
IPL_REC_PTR ipl_rec);
  /* a pointer to the buffer into which the IPL record will be read */


int lvm_tscomp (
struct timestruc_t * ts1,
  /* first timestamp value */
struct timestruc_t * ts2);
  /* second timestamp value */


int lvm_updtime (
struct timestruc_t * beg_time,
  /* a pointer to the beginning timestamp to be updated */
struct timestruc_t * end_time);
  /* a pointer to the ending timestamp to be updated */



/*
 * crtinsutl.c
 */
```

FIG. 21-21

```
int lvm_initbbdir (
int pv_fd,
  /* the file descriptor for the physical volume device */
daddr_t reloc_psn);
  /* the physical sector number of the beginning of the bad block
    relocation pool */

void lvm_initlvmrec (
struct lvm_rec * lvm_rec,
  /* pointer to the LVM information record */
short int vgda_size,
  /* the length of the volume group descriptor area in blocks */
short int ppsize,
  /*physical partition size represented as a power of 2 */
long data_capacity);
  /* the data capacity of the disk in number of blocks */
int lvm_instsetup (
struct unique_id * vg_id,
  /* pointer to id of the volume group into which the PV is to be
    installed */
char * pv_name,
  /* a pointer to the name of the physical volume to be added to the
    volume group */
short int override,
  /* flag for which a true value indicates to override a VG member  error,
    if it occurs, and install the physical volume into the indicated
    volume group */
struct unique_id * cur_vg_id,
  /* structure in which to return the volume group id, if this PV's
    LVM record indicates it is already a member of a volume group   */
int * pv_fd,
  /* a pointer to where the file descriptor for the physical volume
    device will be stored */
IPL_REC_PTR ipl_rec,
  /* a pointer to the block into which the IPL record will be read */
struct lvm_rec * lvm_ rec,
```

**FIG. 21-22**

```
/* a pointer to the block into which the LVM information record  will
    be read */
long * data_capacity);
  /* the data capacity of the disk in number of sectors */

void lvm_pventry (
struct unique_id * pv_id,
  /* pointer to a structure which contains id for the physical volume  for
    which the entry is to be created */
struct vg_header * vghdr_ptr,
  /* a pointer to the volume group header of the descriptor area */
struct pv_header ** pv_ptr;
  /* a pointer to the beginning of the list of physical volume entries
    in the descriptor area */
long num_parts,
  /* the number of partitions available on this physical volume */
daddr_t beg_psn,
  /* the physical sector number of the first physical partition on this
    physical volume */
short int num_vgdas);
  /* the number of volume group descriptor areas which are to be  placed
    on this physical volume */

int lvm_vgdas3to3 (
int lv_fd,
  /* the file descriptor of the LVM reserved area logical volume */
caddr_t vgmap_ptr,
  /* pointer to the beginning of the mapped file */
short int new_pv,
  /* the PV number of the new physical volume which is being added */
short int save_pv_2;
  /* the PV number of the physical volume which previously had two copies
    of the VGDA */
short int save_pv_1);
  /* the PV number of the physical volume which previously had  one copy
    of the VGDA */
```

## FIG.  21-23

```
int lvm_vgmem (
struct unique_id * pv_id,
    /* pointer to id of the physical volume for which we are to  determine
       membership in the specified VG */
caddr_t vgda_ptr);
    /* pointer to the beginning of the volume group descriptor area */


int lvm_zeroomwc (
int pv_fd,
    /* the file descriptor of the physical volume */
short int newvg);
    /* flag to indicate if this is newly created volume group */


int lvm_zerosa (
int lv_fd,
    /* the file descriptor for the LVM reserved area logical volume */
daddr_t sa_lsn ff[LVM_PVMAXVGDAS]);
    /* the logical sector numbers within the LVM reserved area  logical
       volume of where to initialize the copies of the volume group  status
       area */




/*
 * configutl.c
 */

int lvm_addmpv (
struct unique_id * vg_id,
    /* the volume group id of the volume group which is to be added  into
       the kernel */
long vg_major,
    /* the major number where the volume group is to be added */
short int pv_num);
    /* number of the PV to be deleted from the volume group */


int lvm_addpv (
long partlen_blks,
```

FIG. 21-24

```
    /* the length of a partition in number of 512 byte blocks */
short int num_desclps,
    /* the number of partitions needed on each physical volume to contain
      the LVM reserved area */
dev_t device,
    /* the major / minor number of the device */
int pv_fd,
    /* the file descriptor of the physical volume device */
short int pv_num,
    /* the index number for this physical volume */
long vg_major,
    /* the major number of the volume group */
struct unique_id * vg_id,
    /* the volume group id of the volume group to which the physical
      volume is to be added */
daddr_t reloc_psn,
    /* the physical sector number of the beginning of the bad block
      relocation pool */
long reloc_len,
    /*  the length of the bad block relocation pool */
daddr_t psn_part1,
    /* the physical sector number of the first partition on the physical
      volume */
daddr_t vgsa_lsnff[LVM_PVMAXVGDAS],
short int quorum_cnt);
    /* the number of VGDAs/VGSAs needed for a quorum */


int lvm_chgqrm (
struct unique_id * vg_id,
    /* the volume group id of the volume group */
long vg_major,
    /* the major number of the volume group */
short int quorum_cnt);
    /* number of VGDA/VGSA copies needed for a quorum */


int lvm_chgvgsa (
```

FIG. 21-25

```
struct unique _id * vg_id,
   /* the volume group id */
long vg_major,
   /* the major number of the volume group */
daddr_t vgsa_lsn ff[LVM_PVMAXVGDAS],
   /* array of logical sector number addresses of the VGSA copies  on this
      PV */
short int pv_num,
   /* number of the PV which is to have changes to the number of  VGSAs */
short int quorum_cnt,
   /* number of VGDAs/VGSAs needed for a quorum */
int command);
   /* command value which indicates the config routine to be called  is
·     that for adding/deleting VGSAs */


int lvm_chkvgstat (
struct varyonvg * varyonvg,
   /* pointer to the structure which contains input information for
      varyonvg */
int * vgstatus);
   /* pointer to variable to contain the varied on status of the  volume
      group */


int lvm_config (
mid_t kmid,
   /* the module id for the object module which contains the logical
      volume device driver */
long vg_major,
   /* the major number of the volume group */
int request,
   /* the request for the configuration routine to be called within the
      kernel hd_config routine */
struct ddi_info * cfgdata);
   /* structure to contain the input parameters for the configuration
      device driver */


int lvm_defvg (
```

FIG.  21-26

```
long partlen_blks,
   /* the length of a partition in number of 512 byte blocks */
short int num_desclps,
   /* the number of partitions needed on each physical volume to contain
      the LVM reserved area */
mid_t kmid,
   /* the module id which identifies where the LVDD code is loaded   */
long vg_major,
   /* the major number where the volume group is to be added */
struct unique_id * vg_id,
   /* the volume group id of the volume group which is to be added into
      the kernel */
short int ppsize,
   /* the physical partition size, represented as a power of 2 of the
      size in bytes, for partitions in this volume group */


long noopen_lvs);
   /* flag to indicate if logical volumes in the volume group are not
      allowed to be opened */


int lvm_delpv (
struct unique_id * vg_id,
   /* the volume group id of the volume group which is to be added into
    the kernel */
long vg_major,
   /* the major number where the volume group is to be added */
short int pv_num,
   /* number of the PV to be deleted from the volume group */
short int num_desclps,
   /* number of logical partitions in the descriptor / status area
      logical volume for this PV */
int flag,
   /* flag to indicate whether the PV is being deleted from the  volume
      group or just temporarily removed */
short int quorum_cnt);
   /* quorum count of logical volume */
```

FIG. 21-27

```
void lvm_delvg (
struct unique_id * vg_id,
  /* the volume group id of the volume group which is to be added  into
     the kernel */
long vg_major);
  /* the major number where the volume group is to be added */



/*
 * lvmrecutl.c
 */


void lvm_cmplvmrec(
struct unique_id *vgid,        /* pointer to volume group id */
char        *match,             /* indicates a matching vgid */
char      pvnameff[LVM_NAMESIZ]); /* name of pv to read lvm rec from */

int lvm_rdlvmrec (
int pv_fd,
  /* the file descriptor for the physical volume device */
struct lvm_rec * lvm_rec);
  /* a pointer to the buffer into which the LVM information record  will
     be read */
int lvm_wrlvmrec (
int pv_fd,
  /* the file descriptor for the physical volume device */
struct lvm_rec * lvm_rec);
  /* a pointer to the buffer which contains the LVM information  record
to be written */

void lvm_zerolvm (
int pv_fd);
  /* the file descriptor for the physical volume device */


/*
```

FIG. 21-28

63

```
 * queryutl.c
 */


extern int lvm_chklvclos (
struct lv_id * lv_id,
  /* logical volume id */
long major_num);
  /* major number of volume group */


extern int lvm_getpvda (
char * pv_name,
  /* a pointer to the name of the physical volume to be added to  the
     volume group */
char ** map_ptr,
  /* a pointer to where the pointer to the memory area containing the
     mapped file information will be stored */
int rebuild);
  /* indicates we are rebuilding the vg file */


extern int lvm_gettsinfo(
int    pvfd,       /* file descriptor for physical volume */
daddr_t psnff[LVM_PVMAXVGDAS],
             /* array of physical sector numbers for VGDAS */
long    vgdalen,
             /* length of volume group descriptor area */
int     *copy, /* copy of VGDA with newest timestamp */
int     rebuild);
             /* indicates we are rebuilding the vg file */



/*
 * rdex_com.c
 */


extern int rdex_proc(
struct lv_id    *lv_id,    /*logical volume id */
struct ext_redlv *ext_red,    /* maps of pps to be extended or  reduced */
```

FIG. 21-29

64

```
char        *vgfptr,     /* pointer to volume group mapped file */
int         vgfd,         /* volume group file descriptor */
short       minor_num,    /* minor number of logical volume */
int         indicator);   /* indicator for extend or reduce operation   */


/*
 * revaryon.c
 */


int lvm_revaryon (
struct varyonvg * varyonvg,
   /* pointer to a structure which contains the input information for
      the lvm_varyonvg subroutine */
int vgmap_fd,
   /* the file descriptor for the mapped file */
struct inpvs_info * inpvs_info,
   /* a pointer to the structure which contains information about PVs
      from the input list */
struct defpvs_info * defpvs_info);
   /* structure which contains information about volume group descriptor
      areas and status areas for the defined PVs in the volume group */


int lvm_vonmisspv (
struct varyonvg * varyonvg,
   /* pointer to a structure which contains the input information for
      the lvm_varyonvg subroutine */
struct inpvs_info * inpvs_info,
   /* a pointer to the structure which contains information about PVs
      from the input list */
struct defpvs_info * defpvs_info,
   /* structure which contains information about volume group descriptor
      areas and status areas for the defined PVs in the volume group */
struct fheader * maphdr_ptr,
   /* pointer to the mapped file header */
caddr_t vgda_ptr,
   /* pointer to the beginning of the volume group descriptor area */
struct pv_header * pv_ptr,
```

FIG. 21-30

```
   /* a pointer to the header of a physical volume entry in the volume
      group descriptor area */
int vg_fd,
   /* the file descriptor for the volume group reserved area logical
      volume */
short int in_index,
   /* index into the input list of a physical volume */
int * chkvvgout);
   /* flag to indicate if the varyonvg output structure should be
      checked */


/*
 * setupvg.c
 */

int lvm_setupvg (
struct varyonvg * varyonvg,
   /*pointer to the structure which contains input information for
      varyonvg */
struct inpvs_info* inpvs_info,
   /* a pointer to the structure which contains information about PVs
      from the input list */
struct defpvs_info * defpvs_info,
   /* pointer to the structure which contains information about the physical
      volumes defined into the kernel */
struct fheader * maphdr_ptr,
   /* a pointer to the file header portion of the mapped file */
int vg_fd,
   /* file descriptor of the volume group reserved area logical volume */
caddr_t vgda_ptr,
   /* a pointer to the in-memory copy of the volume group descriptor
      area */
struct vgsa_area * vgsa_ptr,
   /* a pointer to the volume group status area */
daddr_t vgsa_lsn ff[LVM_MAXPVS] ff[LVM_PVMAXVGDAS],
   /* array of logical sector number addresses of all VGSA copies */
```

FIG. 21-31

66

struct mwc_rec * mwcc);
 /* buffer which contains latest mirror write consistency cache */

int lvm_bldklvlp (
caddr_t vgda_ptr,
 /* a pointer to the volume group descriptor area */
struct vgsa_area * vgsa_ptr,
 /* a pointer to the volume group status area */
struct lvol * lvol_ptrs ff[LVM_MAXLVS]);
 /* array of pointers to the LVDD logical volume structures */

int lvm_mwcinfo (
struct varyonvg * varyonvg,
 /* pointer to the structure which contains input information for
   varyonvg */
struct inpvs_info * inpvs_info,
 /* a pointer to the structure which contains information about PVs
   from the input list */
struct defpvs_info * defpvs_info,
 /* pointer to structure which contains information about the physical
   volumes defined into the kernel */
struct fheader * maphdr_ptr,
 /* a pointer to the file header portion of the mapped file */
int vg_fd,
 /* file descriptor of the volume group reserved area logical volume */
caddr_t vgda_ptr,
 /* a pointer to the volume group descriptor area */
struct vgsa_area * vgsa_ptr,
 /* a pointer to the volume group status area */
daddr_t vgsa_lsn ff[LVM_MAXPVS] ff[LVM_PVMAXVGDAS],
 /* array of logical sector number addresses of all VGSA copies */
struct lvol * lvol_ptrs ff[LVM_MAXLVS],
 /* array of pointers to LVDD logical structures */
struct mwc_rec * mwcc,
 /* buffer which contains latest mirror write consistency cache */
struct mwc_rec * kmwcc,
 /* buffer to contain list of logical track groups from the MWCC which

FIG. 21-32

```
        need to be resynced in the kernel */
short int * num_entries);
    /* number of logical track group entries in the kernel MWCC buffer */



/*
 * synclp.c
 */


extern int synclp(
    int             lvfd,        /* logical volume file descriptor */
    struct lv_entries *lv,       /* pointer to logical volume entry */
    struct unique_id   *vg_id,   /* volume group id */
    char               *vgptr,   /* pointer to the volume group mapped file /*
    int                vgfd,     /* volume group mapped file descriptor */
    short              minor_num, /* minor number of the logical volume */
    long               lpnum,    /* logical partition number to sync */
    int                force);   /* resync any non-stale lp if TRUE */



/*
 * utilities.c
 */


extern int get_lvinfo(
    struct lv_id    *lv_id,    /* logical volume id */
    struct unique_id *vg_id,   /* volume group id */
    short            *minor num, /* logical volume minor number */
    int              *vgfd,    /* volume group file descriptor */
    char             **vgptr,  /* pointer to volume group mapped file */
    int              mode);    /* how to open the vg mapped file */

extern int get_ptrs(
    char *vgmptr,              /* pointer to the beginning of the volume   */
                              /* group mapped file */
    struct fheader **header,   /* points to the file header */
    struct vg_header **vgptr,  /* points to the volume group header */
```

FIG. 21-33

```
struct lv_entries **lvptr, /* points to the logical volume entries */
struct pv_header **pvptr,  /* points to the physical volume header    */
struct pp_entries **pp_ptr,     /* points to the physical partition entries */
struct namelist **nameptr);      /* points to the name descriptor area */


extern int lvm_errors(
  char    failing_rtnff[LVM_NAMESIZ],           /* name of routine with error */
  char    calling_rtnff[LVM_NAMESIZ],           /* name of calling routine */
  int     rc);                       /* error returned from failing rtn */


extern int get_pvandpp(
  struct pv_header  **pv,            /* pointer to the physical volume header */
  struct pp_entries **pp,            /* pointer to the physical partition entry */
  short             *pvnum,          /* pv number of physical volume id sent in */
  char              *vgfptr,         /* pointer to the volume group mapped file */
  struct unique_id  *id);            /* id of pv you need a pointer to */


extern int bldlvinfo(
  struct logview    **lp,            /* pointer to logical view of a logical vol */
  char              *vgfptr,         /* pointer to volume group mapped file */
  struct lv_entries *lv,             /* pointer to a logical volume */
  long              *cnt,            /* number of pps per copy of logical volume */
  short             minor_num,       /* minor number of logical volume */
  int               flag);           /* GETSTALE if info on stale pps is desired */
                                     /* NOSTALE if not */


extern int status_chk(
  char    *vgptr,          /* pointer to volume group mapped file */
  char    *name,           /* name of device to be checked */
  int     flag,            /* indicator to check the major number */
  char    *rawname);       /* pointer to new raw device name */


extern int lvm_special_3to2(
  char              *pvname,
                                     /* name of physical volume being removed */
  struct unique_id  *vgid,
                                     /* pointer to volume group id */
  int               lvfd,
```

FIG. 21-34

```
                                    /* reserved area logical volume file desc */
char               *vgdaptr
                                    /* pointer to vgda area of the vg file */
short              pvnum0, /* number of pv to delete/remove */
short              pvnum1, /* number of pv to keep one copy */
short              pvnum2, /* number of pv to keep two copies */
char               *match
                                    /* indicates the vgid in the lvm record */
                                    /* matches the one passed in */
char               delete,      /* indicates we are called by deletepv */
struct fheader     *fhead);      /* pointer to vg mapped file header */


extern int getstates(
struct vgsa_area *vgsa,          /* pointer to buffer for volume group status */
                          /* area */
char               *vgfptr);      /* pointer to volume group mapped file */


extern int timestamp(
struct vg_header *vg,           /* pointer to volume group header */
char               *vgptr,       /* pointer to volume group file */
struct fheader   *fhead);       /* pointer to vg file header */


extern int timestamp(
struct vg_header *vg,           /* pointer to volume group header */
char               *vgptr, /* pointer to volume group file */
struct fheader   *fhead);       /* pointer to file header of vg file */


extern int buildname(
dev_t     dev,                   /* device info for physical volume */
char         nameff[LVM_EXTNAME],        /* array to store name we create for pv */
int     mode,                /* mode to set the device entry to */
int     type);               /* type of name to build */


extern int rebuild_file (
struct unique_id *vgid,          /* pointer to volume group id */
int           *vgfd);        /* vg file descriptor */
```

FIG. 21-35

70

```
extern void calc_lsn(
  struct fheader *fhead,                /* pointer to volume group file header */
  struct rebuild *rebuild);      /* pointer to info from the rebuilding */
                          /* of the volume group file */


/*
 * varyonvg.c
 */


int lvm_forceqrm (
caddr_t vgda_ptr,
  /* pointer to the volume group descriptor area */
struct defpvs_info * defpvs_info);
  /* structure which contains information about volume group descriptor
     areas and status areas for the defined PVs in the volume group */


void lvm_mapfile (
struct varyonvg * varyonvg,
  /* pointer to a structure which contains the input information for
     the lvm_varyonvg subroutine */
struct inpvs_info * inpvs_info,
  /* a pointer to the structure which contains information about PVs
     from the input list */
struct defpvs_info * defpvs_info,
  /* pointer to structure which contains information about PVs which are
     defined into the kernel */
struct fheader * mapfilehdr,
  /* a pointer to the mapped file header which contains the offsets of
     the different data areas within the mapped file */
caddr_t vgda_ptr);
  /* pointer to the volume group descriptor area */


void lvm_pvstatus (
struct varyonvg * varyonvg,
  /* pointer to the structure which contains input parameter data for
     the lvm_varyonvg routine */
```

FIG. 21-36

71

```
struct defpvs_info * defpvs_info,
    /* pointer to structure which contains information about PVs which are
       defined into the kernel */
caddr_t vgda_ptr),
    /* pointer to the volume group descriptor area */
int * missname,
    /* flag to indicate if there are any PV names missing from the input
       list */
int * misspv);
    /* flag to indicate if there are any PVs missing from the varied-on
       volume group (i.e., PVs that could not be defined into the kernel */


int lvm_update (
struct varyonvg * varyonvg,
    /* pointer to the structure which contains input information for
       varyonvg */
struct inpvs_info * inpvs_info,
    /* a pointer to the structure which contains information about PVs
       from the input list */
struct defpvs_info * defpvs_info,
    /* structure which contains information about volume group descriptor
       areas and status areas for the defined PVs in the volume group */
struct fheader * maphdr_ptr,
    /* a pointer to the file header portion of the mapped file */
int vg_fd,
    /* the file descriptor for the volume group reserved area logical
       volume */
caddr_t vgda_ptr,
    /* pointer to the volume group descriptor area */
struct vgsa_area * vgsa_ptr,
    /* pointer to the volume group status area */
daddr_t vgsa_lsn ff[LVM_MAXPVS] ff[LVM_PVMAXVGDAS],
    /* array which contains the logical sector number addresses of all
       the VGSAs */
char mwcc ff[DBSIZE],
    /* buffer containing the latest mirror write consistency cache */
int forceqrm,
```

FIG. 21-37

```
      /* flag to indicate if the quorum has been forced */
int misspv);
      /* flag to indicate if there were any missing PVs */



/*
 * verify.c
 */

int lvm_verify (
struct varyonvg * varyonvg,
   /* pointer to the structure which contains input parameter data for
      the lvm_varyonvg routine */
int * vg_fd,
   /* pointer to the variable to contain the file descriptor for the
      volume group reserved area logical volume */
struct inpvs_info * inpvs_info,
   /* structure which contains information about the input list of PVs
      for the volume group */
struct defpvs_info * defpvs_info,
   /* structure which contains information about volume group descriptor
      areas and status areas for the defined PVs in the volume group */
caddr_t * vgda_ptr,
   /* pointer to variable where the pointer to the volume group descriptor
      area is to be returned */
struct vgsa_area  **vgsa_ptr,
   /* variable to contain the pointer to the buffer which will contain the
      volume group status area */
daddr_t vgsa_lsn ff[LVM_MAXPVS] ff[LVM_PVMAXVGDAS],
   /* array in which to store the logical sector number addresses of the
      VGSAs for each PV */
char mwcc ff[DBSIZE]);
   /* buffer in which the latest mirror write consistency cache will be
      returned */
```

## FIG. 21-38

```
int lvm_defpvs (
struct varyonvg * varyonvg,
   /* pointer to the structure which contains input parameter data for
       the lvm_varyonvg routine */
int vg_fd,
   /* file descriptor of the volume group reserved area logical volume */
struct inpvs_info * inpvs_info,
   /* structure which contains information about the input list of PVs for
       the volume group */
struct defpvs_info * defpvs_info);
   /* structure which contains information about the volume group
       descriptor and status areas for PVs defined into the kernel */


void lvm_getdainfo (
int vg_fd,
   /* file descriptor for the VG reserved area logical volume which
       contains the volume group descriptor area and status area */
short int pv_index,
   /* index variable for looping on physical volumes in input list */
struct inpvs_info * inpvs_info,
   /* structure which contains information about the input list of PVs for
       the volume group */
struct defpvs_info * defpvs_info);
   /* pointer to structure which contains information about PVs defined
       into the kernel */


int lvm_readpvs (
struct varyonvg * varyonvg,
   /* pointer to the structure which contains input parameter data for
       the lvm_varyonvg routine */
struct inpvs_info * inpvs_info);
   /* structure which contains information about the input list of PVs
       for the volume group */


int lvm_readvgda (
int vg_fd,
   /* the file descriptor for the volume group reserved area logical
       volume */
```

FIG. 21-39

74

```
short int override,
  /* flag which indicates if no quorum error is to be overridden */
struct inpvs_info * inpvs_info,
  /* structure which contains information about the input list of PVs
    for the volume group */
struct defpvs_info * defpvs_info,
  /*structure which contains information about volume group descriptor
    areas and status areas for the defined PVs in the volume group */
caddr_t * vgda_ptr);
  /* pointer to buffer in which to read the volume group descriptor
    area */


/*
 * vonutl.c
 */


void lvm_clsinpvs (
struct varyonvg * varyonvg,
  /* pointer to the structure which contains input parameter data for
    the lvm_varyonvg routine */
struct inpvs_info * inpvs_info);
  /* structure which contains information about the input list of PVs
    for the volume group */


int lvm_deladdm (
struct varyonvg * varyonvg,
  /* pointer to the structure which contains input information for
    varyonvg */
struct inpvs_info * inpvs_info,
  /* a pointer to the structure which contains information about PVs
    from the input list */
struct defpvs_info * defpvs_info,
  /* pointer to structure which contains information about the physical
    volumes defined into the kernel */
short int pv_num);
```

FIG. 21-40

/* the PV number of PV being changed to a missing PV */

```
int lvm_vonresync (
struct unique_id * vg_id);
 /* pointer to the volume group id */
```

```
/*
 * wrtutl.c
 */
```

```
int lvm_diskio (
caddr_t vg_mapptr,
 /* a pointer to the mapped file for this volume group */
int vg_mapfd);
 /* the file descriptor of the mapped file for this volume group */
```

```
int lvm_updvgda (
int lv_fd,
  /* the file descriptor of the descriptor area logical volume, if it
    is already open */
struct fheader * maphdr_ptr,
 /* a pointer to the file header portion of the mapped file */
caddr_t vgda_ptr);
 /* a pointer to the memory location which holds the volume group
    descriptor area */
```

```
int lvm_wrtdasa (
int vg_fd,
 /* the file descriptor of the LVM reserved area logical volume */
caddr_t area_ptr,
 /* a pointer to the memory location which holds the volume group
    descriptor or status area */
struct timestruc_t * e_timestamp,
 /* a pointer to the end timestamp for the area */
long area_len,
```

FIG. 21-41

```
    /* the length in sectors of the area */
daddr_t lsn,
    /* the logical sector number within the LVM reserved area logical
      volume of where to write a copy of the area */
short int write_order);
    /* flag which indicates whether the area is to be written in the order
      of beginning/middle/end or middle/beginning/end */


int lvm_wrtmapf (
int vgmap_fd,
    /* the file descriptor of the mapped file */
caddr_t vgmap_ptr);
    /* the pointer to the beginning of the mapped file */


int lvm_wrtnext (
int lv_fd,
    /* the file descriptor of the LVM reserved area logical volume */
caddr_t vgda_ptr,
    /* a pointer to the memory location which holds the volume group
      descriptor area */
struct timestruc_t *etimestamp,
    /* pointer to the ending timestamp in the vg trailer */
short int pvnum,
    /* the PV number of the PV to which the VGDA is to be written */
struct fheader * maphdr_ptr,
    /* pointer to the mapped file header */
short int pvnum_vgdas);
    /* number of volume group descriptor areas to be written to the PV */


#else

/*
 * bbdirutl.c
 */

int lvm_ bbdsane ( );
```

<div align="center">

**FIG. 21-42**

</div>

int lvm_getbbdir ( );

int lvm_rdbbdir ( );

int lvm_wrbbdir ( );

```
/*
 * bblstutl.c
 */
```

void lvm_addbb ( );

int lvm_bldbblst ( );

void lvm_chgbb ( );

```
/*
 * chkquorum.c
 */
```

int lvm_chkquorum ( ):

int lvm_vgsamwcc ( ):

```
/*
 * computl.c
 */
```

int lvm_chkvaryon ( );

int lvm_mapoff ( );

int lvm_openmap ( );

int lvm_relocmwcc ( );

**FIG. 21-43**

int lvm_rdiplrec ( );

int lvm_tscomp ( );

int lvm_updtime ( );

```
/*
 * crtinsutl.c
 */
```

int lvm_initbbdir ( );

void lvm_initlvmrec ( );

int lvm_instsetup ( );

void lvm_pventry ( );

int lvm_vgdas3to3 ( );

int lvm_vgmem ( );

int lvm_zeromwc ( );

int lvm_zerosa ( );

```
/*
 * configutl.c
 */
```

int lvm_addmpv ( );

int lvm_addpv ( );

int lvm_chgvgsa ( );

**FIG. 21-44**

int lvm_chkvgstat ( );

int lvm_config ( );

int lvm_defvg ( );

int lvm_delpv ( );

void lvm_delvg ( );

```
/*
 * lvmrecutl.c
 */
```

void lvm_cmplvmrec ( );

int lvm_rdlvmrec ( );

int lvm_wrlvmrec ( );

void lvm_zerolvm ( );

```
/*
 * queryutl.c
 */
```

extern int lvm_chklvclos ( );

extern int lvm_getpvda ( );

extern int lvm_gettsinfo ( );

```
/*
 * rdex_com.c
 */
```

**FIG. 21-45**

```
extern int rdex_proc ( );
/* struct lv_id      *lv_id     logical volume id
   struct ext_redlv *ext_red    maps of pps to be extended or reduced
   int              indicator   indicator for extend or reduceperation */



/*
 * revaryon.c
 */

int lvm_revaryon ( );

void lvm_vonmisspv ( );



/*
 * setupvg.c
 */

int lvm_setupvg ( );

int lvm_bldklvlp ( );

int lvm_mwcinfo ( );



/*
 * synclp.c
 */

extern int synclp ( );
/* int              lvfd       logical volume file descriptor
   struct lv_entries *lv        pointer to logical volume entry
   char             *vgptr     pointer to the volume group mappedfile
   int              vgfd      volume group mapped filedescriptor
   short            minor_num  minor number of the logicalolume
   int              lpnum      logical partition number to sync
```

FIG. 21-46

```
struct unique_id  *vg_id   volume group id
int                force    resync any non-stale lp if TRUE */



/*
 * utilities.c
 */

extern int get_lvinfo ( );
/* struct unique_id *vg_id    volume group id
   struct lv_id     *lv_id        logical volume id
   int              *vgfd     volume group file descriptor
   short            *minor_num   logical volume minor number
   char             **vgptr       pointer to volume group mapped file
   int              mode        how to open the vg mapped file */

extern int get_ptrs ( );
/*  struct fheader     **header      points to the file header
    struct vgheader  **vgptr      points to the volume group header
    struct lv_entries **lvptr      points to the logical volume entries
    struct pv_header **pvptr      points to the physical volume header
    struct pp_entries **pp_ptr     points to the physical partition ents
    struct namelist     **nameptr    points to the name descriptor area */

extern int lvm_errors ( );
/*  char      failing_rtnff[LVM_NAMESIZ]  name of routine with error
    char      calling_rtnff[LVM_NAMESIZ]  name of calling routine
    int       rc                  error returned from failing rtn */

extern int get_pvandpp ( );
/*  struct pv_header  **pv    pointer to the physical volume header
    struct pp_entries  **pp   pointer to the physical partition entry
    short            *pvnum   pv number of physical volume id sent
    char             *vgfptr pointer to the volume group mapped file  in
    struct unique_id *id      id of pv you need a pointer to
```

## FIG. 21-47

```
extern int bldlvinfo ( );
 /* struct logview      **lp pointer to logical view of a logical vol
   char              *vgfptr pointer to volume group mapped file
   struct lv_entries  *lv pointer to a logical volume
   long              *cnt number of pps per copy of logical volume
   short             minor_num  minor number of logical volume */


extern int status_chk ( );
/* char    *vgptr      pointer to volume group mapped file
   char    *name       name of device to be checked
   int     flag        indicator to check the major number
   char    *rawname    pointer to new raw device name  */


extern int lvm_special_3to2 ( );
/* char             *pvname,
                     name of physical volume being removed
   struct unique_id     *vgid,
                     pointer to the volume group id
   int               lvfd,
                     reserved area logical volume file desc
   char             *vgdaptr,
                     pointer to vgda area of the vg file
   short            pvnum0,     number of pv to delete/remove
   short            pvnum1,     number of pv to keep one copy
   short            pvnum2,     number of pv to keep two copies
   char             match
                     indicates the vgid in the lvm record   matches
                     the vgid passed in
   char             delete indicates we are called by deletepv
   struct fheader       *fhead   pointer to vg mapped file header
*/


extern int getstates ( );
/* struct vgsa_area   *vgsa    pointer to buffer for volume group status
                     area
   char             *vgfptr      pointer to volume group mapped file
*/
```

FIG. 21-48

```
extern int timestamp ( );
/* struct vg_header *vg,        pointer to volume group header
   char              *vgptr,    pointer to volume group file
   struct fheader  *fhead);     pointer to vg file header
*/


extern int timestamp ( );
/*
   struct vg_header *vg,        pointer to volume group header
   char              *vgptr,    pointer to volume group file
   struct fheader  *fhead)      pointer to file header of vg file
*/


extern int buildname ( );
/* dev_t    dev,        device info for physical volume
   char      nameff[LVM_EXTNAME],     array to store name  we create for pv
   int    mode,                   mode to set the device entry to
   int    type);           type of name to build
*/


extern int rebuild_file ( );
/*
   struct unique_id *vgid,        pointer to volume group id
   int              *vgfd);    vg file descriptor
*/


extern void calc_lsn ( );
/*
   struct fheader *fhead,                pointer to volume group file header
   struct rebuild *rebuild);        pointer to info from the rebuilding
                of the volume group file
*/



/*
 * varyonvg.c
 */
```

FIG. 21-49

```
int lvm_deladdm ( );

int lvm_forceqrm ( );

void lvm_mapfile ( );

int lvm_pvstatus ( );

int lvm_update ( );


/*
 * verify.c
 */

int lvm_verify ( );

void lvm_clsinpvs ( );

int lvm_defpvs ( );

void lvm_getdainfo ( );

int lvm_readpvs ( );

int lvm_readvgda ( );


/*
 * wrtutl.c
 */

int lvm_diskio ( );

void lvm_updvgda ( );

int lvm_wrtdasa ( );
```

FIG. 21-50

```
int lvm_wrtdasa ( );

int lvm_wrtmapf ( );

int lvm_wrtnext ( );


#endif /* _NO_PROTO */

#endif /* _H_LIBLVM */




/*    DASD.H    */

#ifndef _H_DASD
#define _H_DASD

/*
* COMPONENT_NAME: (SYSXLVM) Logical Volume Manager - dasd.h
*
*
* © COPYRIGHT International Business Machines Corp. 1988, 1990
* All Rights Reserved
*
*/

/*
*    Logical Volume Manager Device Driver data structures.
*/

#include < sys/types.h >
#include < sys/sleep.h >
#include < sys/lockl.h >
```

FIG. 21-51

```c
#include < sys/sysmacros.h >
#include < sys/buf.h >
#include < sys/lvdd.h >


/*  FIFO queue structure for scheduling logical requests. */
struct hd_queue {                  /* queue header structure     */
        struct buf *head;          /* oldest request in the queue     */
        struct buf *tail;   /* newest request in the queue      */
};


struct hd_capvq {                  /* queue header structure     */
        struct pv_wait *head; /* oldest request in the queue    */
        struct pv_wait *tail;     /* newest request in the queue  */
};
/*
 * Structure used by hd_redquiet( ) to mark target PPs for removal.
 * Both are zero relative.
 */
struct hd_lvred  {
        long  lp;               /* LP the pp belongs to                */
        char  mirror;             /* mirror number of PP               */
};
/*
 * Physical request buf structure.
 *
 *  A 'pbuf' is a 'buf' structure with some additional fields used
 *  to track the status of the physical requests that correspond to
 *  each logical request.  A pool of pinned pbuf's is allocated and
 *  managed by the device driver.  The size of this pool depends on
 *  the number of open logical volumes.
 */
struct pbuf {

        /* this must come first, 'buf' pointers can be cast to 'pbuf' */
        struct buf  pb;             /* imbedded buf for physical driver */
```

FIG. 21-52

```
        /* physical buf structure appendage: */
        struct buf   *pb_lbuf;   /* corresponding logical buf struct */

        /* scheduler I/O done policy function      */
#ifndef _NO_PROTO
        void        (*pb_sched) (struct pbuf *);
#else
        void        (*pb_sched) ( );
#endif
        struct pvol *pb_pvol; /* physical volume structure   */
        struct bad_blk   *pb_bad;   /* defects directory entry      */
        daddr_t         pb_start;   /* starting physical address  */

        char       pb_mirror; /* current mirror                  */
        char       pb_miravoid;     /* mirror avoidance mask      */
        char       pb_mirbad;       /* mask of broken mirrors     */
        char       pb_mirdone;      /* mask of mirrors done          /*

        char       pb_swretry;      /* number of sw relocation retries */
        char       pb_type;     /* Type of pbuf                 */
        char       pb_bbop;     /* BB directory operation      */
        char       pb_bbstat;   /* status of BB directory operation */

        uchar         pb_whl_stop;   /* wheel_idx value when this pbuf is*/
                                /* to get off of the wheel          */
#ifdefDEBUG
        ushort        pb_hw_reloc;   /* Debug - it was a HW reloc request*/
        char       pad       /* pad to full long word         */
#else
        char       padff[3];         /* pad to full long word         */
#endif

        struct part *pb_part;    */ ptr to part structure.  Care must*/
                                 */ be taken when this is used since */
                                 */ the parts structure can be moved */
                                 */ by hd_config routines while the  */
                                 */ request is in flight          */
```

**FIG. 21-53**

```
        struct unique_id *pb_vgid;     */ volume group ID                    */
        /* used to dump the allocated pbuf at dump time                          */
        struct pbuf *pb_forw;    */ forward pointer                */
         struct pbuf *pb_back;   */ backward pointer               */
};


#define pb_addr pb.b_un.b_addr          */ too ugly in its raw form     */


/* defines for pb_swretry */
#define MAX_SWRETRY  3                    */ maximum retries for relocation
                              before declaring disk dead */


/* values for b_work in pbuf struct (since real b_work value only used
 * in lbuf)
 */
#define FIX_READ_ERROR          1     */ fix a previous EMEDIA read error  */
#define FIX_ESOFT    2     /* fix a read or write ESOFT error     */
#define FIX_EMEDIA          3     /* fix a write EMEDIA error                 */


/* defines for pb_type */
#define      SA_PVMISSING       1    /* PV missing type request      */
#define      SA_STALEPP  2     /* stale PP type request           */
#define      SA_FRESHPP  3     /* fresh PP type request          */
#define      SA_CONFIGOP        4   /* hd_config operation type request   */


/*
 * defines to tell hd_bldpbuf what kind of pbuf to build
 *
 * These defines are not the only ones that tell hd_bldpbuf what to
 * build.  Check the routine before changing/adding new defines here
 */
#define      CATYPE_WRT  1     /* pbuf struct is a cache write  type      */


/*
 * defines for pb_bbop
 *
 * First set is used by the requests pbuf that is requesting the BB operation.
```

FIG. 21-54

```
* The second set is used in the bb_pbuf to control the action of the
* actual reading and writing of the BB directory of the PV.
*/
#define BB_ADD          41    /* Add a new bad block entry to BB directory */
#define BB_UPDATE       42    /* Update a bad block entry to BB directory */
#define BB_DELETE  43   /* Delete a bad block entry to BB directory  */
#define BB_RDDFCT       44    /* Reading a defective block           */
#define BB_WTDFCT       45    /* Writing a defective block           */
#define BB_SWRELO       46    /* Software relocation in progress     */


#define RD_BBPRIM       70    /* Read the BB primary directory      */
#define WT_UBBPRIM      71    /* Write BB prim dir with UPDATE         */
#define WT_DBBPRIM      72    /* Rewrite BB prim dir 1st blk with UPDATE */
#define WT_UBBBACK      73    /* Write BB backup dir with UPDATE      */
#define WT_DBBBACK      74    /* Rewrite BB back dir 1st blk with UPDATE */



/* defines for pb_berror; 0-63 (good) 64-127 (bad) */
#define BB_SUCCESS      0     /* BBdir updating worked              */
#define BB_CRB          1     /* Reloc blkno was changed in this BB entry */
#define BB_ERROR   64   /* Bad Block directories were not updated   */
#define BB_FULL         65    /* BBdir is full -no free bad blk entries   */



/*
 * Volume group structure.
 *
 * Volume groups are implicitly open when any of their logical   volumes are.
 */


#define MAXVGS          255      /* implementation limit on # VGs */
#define MAXLVS          256      /* implementation limit on # LVs */
#define MAXPVS          32       /* implementation limit on number*/
                                 /* physical volumes per vg     */
#define     CAHHSIZE    8        /* Number of mwc cache queues    */
#define NBPI      (NBPB * sizeof(int))   /* Number of bits per int    */
#define NBPL      (NBPB * sizeof(long))  /* Number of bits per long     */
```

FIG. 21-55

```
/* macros to set and clear the bits in the opn_pin array */
#define SETLVOPN(Vg,N) ((Vg)-> opn_pinff[(N)/NBPI] |=1 < < ((N)%NBPI))
#define CLRLVOPN(Vg,N)     ((Vg)-> opn_pinff[(N)/NBPI] & =  ~( 1 < < ((N)%NBPI)))
#define TSTLVOPN(Vg,N) ((Vg)-> opn_pinff[(N)/NBPI] & 1 < < ((N)%NBPI))


/*
 * macros to set and clear the bits in the ca_pv_wrt field
 *
 * NOTE TSTALLPVWRT will not work if max PVs per VG is greater than 32
 */
#define SETPVWRT(Vg,N)   ((Vg)-> ca_pv_wrtff[(N) / NBPL] |= 1< < ((N) % MAXPVS))
#define CLRPVWRT(Vg,N)   ((Vg)-> ca_pv_wrtff[(N) / NBPL] &= ~(1< < ((N) % MAXPVS)))
#define TSTPVWRT(Vg,N)   ((Vg)-> ca_pv_wrtff[(N) / NBPL] & ( 1< < ((N) % MAXPVS)))
#define TSTALLPVWRT(Vg) ((Vg)-> ca_pv_wrtff[(MAXPVS - 1) / NBPL])


/*
 * head of list of varied on volgrp structs in the system
 */
struct
{
    lock_t lock;              /* lock while manipulating list of VG structs */
    struct volgrp * ptr;      /* ptr to list of varied on VG structs */
} hd_vghead = {EVENT_NULL, NULL};


struct volgrp {
  lock_t          vg_lock;    /* lock for all vg structures      */
  short           padl;                 /* pad to long word boundary          */
  short           partshift;  /* log base 2 of part size in blks */
  short           open_count;       /* count of open logical volumes   */
  ushort          flags;        /* VG flags field              */
  ulong           tot_io_cnt;  /* number of logical request to VG   */
  struct lvol             *lvolsff[MAXLVS];  /* logical volume struct array           */
  struct pvol             *pvolsff[MAXPVS]; /* physical volume struct array        */
  long            major_num;        /* major number of volume group     */
  struct unique_id        vg_id;              /* volume group id              */
```

FIG. 21-56

```
struct volgrp      *nextvg;      /* pointer to next volgrp structure */
                                 /* Array of bits indicating open LVs*/
                                 /* A bit per LV                    */
int                opn_pinff[(MAXLVS + (NBPI - 1))/NBPI];
pid_t              von_pid;     /* process ID of the varyon process */


    /* Following used in write consistency cache management          */
struct volgrp      *nxtactvg;  /* pointer to next volgrp with       */
                                 /* write consistency activity      */
struct pv_wait      *ca_freepvw;     /* head of pv_wait free list      */
struct pv_wait      *ca_pvwmem;  /* ptr to memory malloced for pvw   */
                                 /* free list                       */
struct hd_queue     ca_hld;            /* head/tail of cache hold queue    */
ulong           ca_pv_wrtff[(MAXPVS + (NBPL - 1)) / NBPL];
                                 /* when bit set write cache to PV     */
char            ca_inflt_cnt;       /* number of PV active writing cache*/
char            ca_size;    /* number of entries in cache             */
ushort          ca_pvwblked;      /* number of times the pv_wait free */
                                 /* list has been empty              */
struct mwc_rec       *mwc_rec; /* ptr to part 1 of cache - disk rec*/
struct ca_mwc_mp     *ca_part2; /* ptr to part 2 of cache - memory  */
struct ca_mwc_mp     *ca_lst;    /* mru/lru cache list anchor        */
struct ca_mwc_mp     *ca_hashff[CAHHSIZE]; /* write consistency hash anchors*/

/* the following 2 variables are used to control a cache clean up opera-*/
/* tion.
pid_t               bcachwait; /* list waiting at the beginning        */
pid_t               ecachwait; /* list waiting at the end              */
volatile int        wait_cnt;   /* count of cleanup waiters           */

/* the following are used to control the VGSAs and the wheel */
uchar               quorum_cnt;      /* Number indicating quorum of SAs */
uchar               wheel_idx; /* VGSA wheel index into pvols      */
ushort              whl_seq_num;    /* VGSA memory image sequence number*/
struct pbuf             *sa_act_lst;    /* head of list of pbufs that are    */
                                 /* actively on the VGSA wheel       */
struct pbuf             *sa_hld_lst;    /* head of list of pbufs that are    */
```

FIG. 21-57

92

```
                                   /* waiting to get on the VGSA wheel */
    struct vgsa_area       *vgsa_ptr;    /* ptr to in memory copy of VGSA    */
    pid_t              config_wait;        /* PID of process waiting in the   */
                                   /* hd_config routines to modify the */
                                   /* memory version of the VGSA        */
    struct buf             sa_lbuf;       /* logical buf struct to use to wrt */
                                   /* the VGSAs                      */
    struct pbuf            sa_pbuf;       /* physical buf struct to use to wrt*/
                                   /* the VGSAs                      */
};

/*
 * Defines for flags field in volgrp structure
 */
#define        VG_SYSMGMT          0x0002  /*VG is on for system management */
                                   /* only commands              */
#define VG_FORCEDOFF      0x0004        /* Should only be on when the VG was*/
#define        VG_OPENING           0x0008  /* VG is being varied on        */
        /* forced varied off and there were LVs still open.  Under this con-*/
        /* dition the driver entry points can not be deleted from the device*/
        /* switch table.  Therefore the volgrp structure must be kept       */
        /* around to handle any rogue operations on this VG.              */
#define        CA_INFLT       0x0010         /* The cache is being written or    */
                                   /* locked            */
#define CA_VGACT       0x0020               /* This volgrp on mwc active list    */
#define        CA_HOLD                0x0040 /* Hold the cache in flight       */
#define        CA_FULL                0x0080 /* Cache is full - no free entries   */
#define        SA_WHL_ACT  0x0100     /* VGSA wheel is active            */
#define        SA_WHL_HLD  0x0200     /* VGSA wheel is on hold        */
#define        SA_WHL_WAIT          0x0400 /* config function is waiting for      */
                                   /* the wheel to stop            */


/*
 * Logical volume structure.
 */
struct lvol {
```

**FIG. 21-58**

```
struct buf   **work_Q;            /* work in progress hash table        */
short        lv_status   /* lv status: closed, closing, open   */
short        lv_options;          /* logical dev options (see below)  */
short        nparts;              /* num of part structures for this  */
                         /* lv - base 1
char         i_sched;    /* initial scheduler policy state   */
char         pad;        /* padding so data word aligned     */
ulong             nblocks;        /* LV length in blocks                */
struct part  *partsff[3];         /* partition arrays for each mirror */
ulong             tot_wrts;       /* total number of writes to LV       */
ulong             tot_rds;        /* total number of reads to LV        */
/* These fields of the lvol structure are read and/or written by
 * the bottom half of the LVDD; and therefore must be carefully
 * modified.
 */
int          complcnt;   /* completion count_used to quiesce */
int          waitlist;   /* event list for quiesce of LV       */
};


/* lv status: */
#define      LV_CLOSED    0              /* logical volumes is closed   */
#define      LV_CLOSING        1         /* trying to close the LV     */
#define      LV_OPEN      2              /* logical volume is open      */


/* scheduling policies: */
#define      SCH_REGULAR         0       /* regular, non-mirrored LV */
#define      SCH_SEQUENTIAL   1          /* sequential write, seq read */
#define      SCH_PARALLEL        2       /* paralled write, read closest    */
#define      SCH_SEQWRTPARRD     3       /* sequential write, read closest*/
#define      SCH_PARWRTSEQRD     4       /* parallel write, seq read    */


/* logical device options: */
#define      LV_NOBBREL   0x0010         /* no bad block relocation   */
#define      LV_RDONLY    0x0020         /* read-only logical volume   */
#define      LV_DMPINPRG         0x0040     /* Dump in progress to this LV   */
#define      LV_DMPDEV    0x0080            /* This LV is a DUMP device    */
                         /* i.e. DUMPINIT has been done     */
```

FIG. 21-59

```
#define LV_NOMWC          0x0100          /* no mirror write consistency  */
                                          /* checking              */
#define     LV_WRITEV     WRITEV          /* Write verify writes in LV  */


/* work_Q hash algorithm - just a stub now */
#define HD_HASH(Lb)       \
        (BLK2TRK((Lb)-> b_blkno) & (WORKQ_SIZE-1))


/*
 * Partition structure.
 */
struct part {
        struct pvol *pvol;              */ containing physical volume    */
        daddr_t         start           */ starting physical disk address */
        short       sync_trk;   /* current LTG being resynced       */
        char        ppstate;    /* physical partition state      */
        char        sync_msk;   /* current LTG sync mask      */
};


/*
 * Physical partition state defines PP_ and structure defines.
 *
 * The PP_STALE and PP_REDUCING bits could be combined into one but it
 * is easier to understand if they are not and a problem arises  later.
 *
 * The PP_RIP bit is only valid in the primary part structure.
 */
#define PP_STALE        0x01              /* Set when PP is stale            */
#define     PP_CHGING    0x02          /* Set when PP is stale but the     */
                                /* VGSAs have not been completely */
                                /* updated yet            */
#define     PP_REDUCING        0x04     /* Set when PP is in the process  */
                                /* of being removed(reduced out     */
#define PP_RIP          0x08             /* Set when a Resync is in progress */
                                /* When set "sync_trk" indicates   */
                                /* the track being synced.  If           */
```

FIG.  21-60

```
                                    /* sync_trk not = = -1 and PP_RIP  */
                                    /* not set sync_trk is next trk        */
                                    /* to be synced                   */
#define PP_SYNCERR                  0x10        /* Set when error in a partition */
                                    /* being resynced.  Causes the      */
                                    /* partition to remain stale.   */


#define NO_SYNCTRK                  -1             /* The LP does not have a resync */
                                    /* in progress                   */
/*
 * Physical volume structure.
 *
 *
 *       Contains defects directory hash anchor table.  The defects
 *       directory is hashed by track group within partition.  Entries within
 *       each congruence class are sorted in ascending block addresses.
 * .
 *
 *       This scheme doesn't quite work, yet.  The congruence classes need
 *       to be aligned with logical track groups or partitions to guarantee
 *       that all blocks of this request are checked.  But physical addresses
 *       need not be aligned on track group boundaries.
 */


#define HASHSIZE        64                  /* number of defect hash classes */

struct defect_tbl {
        struct bad_blk *defects ff[HASHSIZE];  /* defect directory anchor */
};

struct pvol {
        dev_t           dev;            /* dev_t of physical device       */
        daddr_t         armpos;             /* last requested arm position       */
        short      xfcnt;               /* transfer count for this pv     */
        short      pvstate;    /* PV state                   */
        short      pvnum;               /* LVM PV number 0-31          */
        short      vg_num;              /* VG major number           */
        struct file *   fp;         /* file pointer from open of PV */
        char       flags;           /* place to hold flags        */
```

FIG. 21-61

```
        char      pad;          /* unused                        */
        short     num_bbdir_ent;    /* current number of BB Dir entries */
        daddr_t         fst_usr_blk;      /* first available block on the PV  */
                              /* for user data          */
        daddr_t         beg_relblk;  /* first blkno in reloc pool       */
        daddr_t         next_relblk;      /* blkno of next unused relocation  */
                              /* block in reloc blk pool at end   */
                              /* of PV                 */
        daddr_t         max_relblk;       /* largest blkno avail for reloc    */
        struct defect_tbl *defect_tbl;  /* pointer to defect table        */
        struct hd_capvq ca_pv;           /* head/tail of queue of request    */
                              /* waiting for cache write to      */
                              /* complete               */
        struct sa_pv_whl {           /* VGSA information for this PV     */
          daddr_t lsn;            /* SA logical sector number - LV 0 */
           ushort  sa_seq_num;      /* SA wheel sequence number       */
           char    nukesa;          /* flag set if SA to be deleted    */
           char    pad;         /* pad to full long word          */
        }         sa_areaff[2];       /* one for each possible SA on PV   */

        struct pbuf pv_pbuf;     /* pbuf struct for writing cache       */
};


/* defines for pvstate field */
#define PV-MISSING          1            /* PV cannot be accessed          */
#define PV-RORELOC          2            /* No HW or SW relocation allowed    */
                              /* only known bad blocks relocated    */
/*
 * returns index into the bad block hash table for this block number
 */
#define BBHASH_IND(blkno)         (BLK2TRK(blkno) & (HASHSIZE - 1))


/*
 * Macro to return defect directory congruence class pointer
 */
#define HASH_BAD(Pb,Bad_blkno)        \
        ((Pb)-> pb_pvol-> defect_tbl-> defectsff[BLK2TRK(Bad_blkno)&(HASHSIZE-1)])
```

FIG. 21-62

```
/*
 * Used by the LVM dump device routines same as HASH_BAD but the first
 * argument is a pvol struct pointer
 */
#define HASH_BAD_DMP(Pvol,Blkno)        \
        ((Pvol)-> defect_tbl-> defectsff[BLK2TRK(Blkno)&(HASHSIZE-1)])


/*
 * Bad block directory entry.
 */
struct bad_blk {                        /* bad block directory entry      */
        struct bad_blk      *next;              /* next entry in congruence class   */
        dev_t               dev;            /* containing physical device       */
        daddr_t             blkno;              /* bad physical disk address       */
        unsigned    status: 4;      /* relocation status (see below)    */
        unsigned    reblk: 28;      /* relocated physical disk address */
};


/*bad block relocation status values: */
#define REL_DONE   0                        /* software relocation completed      */
#define REL_PENDING         1               /* software relocation in progress  */
#define REL_DEVICE          2               /* device (HW) relocation requested */
#define REL_CHAINED         3               /* relocation blk structure exists  */
#define REL_DESIRED         8               /* relocation desired-hi order bit on*/


/*
 * Macros for getting and releasing bad block structures from the
 * pool of bad_blk structures. They are linked together by their next pointers.
 * "hd_freebad" points to the head of bad-blk free list
 * NOTE:  Code must check if hd_freebad != null before calling
 *        the GET_BBLK macro.
 */
#define GET_BBLK(Bad)       { \
                (Bad) = hd_freebad; \
                hd_freebad = hd_freebad-> next; \
                hd_freebad_cnt--; \
                }
```

FIG. 21-63

```
#define REL_BBLK(Bad) { \
                (Bad)-> next = hd_freebad; \
                hd_freebad = (Bad); \
                hd_freebad_cnt + +; \
                }
```

```
/*
 * Macros for accessing these data structures.
 */
#define VG_DEV2LV(Vg, Dev)        ((VG)-> lvolsff[minor(Dev)])
#define VG_DEV2PV(Vg, Pnum)       ((Vg)-> pvolsff[(Pnum)])


#define BLK2PART(Pshift,Lbn)      ((ulong)(Lbn) > > (Pshift))
#define PART2BLK(Pshift,P_no)     ((P_no) < < (Pshift))
#define PARTITION(LV,P_no,Mir)    ((Lv)-> partsff[(Mir)] + (P_no))


/*
 * Mirror bit definitions
 */


#define PRIMARY_MIRROR            001 /* primary mirror mask        */
#define SECONDARY_MIRROR          002 /* secondary mirror mask      */
#define TERTIARY_MIRROR           004 /* tertiary mirror mask       */
#define ALL_MIRRORS               007 /* mask of all mirror bits    */


/* macro to extract mirror avoidance mask from ext parameter */
#define    X_AVOID(Ext)           ( ((Ext) > > AVOID_SHFT) & ALL_MIRRORS )


/*
 * Macros to select mirrors using avoidance masks:
 *
 *      FIRST_MIRROR      returns first unmasked mirror (0 to 2); 3 if all masked
 *      FIRST_MASK   returns first masked mirror (0 to 2); 3 if none masked
 *      MIRROR_COUNT      returns number of unmasked mirrors (0 to 3)
 *      MIRROR_MASK       returns a mask to avoid a specific mirror (1, 2, 4)
 *      MIRROR_EXIST      returns a mask for non-existent mirrors (0, 4, 6, or 7)
 */
```

## FIG. 21-64

```
#define     FIRST_MIRROR(Mask)       ((0x30102010 > > ((Mask) < < 2))&0x0f)
#define     FIRST_MASK(Mask)         ((0x01020103 > > ((Mask) < < 2))&0x0f)
#define     MIRROR_COUNT(Mask)       ((0x01121223 > > ((Mask) < < 2))&0x0f)
#define     MIRROR_EXIST(Nmirrors)      ((0x00000467 > > ((Nmirrors) < < 2))&0x0f)
#define     MIRROR_MASK(Mirror)    (1 < < (Mirror))


/*
 * DBSIZE and DBSHIFT were originally UBSIZE and UBSHIFT from param.h.
 * There were renamed and moved to here to more closely resemble a disk
 * block and not a user block size.
 */
#define DBSIZE          512        /* Disk block size in bytes   */
#define DBSHIFT         9          /* log 2 of DBSIZE            */


/*
 * LVPAGESIZE and LVPGSHIFT were originally PAGESIZE and  PGSHIFT from param.h.
 * There were renamed and moved to here to isolate LVM from the changable
 * system parameters that would have undesirable effects on LVM  functionality.
 */
#define LVPAGESIZE          4096        /* Page size in bytes          */
#define LVPAGESHIFT 12                  /* log 2 of LVPAGESIZE    */


#define BPPG            (LVPAGESIZE/DBSIZE) /* blocks per page        */
#define BPPGSHIFT       (LVPGSHIFT-DBSHIFT) /* log 2 of BPPG          */
#define PGPTRK              32             /* pages per logical track group */
#define TRKSHIFT        5              /* log base 2 of PGPTRK    */
#define LTGSHIFT        (TRKSHIFT + BBGSHIFT)/* logical track group log base 2*/
#define BYTEPTRK        PGPTRK*LVPAGESIZE /* bytes per logical track group */
#define BLKPTRK             PGPTRK*BPPG          /*blocks per logical track group*/
#define SIGNED_SHIFTMSK 0x80000000    /* signed mask for shifting to   */
                          */ get page affected mask        */


#define BLK2BYTE(Nblocks)        ((unsigned)(Nblocks) < < (DBSHIFT))
#define BYTE2BLK(Nbytes)         ((unsigned)(Nbytes) > > (DBSHIFT))
#define BLK2PG(Blk)              ((unsigned)(Blk) > > BPPGSHIFT)
#define PG2BLK(Pageno)           ((Pageno) < < (LVPGSHIFT-DBSHIFT))
#define BLK2TRK(Blk)             ((unsigned)(Blk) > > (TRKSHIFT + BPPGSHIFT))
#define TRK2BLK(T_no)            ((unsigned)(T_no) < < (TRKSHIFT + BPPGSHIFT))
```

FIG. 21-65

```
#define PG2TRK(Pageno)        ((unsigned)(Pageno)) > > (TRKSHIFT))


/* LTG per partition */
#define TRKPPART(Pshift)  ((unsigned)(1 < < (Pshift -LTGSHIFT)))
/* LTG in the partition  */
#define TRK_IN_PART(Pshift, Blk) ( BLK2TRK(Blk) & (TRKPPART(Pshift) -1) )


*/ defines for top half of LVDD */
#define LVDD_HFREE_BB            30 /* high water mark for kernel bad_blk struct*/
#define LVDD_LFREE_BB            15 /* low water mark for kernel bad_blk struct */
#define WORKQ_SIZE        64    /* size of LVs work in progress queue      */
#define PBSUBPOOLSIZE     16    /* size of pbuf subpool alloc'd by PVs        */
#define HD_ALIGN         (uint)0  /* align characteristics for alloc'd memory */
#define FULL_WORDMASK           3   /* mask for full word (log base 2)      */
#define BUFCNT          .     3       /* parameter sent to uphysio for # buf      */
                          /* structs to allocate                */


#define NOMIRROR 0          /* no mirrors          */
#define PRIMMIRROR         0      /* primary mirror */
#define SINGMIRROR         1      /* one mirror       */
#define DOUBMIRROR         2      /* two mirrors        */


#define MAXNUMPARTS        3      /* maximum number of parts in a logical part */
#define PVNUMVGDAS         2      /* max number of VGDA/VGSAs on a PV */


/* return codes for LVDD top 1/2 */
#define LVDD_SUCCESS       0     /* general success code                  */
#define LVDD_ERROR         -1    /* general error code                  */
#define LVDD_NOALLOC            -200 /* hd_init: not able to allocate pool of bufs*/


#endif /* _H_DASD */
/*      HD.H       */


#ifndef_H_HD
#define_H_HD


/*
```

FIG. 21-66

```
* COMPONENT_NAME: (SYSXLVM) Logical Volume Manager Device Driver - hd.h
*
* © COPYRIGHT International Business Machines Corp.  1988, 1990
* All Rights Reserved
*
*/


#include < sys/errids.h >


/*
 * LVDD internal macros and extern staticly declared variables.
 */


/* LVM internal defines; */
#define      FAILURE               0   /* must be logic FALSE for 'if' tests       */
#define      SUCCESS              1      /* must be logic TRUE for 'if' tests      */
#define MAXGRABLV             16    /* Max number of LVs to grab pbuf structs */
#define MAXSYSVG 3               /* Max number of VGs to grab pbuf structs */
#define      CAHEAD              1      /* move cache entry to head of use list    */
#define      CATAIL               2      /* move cache entry to tail of use list       */
#define CA_MISS              0      /* MWC cache miss                   */
#define CA_HIT              1      /* MWC cache hit                    */
#define CA_LBHOLD            2      /* The logical request should hold           */


/*
 * Following defines are used to communicate with the kernel process
 */
#define LVDD_KP_TERM        0x80000000  /* Terminate the kernel process    */
#define LVDD_KP_BADBLK           0x40000000  /* Need more bad_blk structs    */
#define LVDD_KP_ACTMSK           0xC0000000  /* Mask of all events        */


/*
 * Following defines are used in the b_options of the logical buf struct.
 * They should be reserved in lvdd.h in relationship to the ext parameters
 */
#define      REQ_IN_CACH           0x40000000  /* When set in the lbuf b_options */
                                  /* the request is in the mirror   */
                                  /* write consistency cache      */
```

## FIG. 21-67

```
#define REQ_VGSA      0x20000000     /* When set in the lbuf b_options */
                                     /* it means this is a VGSA write    */
                                     /* and to use the special sa_pbuf */
                                     /* in the volgrp structure          */


/* * * * * * * * * * * * * * * * * * * * * * * * * * * * * * * * * * * * * * * * * * * * *
 *

 * The following variables are only used in the kernel and therefore are
 * only included if the _KERNEL variable is defined.
 *

 * * * * * * * * * * * * * * * * * * * * * * * * * * * * * * * * * * * * * * * * * * * * */


#ifdef _KERNEL
#include < sys/syspest.h >

/*
 * Set up a debug level if debug turned on
 */
#ifdef DEBUG
#ifdef LVDD_PHYS
BUGVDEF(debuglvl, 0)
#else
BUGXDEF(debuglvl)
#endif
#endif


/*
 * pending queue
 *

 *        This is the primary data structure for passing work from
 *        the strategy routines (see hd_strat.c) to the scheduler
 *        (see hd_sched.c) via the mirror write consistency logic.
 *        From this queue the request will go to one of three other
 *        queues.
 *

 *        1.   cache hold queue - If the request involves mirrors
 *             and the write consistency cache is in flight.
```

FIG. 21-68

```
*               i.e. being written to PVs.
*
*       2.   cache PV queue - If the request must wait for the
*            write consistency cache to be written to the PV.
*
*       3.   schedule queue - Requests are scheduled from this
*            queue.
*
*       This queue is only changed within a device driver critical section.
*/
#ifdef LVDD_PHYS
struct hd_queue  pending_Q
#else
extern struct hd_queue          pending_Q;
#endif


/*
* ready queue -- physical requests that are ready to start.
*
*       This queue is only valid within a single critical section.
*       It really contains a list of pbuf's, but only the imbedded
*       buf struct is of interest at this point.  Since the pointers
*       are of type (struct buf *) it is convenient that the queue be
*       declared similarly.
*/
#ifdef LVDD_PHYS
struct buf          *ready_Q = NULL;
#else
extern struct buf    *ready_Q;
#endif


/*
* Chain of free and available pbuf structs.
*/
#ifdef LVDD_PHYS
struct pbuf          *hd_freebuf = NULL;
#else
```

FIG.  21-69

```
extern struct pbuf          *hd_freebuf;
#endif


/*
 * Chain of pbuf structs currently allocated and pinned for LVDD use.
 * Only used at dump time and by crash to find them.
 */
#ifdef LVDD_PHYS
struct pbuf          *hd_dmpbuf = NULL:
#else
extern struct pbuf          *hd_dmpbuf;
#endif


/*
 * Chain and count of free and available bad_blk structs.
 * The first open of a VG, really the first open of an LV, will cause
 * LVDD_HFREE_BB( currently 30 ) bad_blk structs to be allocated and
 * chained here.  After that when the count gets to LVDD_LFREE_BB(low
 * water mark, currently 15) the kernel process will be kicked to go
 * get more up to LVDD_HFREE_BB( high water mark ) more.
 *
 * *NOTE* hd_freebad_lk is a lock mechanism to keep the top half of the
 *        driver and the kernel process from colliding.  This would only
 *        happen if the last request before the last LV closed received
 *        an ESOFT or EMEDIA( and request was a write ) and the getting of
 *        a bad_blk struct caused the count to go below the low water
 *        mark.  This would result in the kproc trying to put more
 *        structures on the list while hd_close via hd_frefrebb would
 *        be removing them.
 */
#ifdef LVDD_PHYS
int                hd_freebad_lk = LOCK_AVAIL;
struct bad_blk          *hd_freebad = NULL;
int                hd_freebad_cnt = 0;
#else
int                hd_freebad_lk;
extern struct bad_blk     *hd_freebad;
extern int           hd_freebad_cnt;
```

**FIG. 21-70**

```
#endif

/*
 * Chain of volgrp structs that have write consistency caches that need
 * to be written to PVs.  This chain is used so all incoming requests
 * can be scanned before putting the write consistency cache in flight.
 * Once in flight the cache is locked out and any new requests will have
 * to wait for all cache writes to finish.
 */
#ifdef LVDD_PHYS
struct volgrp            *hd_vg_mwc = NULL;
#else
extern struct volgrp     *hd_vg_mwc;
#endif


/*
 * The following arrays are used to allocate mirror write consistency
 * caches in a group of 8 per page.  This is due to the way the hide
 * mechanism works only on page quantities.  These two arrays should be
 * treated as being in lock step.  The lock, hd_ca_lock, is used to
 * ensure only one process is playing with the arrays at any one time.
 */
#define      VGS_CA   ((MAXVGS + (NBPB - 1)) / NBPB)

#ifdef LVDD_PHYS
lock_t              hd_ca_lock = LOCK_AVAIL; /* lock for cache arrays    */
char            ca_allocedff[VGS_CA];      /* bit per VG with cache allocated */
struct mwc_rec      *ca_grp_ptrff[VGS_CA];   /* 1 for each 8 VGs           */
#else
extern lock_t             hd_ca_lock;
extern char               ca_allocedff[ ];
extern struct mwc_rec     *ca_grp_ptrff[ ];
#endif

/*
 * The following variables are used to control the number of pbuf
 * structures allocated for LVM use.  It is based on the number of
```

FIG. 21-71

```
 * PVs in varied on VGs.  The first PV gets 64 structures and each
 * PV thereafter gets 16 more.  The number is reduced only when a
 * VG goes inactive. i.e. all it's LVs are closed.
 */
#ifdef LVDD_PHYS
int hd_pbuf_cnt = 0;                /* Total Number of pbufs allocated      */

int hd_pbuf_grab = PBSUBPOOLSIZE; /* Number of pbuf structs to allocate*/
                       /* for each active PV on the system      */

int hd_pbuf_min = PBSUBPOOLSIZE  * 4;
                       /* Number of pbuf to allocate for the     */
                       /* first PV on the system                 */

int hd_vgs_opn = 0;            /* Number of VGs opened                */
int hd_lvs_opn = 0;            /* Number of LVs opened                */
int hd_pvs_opn = 0;           /* Number of PVs in varied on VGs       */

int hd_pbuf_inuse = 0;                /* Number of pbufs currently in use      */

int hd_pbuf_maxuse = 0;              /* Maximum number of pbufs in use during*/
                  /* this boot                      */
#else
extern int hd_pbuf_cnt;
extern int hd_pbuf_grab;
extern int hd_pbuf_min;
extern int hd_vgs_opn;
extern int hd_lvs_opn;
extern int hd_pvs_opn;
extern int hd_pbuf_inuse;
extern int hd_pbuf_maxuse;
#endif

/*
 * The following are used to update the bad block directory on a disk
 */
#ifdef LVDD PHYS
```

**FIG. 21-72**

```
struct pbuf *bb_pbuf;      /* ptr to pbuf reserved for BB dir updating  */
struct hd_queue    bb_hld;              /* holding Q used when there is a BB       */
                        /* directory update in progress               */
#else
extern struct pbuf        *bb_pbuf;
extern struct hd_queue         bb_hld;
#endif


/*
 * The following variables are used to communicate between the LVDD
 * and the kernel process.
 */
#ifdef LVDD_PHYS
pid_t          hd_kpid   = 0;   /* PID of the kernel process               */
#else
extern pid_t        hd_kpid;
#endif


/*
 * The following variables are used in an attempt to keep some information
 * around about the performance and potential bottle necks in the driver.
 * Currently these must be looked at with crash or the kernel debugger.
 */
#ifdef LVDD_PHYS
ulong          hd_pendqblked  = 0; /* How many times the scheduling queue     */
                        /* (pending_Q) has been block due to no        */
                        /* pbufs being available.              */
#else
extern ulong hd_pendqblked;
#endif


/*
 * The following are used to log error messages by LVDD.  The de_data
 * is defined as a general 16 byte array, BUT, it's actual use is
 * totally dependent on the error type.
 */
#define RESRC_NAME        "LVDD"    /* Resource name for error logging     */
struct hd_errlog_ent {          /* Error log entry structure         */
```

FIG. 21-73

```
    struct irr_rec0 id;
    char de_dataff[16];
};


/* macros to allocate and free pbuf structures */
#define GET_PBUF(PB)          { \
                (PB) = hd_freebuf;      \
                hd_freebuf = (struct pbuf *) hd_freebuf-> pb.av_forw; \
                hd_pbuf_inuse + + ; \
                if( hd_pbuf_inuse > hd_pbuf_maxuse ) \
                        hd_pbuf_maxuse = hd_pbuf_inuse; \
                }
#define REL_PBUF(PB)          { \
                (PB)-> pb.av_forw =   (struct buf *) hd_freebuf;     \
                hd freebuf = (PB); \
                hd_pbuf_inuse--; \
                }


/* macros to allocate and free pv_wait structures  */
#define GET_PVWAIT(Pvw, Vg)         { \
                (Pvw) = (Vg)-> ca_freepvw;     \
                (Vg)-> ca_freepvw = (Pvw)-> nxt_pv_wait; \
                }


#define REL_PVWAIT(Pvw, Vg)         { \
                (Pvw)-> nxt_pv_wait = (Vg)-> ca_freepvw;  \
                (Vg)-> ca_freepvw = (Pvw); \
                }


#define TST_PVWAIT(Vg) ((Vg)-> ca_freepvw = = NULL


/*
 * Macro to put volgrp ptr at head of the list of VGs waiting to start
 * MWC cache writes
 */
#define CA_VG_WRT( VG )           { \
                if( !((Vg)-> flags & CA_VGACT) ) \
```

FIG. 21-74

```
                         { \
                         (Vg)-> nxtactvg = hd_vg_mwc; \
                         hd_vg_mwc = (Vg); \
                         (Vg)-> flags | = CA_VGACT; \
                         } \
             }
/*
 * Macro to determine if a physical request should be returned to
 * the scheduling layer or continue(resume).
 */
#define PB_CONT( PB )  { \
    if(((Pb)-> pb_addr = = ((Pb)-> pb_lbuf-> b_baddr + (Pb)-> pb_lbuf-> b_bcount)) || \
        ((Pb)-> pb.b_flags & B_ERROR) ) \
             HD_SCHED( (Pb) ); \
        else \
             hd_resume( (Pb) ): \
   }
/*
 * HD_SCHED -- invoke scheduler policy routine for this request.
 *
 *    For physical requests it invokes the physical operation end policy.
 */
#define HD_SCHED(Pb)   (*(Pb)-> pb_sched)(Pb)


/* define for b_error value (only used by LVDD) */
#define ELBBLOCKED 255                 /* this logical request is blocked by    */
                         /* another on in progress               */

#endif         /* _KERNEL   */

/*
 * Write consistency cache structures and macros
 */

/* cache hash algorithms - returns index into cache hash table */
#define CA_HASH(Lb)        (BLK2TRK((LB)->b_blkno) & (CAHHSIZE-1))
#define CA_THASH(Trk)      ((TRK & (CAHHSIZE-1))
```

FIG. 21-75

```
/*
 * This structure will generally be referred to as part 2 of the cache
 */
struct ca_mwc_mp {        /* cache mirror write consistency memory only part */

    struct ca_mwc_mp    *hq_next;    /* ptr to next hash queue entry       */
    char                state;       /* State of entry           */
    char                pad1;        /* Pad to word                  */
    ushort              iocnt;       /* Non-zero - io active to LTG         */
    struct ca_mwc_dp    *part1;        /* Ptr to part 1 entry - ca_mwc_dp  */
    struct ca_mwc_mp    *next;         /* Next memory part struct         */
    struct ca_mwc_mp    *prev;         /* Previous memory part struct        */
};


/* ca_mwc_mp state defines */
#define CANOCHG            0x00 /* Cache entry has NOT changed since last   */
                               /* cache write operation, but is on a hash    */
                               /* queue somewhere                  */
#define    CACHG          0x01 /* Cache entry has changed since last cache */
                               /* write operation                  */
#define    CACLEAN          0x02   /* Cache entry has not been used since last  */
                               /* clean up operation              */


/*
 * This structure will generally be referred to as part 1 of the cache
 * In order to stay long word aligned this structure has a 2 byte pad.
 * This reduces the number of cache entries available in the cache.
 */
struct ca_mwc_dp {        /* cache mirror write consistency disk part    */

        ulong           lv_ltg;        /* LV logical track group       */
        ushort          lv_minor;    /* LV minor number            */
        short       pad;
};
#define MAX_CA_ENT        62       /* Max number that will fit in block      */
```

FIG. 21-76

```
/*
 * This structure must be maintained to be 1 block in length(512 bytes).
 * This also implies the maximum number of write consistency cache entries.
 */
struct mwc_rec {            /* mirror write consistency disk record      */

   struct timestruc_t     b_tmstamp;     /* Time stamp at beginning of block */
   struct ca_mwc_dp       ca_p lff[MAX_CA_ENT]; /* Reserve 62 part 1 structures   */
   struct timestruc_t     e_tmstamp;     /* Time stamp at end of block       */
};


/*
 * This structure is used by the MWCM.  It is hung on the PV cache write
 * queues to indicate which lbufs are waiting on any particular PV.  The
 * define controls how much memory to allocate to hold these structures.
 * The algorithm is 3 * CA_MULT * cache size * size of structure.
 */
#define CA_MULT              4          /* pv_wait * cache size multiplier   */
struct pv_wait {
   struct pv_wait          *nxt_pv_wait;   /* next pv_wait structure on chain  */
   struct buf              *lb_wait;    /* ptr to lbuf waiting for cache     */
};


/*
 * LVM function declarations - arranged by module in order by how they occur
 * in said module.
 */
#ifdef_KERNEL
#ifndef_NO_PROTO

/* hd_mircach.c */

extern int hd_ca_ckcach (
          register struct buf      *lb,   /* current logical buf struct    */
          register struct volgrp   *vg,   /* ptr to volgrp structure       */
          register struct lvol     *lv);  /* ptr to lvol structure         */
```

FIG. 21-77

112

```
extern void hd_ca_use (
      register struct volgrp    *vg,      /* ptr to volgrp structure      */
      register struct ca_mwc_mp  *ca_ent,/* cache entry pointer  */
      register int h_t);          /* head/tail flag          */

extern struct ca_mwc_mp *hd_ca_new (
      register struct volgrp    *vg); /* ptr to volgrp structure        */

extern void hd_ca_wrt (void);

extern void hd_ca_wend (
      register struct pbuf *pb);       /* Address of pbuf completed      */

extern void hd_ca_sked(
      register struct volgrp   *vg,  /* ptr to volgrp structure    */
      register struct pvol     *pvol);    /* pvol ptr for this PV            */

extern struct ca_mwc_mp *hd_ca_fnd(
      register struct volgrp   *vg,  /* ptr to volgrp structure    */
      register struct buf      *lb);  /* ptr to lbuf to find the entry*/
                                 /* for                    */

extern void hd_ca_clnup(
      register struct volgrp    *vg); /* ptr to volgrp structure      */

extern void hd_ca_qunlk(
      register struct volgrp    *vg,  /* ptr to volgrp structure    */
      register struct ca_mwc_mp  *ca_ent);/* ptr to entry to unlink  */

extern int hd_ca_pvque(
      register struct buf      *lb,  /* current logical buf struct  */
      register struct volgrp   *vg,  /* ptr to volgrp structure    */
      register struct lvol     *lv);  /* ptr to lvol structure      */

extern void hd_ca_end (
      register struct pbuf *pb);        */ physical device buf struct  */

extern void hd_ca_term (
```

**FIG. 21-78**

```
        register struct buf        *lb);  /* current logical buf struct    */

extern void hd_ca_mvhld (
        register struct volgrp    *vg);  /* ptr to volgrp structure         */


/* hd_dump.c */


extern int hd_dump (
        dev_t              dev,   /* major/minor of LV              */
        struct uio    *uiop,        /* ptr to uio struct describing operation*/
        int             cmd,  /* dump command
        char            *arg,  /* cmd dependent - ptr to dmp_query struct*/
        int             chan,       /* not used                      */
        int             ext);  /* not used                        */


extern int hd_dmpxlate(
        register dev_t            dev,  /* major/minor of LV             */
        register struct uio        *luiop,    /* ptr to logical uio structure     */
        register struct volgrp   *vg);  /* ptr to VG from device switch table*/


/* hd_top.c */


extern int hd_open(
        dev_t dev,  /* device number major,minor of LV to be opened */
        int flags,    /* read/write flag        /*
        int chan,    /* not used             /*
        int ext);    /* not used             /*


extern int hd_allocpbuf(void);


extern void hd_pbufdmpq(
        register struct pbuf *pb,            /* new pbuf for chain   */
        register struct pbuf **qq);          /* Ptr to queue anchor           */


extern void hd_openbkout(
        int           bopoint,    /* point to start backing out             */
```

## FIG. 21-79

```
        struct volgrp    *vg);        /* struct volgrp ptr                */

extern void hd_backout(
        int         bopoint,/* point where error occurred & need to   */
                            /* backout all structures pinned before   */
                            /* this point                             */
        struct lvol  *lv,   /* ptr to lvol to backout                 */
        struct volgrp    *vg);   /* struct volgrp ptr                 */

extern int hd_close(
        dev_t       dev,  /* device number major,minor of LV to be closed  */
        int    chan,     /* not used */
        int    ext); /* not used */

extern void hd_vgcleanup(
        struct volgrp    *vg);        /* struct volgrp ptr              */

extern void hd_frefrebb(void);

extern int hd_allocbblk(void);

extern int hd_read(
        dev_t       dev,              /* num major,minor of LV to be read   */
        struct uio *uiop,  /* pointer to uio structure that specifies    */
                           /* location & length of caller's data buffer*/
        int    chan,       /* not used */
        int    ext);       /* extension parameters */

extern int hd_write(
        dev_t       dev,              /* num major,minor of LV to be written   */
        struct uio *uiop,  /* pointer to uio structure that specifies */
                           /* location & length of caller's data buffer*/
        int    chan,       /* not used */
        int    ext);       /* extension parameters */

extern int hd_mincnt(
        struct buf  *bp,    /* ptr to pbuf struct to be checked   */
        void        *minparms); /* ptr to ext value sent to uphysio by*/
```

FIG. 21-80

/* hd_read/hd_write.                              */

```
extern int hd_ioctl(
        dev_t       dev,  /* device number major,minor of LV to be opened */
        int     cmd,/* specific ioctl command to be performed    */
        int     arg,        /* addr of parameter blk for the specific cmd   */
        int     mode,    /* request origination                         */
        int     chan,      /* not used */
        int     ext); /* not used */
```

extern struct mwc_rec  * hd_alloca(void);

```
extern void hd_dealloca(
        register struct mwc_rec  *ca_ptr);   /* ptr to cache to free   */
```

```
extern void hd_nodumpvg(
        struct volgrp *);
```

/* hd_phys.c */

```
extern void hd_begin(
        register struct pbuf *pb,      /* physical device buf struct */
        register struct volgrp *vg);   /* physical to volgrp struct    */
```

```
extern void hd_end(
        register struct pbuf *pb);     /* physical device buf struct */
```

```
extern void hd_resume(
        register struct pbuf *pb);     /* physical device buf struct */
```

```
extern void hd_ready(
        register struct pbuf *pb);     /* physical request buf            */
```

extern void hd_start(void);

extern void hd_gettime(

**FIG. 21-81**

```
        register struct timestruc_t  *o_time);     /* oldtime              */


/* hd_bbrel.c */


extern int hd_chkblk(
        register struct pbuf *pb);      /* physical device buf struct */


extern void hd_bbend(
        register struct pbuf *pb);      /* physical device buf struct */


extern void hd_baddone(
        register struct pbuf *pb);      /* physical request to process      */


extern void hd_badblk(
        register struct pbuf *pb);      /* physical request to process      */


extern void hd_swreloc(
        register struct pbuf *pb);      /* physical request to process      */


extern daddr_t hd_assignalt(
        register struct pbuf *pb);      /* physical request to process      */


extern struct bad_blk *hd_fndbbrel(
        register struct pbuf *pb);      /* physical request to process */


extern void hd_nqbblk(
        register struct pbuf *pb);      /* physical request to process      */


extern void hd_dqbblk(
        register struct pbuf *pb,       /* physical request to process      */
        register daddr_t blkno);


/* hd_sched.c */


extern void hd_schedule(void);


extern int hd_avoid(
        register struct buf      *lb,   /* logical request buf      */
```

FIG.  21-82

117

```
        register struct volgrp    *vg);  /* VG volgrp ptr           */

extern void hd_resyncpp(
        register struct pbuf *pb);      /* physical device buf struct */

extern void hd_freshpp(
        register struct volgrp    *vg,  /* pointer to volgrp struct    */
        register struct pbuf      *pb);     /* physical request buf        */

extern void hd_mirread(
        register struct pbuf *pb);      /* physical device buf struct  */

extern void hd_fixup(
        register struct pbuf *pb);      /* physical device buf struct  */

extern void hd_stalepp(
        register struct volgrp    *vg,  /* pointer to volgrp struct    */
        register struct pbuf *pb);      /* physical device buf struct */

extern void hd_staleppe(
        register struct pbuf *pb);      /* physical request buf           */

extern void hd_xlate(
        register struct pbuf      *pb,  /* physical request buf        */
        register int      mirror,       /* mirror number              */
        register struct    volgrp      *vg); /* VG volgrp ptr          */

extern int hd_regular(
        register struct buf       *lb,  /* logical request buf         */
        register struct volgrp    *vg); /* volume group structure      */

extern void hd_finished(
        register struct pbuf *pb);      /* physical device buf struct  */

extern int hd_sequential(
        register struct buf       *lb,  /* logical request buf         */
        register struct volgrp    *vg); /* volume group structure      */
```

FIG. 21-83

```
extern void hd_seqnext(
        register struct pbuf      *pb); /* physical request buf              */
        register struct      volgrp      *vg); /* VG volgrp pointer          */

extern void hd_seqwrite(
        register struct pbuf *pb);        /* physical device buf struct  */

extern int hd_parallel(
        register struct buf       *lb,   /* logical request buf         */
        register struct volgrp    *vg);  /* volume group structure      */

extern void hd_freeall(
        register struct pbuf *q);        /* write request queue         */

extern void hd_append(
        register struct pbuf *pb,        /* physical request pbuf       */
        register struct pbuf **qq);      /* Ptr to write request queue anchor */

extern void hd_nearby(
        register struct pbuf      *pb,   /* physical request pbuf       */
        register struct buf       *lb,   /* logical request buf         */
        register int             mask,   /* mirrors to avoid            */
        register struct volgrp    *vg,   /* volume group structure      */
        register struct lvol      *lv);

extern void hd_parwrite(
        register struct pbuf *pb);       /* physical device buf struct  */

/* hd_strat.c */

extern void hd_strategy(
        register struct buf *lb);        /* input list of logical buf structs */

extern void hd_initiate(
        register struct buf *lb);        /* input list of logical buf's */
```

FIG. 21-84

119

```
extern struct buf *hd_reject(
        struct buf    *lb,          /* offending buf structure      */
        int           errno);          /* error number              */

extern void hd_quiescevg(
        struct volgrp    *vg);  /* pointer from device switch table      */

extern void hd_quiet(
        dev_t              dev,   /* number major,minor of LV to quiesce      */
        struct volgrp      *vg);  /* ptr from device switch table            */

extern void hd_redquiet(
        dev_t              dev,          /* number major,minor of LV      */
        struct hd_lvred    *red_lst);   /* ptr to list of PPs to remove    */

extern int hd_add2pool(
        register struct pbuf *subpool,     /* ptr to pbuf sub pool            */
        register struct pbuf *dmpq);   /*ptr to pbuf dump queue    */

extern void hd_deallocpbuf(void);

extern int hd_numpbufs(void);

extern void hd_terminate(
        register struct buf *lb);         /* logical buf struct            */

extern void hd_unblock(
        register struct buf *next,        /* first request on hash chain       */
        register struct buf *lb);         /* logical request to reschedule*/

extern void hd_quelb (
        register struct buf        *lb,   /* current logical buf struct  */
        register struct hd_queue *que);   /* queue structure prt            */

extern int hd_kdis_initmwc(
        struct volgrp *vg);                /* volume group pointer */
```

FIG. 21-85

120

```
extern int hd_kdis_dswadd(
        register dev_t          device,   /* device number of the VG      */
        register struct devsw   *devsw); /* address of the devsw entry   */

extern int hd_kdis_chgqrm(
        struct volgrp       *vg          /* volume group pointer */
        short               newqrm);   /* new quorum count */ .

extern int hd_kproc(void);

/* hd_vgsa.c */

extern int hd_sa_strt(
        register struct pbuf      *pb,  /* physical device buf struct   */
        register struct volgrp    *vg,  /* volgrp pointer               */
        register int        type);      /* type of request              */

extern void hd_sa_wrt(
        register struct volgrp    *vg); /* volgrp pointer               */

extern void hd_sa_iodone(
        register struct buf       *lb);  /* ptr to lbuf in VG just completed */

extern void hd_sa_cont(
        register struct volgrp    *vg,  /* volgrp pointer               */
        register int sa_updated);       /* ptr to lbuf in VG just completed */

extern void hd_sa_hback(
        register struct pbuf      *head_ptr, /* head of pbuf list            */
        register struct pbuf      *new_pbuf); /* ptr to pbuf to append to list */

extern void hd_sa_rtn(
        register struct pbuf      *head_ptr, /* head of pbuf list            */
        register int err_flg);      /* if true return requests with      */
                                    /* ENXIO error                       */

extern int hd_sa_whladv(
```

FIG. 21-86

121

```
        register struct volgrp    *vg,   /* volgrp pointer                    */
        register int c_whl_idx);         /* current wheel index               */


extern void hd_sa_update(
        register struct volgrp    *vg); /* volgrp pointer                     */


extern int hd_sa_qrmchk(
        register struct volgrp    *vg); /* volgrp pointer                     */


extern int hd_sa_config(
        register struct volgrp    *vg,   /* volgrp pointer                    */
        register int       type,  /* type of hd_config request    */
        register caddr_t   arg);  /* ptr to arguments for the request  */


extern int hd_sa_onerev(
        register struct volgrp    *vg,   /* volgrp pointer                    */
        register struct pbuf      *pv,   /* ptr pbuf structure                */
        register int       type);        /* type of hd_config request     */


extern void hd_bldpbuf(
        register struct pbuf    *pb,    /* ptr to pbuf struct             */
        register struct pvol      *pvol,    /* target pvol ptr              /*
        register int       type,  /* type of pbuf to build        */
        register caddr_t   buffaddr,/* data buffer address - system   */
        register unsigned cnt,    /* length of buffer             */
        register struct xmem    *xmem,   /* ptr to cross memory descriptor */
        register void             (*sched)()); /* ptr to function ret void */


extern int hd_extend(
        struct sa_ext *saext);          /* ptr to structure with extend info    */


extern void hd_reduce(
        struct sa_red *sared,           /* ptr to structure with reduce info    */
        struct volgrp *vg);             /* ptr to volume group structure */


/* hd_bbdir.c */


extern void hd_upd_bbdir(
```

FIG. 21-87

122

```
        register struct pbuf *pb);        /* physical request to process */

extern void hd_bbdirend(
        register struct pbuf *vgpb);     /* ptr to VG bb_pbuf              */

extern void hd_bbdirop( void );

extern int hd_bbad(
        register struct pbuf *vgpb);     /* ptr to VG bb_pbuf              */

extern int hd_bbdel(
        register struct pbuf *vgpb);     /* ptr to VG bb_pbuf              */

extern int hd_bbupd(
        register struct pbuf *vgpb);     /* ptr to VG bb_pbuf              */

extern void hd_chk_bbhld( void );

extern void hd_bbdirdone(
        register struct pbuf *origpb);       /* physical request to process */

extern void hd_logerr(
        register unsigned id,    /* original request to process      */
        register ulong           dev,  /* device number            */
        register ulong           arg1,
        register ulong           arg2);

#else

/*    See above for description of call arguments     */

/* hd_mircach.c */

extern int          hd_ca_ckcach ( );
extern void              hd_ca_use ( );
extern struct ca_mwc_mp      *hd_ca_new ( );
extern void              hd_ca_wrt ( );
extern void              hd_ca_wend ( );
```

FIG. 21-88

```
extern void              hd_ca_sked ( );
extern struct ca_mwc_mp  *hd_ca_fnd ();
extern void              hd_ca_clnup ( );
extern void              hd_ca_qunlk ( );
extern int          hd_ca_pvque ( );
extern void              hd_ca_end ( );
extern void              hd_ca_term ( );
extern void              hd_ca_mvhld ( );


/* hd_dump.c */


extern int          hd_dump ( );
extern int          hd_dmpxlate ( );


/* hd_top.c */


extern int          hd_open ( );
extern int          hd_allocpbuf ( );
extern void              hd_pbufdmpq ( );
extern void              hd_openbkout ( );
extern void              hd_backout ( );
extern int          hd_close ( );
extern int          hd_vgcleanup ( );
extern void              hd_frefrebb ( );
extern int          hd_allocpbblk ( );
extern int          hd_read ( );
extern int          hd_write ( );
extern int          hd_mincnt ( );
extern int          hd_ioctl ( );
extern struct mwc_rec   *hd_alloca ( );
extern void              hd_dealloca ( );
extern void              hd_nodumpvg ( );


/* hd_phys.c */


extern void              hd_begin ( );
extern void              hd_end ( );
extern void              hd_resume ( );
```

**FIG. 21-89**

```
extern void              hd_ready ( );
extern void              hd_start ( );
extern void              hd_gettime ( );


/* hd_bbrel.c */

extern int          hd_chkblk ( );
extern void              hd_bbend ( );
extern void              hd_baddone ( );
extern void              hd_badblk ( );
extern void              hd_swreloc ( );
extern daddr_t           hd_assignalt ( );
extern struct bad_blk    *hd_fndbbrel ( );
extern void              hd_nqbblk ( );
extern void              hd_dqbblk ( );


/* hd_sched.c */

extern void               hd_schedule ( );
extern int          hd_avoid ( );
extern void              hd_resyncpp ( );
extern void              hd_freshpp ( );
extern void              hd_mirread ( );
extern void              hd_fixup ( );
extern void              hd_stalepp ( );
extern void              hd_stalepp ( );
extern void              hd_xlate ( );
extern int          hd_regular ( );
extern void               hd_finished ( );
extern int          hd_sequential ( );
extern int          hd_seqnext ( );
extern void               hd_seqwrite ( );
extern int          hd_parallel ( );
extern void              hd_freeall ( );
extern void              hd_append ( );
extern void              hd_nearby ( );
extern void              hd_parwrite ( );
```

**FIG. 21-90**

```
/* hd_strat.c */

extern void            hd_strategy ( );
extern void            hd_initiate ( );
extern struct buf    *hd_reject ( );
extern void            hd_quiescevg ( );
extern void            hd_quiet ( );
extern void            hd_redquiet ( );
extern int         hd_add2pool ( );
extern void            hd_deallocpbuf ( );
extern int         hd_numpbufs ( );
extern void            hd_terminate ( );
extern void            hd_unblock ( );
extern void            hd_quelb ( );
extern void            hd_kdis_dswadd ( );
extern void            hd_kdis_initmwc ( );
extern int         hd_kdis_chgqrm ( );
extern int         hd_kproc ( );


/* hd_vgsa.c */

extern int         hd_sa_strt ( );
extern void            hd_sa_wrt ( );
extern void            hd_sa_iodone ( );
extern void            hd_sa_cont ( );
extern void            hd_sa_hback ( );
extern void            hd_sa_rtn ( );
extern int         hd_sa_whladv ( );
extern void            hd_sa_update ( );
extern int         hd_sa_qrmchk ( );
extern int         hd_sa_config ( );
extern void            hd_bldpbuf ( );
extern int         hd_extend ( );
extern void            hd_reduce ( );
extern void            hd_sa_onerev ( );


/* hd_bbdir.c */
```

FIG. 21-91

```
extern void          hd_upd_bbdir ( );
extern void          hd_bbdirend ( );
extern void          hd_bbdirop ( );
extern int       hd_bbadd ( );
extern int       hd_bbdel ( );
extern int       hd_bbupd ( );
extern void          hd_chk_bbhld ( );
extern void          hd_bbdirdone ( );
extern void          hd_logerr ( );

#endif      /* _NO_PROTO */
#endif      /* _KERNEL   */


#endif /* _H_HD */
```

Subject: LVM code

```
static char sccsidff[ ] = "@(#)hd_vgsa.c 1.4 com/sysx/lvm,3.1.1 10/11/90 18:59:17";
/*
 * COMPONENT_NAME; (SYSXLVM) Logical Volume Manager Device Driver - hd_vgsa.c
 *
 * FUNCTIONS; hd_sa_strt, hd_sa_wrt, hd_sa_iodone, hd_sa_cont, hd_sa_hback,
 *      hd_sa_rtn, hd_sa_whladv, hd_sa_update, hd_sa_qrmchk,
 *      hd_sa_config, hd_bldpbuf, hd_sa_onerev, hd_reduce, hd_extend,
 *
 * © COPYRIGHT International Business Machines Corp. 1989, 1990
 * All Rights Reserved
 *
 */


/*
 *
 * hd_vgsa.c -- LVM device driver Volume Group Status Area support routines
 *
 *
 *    These routines handle the volume Group Status Area(VGSA) used
 *    to maintain the state of physical partitions that are copies of each
 *    other.  The VGSA also indicates whether a physical volume is missing.
```

FIG. 21-92

127

```
*
* Function:
*
* Execution environment:
*
*    All these routines run on interrupt levels, so they are not
*    permitted to page fault.  They run within critical sections
*    that are serialized with block I/O offlevel iodone( ) processing.
*/


#include < sys/types.h >
#include < sys/errno.h >
#include < sys/intr.h >
#include < sys/malloc.h >
#include < sys/sleep.h >
#include < sys/hd_psn.h >
#include < sys/dasd.h >
#include < sys/vgsa.h >
#include < sys/hd_config.h >
#include < sys/trchkid.h >
#include < sys/hd.h >

/*
* NAME:        hd_sa_strt
*
* FUNCTION:         Process a new SA request.  Put the request on the hold list
*          (sa_hld_lst).  If the wheel is not rolling start it.
*
* NOTES:
*
* PARAMETERS:
*
* DATA STRUCTS:
*
* RETURN VALUE: SUCCESS or FAILURE
*/
```

FIG. 21-93

128

```
int
hd_sa_strt(
register struct pbuf      *pb,        /* physical device buf struct   */
register struct volgrp    *vg,        /* volgrp pointer               */
register int         type)           /* type of request              */
{
        register struct pbuf      *hlst;        /* temporary sa_hld_lst ptr    */
        register int         rc;      /* general function return code    */

        /*
         * If the VG is closing don't start anything
         */
        if( vg-> flags & VG_FORCEDOFF )
           return( FAILURE );


        /*
         * If "pb" is NULL then this is a restart from the config routines.
         * The config routines got control of the WHEEL but then found they
         * did not change anything so they just want to restart it.
         */
        if( pb ) {
           /*
            * Save the type of the request and hang it on the hold list
            */
           pb-> pb_type = type;
           pb-> pb.av_forw = NULL;
           if( vg-> sa_hld_lst ) {
              /*
               * Find end of list
               */
              hlst = vg-> sa_hld_lst;
              while( hlst-> pb.av_forw )
                 hlst = (struct pbuf *)(hlst-> pb.av_forw);
              hlst-> pb.av_forw = (struct buf *)pb;
           }
           else
              vg-> sa_hld_lst = pb;
```

FIG. 21-94

129

```
        }

        /*
         * Start the wheel if not rolling already
         */
        if( !(vg-> flags & (SA_WHL_ACT | SA_WHL_HLD)) ) {
            vg-> flags |= SA_WHL_ACT;

            /*
             * Generate a cross memory descriptor - see hd_sa_wrt( )
             * for reason why it is done here.
             */
            vg-> sa_lbuf.b_xmemd.aspace_id = XMEM_INVAL;
            rc = xmattach( vg-> vgsa_ptr, sizeof( struct vgsa_area ),
                    &(vg-> sa_lbuf.b_xmemd), SYS_ADSPACE);
            ASSERT ( rc = = XMEM_SUCC );

            hd_sa_cont( vg, 0 );
        }

        return( SUCCESS );
}

/*
 * NAME:          hd_sa_wrt
 *
 * FUNCTION:          Build a buf structure to do logical IO to write the next
 *       SA on the wheel.
 *
 * NOTES:
 *
 * PARAMETERS:
 *
 * DATA STRUCTS:
 *
 * RETURN VALUE: none
 */
void
```

FIG. 21-95

```
hd_sa_wrt(
register struct volgrp      *vg)          /* volgrp pointer                    */
{
    register struct buf          *lb;   /* ptr to lbuf in volgrp struct        */
    register int            widx;       /* VG wheel index                      */

    register int            rc;    /* function return code          */

    struct   xmem                 xmemd;  /* area to save the xmem descriptor*/

    widx = vg-> wheel_idx;
    /*
     * Save the cross memory descriptor then zero the buf structure
     * then stuff it with the necessary fields
     *
     * Saving the cross memory descriptor is faster than attaching/
     * detatching on each PV write.  This way we can attach when
     * the wheel is started and not detach until it stops.
     */

    lb = &(vg-> sa_lbuf);
    xmemd = lb-> b_xmemd;
    bzero( lb, sizeof(struct buf) );

    lb-> b_flags          = B_BUSY;
    lb-> b_iodone         = hd_sa_iodone;
    lb-> b_dev            = makedev( vg-> major_num, 0);
    lb-> b_blkno          = GETSA_LSN( vg, widx );
    lb-> b_baddr          = (caddr_t)(vg-> vgsa_ptr);
    lb-> b_bcount         = sizeof( struct vgsa_area );
    lb-> b_options        = REQ_VGSA;
    lb-> b_event          = EVENT_NULL;

    /* restore the cross memory descriptor */
    lb-> b_xmemd = xmemd;

    /*
     * Save the wheel sequence number that is being written to this
```

FIG. 21-96

```
     * VGSA
     */
    SETSA_SEQ( vg, widx, vg-> whl_seq_num );

    /*
     * Call hd_regular( ) to translate the logical request then hd_start( )
     * to issue it to the disk drivers.
     *
     * NOTE: hd_regular( ) will use the embedded pbuf in the volgrp
     *       structure, therefore it will never fail due to no
     *       pbufs available.  This also means that LV0 does not
     *       have to be open!
     */
    hd_regular( lb, vg );
    hd_start ( );

    return;
}


/*
 * NAME:          hd_sa_iodone
 *
 * FUNCTION:          Return point for end of VGSA write operation.
 *
 *NOTES:          Process any error on the write.  This means marking the
 *          PV as missing.  Then call hd_sa_cont( ) to start the next
 *          SA write if more to do.
 *
 *          If a PV is marked as missing there is no pbuf needed to
 *          remember when this happened.  BECAUSE, there is no
 *          specific request waiting on any one particular SA write
 *          request.  THEREFORE, the only thing that must be done
 *          is to ensure the wheel keeps rolling for at least one more
 *          revolution from this point.  This is done by bumping the
 *          whl_seq_num variable.
 *
 * PARAMETERS:
 *
```

FIG.  21-97

```
 * DATA STRUCTS:
 *
 * RETURN VALUE: none
 */
void
hd_sa_iodone(
register struct buf        *lb)           /* ptr to lbuf in VG just completed */
{
   register int       sa_updated = 0;      /* nonzero indicates SA updated      */

   struct volgrp      *vg;  /* VG volgrp ptr from devsw table          */


   /* get the volgrp ptr from device switch table       */
   (void) devswqry( lb-> b_dev, NULL, &vg );

   lb-> b_flags & = ~B_BUSY;

   /*
    * If error on write mark the PV missing
    */
   if( lb-> b_flags & B_ERROR ) {
      /*
       * Change pvstate to missing.  Set pvmissing flag in VGSA.  Check
       * for quorum.  Change VGSA timestamp and sequence number.
       * Log an error message concerning the missing PV.
       *
       */
      register struct pvol        *pvol;      /* ptr to pvol of missing pv */

      pvol = vg-> sa_pbuf.pb_pvol;

      pvol-> pvstate = PV_MISSING;
      SETSA_PVMISS( vg-> vgsa_ptr, pvol-> pvnum );
      (void) hd_sa_qrmchk( vg );
      sa_updated = 1;
      hd_sa_update( vg );
```

FIG. 21-98

```
    /*
     error message(????);
     */

  }

  /*
   * Continue to next VGSA write
   */
  hd_sa_cont( vg, sa_updated );

  return;
}

/*
 * NAME:   hd_sa_cont
 *
 * FUNCTION:    Continue writing VGSA areas
 *
 * NOTES:         This function is used to start the wheel or keep it
 *                rolling.  The only thing that stops the wheel once
 *                it is rolling is the whl_seq_num variables.  When the
 *                last write sa_seq_num matches the next one we are
 *                complete.
 *
 *                If the VG is closing due to a loss of quorum then all
 *                active requests are returned with errors.  This will
 *                result in an error being returned with the original
 *                request.  Because of the loss of quorum we can not
 *                guarantee the VGSA was updated with the correct information.
 *                Any user data will be recovered by the MWC cache.
 *
 * PARAMETERS:
 *
 * DATA STRUCTS:
 *
 * RETURN VALUE: none
 */
void
```

FIG. 21-99

134

```
hd_sa_cont(
register struct volgrp      *vg              /* volgrp pointer                    /*
register int         sa_updated)      /* ptr to lbuf in VG just completed */
{

    register struct pbuf *hld_req;         /* ptr to request being moved to */
                                    /* active list
    register struct pbuf *alst;            /* temp sa_act_lst ptr          */
    register struct buf    **alst_forw;       * address of sa_act_lst av_forw ptr*/
    register struct pbuf *new_req = NULL:        /* ptr to the first new request      */
                                    /* that was put on the active list */
    register struct buf      *alst_lb;    /* ptr to lbuf for active list pbuf*/
    register struct buf      *hld_lb;    /* ptr to lbuf for hold request pbuf*/
    register int         n_whl_idx;        /* new wheel index              */
    register int         i;               /* general counter              */




    /*
    * Put the wheel on hold if some config process wants control of it and
    * that process is not waiting for the wheel to stop.  Then
    * wake that process up.  Said process will restart the wheel when
    * it is finished making it's changes
    *
    * *NOTE*  It is assumed the process has everything it needs in memory
    *       and it is all pinned.
    */
    if( (vg-> config_wait != EVENT_NULL) && !(vg-> flags & SA_WHL_WAIT) ) {
        vg-> flags |= SA_WHL_HLD;
        vg-> flags & = ~SA_WHL_ACT;
        xmdetach( &(vg-> sa_lbuf.b_xmemd) );
        e_wakeup( &(vg-> config_wait) );
        return;
    }

    /*
```

FIG. 21-100

```
* Move any requests currently on the hold list to the active list
*/
while( vg-> sa_hld_lst ) {

        /* Get pbuf at head of list */
        hld_req = vg-> sa_hld_lst;
        vg-> sa_hld_lst = (struct pbuf *)(hld_req-> pb.av_forw);

        hld_req-> pb.av_forw = NULL;
        hld_req-> pb.av_back = NULL;

        /*
         * Scan active list for any request that is doing the same
         * type of request on the same PPs/PVs.  If one is found
         * then hang this request on the av_back list.  Thus, this
         * request will be allowed to continue when the head of the
         * av_back list is allowed.
         */
        alst = vg-> sa_act_lst;
        alst_forw = (struct buf **)(&(vg-> sa_act_lst));
        /*
         * Scan the active list until the end or we find a match
         */
        while( hld_req && alst ) {
            if(  alst-> pb_type != hld_req-> pb_type ) {
                alst_forw = (struct buf **)(&(alst-> pb.av_forw));
                alst = (struct pbuf *)(alst-> pb.av_forw);
                continue;
            }
            switch( alst-> pb_type ) {

                case SA_PVMISSING:
                case SA_PVREMOVED:

                    /*
                     * Check the pvol addresses in the pbufs
                     */
```

FIG. 21-101

```
if( alst-> pb_pvol = = hld_req-> pb_pvol ) {
    /*
     * We have a match.  Hang the new request
     * on the av_back list.
     */
    hd_sa_hback( alst, hld_req );
    hld_req = NULL;
}
break;

case SA_STALEPP:

/*
 * Check that the device number(b_dev) are the same
 * in the corresponding lbufs.  Then that the LPs
 * are the same.  And finally the actual mirrors.
 */
alst_lb = alst-> pb_lbuf;
hld_lb = hld_req-> pb_lbuf;
if( (alst_lb-> b_dev = = hld_lb- b_dev) &&
    (BLK2PART(vg-> partshift, alst_lb-> b_blkno) = =
    BLK2PART(vg-> partshift, hld_lb-> b_blkno))  ) {

    /*
     * Check mirrors - if a mirror is stale on the
     * active list pbuf but not in the new request
     * pbuf count it as a match.  If the bits are
     * reversed the new request must be put on the
     * active list (av_forw) since it must wait
     * for the PP to be marked as stale.
     */
    for( i=0; i < MAXNUMPARTS; i + + ) {
        if( (alst-> pb_mirbad & (1 < < i)) ¬
            (hld_req-> pb_mirbad & (1 < < i)) ) {

            if( !(alst-> pb_mirbad & (1 < < i)) ) {
                break;
            }
```

FIG. 21-102

137

```
                }
            }

        if( i = = MAXNUMPARTS ) {
            /*
             * We have a match.  Hang the new request
             * on the av_back list.
             */
            hd_sa_hback( alst, hld_req );
            hld_req = NULL;
        }
    }
    break;

case SA_FRESHPP:
case SA_CONFIGOP:

    /*
     * Since there can only be one resync operation per
     * LP all fresh PP operations must be unique.
     * Therefore, we can go directly to the end of
     * the active list.
     *
     * The same thing holds true for config operations.
     * There can only be one active in the VG at a time.
     */
    break;

default:
    panic("hd_sa_cont: unknown pbuf type");

} /* END switch on pb_type */
/*
 *  If the new request pointer is NULL then the request was
 *  put on the av_back list and we can carry on.  Otherwise,
 *  we must look further down the av_forw list.
 */
```

FIG. 21-103

```
if( hld_req ) {
    alst_forw = (struct buf * *)(&(alst-> pb.av_forw));
    alst = (struct pbuf *)(alst-> pb.av_forw);
}
} /* END while( hld_req && alst ) */
/*
 *  If alst is NULL we are at the end of the active list.
 *  Put the new request on the list and modify the VGSA as per
 *  the type of request.
 */
if( !alst ) {
    *alst_forw = (struct buf *)hld_req;

    /*
     *  If the timestamp on the memory version of the VGSA has
     *  not been bumped do it now.  Then remember the address of
     *  this first pbuf to be added to active list this pass.
     */
    if( !sa_updated ) {
        sa_updated = 1;
        hd_sa_update( vg );
    }
    if( !new_req )
        new_req = hld_req;

    switch( hld_req-> pb_type ) {

            register struct lvol    *lv; /* ptr to lvol structure      */
            register struct part    *part;   /* ptr to PP part structure*/
            register ulong          lp;  /* request LP number        */
            register ulong          pp; /* mirror PP number          */
            register int        mirrors;/* mirror mask for action   */
            register int        i;    /* general                   */

            case SA_PVMISSING:
            case SA_PVREMOVED:
```

FIG. 21-104

```
/*
 * Change pvstate to missing.  Set pvmissing flag in
 * VGSA.  (If removed PV, update the VG's quorum count.
 * before it is rechecked.) Check the quorum.
 * Log an error message concerning the missing/removed PV.
 */
hld_req-> pb_pvol-> pvstate = PV_MISSING;
SETSA_PVMISS( vg-> vgsa_ptr, hld_req-> pb_pvol-> pvnum );
if ( hld_req-> pb_type = = SA_PVREMOVED )
   vg-> quorum_cnt = hld_req-> pb.b_work;
(void) hd_sa_qrmchk( vg );
/*
error message(????)
*/

   break;

case SA_STALEPP:
case SA_FRESHPP:

   /*
    * For SA_STALEPP the pb_mirbad field in the pbuf
    * indicates which mirrors should be marked as
    * stale.  For SA_FRESHPP the pb_mirdone field in
    * the pbuf indicates which mirrors should be made
    * fresh(active).
    *
    * Find the LV lvol structure and LP number of the
    * logical request.
    */
   if( hld_req-> pb_type = = SA_STALEPP )
      mirrors = hld_req-> pb_mirbad;
   else
      mirrors = hld_req-> pb_mirdone;
   hld_lb = hld_req-> pb_lbuf;
   lv = VG_DEV2LV( vg, hld_lb-> b_dev );
   lp = BLK2PART( vg-> partshift, hld_lb-> b_blkno );
   /*
```

FIG. 21-105

```
*   Now scan the mirrors bits and for each one that
*   is set log an error message concerning the
*   operation then set/reset corresponding
*   bit in the in memory version of the VGSA.
*/
while( mirrors ) {
    i = FIRST_MASK( mirrors );
    mirrors & = (˜(MIRROR_MASK ( i )));
    part = PARTITION( lv, lp, i );
    pp = BLK2PART( vg-> partshift,
                  part-> start - part-> pvol-> fst_usr_blk );
    if( hld_req-> pb_type = = SA_STALEPP ) {
        /*
        error message(????) STALE pp + 1
        */
        SETSA_STLPP(vg-> vgsa_ptr,part-> pvol-> pvnum,pp);
    }
    else {
        /*
        error message(????) FRESH pp + 1
        */
        CLRSA_STLPP(vg-> vgsa_ptr,part-> pvol-> pvnum,pp);
    }
}

    break;

case SA_CONFIGOP:

    /*
    *   No action needed on a hd_config routine request.
    *   the in memory version was modified when the wheel
    *   was put on hold and control passed to the config
    *   routines.
    */

    break:
```

**FIG. 21-106**

141

```
            default:
                panic("hd_sa_cont: unknown pbuf type");

        } /* END of switch on pb_type */
    } /* END of if( !alst ) */
} /* END while( sa_hld_lst ) */

/*
 *   At this point everything is on the active list and the appropriate
 *   action taken.  If we have lost a quorum due to said action then
 *   return all requests on the active lists with errors(ENXIO) if
 *   they do not currently have an error indicated.  Before getting out
 *   clear the active and hold flags and detach the VGSA memory area.
 */
if( vg-> flags & VG_FORCEDOFF ) {
    while( vg-> sa_act_lst ) {
        /* Get pbuf at head of list */
        alst = vg-> sa_act_lst;
        vg-> sa_act_lst = (struct pbuf *)(alst-> pv.av_forw);
        hd_sa_rtn( alst, RTN_ERR );
    }
    vg-> flags & = (~(SA_WHL_ACT | SA_WHL_HLD));
    xmdetach( &(vg-> sa_lbuf.b_xmemd) );
    /*
     *   If the wait flag is on then a config function is waiting for
     *   the wheel to stop.  So, inform that function that is has.  This
     *   is used so the varyoffvg function will wait, if the wheel is
     *   rolling, before removing the data structures.
     */
    if( vg-> flags & SA_WHL_WAIT ) {
        vg-> flags & = ~SA_WHL_WAIT;
        e_wakeup( &(vg-> config_wait) );
    }
    return;
} /* END if( VG closing ) */

/*
```

FIG. 21-107

```
*   Now see if any request should get off of the wheel. This algorithm
*   assumes that a VGSA can not be removed from the wheel if anyone is
*   using it as a stopping point.
*/


n_whl_idx = hd_sa_whladv( vg, vg-> wheel_idx );
while( (vg-> sa_act_lst) && (new_req != vg-> sa_act_lst) ) {
    if(vg->sa_act-lst-> pb_whl_stop = = n_whl_idx ) {
        /*
         * Time for this request to get off the wheel and continue
         */
        alst = vg-> sa_act_lst;
        vg-> sa_act_lst = (struct pbuf *)(alst-> pb.av_forw);
        hd_sa_rtn( alst, RTN_NORM );
    }
    else if( (vg-> pvolsff[n_whl_idx > > 1]-> pvstate = = PV_MISSING) ||
            (NUKESA( vg, n_whl_idx) = = TRUE) ) {
        /*
         * If the next wheel index is on a missing PV, i. e. an
         * inactive VGSA, advance to the next wheel index and see
         * if any request should get off at it. Also, if the SA
         * is to be removed(nuked) then do it now.
         *
         * *NOTE* We should never get here is we lose a quorum.  As
         *      a safety measure the assert is in place to prevent
         *      an infinite loop.  If we go completely around the
         *      wheel without finding an active VGSA we have a
         *      problem somewhere.
         */
        if( NUKESA( vg, n_whl_idx) = = TRUE ) {
            SETSA_LSN( vg, n_whl_idx, 0);
            SET_NUKESA( vg, n_whl_idx, FALSE);
        }
        n_whl_idx = hd_sa_whladv( vg, n_whl_idx );
        assert( n_whl_idx != vg-> wheel_idx );
    }
    else
```

FIG.  21-108

143

```
            break;
}
/*
 *   We got out of the last loop under 1 of 3 conditions
 *
 *   1.  The active list was empty.
 *   2.  The head of active list points to a request that was just added.
 *   3.  The head of active list has a stopping point further around
 *       the wheel and we are at the next active VGSA to write.
 *
 *   At this point we must make sure the next wheel index(n_whl_idx) is
 *   pointing at an active VGSA. i.e. we came out because of condition
 *   1 or 2.  If the VGSA is inactive advance to the next active one
 *   and then set the pb_whl_stop fields of any new requests.  Thus, no
 *   request gets put on the wheel at an inactive VGSA.
 */
while( ( vg-> pvolsff[n_whl_idx > > 1]-> pvstate = = PV_MISSING) ||
       (NUKESA( vg, n_whl_idx) = = TRUE) ) {
    /*
     *   *NOTE* We should never get here if we lose a quorum.  As
     *       a safety measure the assert is in place to prevent
     *       an infinite loop.  If we go completely around the
     *       wheel without finding an active VGSA we have a
     *       problem somewhere.
     */
    if(  NUKESA( vg, n_whl_idx) = = TRUE ) {
        SETSA_LSN( vg, n_whl_idx, 0);
        SET_NUKESA( vg, n_whl_idx, FALSE);
    }
    n_whl_idx = hd_sa_whladv( vg, n_whl_idx );
    assert( n_whl_idx != vg-> wheel_idx );
}
while( new_req ) {
    new_req-> pb_whl_stop = n_whl_idx;
    new_req = (struct pbuf *)(new_req-> pv.av_forw);
}

/* Save the next wheel index */
```

## FIG. 21-109

```
        vg-> wheel_idx = n_whl_idx;

        /*
         *   Check to see if the current VGSA sequence number has been written
         *   to the next VGSA.  If it has not then write it.  If it matches
         *   then we have written the latest SA to all available VGSAs so
         *   stop the wheel.
         */
        if( vg-> whl_seq_num != GETSA_SEQ( vg, n_whl_idx ) )
            hd_sa_wrt( vg );
        else {
            vg-> flags & = ˜SA_WHL_ACT;
            xmdetach( &(vg-> sa_lbuf.b_xmemd) ):
            /*
             *   If the wait flag is on then a config function is waiting for
             *   the wheel to stop.  So, inform that function that it has.  This
             *   is used so the varyoffvg function will wait, if the wheel is
             *   rolling, before removing the data structures.
             */
            if(  vg-> flags & SA_WHL_WAIT ) {
                vg-> flags & = ˜SA_WHL_WAIT;
                e_wakeup( &(vg-> config_wait) );
            }
        }

        /*
         *   Just in case anything was unblocked or the cache hold queue was
         *   moved to the pending_Q
         */
        hd_schedule ( );

        return;
}
/*
 *   NAME:          hd_sa_hback
 *
 *   FUNCTION:        Hang a pbuf on the end of the given av_back list
 *
```

**FIG.  21-110**

145

```
*  NOTES:      This function is used to find the end of the given pbuf
*              list via the av_back pointer.  Then, link the new pbuf
*              on to the list there.  Assumes the av_back pointer in the
*              new pbuf is NULL.
*
*  PARAMETERS:
*
*  DATA STRUCTS:
*
*  RETURN VALUE: none
*/
void
hd_sa_hback(
register struct pbuf       *head_ptr,  /* head of pbuf list            */
register struct pbuf       *new_pbuf)      /* ptr to pbuf to append to list    */
{
    while( head_ptr-> pb.av_back )
        head_ptr = (struct pbuf *)(head_ptr-> pb.av_back);

    head_ptr-> pb.av_back = (struct buf *)new_pbuf;

    return;
}


/*
*  NAME:         hd_sa_rtn
*
*  FUNCTION:         Return the given av_back list of request to their
*          respective caller.
*
*  NOTES:
*
*  PARAMETERS:
*
*  DATA STRUCTS:
*
*  RETURN VALUE: none
*/
```

FIG. 21-111

146

```
void
hd_sa_rtn(
register struct pbuf      *head_ptr,   /* head of pbuf list              */
register int          err_flg)      /* if true return requests with      */
                              /* ENXIO error                     */
{
    register struct pbuf   *lst_ptr;      /* anchor for av_back list    */

    while( head_ptr ) {

        /*
         * piggybacked requests are on the av_back chain
         */
        lst_ptr = (struct pbuf *)(head_ptr-> pb.av_back);
        /*
         * if the request should be returned with an error but the
         * B_ERROR flag is off TURN IT ON.  Dummy up address so it
         * looks like none of the request worked
         */
        if( (err_flg = = RTN_ERR) && (!(head_ptr-> pb.b_flags & B_ERROR)) ) {
            head_ptr-> pb.b_flags | = B_ERROR;
            head_ptr-> pb.b_error = EIO;
            head_ptr-> pb_addr = head_ptr-> pb_lbuf-> b_baddr;
        }

        /* Set the B_DONE flag to indicate the request is done */
        head_ptr-> pb.b_flags |= B_DONE;

        /*
         * return the request via wakeup or function call
         *
         * it is possible for b_event to still be EVENT_NULL because of
         * some error and pb_sched to be NULL. If this condition exists
         * just drop the request and the caller will see it is complete
         * by checking the B_DONE
         */
        if( head_ptr-> pb.b_event != EVENT_NULL )
```

## FIG. 21-112

147

```
        e_wakeup( &(head_ptr-> pb.b_event) );
      else if( head_ptr-> pb_sched )
        HD_SCHED(head_ptr);


      /*
       * get the next one off of the list
       */

      head_ptr = lst_ptr;

   } /* END while( head_ptr ) */

   return;
}


/*
 *  NAME:          hd_sa_whladv
 *
 *  FUNCTION:          Advance wheel index to next VGSA
 *
 *  NOTES:      The wheel index has 2 components.  A primary/secondary
 *          bit, the low order bit of the index.  This controls which
 *          VGSA is being indexed on any particular PV.  The second
 *          component is the PV index.  It is the remaining bits of
 *          index.  It is used as the index into the pvols array in
 *          the volgrp structure.  This mechanism assumes that the
 *          maximum number of PVs in a VG is a power of 2.
 *
 *          If MAXPVS is a power of 2 this function will be much
 *          more efficient.
 *
 *  PARAMETERS:
 *
 *  DATA STRUCTS:
 *
 *  RETURN VALUE:  next VGSA on the wheel
 */
int
hd_sa_whladv(
```

FIG. 21-113

148

```
register struct volgrp      *vg,              /*volgrp pointer              */
register int          c_whl_idx) /* current wheel index              */
{
    c_whl_idx + + ;
    while( 1 ) {
        c_whl_idx % = (MAXPVS * 2);
        /*
         * If no pvol pointer then advance index to next PV.
         * If pvol pointer then look to see if there is a logical sector
         * number associated with the index.  If so we have found the
         * next VGSA index.  If not bump the index and look again.
         */
        if( !(vg-> pvolsff[ c_whl_idx > > 1 ]) ) {
            /*
             *   If the index is odd just bump it by 1 to get to next PV.
             *   If it is even bump the index by 2 to get to the next PV.
             */
            if( c_whl_idx & 1 )
                c_whl_idx + = 1;
            else
                c_whl_idx + = 2;
        }
        else if( GETSA_LSN( vg, c_whl_idx ) )
            break;
        else
            c_whl_idx + = 1;

    }
    return( c_whl_idx );
}


/*
 *  NAME:        hd_sa_update
 *
 *  FUNCTION:        Update the in memory version the VGSA timestamps
 *      and sequence number.
 *
```

FIG. 21-114
149

```
*   NOTES:
*
*   PARAMETERS:
*
*   DATA STRUCTS:
*
*   RETURN VALUE: none
*/
void
hd_sa_update(
register struct volgrp     *vg)          /* volgrp pointer                    */
{

        hd_gettime( &(vg-> vgsa_ptr-> b_tmstamp) ):
        vg-> vgsa_ptr-> e_tmstamp = vg-> vgsa_ptr-> b_tmstamp;
        /* bunp sequence number */
        vg-> whl_seq_num + +;

        return;
}

/*
*   NAME:        hd_sa_qrmchk
*
*   FUNCTION:        Check the VG for a quorum of SAs
*
*   NOTES:        Count the number of active VGSAs.  If the count
*            is less than the threshold(quorum_cnt) set the
*            VG_FORCEDOFF flag so the VG will unwind and shutdown.
*
*   PARAMETERS:
*
*   DATA STRUCTS:
*
*   RETURN VALUE: count of active VGSAs
*/
int
hd_sa_qrmchk(
```

**FIG. 21-115**

```
register struct volgrp      *vg)          /* volgrp pointer                          */
{
    register int    act_cnt;    /* count of active VGSAs     */
    register int    idx;         /* PV index                        */

    /*
     *   loop thru the pvols array in the volgrp structure
     */
    for( act_cnt=0, idx=0; idx < MAXPVS; idx + + ) {
        if( (vg-> pvolsff[idx]) & & (vg-> pvolsff[idx]-> pvstate != PV_MISSING) ) {
            if( vg-> pvolsff[idx]-> sa_areaff[0] .lsn )
                act_cnt + + ;
            if( vg-> pvolsff[idx]-> sa_areaff[1].lsn )
                act_cnt + + ;
        }
    }

    /*
     *   If the VG is already closing there is not need to do this all again
     */
    if( !(vg-> flags & VG_FORCEDOFF) && (act_cnt < vg-> quorum_cnt) ) {
        vg-> flags | = VG_FORCEDOFF;
        /*
        error message(????) Loss of quorum VG is closing
        */
    }

    return( act_cnt );
}


/*
 *   NAME:        hd_sa_config
 *
 *   FUNCTION:          Interface for hd_config routines to access the
 *           VGSA wheel.
 *
 *   NOTES:       Assumes the hd_config routine has the VG lock.
```

FIG. 21-116

```
*           Thus preventing more than one operation at a time.
*                       AND
*           The arg variable(array) is in memory and PINNED. Since
*           this routine may be executed during offlevel interrupt
*           processing it can not page fault or rely on any disk IO.
*
*           There are 3 phases to the hd_config routines modifying
*           the VGSAs
*               1.      Getting control of the wheel if it is rolling.
*               2.      Modifying the in memory VGSA.
*               3.      Restarting the wheel and waiting for one
*                   revolution.
*
*           This function takes care of all of these for the caller.
*
*   PARAMETERS:
*
*   DATA STRUCTS:
*
*   RETURN VALUE: SUCCESS or FAILURE
*/
int
hd_sa_config(
register struct volgrp       *vg,           /* volgrp pointer                       */
register ing        type,          /* type of hd_config request   */
register caddr_t    arg)           /* ptr to arguments for the request */
{
    register struct pbuf    *pb;   /* ptr to a pbuf struct to use           */
    register struct pvol    *pv;   /* ptr to target pvol struct       */
    register struct cnfg_pp_state      *ppi;
    register struct cnfg_pv_ins        *pv_info;
    register struct cnfg_pv_del            *pvdel_info;
    register struct cnfg_pv_vgsa       *vgsa_info;
    register struct pvol           *pvol;
    register int     o_prty = -1;        /* saved interrupt priority        */
    register int     rc;             /* function return code            */
    register int     i;              /* general counter            */
```

FIG. 21-117

152

```
register struct sa_ext  *saext;    /* arg for HD_KEXTEND */
register struct part    *oldpp;    /* old part structs */
register struct part    *newpp;     /* new part structs */
register struct sa_red  *sared;    /* arg for HD_KREDUCE */

register int  clear_pv;              /* PV missing flags have changed  */
register int  rollwheel;            /* indicates we should start wheel */
register int  re_enable;             /* shows a need to re-enable */
register struct extred_part  *pplist;/* ptr to pps to reduce */
struct part *oldpartsff[MAXNUMPARTS]; /* ptrs to old part structs */
register int ppcnt,cpcnt,ix;        /* for loop indexes */
register struct part *pp, *ppl, *ppnew;/* ptrs to part structs in reduce */
register short ppnum;                /* pp number used in reduce */
register int copy,cpymsk,lpmsk,redpps,stlpps,statechg;
                                  /* mask variables */
    /*
     * If the VG is closing return error
     */
    if (vg-> flags & VG_FORCEDOFF)
       return( FAILURE );

    pb = (struct pbuf *)xmalloc(sizeof(struct pbuf),HD_ALIGN,pinned_heap);
    if( pb = = NULL )
       return( FAILURE );

    rc = SUCCESS;
    o_prty = i_disable(INTIODONE); /* start critical section */

    /*
     * Do what the caller wants
     */
    switch( type ) {

      case HD_KMISSPV:
      case HD_KREMPV:

        /*
```

FIG. 21-118

```
 * Assumes that only one PV at a time can be marked as
 * missing/removed.
 */
pvdel_info = (struct cnfg_pv_del *) arg;

/*
 * zero out the DALV's LP on this PV
 */
 bzero( pvdel_info-> lp_ptr, pvdel_info-> lpsize);

/*
 * Go build a pbuf to give to the SA write routines.  This
 * way they do all quorum checking and clean up.
 * ( If removing a PV, save the new quorum count in pbuf so
 * hd_sa_cont can update the VG's quorum count right before
 * the quorum is rechecked.)
 */
hd_bldpbuf( pb, (struct pvol *) pvdel_info-> pv_ptr, type,
                       NULL, 0, NULL, NULL);
if ( type = = HD_KREMPV ) {
   pb-> pb.b_work _ pvdel_info-> qrmcnt;
   rc = hd_sa_strt( pb, vg, SA_PVREMOVED );
}
else
   rc = hd_sa_strt( pb, vg, SA_PVMISSING );
if( rc = = FAILURE )
   break;

/*
 * If the done flag is on at this point the pbuf has been
 * completed and if we sleep the calling process will hang.
 */
if( !(pb-> pb.b_flags & B_DONE) )
   e_sleep(&(pb-> pb.b_event), EVENT_SHORT);

/*
 * If the error flag is set return FAILURE to the caller
 */
```

**FIG. 21-119**

154

```
        if( pb-> pb.b_flags & B_ERROR )
            rc = FAILURE;

        break;

case HD_KADDPV:
    /*
     * perform miscellaneous tasks that must be done disabled
     */
    pv_info = (struct cnfg_pv_ins *) arg;
    pv = (struct pvol *)(pb_info-> pvol);

    if (vg-> pvolsff[pv_info-> pv_idx] = = NULL)
        /* set pvol structure pointer for add of a new PV */
        vg->pvolsff[pv_info-> pv_idx] = pv;
    else
        /* copy new pvol data for add of a previously missing PV */
        bcopy ((caddr_t)pv, (caddr_t)vg-> pvolsff[pv_info-> pv_idx],
                        sizeof(structpvol));

    if(vg-> open_count != 0 )
        hd_pvs_opn+ +;                  /* bump number of open PVs    */

    /*
     * If we're varying on the VG then return,
     * otherwise initialize the VGSA
     * on this new PV via the WHEEL
     */
    if (vg-> flags & VG_OPENING)
        break;

    /*
     * Get control of the wheel if it is rolling.
     */
    if( vg-> flags & SA_WHL_ACT )
        e_sleep(&(vg-> config_wait), EVENT_SHORT);

    if( vg-> flags & VG_FORCEDOFF ) {
```

FIG. 21-120

155

```
        rc = FAILURE;
        break;
    }

    /* update VG's quorum count to include this new PV */
    vg-> quorum_cnt = pv_info-> qrmcnt;

    /*
     * initialize the SA_SEQ_NUM to a value that will
     * make sure the VGSA on this new PV will be written,
     * and then reset the PV missing flag in the memory
     * copy of the VGSA.
     */
    if (pv-> sa_areaff[0].lsn)
        pv-> sa_areaff[0] .sa_seq_num = vg-> whl_seq_num - 1;
    if (pv-> sa_areaff[1].lsn)
        pv-> sa_areaff[1] .sa_seq_num = vg-> whl_seq_num - 1;

    CLRSA_PVMISS( vg-> vgsa_ptr, pv-> pvnum );

    /*
     * Now force the wheel one revolution.  Build a pbuf
     * to give the the wheel, reset the SA holding flag,
     * (re)start the wheel, wait for the wake up to signal
     * the wheel has completed the operation, check status.
     */
    rc = hd_sa_onerev(vg, pb, type);
    break;

case HD_KEXTEND:
case HD_KREDUCE:
    /*
     * Get control of the wheel if it is rolling.
     */
    if( vg-> flags & SA_WHL_ACT )
        e_sleep(&(vg-> config_wait), EVENT_SHORT);
```

**FIG. 21-121**

```
if( vg-> flags & VG_FORCEDOFF ){
    rc = FAILURE;
    break;
}

/*
 * Now that the wheel is ours we can do what needs to be
 * done.
 */
switch( type ) {
case HD_KEXTEND:

    /*
     * set up a pointer to the arguments passed in and loop
     * through the cnfg_pp_state structures to process the pps
     * until we come to a ppstate that is CNFG_STOP
     */
    saext = (struct sa_ext *) arg;
    for(ppi = saext-> vgsa;(ppi-> ppstate != CNFG_STOP);ppi + + ) {
        if((TSTSA_STLPP(vg-> vgsa_ptr,ppi-> pvnum,ppi-> pp) ? STALEPP :
        FRESHPP) != ppi-> ppstate) {
            XORSA_STLPP(vg-> vgsa_ptr, ppi-> pvnum,ppi-> pp);
            rollwheel = TRUE;
        }

    }
    if(rollwheel = = TRUE) {  /* we changed the VGSA */
        /*
         * force the wheel one revolution.  Build a pbuf to give
         * to the wheel, reset the SA holding flag, (re)start
         * the wheel, wait for the wake up to signal that the
         * wheel has completed the operation, check status.
         */
        hd_bldpbuf(pb, NULL, type, NULL, 0, NULL, NULL);
        vg-> flags & = ~SA_WHL_HLD;
        rc = hd_sa_strt( pb, vg, SA_CONFIGOP );
        if( rc = = FAILURE )
            break;
```

FIG. 21-122

157

```
        /*
         * If the done flag is on at this point the pbuf has
         * been completed and if we sleep, the calling process
         * will hang.
         */
        if( !(pb-> pb.b_flags & B_DONE) )
            e_sleep(&(pb-> pb.b_event), EVENT_SHORT);


        /*
         * If the error flag is set return FAILURE to the
         * caller.
         */
        if( pb-> pb.b_flags & B_ERROR ) {
            rc = FAILURE;
            break;
        }
    } /* end if roll wheel = = TRUE */
        /*
         * call hd_extend( ) to check for resync in progress and to
         * transfer the new lv information to the old lv information
         */
        rc = hd_extend(saext);
        break;
case HD_KREDUCE:
        /* set up the needed pointers and variables */
        sared = (struct sa_red *) arg;
        rollwheel = FALSE;
        pplist = sared-> list;
        for(i = 0; i < MAXNUMPARTS; i + + )
            oldpartsff[i] = sared-> lv-> partsff[i];
        /*
         * for the number of physical partitions being reduced, go through
         * the logical partitions and build masks for the pps being
         * reduced, pps that are stale, and the pps that exist; and,
         * check that there are no resyncs in progress. Once the masks
         * are built, go through and check that we aren't reducing the last
         * good copy of the lp. After this, we have finished the validation
```

**FIG. 21-123**

```
 * phase and can then begin the process phase in which we
 * go through and turn on the PP_REDUCING bits and the
 * PP_STALE and PP_CHGING bits in the active pps that are being
 * reduced.
 */


for(ppcnt = 1; ppcnt < = sared-> numred; pplist + +, ppcnt + + ) {
   if(pplist-> mask != 0) {
      cpymsk = MIRROR_EXIST(sared-> lv-> nparts);
      lpmsk = stlpps = 0;
      redpps = pplist-> mask;
      while(cpymsk != ALL_MIRRORS) {
        copy = FIRST_MIRROR(cpymsk);
        cpymsk |= MIRROR_MASK(copy);
        pp = PARTITION(sared-> lv,(pplist-> lp_num - 1),copy);
        if(pp-> pvol) {
          if(copy = = 0) {
             if(pp-> sync_trk != NO_SYNCTRK) {
               rc = FAILURE;
               sared-> error = CFG_SYNCER;
               break;
             }
          }
          lpmsk |= MIRROR_MASK(copy);
          if((pp-> ppstate & (PP_STALE | PP_CHGING)) = = PP_STALE)
             stlpps |= MIRROR_MASK(copy);
        } /* end if there is a pvol in this part struct */
      } /* end while */
      if(rc = = FAILURE)
        break;
      /*
       * if we're not reducing all of the copies of this lp, check
       * to be sure we're not reducing the last good copy
       */
      if(redpps ¬ lpmsk) {
        /* if there are no good copies left */
        if(!((stlpps | redpps) ¬ lpmsk)) {
```

FIG. 21-124

159

```
                    rc = FAILURE;
                    sared-> error = CFG_INLPRD;
                    break;
                }
            } /* end if redpps ¬ lpmsk */
        } /* end if */
    } /* end for */
    if(rc = = FAILURE)
        break;
    /* now that we've validated the data, we can proceed */
    pplist = sared-> list;
    for(cpymsk = pplist-> mask; cpymsk; cpymsk & = ¯MIRROR_MASK(copy)) {
        copy = FIRST_MASK(cpymsk);
        pp = PARTITION(sared-> lv,(pplist-> lp_num - 1),copy);
        if((pp-> ppstate & (PP_STALE | PP_CHGING)) = = PP_STALE)
            pp-> ppstate |= PP_REDUCING;
        else {
            pp-> ppstate |= (PP_STALE | PP_CHGING | PP_REDUCING);
            ppnum = BLK2PART(vg-> partshift,
                    (pp-> start - pp-> pvol-> fst_usr_blk));
            SETSA_STLPP(vg-> vgsa_ptr,pp-> pvol-> pvnum,ppnum);
            rollwheel = TRUE;
        }
    } /* end for */
    /* If we changed the VGSA */
    if(rollwheel = = TRUE) {
        /*
         * force the wheel one revolution.  Build
         * a pbuf to give the wheel, reset the SA
         * holding flag, (re)start the wheel, wait for
         * the wake up to signal the wheel has completed
         * the operation, check status.
         */
        hd_bldpbuf(pb, NULL, type, NULL, 0, NULL, NULL);
        vg-> flags & = ¯SA_WHL_HLD;
        rc = hd_sa_strt( pb, vg, SA_CONFIGOP );
        if( rc = = FAILURE )
            break;
```

FIG.  21-125

160

```
        /*
        *  If the done flag is on at this point the
        *  pbuf has been completed and if we sleep the
        *  calling process will hang.
        */
        if( !(pb-> pb.b_flags & B_DONE) )
            e_sleep(&(pb-> pb.b_event), EVENT_SHORT);


        /*
        *  If the error flag is set return FAILURE to
        *  the caller.
        */
        if( pb-> pb.b_flags & B_ERROR ) {
            rc = FAILURE;
            break;
        }
        /*
        *  if the logical volume is open, then them
        *  drain the logical volume : wait for all requests currently
        *  in the lv work queue to complete
        */
        if(sared-> lv-> lv_status = = LV_OPEN)
            hd_quiet(makedev(vg-> major_num,sared-> min_num),vg);
    } /* end if rollwheel */
else
        /*
        *  if we didn't change the VGSA, then release the inhibit
        *  on the wheel and restart it if it was rolling when we
        *  started
        */
        if(vg-> flags & SA_WHL_HLD) {
            vg-> flags & = ¯SA_WHL_HLD;
            rc = hd_sa_strt(NULL, vg,SA_CONFIGOP);
            if(rc = = FAILURE)
                break;
        }
```

FIG. 21-126

161

```
/*   reset the pplist pointer to the beginning of the list */
pplist = sared-> list;
/*
 *   call hd_reduce( ) to handle promotions and to transfer the
 *   new lv information to the old lv information
 */
hd_reduce(sared,vg);
break;
} /* END of switch( type ) */

break;

case HD_KDELPV:

    pvdel_info = (struct cnfg_pv_del *) arg;
    pv = (struct pvol *)(pvdel_info-> pv_ptr);

    /*   update the VG quorum count ---
     *   For a PV to be deleted, NO partitions may be allocated,
     *   therefore, we don't have to be as careful here as we
     *   are with REMOVEPV when we update the quorum count.
     */
    vg-> quorum_cnt = pvdel_info-> qrmcnt;

    /*
     *   If the wheel is not rolling just remove the pvol pointer
     *   from the volgrp structure.  If any PV missing flags should
     *   be reset then reset them and roll the wheel when ready.
     *
     *   If the wheel is rolling things are not so simple.  The
     *   pvol pointer cannot be jerked out from under the wheel if
     *   a request is using it as a stopping point.  Therefore,
     *   mark the PV missing in the pvol structure, then issue a
     *   config request to the wheel forcing the wheel to go
     *   one revolution.  Since the PV was marked as missing before
     *   the config request, it is guaranteed that no request will
     *   be using it as a stopping point.  It is also guaranteed
     *   that the wheel index will not be setting on any missing PV.
```

FIG. 21-127

162

```
 *   Therefore, at this point the pvol pointer can be removed
 *   safely.
 */
if( vg-> flags & SA_WHL_ACT ) {
    pv-> pvstate = PV_MISSING;

    /*
     * Now force the wheel one revolution.  Build a pbuf
     * to give the wheel, reset the SA holding flag,
     * (re)start the wheel, wait for the wake up to signal
     * the wheel has completed the operation, check status.
     */
    if (rc = hd_sa_onerev(vg, pb, type) != LVDD_SUCCESS)
        break;

} /* END of if the wheel active */

/* zero out the VG's pvol ptr */
vg-> pvolsff[ pv-> pvnum ] = NULL;

/*
 *   Miscellaneous updates that must be made disabled:
 *   delete the DALV's LP on this PV, decrement the global
 *   PV open count, and update the VG's quorum count
 */
bzero ( pvdel_info-> lp_ptr, pvdel_info-> lpsize);
if ( vg-> open_count != 0 )
    hd_pvs_opn--;

break;

case HD_KADDVGSA:
case HD_KDELVGSA:

    vgsa_info = (struct cnfg_pv_vgsa *) arg;
    pv = vgsa_info-> pv_ptr;

    vg-> quorum_cnt = vgsa_info-> qrmcnt;
```

**FIG. 21-128**

```
if(type = = HD_KADDVGSA) {
    /*
     * ADDING VGSA(s) to this PV - fill in the VGSA LSNs
     * and change the PV's VGSA sequence number so this
     * PV's vgsas will be written.
     */
    if (vgsa_info -> sa_lsnsff[0]) {
        pv->sa_areaff[0].lsn = vgsa_info -> sa_lsnsff[0];
        pv->sa_areaff[0].sa_seq_num = vg -> whl_seq_num - 1;
    }
    if (vgsa_info -> sa_lsnsff[1]) {
        pv->sa_areaff[1].lsn = vgsa_info -> sa_lsnsff[1];
        pv->sa_areaff[1].sa_seq_num = vg -> whl_seq_num - 1;
    }

    /*
     * get control of the wheel and wait for it to run
     * one full revolution
     */
    if( vg-> flags & SA_WHL_ACT )
        e_sleep(&(vg-> config_wait), EVENT_SHORT);
    if( vg-> flags & VG_FORCEDOFF ) {
        rc = FAILURE;
        break;
    }
    rc = hd_sa_onerev(vg, pb, type);
}
else {
    /*
     * DELETING VGSA(s) from this PV - if the wheel is active,
     * get control of it, set the flag for the VGSA(s) being
     * deleted, and then wait for the wheel to run one
     * revolution (the LVDD code that runs the wheel will zero
     * out the VGSA LSN when the nukesa flag is set).
     * If the wheel is NOT active, then just zero out the VGSA
     * LSN's now.
     */
    if( vg-> flags & SA_WHL_ACT ) {
```

**FIG. 21-129**

```
        e_sleep(&(vg-> config_wait), EVENT_SHORT);

        if( vg-> flags & VG_FORCEDOFF ){
          rc = FAILURE;
          break;
        }

        if (vgsa_info -> sa_lsnsff[0])
          pv-> sa_areaff[0].nukesa = TRUE;
        if (vgsa_info -> sa_lsnsff[1])
          pv-> sa_areaff[1].nukesa = TRUE;

        rc = hd_sa_onerev(vg, pb, type);
      }
      else {          /* the wheel is NOT rolling */
        if (vgsa_info -> sa_lsnsff[0])
          pv-> sa_areaff[0].lsn = 0;
        if (vgsa_info -> sa_lsnsff[1])
          pv-> sa_areaff[1].lsn = 0;
      }

    }

  break;

case HD_MWC_REC:
  /*
   *  Just update the VGSA:
   *  get control of the wheel and wait for it to run
   *  one full revolution.
   */
  if ( vg-> flags & SA_WHL_ACT )
      e_sleep(&(vg-> config_wait), EVENT_SHORT);
  if ( vg-> flags & VG_FORCEDOFF ) {
      rc = FAILURE;
      break;
  }
```

FIG. 21-130

```
            rc = hd_sa_onerev(vg, pb, type);
            break;


        default:
            panic("hd_sa_config: unknown request type");


    } /* END of switch( type ) */


    i_enable(o_prty);                    /* return to caller priority */


    /* Give back the memory we borrowed for the pbuf struct */
    assert(xmfree(pb,pinned_heap) = = LVDD_SUCCESS);


    return( rc );
}




/*
 *  NAME:        hd_sa_onerev
 *
 *  FUNCTION:    Force the WHEEL one revolution to update the VGSA
 *                  on all active PVs
 *
 *  NOTES:
 *
 *  PARAMETERS:    vg   - pointer to volume group
 *                 pb   - pbuf pointer
 *                 type - type of VGSA config operation
 *
 *  DATA STRUCTS:
 *
 *  RETURN VALUE: none
 *
 */
```

FIG. 21-131

```
int
hd_sa_onerev(
register struct volgrp      *vg,        /* ptr to volgrp struct        */
register struct pbuf        *pb,        /* ptr to pbuf struct          */
register int           type)           /* type of pbuf to build       */
{

        register int rc;

        /*
         * Now force the wheel one revolution.  Build a pbuf
         * to give the the wheel, reset the SA holding flag,
         * (re)start the wheel, wait for the wake up to signal
         * the wheel has completed the operation, check status.
         */
        hd_bldpbuf( pb, NULL, type, NULL, 0, NULL, NULL);
        vg-> flags & = ~SA_WHL_HLD;
        rc = hd_sa_strt( pb, vg, SA_CONFIGOP );
        if( rc = = FAILURE )
            return(rc);
        /*
         * If the done flag is on at this point the pbuf has been
         * completed and if we sleep the calling process will hang.
         */
        if( !(pb-> pb.b_flags & B_DONE) )
            e_sleep(&(pb-> pb.b_event), EVENT_SHORT);

        /*
         * If the error flag is set return FAILURE to the caller
         */
        if( pb-> pb.b_flags & B_ERROR )
            rc = FAILURE;

        return(rc);
}
```

FIG. 21-132

```
/*
 *   NAME:        hd_bldpbuf
 *
 *   FUNCTION:    Initialize a pbuf structure for LVDD disk io.
 *
 *   NOTES:
 *
 *   PARAMETERS:    none
 *
 *   DATA STRUCTS:
 *
 *   RETURN VALUE: none
 *
 */
void
hd_bldpbuf(
register struct pbuf   *pb,              /* ptr to pbuf struct           */
register struct pvol       *pvol,            /* target pvol ptr              */
register int           type,         /* type of pbuf to build        */
register caddr_t    bufaddr,     /* data buffer address - system    */
register unsigned  cnt,              /* length of buffer             */
register struct xmem     *xmem,            /* ptr to cross memory descriptor*/
register void                (*sched)())  /* point to function returning void */
{
    register struct buf     *lb;          /* ptr to buf struct part of pbuf*/

    /*
     * Zero the pbuf then stuff it with the necessary fields
     */
    bzero( pb, sizeof(struct pbuf) );

    lb = (struct buf *)pb;
    if( pvol )
        lb-> b_dev = pbol-> dev;

    lb-> b_baddr = bufaddr;
    lb-> b_bcount = cnt;
    lb-> b_event = EVENT_NULL;
```

FIG.  21-133

```
if( xmem )
    lb-> b_xmemd = *xmem;

pb-> pb_sched = sched;
pb-> pb_pvol = pvol;

switch( type ){

    /* mirror write consistency cache write type */
    case CATYPE_WRT:

        lb-> b_iodone = hd_ca_end;
        lb-> b_flags = B_BUSY | B_NOHIDE;
        lb-> b_blkno = PSN_MWC_REC0;
        break;

    case HD_MWC_REC:
    case HD_KMISSPV:
    case HD_KREMPV:
    case HD_KREDUCE:
    case HD_KEXTEND:
    case HD_KADDPV:
    case HD_KDELPV:
    case HD_KADDVGSA:
    case HD_KDELVGSA:

        lb-> b_iodone = NULL;
        lb-> b_flags = B_BUSY;
        break;

    default:
        panic("hd_vgsa: unknown pbuf type");
        break;
}

return;
}
```

FIG. 21-134

```
/*
 *  NAME:          hd_extend
 *
 *  FUNCTION:   Transfers old part struct information to new part struct
 *          information.
 *
 *  NOTES:
 *
 *  PARAMETERS:   saext  pointer to information structure for the extend
 *
 *  DATA STRUCTS:
 *
 *  RETURN VALUE: SUCCESS or FAILURE
 */


int
hd_extend(
    struct sa_ext *saext) / pointer to extend information structure */



{
    register int lpi,cpi;          /* loop counters */
    register int rc;               /* return code */
    register struct part *oldpp;        /* pointer to old part struct */
    register struct part *newpp;        /* pointer to new part struct */

    /*
     *  for the old number of logical partitions on the
     *  logical volume, go through and search each possible
     *  old copy.  If the logical partition is not being
     *  resynced, put the old part struct information
     *  into the new part struct entry
     */
    rc = SUCCESS;
    for(lpi = 0; lpi < saext- > old_numlps; lpi + + ) {
        for(cpi = 0; cpi < saext- > old_nparts; cpi + + ) {
            if(saext-> klv_ptr-> partsff[cpi] != NULL) {
```

FIG. 21-135

```
            oldpp = (struct part *)(saext-> klv_ptr-> partsff[cpi] + lpi);
            if(oldpp-> pvol != NULL) {
              if(cpi = = 0) {
                if(oldpp-> sync_trk != NO_SYNCTRK) {
                    saext-> error = CFG SYNCER;
                    rc = FAILURE;
                    break;
                }
              }
              newpp = (struct part *)
                        (*(saext -> new_parts + cpi) + lpi);
              *newpp = *oldpp;
            } /* end if oldpp-> pvol != NULL */
          } /* end if klv_ptr-> parts != NULL */
        } /* end for number of old copies */
        if(rc = = FAILURE)
            break;
    } /* end for old number of lps */
    /*
     *   if no errors were found, we can complete the
     *   extend by filling in the lvol struct with the
     *   new info.
     */
    if(rc = = SUCCESS) {
        saext-> klv_ptr-> nparts = saext-> nparts;
        saext-> klv_ptr-> nblocks = saext-> nblocks;
        saext-> klv_ptr-> i_sched = saext-> isched;
        for(cpi = 0; cpi < saext-> nparts; cpi + + )
            saext-> klv_ptr-> partsff[cpi] =
                saext-> new_partsff[cpi];
    } /* end if rc = = SUCCESS */
    return(rc):
}


/*
 *  NAME:       hd_reduce
 *
```

FIG. 21-136

```
*   FUNCTION: Transfers old part struct information to new part struct
*              information, and handles promotion if needed.
*
*   NOTES:
*
*   PARAMETERS: sared  pointer to information structure for the reduce
*               vg    pointer to volume group structure
*
*   DATA STRUCTS:
*
*   RETURN VALUE: none
*/


void
hd_reduce(
   struct sa_red *sared,  /* pointer to information on the reduce */
   struct volgrp *vg)        /* pointer to volume group structure */
{
    register int i,ppcnt,lpcnt,cpcnt;
                            /* loop counters */
    register struct part *pp,*op,*np,*sp,*tp;
                            /* part struct pointers */
    register struct extred_part *pplist;
                            /* pointer to array of ppinfo structs */
    register int ppsleft;        /* mask for pps left after reduction */
    register int copy;            /* holds copy of lp we're processing */
    register int redpps, cpymsk;/* masks for the logical partition */
    register int zeromsk;        /* mask for copies to zero out */
    register int size;            /* size of old part structs to copy to new */

    struct part zeropp;          /* zeroed out part struct used to zero parts */

    pplist = sared-> list;
    bzero((char *)(&zeropp), sizeof(struct part));

    /*
     * go through the pps being reduced and update the old copy as needed.
```

FIG. 21-137

```
 *  Do the necessary promotions and deletions in the old copy PRIOR to
 *  copying things over to the new copy.
 */
cpymsk = MIRROR_EXIST(sared-> lv-> nparts);
for(ppcnt = 1, ppcnt < = sared- > numred; pplist + + , ppcnt + + ) {
    if(pplist-> mask != 0) {
      redpps = cpymsk | pplist-> mask;
      /*
       * NOTE: redpps is a 3 bit field that can have the values
       * 0 (000) - 7 (111). The zero condition cannot exist on a reduce,
       * however.
       */
      switch(redpps) {
      /* promote secondary to primary and tertiary to secondary */
      case 1: pp = PARTITION(sared-> lv,(pplist-> lp_num-1),PRIMMIRROR);
              sp = PARTITION(sared-> lv,(pplist-> lp_num-1),SINGMIRROR);
              tp = PARTITION(sared-> lv,(pplist-> lp_num-1),DOUBMIRROR);
              *pp = *sp;
              /*
               * set up a mask to show the promoted lp
               * the bits will be off for good copies and on for
               * the copies that are now invalid.
               */
              *sp = *tp;
              zeromsk = TERTIARY_MIRROR;
              break;
      /* promote tertiary to secondary */
      case 2: sp = PARTITION(sared-> lv,(pplist-> lp_num-1),SINGMIRROR);
              tp = PARTITION(sared-> lv,(pplist-> lp_num-1),DOUBMIRROR);
              *sp = *tp;
              zeromsk = TERTIARY_MIRROR;
              break;
      /* promote tertiary to primary */
      case 3: pp = PARTITION(sared-> lv,(pplist-> lp_num-1),PRIMMIRROR);
              tp = PARTITION(sared-> lv,(pplist-> lp_num-1),DOUBMIRROR);
              *pp = *tp;
              zeromsk = (TERTIARY_MIRROR | SECONDARY_MIRROR);
```

FIG. 21-138

```
                    break;
            /* no promotion */
            case 4:
            case 6:
            case 7: zeromsk = redpps;
                    break;
            /* promote secondary to primary */
            case 5: pp = PARTITION(sared-> lv,(pplist-> lp_num-1),PRIMMIRROR);
                    sp = PARTITION(sared-> lv,(pplist-> lp_num-1),SINGMIRROR);
                    *pp = *sp;
                    zeromsk = (TERTIARY_MIRROR | SECONDARY_MIRROR);
                    break;
        } /* end switch */
        /* set up a mask of copies to zero out */
        zeromsk & = ~cpymsk;
        /* zero out the necessary copies of the logical partition */
        while(zeromsk != 0) {
            copy = FIRST_MASK(zeromsk);
            pp = PARTITION(sared-> lv,(pplist-> lp_num-1), copy);
            *pp = zeropp;
            zeromsk & = ~MIRROR_MASK(copy);

        }
    } /* end if */
} /* end for ppcnt */
/* go through and transfer each copy to the new part structure */
for(cpcnt = 0; cpcnt < sared-> nparts; cpcnt + + ) {
    size = sared-> numpls * sizeof(struct part);
    bcopy(sared-> lv-> partsff[cpcnt], sared-> newpartsff[cpcnt], size);
    sared-> lv-> partsff[cpcnt] = sared-> newpartsff[cpcnt];
}
/* NULL out the pointers to the copies that no longer exist */
for(i = sared-> nparts; i < sared-> lv-> nparts; i + + )
    sared-> lv-> partsff[i] = NULL;
/*
 *   reset the lvol structure with the values in the extred
 *   structure and loop through to put the newparts pointers
 *   into the lvol parts field
 */
```

FIG. 21-139

174

```
        sared-> lv-> nparts = sared-> nparts;
        sared-> lv-> nblocks = PART2BLK(vg-> partshift, sared-> numlps;
        sared-> lv-> i_sched = sared-> isched;

        return;
}
```

```
/*      DASD.H          */

#ifndef_H_DASD
#define_H_DASD

/*
 *      COMPONENT_NAME: (SYSXLVM) Logical Volume Manager - dasd.h
 *
 *
 *
 *      © COPYRIGHTInternational Business Machines Corp. 1988, 1990
 *      All Rights Reserved
 *
 */


/*
 *          Logical Volume Manager Device Driver data structures.
 */

#include < sys/types.h >
#include < sys/sleep.h >
#include < sys/lockl.h >
#include < sys/sysmacros.h >
```

## FIG.  21-140

```
#include < sys/buf.h >
#include < sys/lvdd.h >


/* FIFO queue structure for scheduling logical requests. */
struct hd_queue {                    /* queue header structure    */
        struct buf *head;    /* oldest request in the queue      */
        struct buf *tail;   /* newest request in the queue      */
};

struct hd_capvq {                    /* queue header structure    */
        struct pv_wait *head;   /* oldest request in the queue      */
        struct pv_wait *tail;   /* newest request in the queue      */
};
/*
 * Structure used by hd_redquiet( ) to mark target PPs for removal.
 * Both are zero relative.
 */
struct hd_lvred      {
        long lp;            /* LP the pp belongs to              */
        char mirror;               /* mirror number of PP              */
};
/*
 *    Physical request buf structure.
 *
 *        A 'pbuf' is a 'buf' structure with some additional fields used
 *        to track the status of the physical requests that correspond to
 *        each logical request.  A pool of pinned pbuf's is allocated and
 *        managed by the device driver.  The size of this pool depends on
 *        the number of open logical volumes.
 */
struct pbuf {

        /* this must come first, 'buf' pointers can be cast to 'pbuf' */
        struct buf   pb;              /* imbedded buf for physical driver */

        /* physical buf structure appendage: */
        struct buf   *pb_lbuf;   /* corresponding logical buf struct  */
```

FIG.  21-141

```
        /* scheduler I/O done policy function   */
#ifndef_NO_PROTO
        void       (*pb_sched) (struct pbuf *);
#else
        void       (*pb_sched) ( ):
#endif
        struct pvol *pb_pvol;   /* physical volume structure   */
        struct bad_blk   *pb_bad;   /* defects directory entry          */
        daddr_t          pb_start;   /* starting physical address        */

        char       pb_mirror;   /* current mirror                  */
        char       pb_miravoid;    /* mirror avoidance mask         */
        char       pb_mirbad;      /* mask of broken mirrors        */
        char       pb_mirdone;     /* mask of mirrors done               */

        char       pb_swretry;      /* number of sw relocation retries  */
        char       pb_type;     /* Type of pbuf                  */
        char       pb_bbop;    /* BB directory operation      */
        char       pb_bbstat;   /* status of BB directory operation  */

        uchar          pb_whl_stop;   /* wheel_idx value when this pbuf is*/
                              /* to get off of the wheel        */
#ifdef DEBUG
        ushort         pb_hw_reloc;   /* Debug - it was a HW reloc request*/
        char       pad;        /* pad to full long word         */
#else
        char       padff[3];        /* pad to full long word            */
#endif

        struct part *pb_part;   /* ptr to part structure.  Care must*/
                              /* be taken when this is used since */
                              /* the parts structure can be moved */
                              /* by hd_config routines while the  */
                              /* request is in flight           */
        struct unique_id *pb_vgid;   /* volume group ID                 */
        /* used to dump the allocated pbuf at dump time              */
        struct pbuf *pb_forw;   /* forward pointer              */
```

FIG.  21-142

```
        struct pbuf *pb_back;   /* backward pointer                    */
};

#define pb_addr  pb.b_un.b_addr          /* too ugly in its raw form    */


/* defines for pb_swretry */
#define MAX_SWRETRY         3            /* maximum retries for relocation
                                    before declaring disk dead */


/* values for b_work in pbuf struct (since real b_work value only used
 * in lbuf)
 */
#define FIX_READ_ERROR          1     /* fix a previous EMEDIA read error  */
#define FIX_ESOFT 2             /* fix a read or write ESOFT error          */
#define FIX_EMEDIA              3    /* fix a write EMEDIA error               */


/* defines for pb_type */
#define      SA_PVMISSING      1    /* PV missing type request        */
#define      SA_STALEPP   2    /* stale PP type request            */
#define      SA_FRESHPP   3    /* fresh PP type request            */
#define      SA_CONFIGOP       4    /* hd_config operation type request  */


/*
 * defines to tell hd_bldpbuf what kind of pbuf to build
 *
 * These defines are not the only ones that tell hd_bldpbuf what to
 * build.  Check the routine before changing/adding new defines here
 */
#define      CATYPE_WRT       1    /* pbuf struct is a cache write type    */


/*
 * defines for pb_bbop
 *
 * First set is used by the requests pbuf that is requesting the BB operation.
 * The second set is used in the bb_pbuf to control the action of the
 * actual reading and writing of the BB directory of the PV.
 */
```

**FIG. 21-143**

178

```
#define BB_ADD              41   /* Add a new bad block entry to BB directory */
#define BB_UPDATE           42   /* Update a bad block entry to BB directory */
#define BB_DELETE 43             /* Delete a bad block entry to BB directory    */
#define BB_RDDFCT           44   /* Reading a defective block               */
#define BB_WTDFCT           45   /* Writing a defective block               */
#define BB_SWRELO           46   /* Software relocation in progress         */
#define RD_BBPRIM           70   /* Read the BB primary directory    */
#define WT_UBBPRIM          71   /* Write BB prim dir with UPDATE      */
#define WT_DBBPRIM          72   /* Rewrite BB prim dir lst blk with UPDATE */
#define WT_UBBBACK          73   /* Write BB backup dir with UPDATE */
#define WT_DBBBACK          74   /* Rewrite BB back dir lst blk with UPDATE */


/* defines for pb_berror: 0-63 (good) 64-127 (bad) */
#define BB_SUCCESS          0    /* BBdir updating worked              */
#define BB_CRB              1    /* Reloc blkno was changed in this BB entry    */
#define BB_ERROR     64          /* Bad Block directories were not updated  */
#define BB_FULL             65   /* BBdir is full -no free bad blk entries    */


/*
 * Volume group structure.
 *
 * Volume groups are implicitly open when any of their logical volumes are.
 */


#define MAXVGS              255      /* implementation limit on # VGs */
#define MAXLVS              256      /* implementation limit on # LVs */
#define MAXPVS              32       /* implementation limit on number*/
                                     /* physical volumes per vg    */
#define    CAHHSIZE         8        /* Number of mwc cache queues    */
#define NBPI     (NBPB * sizeof(int))   /* Number of bits per int    */
#define NBPL     (NBPB * sizeof(long)) /* Number of bits per long    */

/* macros to set and clear the bits in the opn_pin array */
#define SETLVOPN(Vg,N)  ((Vg)-> opn_pinff[(N)/NBPI] |= 1 < < ((N)%NBPI))
```

FIG. 21-144

```
#define CLRLVOPN(Vg,N)          ((Vg)-> opn_pinfff[(N)/ NBPI] &= ¯(1 << ((N)%NBPI)))
#define TSTLVOPN(Vg,N)          ((Vg)-> opn_pinff[(N)/ NBPI] & 1 << ((N)%NBPI))

/*
 * macros to set and clear the bits in the ca_pv_wrt field
 *
 * NOTE TSTALLPVWRT will not work if max PVs per VG is greater than 32
 */
#define SETPVWRT(Vg,N)          ((Vg)-> ca_pv_wrtff[(N) / NBPI] |= 1 << ((N) % MAXPVS))
#define CLRPVWRT(Vg,N)          ((Vg)-> ca_pv_wrtff[(N) / NBPI] & = ¯(1 << ((N) % MAXPVS))
#define TSTPVWRT(Vg,N)          ((Vg)-> ca_pv_wrtff[(N) / NBPI] & (1 << ((N) % MAXPVS)))
#define TSTALLPVWRT(Vg,N)       ((Vg)-> ca_pv_wrtff[(MAXPVS - 1) / NBPL])


/*
 * head of list of varied on volgrp structs in the system
 */
struct
{
        lock_t lock;            /* lock while manipulating list of VG structs */
        struct volgrp * ptr;    /* ptr to list of varied on VG structs */
} hd_vghead = {EVENT_NULL, NULL};


struct volgrp {
    lock_t          vg_lock;    /* lock for all vg structures       */
    short           pad1;           /* pad to long word boundary        */
    short           partshift;  /* log base 2 of part size in blks  */
    short           open_count; /* count of open logical volumes   */
    ushort          flags;      /* VG flags field              */
    ulong           tot_io_cnt; /* number of logical request to VG   */
    struct lvol         *lvolsff[MAXLVS];    /* logical volume struct array     */
    struct pvol         *pvolsff[MAXPVS];  /* physical volume struct array    */
    long            major_num;  /* major number of volume group  */
    struct unique_id    vg_id;          /* volume group id             */
    struct volgrp   *nextvg;    /* pointer to next volgrp structure  */
                                /* Array of bits indicating open LVs*/
                                /* A bit per LV                */
    int                 opn_pinff[(MAXLVS + (NBPI - 1))/NBPI];
```

FIG. 21-145

180

```
pid_t                 von_pid;     /* process ID of the varyon process */

        /* Following used in write consistency cache management   */
struct volgrp       *nxtactvg;  /* pointer to next volgrp with         */
                               /* write consistency activity      */
struct pv_wait        *ca_freepvw;   /* head of pv_wait free list         */
struct pv_wait        *ca_pvwmem;  /* ptr to memory malloced for pvw   */
                               /* free list                   */
struct hd_queue       ca_hld;         /* head/tail of cache hold queue  */
ulong            ca_pv_wrtff[(MAXPVS + (NBPL - 1)) / NBPL];
                               /* when bit set write cache to PV */
char             ca_inflt_cnt;      /* number of PV active writing cache*/
char             ca_size;     /* number of entries in cache        */
ushort           ca_pvwblked;     /* number of times the pv_wait free */
                               /* list has been empty          */
struct mwc_rec        *mwc_rec; /* ptr to part 1 of cache - disk rec*/
struct ca_mwc_mp       *ca_part2; /* ptr to part 2 of cache - memory */
struct ca_mwc_mp       *ca_lst;     /* mru/lru cache list anchor   */
struct ca_mwc_mp       *ca_hashff[CAHHSIZE];/* write consistency hash anchors*/

/* the following 2 variables are used to control a cache clean up opera-*/
/* tion.                                          */
pid_t            bcachwait;  /* list waiting at the beginning   */
pid_t            ecachwait;  /* list waiting at the end          */
volatile int      wait_cnt;     /* count of cleanup waiters     */

/* the following are used to control the VGSAs and the wheel */
uchar            quorum_cnt;      /* Number indicating quorum of SAs  */
uchar            wheel_idx;  /* VGSA wheel index into pvols      */
ushort           whl_seq_num;   /* VGSA memory image sequence number*/
struct pbuf            *sa_act_lst;     /* head of list of pbufs that are  */
                               /* actively on the VGSA wheel      */
struct pbuf            *sa_hld_lst;     /* head of list of pbufs that are   */
                               /* waiting to get on the VGSA wheel */
struct vgsa_area       *vgsa_ptr; /* ptr to in memory copy of VGSA */
pid_t            config_wait;       /* PID of process waiting in the */
```

**FIG. 21-146**

```
                                    /* hd_config routines to modify the */
                                    /* memory version of the VGSA      */
        struct buf          sa_lbuf;    /* logical buf struct to use to wrt */
                                    /* the VGSAs                       */
        struct pbuf         sa_pbuf;   /* physical buf struct to use to wrt*/
                                    /* the VGSAs                       */
};


/*
 * Defines for flags field in volgrp structure
 */
#define     VG_SYSMGMT      0x0002       /* VG is on for system management */
                                /* only commands          */
#define VG_FORCEDOFF      0x0004       /* Should only be on when the VG was*/
#define     VG_OPENING       0x0008       /* VG is being varied on   */
        /* forced varied off and there were LVs still open.  Under this con-*/
        /* dition the driver entry points can not be deleted from the device*/
        /* switch table.  Therefore the volgrp structure must be kept     /*
        /* around to handle any rogue operations on this VG.           */
#define     CA_INFLT        0x0010       /* The cache is being written or */
                                /* locked              */
#define CA_VGACT    0x0020              /* This volgrp on mwc active list  */
#define     CA_HOLD          0x0040       /* Hold the cache in flight  */
#define     CA_FULL          0x0080       /* Cache is full - no free entries  */
#define     SA_WHL_ACT   0x0100       /* VGSA wheel is active         */
#define     SA_WHL_HLD   0x0200       /* VGSA wheel is on hold    */
#define     SA_WHL_WAIT      0x0400       /* config function is waiting for */
                                /* the wheel to stop          */


/*
 * Logical volume structure.
 */
struct lvol {
        struct buf   **work_Q;       /* work in progress hash table      */
        short       lv_status;   /* lv status: closed, closing, open */
        short       lv_options;      /* logical dev options (see below) */
        short       nparts;              /* num of part structures for this  */
                                /* lv - base 1              */
```

FIG. 21-147

```
        char       i_sched;      /* initial scheduler policy state */
        char       pad;          /* padding so data word aligned    */
        ulong              nblocks;   /* LV length in blocks          */
        struct part *partsff[3]       /* partition arrays for each mirror */
        ulong              tot_wrts;  /* total number of writes to LV    */
        ulong              tot_rds;   /* total number of reads to LV     */

        /* These fields of the lvol structure are read and/or written by
         * the bottom half of the LVDD; and therefore must be carefully
         * modified.
         */
        int        cmplcnt;      /* completion count-used to quiesce */
        int        waitlist;     /* event list for quiesce of LV        */
};


/* lv status: */
#define     LV_CLOSED    0        /* logical volumes is closed  */
#define     LV_CLOSING       1        /* trying to close the LV     */
#define     LV_OPEN      2        /* logical volume is open      */


/* scheduling policies: */
#define     SCH_REGULAR      0        /* regular, non_mirrored LV */
#define     SCH_SEQUENTIAL 1        /* sequential write, seq read   */
#define     SCH_PARALLEL     2        /* parallel write, read closest       */
#define     SCH_SEQWRTPARRD   3        /* sequential write, read closest*/
#define     SCH_PARWRTSEQRD   4        /* parallel write, seq read      */


/* logical device options: */
#define     LV_NOBBREL   0x0010       /* no bad block relocation    */
#define     LV_RDONLY    0x0020       /* read-only logical volume  */
#define     LV_DMPINPRG      0x0040       /* Dump in progress to this LV  */
#define     LV_DMPDEV    0x0080       /* This LV is a DUMP device    */
                                      /* i.e.DUMPINIT has been done      */
#define LV_NOMWC            0x0100       /* no mirror write consistency    */
                                      /* checking               */
#define     LV_WRITEV    WRITEV       /* Write verify writes in LV */
```

FIG. 21-148

```
/* work_Q hash algorithm - just a stub now */
#define HD_HASH(Lb)                \
        (BLK2TRK((Lb)-> b_blkno) & (WORKQ_SIZE-1))


/*
 * Partition structure.
 */
struct part {
        struct pvol *pvol;              /* containing physical volume    */
        daddr_t         start;          /* starting physical disk address */
        short       sync_trk;   /* current LTG being resynced    */
        char        ppstate;    /* physical partition state   */
        char        sync_msk;   /* current LTG sync mask   */
};


/*
 * Physical partition state defines PP_ and structure defines.
 *
 * The PP_STALE and PP_REDUCING bits could be combined into one but it
 * is easier to understand if they are not and a problem arises later.
 *
 * The PP_RIP bit is only valid in the primary part structure.
 */
#define PP_STALE        0x01       /* Set when PP is stale                  */
#define       PP_CHGING    0x02      /* Set when PP is stale but the  */
                                /* VGSAs have not been completely */
                                /* updated yet                */
#define       PP_REDUCING       0x04      /* Set when PP is in the process  */
                                /* of being removed(reduced out   */
#define PP_RIP          0x08          /* Set when a Resync is in progress */
                                /* When set "sync_trk" indicates  */
                                /* the track being synced.  If            */
                                /* sync_trk not = = -1 and PP_RIP   */
                                /* not set sync_trk is next trk         */
                                /* to be synced                 */
#define PP_SYNCERR              0x10      /* Set when error in a partition  */
```

**FIG. 21-149**

```
                                   /* being resynced.  Causes the      */
                                   /* partition to remain stale.       */

#define NO_SYNCTRK       -1            /* The LP does not have a resync  */
                                   /* in progress                  */
/*
 * Physical volume structure.
 *
 *    Contains defects directory hash anchor table.  The defects
 *    directory is hashed by track group within partition.  Entries within
 *    each congruence class are sorted in ascending block addresses.
 *
 *    This scheme doesn't quite work, yet.  The congruence classes need
 *    to be aligned with logical track groups or partitions to guarantee
 *    that all blocks of this request are checked.  But physical addresses
 *    need not be aligned on track group boundaries.
 */

#define HASHSIZE       64            /* number of defect hash classes */

struct defect_tbl {
        struct bad_blk *defects ff[HASHSIZE]; /* defect directory anchor */
};

struct pvol {
        dev_t           dev;        /* dev_t of physical device      */
        daddr_t         armpos;        /* last requested arm position        */
        short       xfcnt;            /* transfer count for this pv     */
        short       pvstate;    /* PV state                  */
        short       pvnum;            /* LVM PV number 0-31
        short       vg_num;            /* VG major number             */
        struct file *  fp;            /* file pointer from open of PV   */
        char        flags;        /* place to hold flags          */
        char        pad;        /* unused                 */
        short       num_bbdir_ent; /* current number of BB Dir entries */
        daddr_t         fst_usr_blk;        /* first available block on the PV  */
                                   /* for user data            */
```

FIG. 21-150

185

```
        daddr_t           beg_relblk;/* first blkno in reloc pool      */
        daddr_t           next_relblk;      /* blkno of next unused relocation */
                              /* block in reloc blk pool at end   */
                              /* of PV                    */
        daddr_t           max_relblk;      /* largest blkno avail for reloc     */
        struct defect_tbl *defect_tbl; /* pointer to defect table      */
        struct hd_capvq   ca_pv;              /* head/tail of queue of request  */
                              /* waiting for cache write to        */
                              /* complete                    */
        struct sa_pv_whl {             /* VGSA information for this PV */
           daddr_t lsn;            /* SA logical sector number - LV 0 */
           ushort  sa_seq_num;    /* SA wheel sequence number          */
           char    nukesa;              /* flag set if SA to be deleted    */
           char    pad;           /* pad to full long word          */
        }             sa_areaff[2];    /* one for each possible SA on PV   */


        struct pbuf pv_pbuf;     /* pbuf struct for writing cache     */
};


/* defines for pvstate field */
#define PV_MISSING          1          /* PV cannot be accessed    */
#define PV_RORELOC          2          /* No HW or SW relocation allowed  */
                              /* only known bad blks relocated    */
/*
 * returns index into the bad block hash table for this block number
 */
#define BBHASH_IND(blkno)      (BLK2TRK(blkno) & (HASHSIZE - 1))


/*
 * Macro to return defect directory congruence class pointer
 */
#define HASH_BAD(Pb,Bad_blkno)      \
        ((Pb)-> pb_pvol-> defect_tbl-> defectsff[BLK2TRK(Bad_blkno)&(HASHSIZE-1)])


/*
 * Used by the LVM dump device routines same as HASH_BAD but the first
 * argument is a pvol struct pointer
 */
```

FIG. 21-151

```
#define HASH_BAD_DMP(Pvol,Blkno)        \
        ((Pvol)-> defect_tbl-> defectsff[BLK2TRK(Blkno)&(HASHSIZE-1)])

/*
 * Bad block directory entry.
 */
struct bad_blk {                        /* bad block directory entry   */
        struct bad_blk    *next;              /* next entry in congruence class */
        dev_t             dev;        /* containing physical device      */
        daddr_t           blkno;              /* bad physical disk address   */
        unsigned   status: 4;   /* relocation status (see below)   */
        unsigned   relblk: 28;  /* relocated physical disk address */
};

/* bad block relocation status values: */
#define REL_DONE  0                    /* software relocation completed   */
#define REL_PENDING      1             /* software relocation in progress */
#define REL_DEVICE       2             /* device (HW) relocation requested   */
#define REL_CHAINED      3             /* relocation blk structure exists   */
#define REL_DESIRED      8             /* relocation desired-hi order bit on*/

/*
 * Macros for getting and releasing bad block structures from the
 * pool of bad_blk structures.  They are linked together by their next pointers.
 * "hd_freebad" points to the head of bad_blk free list
 * NOTE:  Code must check if hd_freebad != null before calling
 *        the GET_BBLK macro.
 */
#define GET_BBLK(Bad)        { \
                (Bad) = hd_freebad; \
                hd_freebad = hd_freebad-> next; \
                hd_freebad_cnt--; \
                }

#define REL_BBLK(Bad)        { \
                (Bad)-> next = hd_freebad; \
                hd_freebad = (Bad); \
```

**FIG. 21-152**

```
                    hd_freebad_cnt + + ;\
                    }


/*
 * Macros for accessing these data structures.
 */
#define VG_DEV2LV(Vg, Dev)        ((Vg)-> lvolsff[minor(Dev)])
#define VG_DEV2LV(Vg, Pnum)       ((Vg)-> pvolsff[(Pnum)])

#define BLK2PART(Pshift,Lbn)      ((ulong)(Lbn) > > (Pshift))
#define PART2BLK(Pshift,P_no)     ((P_no) < < (Pshift))
#define PARTITION(Lv,P_no,Mir)    ((Lv)-> partsff[(Mir)] + (P_no))


/*
 * Mirror bit definitions
 */


#define PRIMARY_MIRROR            001 /* primary mirror mask          */
#define SECONDARY_MIRROR          002 /* secondary mirror mask   */
#define TERTIARY_MIRROR           004 /* tertiary mirror mask         */
#define ALL_MIRRORS           007 /* mask of all mirror bits   */

/* macro to extract mirror avoidance mask from ext parameter */
#define     X_AVOID(Ext)          ( ((Ext) > > AVOID_SHFT) & ALL_MIRRORS )


/*
 * Macros to select mirrors using avoidance masks:
 *
 *      FIRST_MIRROR        returns first unmasked mirror (0 to 2); 3 if all masked
 *      FIRST_MASK    returns first unmasked mirror (0 to 2); 3 if none masked
 *      MIRROR_COUNT        returns number of unmasked mirror (0 to 3)
 *      MIRROR_MASK         returns a mask to avoid a specific mirror (1, 2, 4)
 *      MIRROR_EXIST        returns a mask for non-existent mirrors (0, 4, 6, or 7)
 */
#define     FIRST_MIRROR(Mask)    ((0x30102010 > > ((Mask) < < 2))&0x0f)
#define     FIRST_MASK(Mask)      ((0x01020103 > > ((Mask) < < 2))&0x0f)
#define     MIRROR_COUNT(Mask)    ((0x01121223 > > ((Mask) < < 2))&0x0f)
#define     MIRROR_EXIST(Nmirrors)   ((0x00000467 > > ((Nmirrors) < < 2))&0x0f)
```

FIG. 21-153

```
#define      MIRROR_MASK(Mirror)  (1 < < (Mirror))

/*
 * DBSIZE and DBSHIFT were originally UBSIZE and UBSHIFT from param.h.
 * There were renamed and moved to here to more closely resemble a disk
 * block and not a user block size.
 */
#define DBSIZE              512        /* Disk block size in bytes   */
#define DBSHIFT             9          /* log 2 of DBSIZE            */


/*
 * LVPAGESIZE and LVPGSHIFT were originally PAGESIZE and PGSHIFT from param.h.
 * There were renamed and moved to here to isolate LVM from the changable
 * system parameters that would have undesirable effects on LVM  functionality.
 */
#define LVPAGESIZE          4096       /* Page size in bytes          */
#define LVPGSHIFT      12              /* log 2 of LVPAGESIZE   */

#define BPPG           (LVPAGESIZE/DBSIZE) /* blocks per page          */
#define BPPGSHIFT      (LVPGSHIFT-DBSHIFT) /* log 2 of BPPG            */
#define PGPTRK             32          /* pages per logical track group */
#define TRKSHIFT       5               /* log base 2 of PGPTRK   */
#define LTGSHIFT       (TRKSHIFT + BPPGSHIFT) /* logical track group log base 2*/
#define BYTEPTRK       PGPTRK *LVPAGESIZE /* bytes per logical track group */
#define BLKPTRK             PGPTRK *BPPG     /* blocks per logical track group*/
#define SIGNED_SHFTMSK  0x80000000 /* signed mask for shifting to */
                                   /* get page affected mask      */

#define BLK2BYTE(Nblocks)      ((unsigned)(Nblocks) < < (DBSHIFT))
#define BYTE2BLK(Nblocks)      ((unsigned)(Nbytes) > > (DBSHIFT))
#define BLK2PG(Blk)            ((unsigned)(Blk) > > BPPGSHIFT)
#define PG2BLK(Pageno)         ((Pageno) < < (LVPGSHIFT-DBSHIFT))
#define BLK2TRK(Blk)           ((unsigned)(Blk) > > (TRKSHIFT + BPPGSHIFT))
#define TRK2BLK(T_no)          ((unsigned)(T_no) < < (TRKSHIFT + BPPGSHIFT))
#define PG2TRK(Pageno)         ((unsigned)(Pageno) > > TRKSHIFT)
```

FIG. 21-154

```
/* LTG per partition */
#define TRKPPART(Pshift)    ((unsigned)(1 < < (Pshift - LTGSHIFT)))
/* LTG in the partition  */
#defineTRK_IN_PART(Pshift,BLK)(BLK2TRK(Blk)&(TRKPPART(Pshift) - 1) )


/* defines for top half of LVDD */
#define LVDD_HFREE_BB          30   /* high water mark for kernel bad_blk struct */
#define LVDD_LFREE_BB          15   /* low water mark for kernel bad_blk struct */
#define WORKQ_SIZE         64  /* size of LVs work in progress queue     */
#define PBSUBPOOLSIZE    16  /* size of pbuf subpool alloc'd by PVs    */
#define HD_ALIGN           (uint)0  /* align characteristics for alloc'd memory */
#define FULL_WORDMASK        3    /* mask for full word (log base 2)      */
#define BUFCNT               3    /* parameter sent to uphysio for # buf  */
                        /* structs to allocate              */


#define NOMIRROR   0      /* no mirrors     */
#define PRIMMIRROR        0   /* primary mirror */
#define SINGMIRROR        1   /* one mirror     */
#define DOUBMIRROR        2   /* two mirrors    */


#define MAXNUMPARTS       3   /* maximum number of parts in a logical part */
#define PVNUMVGDAS        2   /* max number of VGDA/VGSAs on a PV */


/* return codes for LVDD top 1/2 */
#define LVDD_SUCCESS      0   /* general success code         */
#define LVDD_ERROR        -1  /* general error code         */
#define LVDD_NOALLOC          -200 /* hd_init: not able to allocate pool of bufs*/

#endif /* _H_DASD */




/*      HD.H        */

#ifndef _H_HD
#define _H_HD
```

FIG. 21-155

```
/*
 * COMPONENT_NAME: (SYSXLVM) Logical Volume Manager Device Driver - hd.h
 *
 * © COPYRIGHT International Business Machines Corp. 1988, 1990
 * All Rights Reserved
 *
 */


#include < sys/errids.h >


/*
 * LVDD internal macros and extern staticly declared variables.
 */


/* LVM internal defines: */
#define     FAILURE              0    /* must be logic FALSE for 'if' tests   */
#define     SUCCESS         1    /* must be logic TRUE for 'if' tests    */
#define MAXGRABLV           16   /* Max number of LVs to grab pbuf structs */
#define MAXSYSVG 3               /* Max number of VGs to grab pbuf structs */
#define     CAHEAD          1    /* move cache entry to head of use list   */
#define     CATAIL          2    /* move cache entry to tail of use list    */
#define CA_MISS             0    /* MWC cache miss                 */
#define CA_HIT              1    /* MWC cache hit              */
#define CA_LBHOLD           2    /* The logical request should hold        */


/*
 * Following defines are used to communicate with the kernel process
 */

#define LVDD_KP_TERM        0x80000000  /* Terminate the kernel process    */
#define LVDD_KP_BADBLK          0x40000000 /* Need more bad_blk structs     */
#define LVDD_KP_ACTMSK          0xC0000000 /* Mask of all events            */


/*
 * Following defines are used in the b_options of the logical buf struct.
 * They should be reserved in lvdd.h in relationship to the ext parameters
 */
#define     REQ_IN_CACH         0x40000000 /* When set in the lbuf b_options */
                                    /* the request is in the mirror   */
```

FIG. 21-156

```
                                    /* write consistency cache     */
#define REQ_VGSA  0x20000000       /* When set in the lbuf b_options */
                                    /* it means this is a VGSA write */
                                    /* and to use the special sa_pbuf */
                                    /* in the volgrp structure        */


/***********************************************
 *
 * The following variables are only used in the kernel and therefore are
 * only included if the _KERNEL variable is defined.
 *
 ***********************************************/


#ifdef _KERNEL
#include < sys/syspest.h >

/*
 * Set up a debug level if debug turned on
 */
#ifdef DEBUG
#ifdef LVDD_PHYS
BUGVDEF(debuglvl, 0)
#else
BUGXDEF(debuglvl)
#endif
#endif


/*
 * pending queue
 *
 *      This is the primary data structure for passing work from
 *      the strategy routines (see hd_strat.c) to the scheduler
 *      (see hd_sched.c) via the mirror write consistency logic.
 *      From this queue the request will go to one of three other
 *      queues.
 *
 *           1. cache hold queue - If the request involves mirrors
```

FIG. 21-157

```
*           and the write consistency cache is in flight.
*           i.e. being written to PVs.
*
*       2. cache PV queue - If the request must wait for the
*           write consistency cache to be written to the PV.
*
*       3. schedule queue - Requests are scheduled from this
*           queue.
*
*       This queue is only changed within a device driver critical section.
*/
#ifdef LVDD_PHYS
struct hd_queue    pending_Q;
#else
extern struct hd_queue        pending_Q;
#endif


/*
 * ready queue - - physical requests that are ready to start.
 *
 *       This queue is only valid within a single critical section.
 *       It really contains a list of pbuf's, but only the imbedded
 *       buf struct is of interest at this point.  Since the pointers
 *       are of type (struct buf *) it is convenient that the queue be
 *       declared similarly.
 */
#ifdef LVDD_PHYS
struct buf         *ready_Q = NULL;
#else
extern struct buf    *ready_Q;
#endif


/*
 * Chain of free and available pbuf structs.
 */
#ifdef LVDD_PHYS
struct pbuf          *hd_freebuf = NULL;
```

**FIG. 21-158**

193

```
#else
extern struct pbuf          *hd_freebuf;
#endif


/*
 * Chain of pbuf structs currently allocated and pinned for LVDD use.
 * Only used at dump time and by crash to find them.
 */
#ifdef LVDD_PHYS
struct pbuf          *hd_dmpbuf = NULL;
#else
extern struct pbuf          *hd_dmpbuf;
#endif


/*
 * Chain and count of free and available bad_blk structs.
 * The first open of a VG, really the first open of an LV, will cause
 * LVDD_HFREE_BB( currently 30 ) bad_blk structs to be allocated and
 * chained here.  After that when the count gets to LVDD_LFREE_BB(low
 * water mark, currently 15) the kernel process will be kicked to go
 * get more up to LVDD_HFREE_BB( high water mark ) more.
 *
 * *NOTE* hd_freebad_lk is a lock mechanism to keep the top half of the
 *        driver and the kernel process from colliding.  This would only
 *        happen if the last request before the last LV closed received
 *        an ESOFT or EMEDIA( and request was a write ) and the getting of
 *        a bad_blk struct caused the count to go below the low water
 *        mark.  This would result in the kproc trying to put more
 *        structures on the list while hd_close via hd_frefrebb would
 *        be removing them.
 */
#ifdef LVDD_PHYS
int               hd_freebad_lk = LOCK_AVAIL:
struct bad_blk          *hd_freebad = NULL;
int               hd_freebad_cnt = 0;
#else
int               hd_freebad_lk;
```

FIG. 21-159

194

```
extern struct bad_blk    *hd_freebuf;
extern int               hd_freebad_cnt;
#endif


/*
 * Chain of volgrp structs that have write consistency caches that need
 * to be written to PVs.  This chain is used so all incoming requests
 * can be scanned before putting the write consistency cache in flight.
 * Once in flight the cache is locked out and any new requests will have
 * to wait for all cache writes to finish.
 */
#ifdef LVDD_PHYS
struct volgrp            *hd_vg_mwc = NULL;
#else
extern struct volgrp    *hd_vg_mwc;
#endif


/*
 * The following arrays are used to allocate mirror write consistency
 * caches in a group of 8 per page.  This is due to the way the hide
 * mechanism works only on page quantities.  These two arrays should be
 * treated as being in lock step.  The lock, hd_ca_lock, is used to
 * ensure only one process is playing with the arrays at any one time.
 */
#define     VGS_CA  ((MAXVGS + (NBPB - 1)) / NBPB)

#ifdefLVDD_PHYS
lock_t              hd_ca_lock = LOCK_AVAIL; /* lock for cache arrays    */
char               ca_allocedff[VGS_CA];       /* bit per VG with cache allocated */
struct mwc_rec     *ca_grp_ptrff[VGS_CA];    /* 1 for each 8 VGs          */
#else
extern lock_t              hd_ca_lock;
extern char                ca_allocedff[ ];
extern struct mwc_rec      *ca_grp_ptrff[ ];
#endif


/*
 * The following variables are used to control the number of pbuf
```

### FIG. 21-160

```
* structures allocated for LVM use.  It is based on the number of
* PVs in varied on VGs.  The first PV gets 64 structures and each
* PV therefore gets 16 more.  The number is reduced only when a
* VG goes inactive. i.e. all it's LVs are closed.
*/
#ifdefLVDD_PHYS
int hd_pbuf_cnt  = 0;              /* Total Number of pbufs allocated    */

int hd_pbuf_grab  = PBSUBPOOLSIZE; /* Number of pbuf structs to allocate
                        /* for each active PV on the system       */

int hd_pbuf_min = PBSUBPOOLSIZE * 4;
                            /* Number of pbuf to allocate for the     */
                            /* first PV on the system              */

int hd_vgs_opn = 0;            /* Number of VGs opened             */
int hd_lvs_opn  = 0;           /* Number of LVs opened             */
int hd_pvs_opn = 0;            /* Number of PVs in varied on VGs      */

int hd_pbuf_inuse  = 0;              /* Number of pbufs currently in use   */

int hd_pbuf_maxuse  = 0;           /* Maximum number of pbufs in use during*/
                        /* this boot                          */
#else
extern int hd_pbuf_cnt;
extern int hd_pbuf_grab;
extern int hd_pbuf_min;
extern int hd_vgs_opn;
extern int hd_lvs_opn;
extern int hd_pvs_opn;
extern int hd_pbuf_inuse;
extern int hd_pbuf_maxuse;
#endif


/*
* The following are used to update the bad block directory on a disk
*/
```

**FIG. 21-161**

196

```
#ifdef LVDD_PHYS
struct pbuf *bb_pbuf;      /* ptr to pbuf reserved for BB dir updating  */
struct hd_queue bb_hld;                /* holding Q used when there is a BB    */
                          /* directory update in progress              */
#else
extern struct pbuf        *bb_pbuf;
extern struct hd_queue        bb_hld;
#endif


/*
 * The following variables are used to communicate between the LVDD
 * and the kernel process.
 */
#ifdef LVDD_PHYS
pid_t          hd_kpid   = 0;   /* PID of the kernel process                */
#else
extern pid_t        hd_kpid;
#endif


/*
 * The following variables are used in an attempt to keep some information
 * around about the performance and potential bottle necks in the driver.
 * Currently these must be looked at with crash or the kernel debugger.
 */
#ifdefLVDD_PHYS
ulong          hd_pendqblked  = 0; /* How many times the scheduling queue    */
                          /* (pending_Q) has been block due to no          */
                          /* pbufs being available.              */
#else
extern ulong hd_pendqblked;
#endif


/*
 * The following are used to log error messages by LVDD. The de_data
 * is defined as a general 16 byte array, BUT, it's actual use is
 * totally dependent on the error type.
 */
```

FIG. 21-162

```
# define RESRC_NAME        "LVDD"   /* Resource name for error logging       */
struct hd_errlog_ent {               /* Error log entry structure      */
    struct err_rec0 id;
    char de_dataff[16];
};


/* macros to allocate and free pbuf structures */
#define GET_PBUF(PB)        { \
                (PB) = hd_freebuf;     \
                hd_freebuf = (struct pbuf *) hd_freebuf-> pb.av_forw; \
                hd_pbuf_inuse + + ; \
                if( hd_pbuf_inuse > hd_pbuf_maxuse ) \
                        hd_pbuf_maxuse = hd_pbuf_inuse; \
                }

#define REL_PBUF(PB)        { \
                (PB)-> pb.av_forw = (struct buf *) hd_freebuf; \
                hd_freebuf = (PB); \
                hd_pbuf_inuse--; \
                }


/* macros to allocate and free pv_wait structures */
#define GET_PVWAIT(Pvw, Vg)         { \
                (Pvw) = (Vg)-> ca_freepvw;   \
                (Vg)-> ca_freepvw = (Pvw)-> nxt_pv_wait; \
                }

#define REL_PVWAIT(Pvw, Vg)          { \
                (Pvw)-> nxt_pv_wait = (Vg)-> ca_freepvw; \
                (Vg)-> ca_freepvw = (Pvw); \
                }

#define TST_PVWAIT(Vg) ((Vg)-> ca_freepvw = = NULL)

/*
 * Macro to put volgrp ptr at head of the list of VGs waiting to start
 * MWC cache writes
 */
```

FIG. 21-163

```
# define CA_VG_WRT( Vg )              { \
              if(  !((Vg)-> flags & CA_VGACT) ) \
                     { \
                     (Vg)-> nxtactvg = hd_vg_mwc; \
                     hd_vg_mwc = (Vg); \
                     (Vg)-> flags | = CA_VGACT; \
                     } \
              }
/*
 * Macro to determine if a physical request should be returned to
 * the scheduling layer or continue(resume).
 */
#define PB_CONT( Pb )         { \
   if((((Pb)-> pb_addr = = ((Pb)-> pb_lbuf-> b_baddr + (Pb)-> pb_lbuf->  b_bcount)) || \
      ((Pb)-> pb.b_flags & B_ERROR) ) \
             HD_SCHED( ( Pb) ); \
      else \
             hd_resume( ( Pb) ); \
   }
/*
 * HD_SCHED - - invoke scheduler policy routine for this request.
 *
 *    For physical requests it invokes the physical operation end policy.
 */
#define HD_SCHED(Pb)         (*(Pb)-> pb_sched)(Pb)


/* define for b_error value (only used by LVDD) */
#define ELBBLOCKED 255                     /* this logical request is blocked by      */
                     /* another on in progress       */

#endif         /* _KERNEL */

/*
 * Write consistency cache structures and macros
 */
```

FIG. 21-164

```
/* cache hash algorithms - returns index into cache hash table */
#define CA_HASH(Lb)        (BLK2TRK((Lb)-> b_blkno) & (CAHHSIZE-1))
#define CA_THASH(Trk)      ((Trk) & (CAHHSIZE-1))


/*
 * This structure will generally be referred to as part 2 of the cache
 */
struct ca_mwc_mp {      /* cache mirror write consistency memory only part */

    struct ca_mwc_mp   *hq_next;   /* ptr to next hash queue entry      */
    char               state;          /* State of entry              */
    char               pad1;           /* Pad to word                     */
    ushort             iocnt;          /* Non-zero - io active to LTG       */
    struct ca_mwc_dp   *part1;         /* Ptr to part 1 entry - ca_mwc_dp  */
    struct ca_mwc_mp   *next;          /* Next memory part struct         */
    struct ca_mwc_mp   *prev;          /* Previous memory part struct       */
};
/*ca_mwc_mp state defines */
#define CANOCHG             0x00 /* Cache entry has NOT changed since last */
                                 /* cache write operation, but is on a hash */
                                 /* queue somewhere              */
#define    CACHG            0x01 /* Cache entry has changed since last cache */
                                 /* write operation          */
#define    CACLEAN          0x02 /* Cache entry has not been used since last */
                                 /* clean up operation          */


/*
 * This structure will generally be referred to as part 1 of the cache
 * In order to stay long word aligned this structure has a 2 byte pad.
 * This reduces the number of cache entries available in the cache.
 */
struct ca_mwc_dp {      /* cache mirror write consistency disk part      */

    ulong          lv_ltg;          /* LV logical track group      */
    ushort         lv_minor;  /* LV minor number      */
    short      pad;
};
```

FIG. 21-165

```
#define MAX_CA_ENT          62   /* Max number that will fit in block   */

/*
 * This structure must be maintained to be 1 block in length(512 bytes).
 * This also implies the maximum number of write consistency cache entries.
 */
struct mwc_rec {          /* mirror write consistency disk record     */

    struct timestruc_t    b_tmstamp;      /* Time stamp at beginning of block */
    struct ca_mwc_dp      ca_plff[MAX_CA_ENT]; /* Reserve 62 part 1 structures   */
    struct timestruc_t    e_tmstamp;       /* Time stamp at end of block       */
};


/*
 * This structure is used by the MWCM.  It is hung on the PV cache write
 * queues to indicate which lbufs are waiting on any particular PV.  The
 * define controls how much memory to allocate to hold these structures.
 * The algorithm is 3 * CA_MULT * cache size * size of structure.
 */
#define CA_MULT               4          /* pv_wait * cache size multiplier */
struct pv_wait {
    struct pv_wait        *nxt_pv_wait;   /* next pv_wait structure on chain */
    struct buf            *lb_wait;   /* ptr to lbuf waiting for cache     */
};


/*
 * LVM function declarations - arranged by module in order by how they occur
 * in said module.
 */
#ifdef_KERNEL
#ifndef_NO_PROTO

/* hd_mircach.c */

extern int hd_ca_ckcach (
        register struct buf        *lb, /* current logical buf struct */
        register struct volgrp     *vg, /* ptr to volgrp structure   */
```

FIG. 21-166

```
        register struct lvol       *lv); /* ptr to lvol structure          */

extern void hd_ca_use (
        register struct volgrp      *vg,      /* ptr to volgrp structure   */
        register struct ca_mwc_mp *ca_ent,/* cache entry pointer */
        register int h_t);          /* head/tail flag       */

extern struct ca_mwc_mp *hd_ca_new (
        register struct volgrp      *vg);/* ptr to volgrp structure     */

extern void hd_ca_wrt (void);

extern void hd_ca_wend (
        register struct pbuf *pb);      /* Address of pbuf completed      */

extern void hd_ca_sked (
        register struct volgrp      *vg, /* ptr to volgrp structure   */
        register struct pvol       *pvol);    /* pvol ptr for this PV              */

extern struct ca_mwc_mp *hd_ca_fnd (
        register struct volgrp      *vg, /* ptr to volgrp structure     */
        register struct buf        *lb); /* ptr to lbuf to find the entry*/
                                   /* for                 */

extern void hd_ca_clnup (
        register struct volgrp      *vg);/* ptr to volgrp structure    */

extern void hd_ca_qunlk (
        register struct volgrp      *vg, /* ptr to volgrp structure   */
        register struct ca_mwc_mp  *ca_ent);/* ptr to entry to unlink    */

extern int hd_ca_pvque (
        register struct buf        *lb,  /* current logical buf struct */
        register struct volgrp      *vg, /* ptr to volgrp structure   */
        register struct lvol       *lv); /* ptr to lvol structure        */

extern void hd_ca_end (
        register struct pbuf *pb);      /* physical device buf struct */
```

FIG. 21-167

202

```
extern void hd_ca_term (
        register struct buf         *lb); /* current logical buf struct   */

extern void hd_ca_mvhld (
        register struct volgrp    *vg);/* ptr to volgrp structure    */

/* hd_dump.c */

extern int hd_dump (
        dev_t              dev,  /* major/minor of LV            */
        struct uio  *uiop,       /* ptr to uio struct describing operation*/
        int           cmd, /* dump command                        */
        char          *arg, /* cmd dependent - ptr to dmp_query struct */
        int           chan,      /* not used                        */
        int           ext);  /* not used

extern int hd_dmpxlate (
        register dev_t             dev, /* major/minor of LV          */
        register struct uio        *luiop,    /* ptr to logical uio structure     */
        register struct volgrp    *vg);/* ptr to VG from device switch table*/

/* hd_top.c */

extern int hd_open (
        dev_t dev, /* device number major,minor of LV to be opened  */
        int flags,    /* read/write flag          */
        int chan,   /* not used                  */
        int ext);    /* not used                  */

extern int hd_allocpbuf(void);

extern void hd_pbufdmpq(
        register struct pbuf *pb,            /* new pbuf for chain */
        register struct pbuf **qq);          /* Ptr to queue anchor     */

extern void hd_openbkout(
        int              bopoint,    /* point to start backing out      */
```

FIG. 21-168

203

```
        struct volgrp      *vg);        /* struct volgrp ptr        */

extern void hd_backout(
        int         bopoint,/* point where error occurred & need to    */
                            /* backout all structures pinned before  */
                            /* this point                     */
        struct lvol  *lv,   /* ptr to lvol to backout           */
        struct volgrp      *vg);  /* struct volgrp ptr              */

extern int hd_close(
        dev_t    dev,   /* device number major,minor of LV to be closed */
        int chan,        /* not used */
        int ext);    /* not used */

extern void hd_vgcleanup(
        struct volgrp      *vg);        /* struct volgrp ptr             */

extern void hd_frefrebb(void);

extern int hd_allocbblk(void);

extern int hd_read(
        dev_t        dev,               /* num major,minor of LV to be read      */
        struct uio *uiop,  /* pointer to uio structure that specifies   */
                           /* location & length of caller's data buffer*/
        int       chan,   /* not used */
        int       ext);   /* extension parameters */

extern int hd_write(
        dev_t        dev,               /* num major,minor of LV to be written    */
        struct uio *uiop,  /* pointer to uio structure that specifies  */
                           /* location & length of caller's data buffer*/
        int       chan,   /* not used */
        int       ext);   /* extension parameters */

extern int hd_mincnt(
        struct buf  *bp,     /* ptr to buf struct to be checked */
        void          *minparms); /* ptr to ext value sent to uphysio by*/
```

FIG. 21-169

204

```
                    /* hd_read/hd_write.                    */

extern int hd_ioctl(
        dev_t      dev,  /* device number major,minor of LV to be opened */
        int    cmd, /* specific ioctl command to be performed   */
        int    arg,        /* addr of parameter blk for the specific cmd   */
        int    mode,     /* request origination                        */
        int    chan,      /* not used */
        int    ext); /* not used */

extern struct mwc_rec * hd_alloca(void);

extern void hd_dealloca(
        register struct mwc_rec *ca_ptr); /* ptr to cache to free */

extern void hd_nodumpvg(
        struct volgrp  *);

/*hd_phys.c */

extern void hd_begin(
        register struct pbuf *pb,      /* physical device buf struct */
        register struct volgrp *vg);   /* pointer to volgrp struct     */

extern void hd_end(
        register struct pbuf *pb);      /* physical device buf struct */

extern void hd_resume(
        register struct pbuf *pb);      /* physical device buf struct */

extern void hd_ready(
        register struct pbuf *pb);      /* physical request buf            */

extern void hd_start(void);

extern void hd_gettime(
        register struct timestruc_t *o_time);   /* old time            */
```

FIG. 21-170

```
/* hd_bbrel.c */

extern int hd_chkblk(
        register struct pbuf *pb);      /* physical device buf struct  */

extern void hd_bbend(
        register struct pbuf *pb);      /* physical device buf struct  */

extern void hd_baddone(
        register struct pbuf *pb);      /* physical request to process  */

extern void hd_badblk(
        register struct pbuf *pb);      /* physical request to process  */

extern void hd_swreloc(
        register struct pbuf *pb);      /* physical request to process  */

extern daddr_t hd_assignalt(
        register struct pbuf *pb);      /* physical request to process  */

extern struct bad_blk *hd_fndbbrel(
        register struct pbuf *pb);      /* physical request to process  */

extern void hd_nqbblk(
        register struct pbuf *pb);      /* physical request to process  */

extern void hd_dqbblk(
        register struct pbuf *pb,       /* physical request to process  */
        register daddr_t blkno);

/* hd_sched.c */

extern void hd_schedule(void);

extern int hd_avoid(
        register struct buf     *lb,  /* logical request buf  */
        register struct volgrp  *vg);/* VG volgrp ptr        */
```

FIG. 21-171

206

```
extern void hd_resyncpp(
        register struct pbuf *pb);      /* physical device buf struct */

extern void hd_freshpp(
        register struct volgrp   *vg, /* pointer to volgrp struct    */
        register struct pbuf     *pb);      /* physical request buf              */

extern void hd_mirread(
        register struct pbuf *pb);      /* physical device buf struct */

extern void hd_fixup(
        register struct pbuf *pb);      /* physical device buf struct */

extern void hd_stalepp(
        register struct volgrp   *vg, /* pointer to volgrp struct    */
        register struct pbuf *pb);      /* physical device buf struct */

extern void hd_staleppe(
        register struct pbuf *pb);      /* physical request buf              */

extern void hd_xlate(
        register struct pbuf     *pb, /* physical request buf              */
        register int         mirror,   /* mirror number                     */
        register struct     volgrp     *vg); /* VG volgrp ptr              */

extern int hd_regular(
        register struct buf      *lb,  /* logical request buf           */
        register struct volgrp   *vg);/* volume group structure       */

extern void hd_finished(
        register struct pbuf *pb);      /* physical device buf struct */

extern int hd_sequential(
        register struct buf      *lb,  /* logical request buf           */
        register struct volgrp   *vg);/* volume group structure       */

extern int hd_seqnext(
        register struct pbuf     *pb  /* physical request buf              */
```

FIG. 21-172

207

```
        register struct    volgrp      *vg); /* VG volgrp pointer           */

extern void hd_seqwrite(
        register struct pbuf *pb);      /* physical device buf struct */

extern int hd_parallel(
        register struct buf      *lb, /* logical request buf          */
        register struct volgrp    *vg);/* volume group structure     */

extern void hd_freeall(
        register struct pbuf *q);       /* write request queue          */

extern void hd_append(
        register struct pbuf *pb,       /* physical request pbuf      */
        register struct pbuf **qq);     /* Ptr to write request queue anchor */

extern void hd_nearby(
        register struct pbuf    *pb, /* physical request pbuf      */
        register struct buf      *lb, /* logical request buf          */
        register int        mask,     /* mirrors to avoid             */
        register struct volgrp    *vg, /* volume group structure     */
        register struct lvol      *lv);

extern void hd_parwrite(
        register struct pbuf *pb);      /* physical device buf struct */

/* hd_strat.c */

extern void hd_strategy(
        register struct buf *lb);       /* input list of logical buf structs */

extern void hd_initiate(
        register struct buf *lb);       /* input list of logical buf's */

extern struct buf *hd_reject(
        struct buf *lb,             /* offending buf structure    */
        int         errno);         /* error number                 */
```

FIG. 21-173

```
extern void hd_quiescevg(
       struct volgrp      *vg);   /* pointer from device switch table    */

extern void hd_quiet(
       dev_t              dev,   /* number major,minor of LV to quiesce    */
       struct volgrp      *vg);  /* ptr from device switch table          */

extern void hd_redquiet(
       dev_t              dev,       /* number major,minor of LV          */
       struct hd_lvred    *red_lst);   /* ptr to list of PPs to remove       */

extern int hd_add2pool(
       register struct pbuf *subpool,      /* ptr to pbuf sub pool                */
       register struct pbuf *dmpq);  /* ptr to pbuf dump queue   */

extern void hd_deallocpbuf(void);

extern int hd_numpbufs(void);

extern void hd_terminate(
       register struct buf *lb);        /* logical buf struct             */

extern void hd_unblock(
       register struct buf *next,     /* first request on hash chain    */
       register struct buf *lb);      /* logical request to reschedule*/

extern void hd_quelb (
       register struct buf      *lb,  /* current logical buf struct   */
       register struct hd_queue *que);   /* queue structure ptr          */

extern int hd_kdis_initmwc(
       struct volgrp *vg);            /* volume group pointer */

extern int hd_kdis_dswadd(
       register dev_t           device    /* device number of the VG   */
       register struct devsw    *devsw); /* address of the devsw entry    */
```

FIG. 21-174

```
extern int hd_kdis_chgqrm(
        struct volgrp      *vg),        /* volume group pointer */
        short              newqrm);  /* new quorum count */


extern int hd_kproc(void);


/* hd_vgsa.c */


extern int hd_sa_strt(
        register struct pbuf      *pb, /* physical device buf struct  */
        register struct volgrp    *vg, /* volgrp pointer              */
        register int       type);     /* type of request             */


extern void hd_sa_wrt(
        register struct volgrp    *vg);/* volgrp pointer              */


extern void hd_sa_iodone(
        register struct buf       *lb); /* ptr to lbuf in VG just completed */


extern void hd_sa_cont(
        register struct volgrp    *vg, /* volgrp pointer              */
        register int sa_updated);     /* ptr to lbuf in VG just completed */


extern void hd_sa_hback(
        register struct pbuf      *head_ptr, /* head of pbuf list           */
        register struct pbuf      *new_pbuf); /* ptr to pbuf to append to list */


extern void hd_sa_rtn(
        register struct pbuf      *head_ptr, /* head of pbuf list           */
        register int err_flg);     /* if true return requests with     */
                                   /* ENXIO error                 */


extern int hd_sa_whladv(
        register struct volgrp    *vg, /* volgrp pointer              */
        register int c_whl_idx);      /* current wheel index         */


extern void hd_sa_update(
        register struct volgrp    *vg);/* volgrp pointer              */
```

FIG. 21-175

210

```
extern int hd_sa_qrmchk(
        register struct volgrp     *vg);/* volgrp pointer                    */

extern int hd_sa_config(
        register struct volgrp     *vg  /* volgrp pointer                    */
        register int      type,  /* type of hd_config request  */
        register caddr_t  arg);  /* ptr to arguments for the request */

extern int hd_sa_onerev(
        register struct volgrp     *vg, /* volgrp pointer                    */
        register struct pbuf       *pv, /* ptr pbuf structure                */
        register int      type);       /* type of hd_config request  */

extern void hd_bldpbuf (
        register struct pbuf       *pb, /* ptr to pbuf struct                */
        register struct pvol       *pvol,     /* target pvol ptr             */
        register int      type, /* type of pbuf to build       */
        register caddr_t  bufaddr,/* data buffer address - system  */
        register unsigned cnt,   /* length of buffer            */
        register struct xmem       *xmem,   /* ptr to cross memory descriptor*/
        register void              (*sched)());  /* ptr to function ret void */

extern int hd_extend (
        register sa_ext *saext);        /* ptr to structure with extend info  */

extern void hd_reduce (
        struct sa_red *sared,           /* ptr to structure with reduce info  */
        struct volgrp *vg);             /* ptr to volume group structure */

/* hd_bbdir.c */

extern void hd_upd_bbdir(
        register struct pbuf *pb);      /* physical request to process  */

extern void hd_bbdirend(
        register struct pbuf *vgpb);  /* ptr to VG bb_pbuf             */

extern void hd_bbdirop( void );
```

FIG. 21-176

211

```
extern int hd_bbadd(
        register struct pbuf *vgpb);   /* ptr to VG bb_pbuf          */

extern int hd_bbdel(
        register struct pbuf *vgpb);   /* ptr to VG bb_pbuf          */

extern int hd_bbupd(
        register struct pbuf *vgpb);   /* ptr to VG bb_pbuf          */

extern void hd_chk_bbhld( void );

extern void hd_bbdirdone(
        register struct pbuf *origpb);        /* physical request to process  */

extern void hd_logerr(
        register unsigned id,    /* original request to process        */
        register ulong          dev, /* device number                  */
        register ulong          arg1,
        register ulong          arg2);

#else

/*      See above for description of call arguments     */

/* hd_mircach.c */

extern int          hd_ca_ckcach ();
extern void                 hd_ca_use ( );
extern struct ca_mwc_mp     *hd_ca_new ( );
extern void                 hd_ca_wrt ( );
extern void                 hd_ca_wend ( );
extern void                 hd_ca_sked ( );
extern struct ca_mwc_mp    *hd_ca_fnd ( );
extern void                 hd_ca_clnup ( );
extern void                 hd_ca_qunlk ( );
extern int          hd_ca_pvque ();
extern void                 hd_ca_end ( );
```

FIG. 21-177

```
extern void              hd_ca_term ( );
extern void              hd_ca_mvhld ( );

/* hd_dump.c */

extern int       hd_dump ( );
extern int       hd_dmpxlate ( );

/* hd_top.c */

extern int       hd_open ( );
extern int       hd_allocpbuf ( );
extern void          hd_pbufdmpq ( );
extern void          hd_openbkout ( );
extern void          hd_backout ( );
extern int       hd_close ( );
extern int       hd_vgcleanup ( );
extern void          hd_frefrebb ( );
extern int       hd_allocbblk ( );
extern int       hd_read ( );
extern int       hd_write ( );
extern int       hd_mincnt ( );
extern int       hd_ioctl ( );
extern struct mwc_rec   *hd_alloca ( );
extern void          hd_dealloca ( );
extern void          hd_nodumpvg ( );

/* hd_phys.c */

extern void          hd_begin ( );
extern void          hd_end ( );
extern void          hd_resume ( );
extern void          hd_ready ( );
extern void          hd_start ( );
extern void          hd_gettime ( );

/* hd_bbrel.c */
```

**FIG. 21-178**

```
extern int          hd_chkblk ( );
extern void           hd_bbend ( );
extern void           hd_baddone ( );
extern void           hd_badblk ( );
extern void           hd_swreloc ( );
extern daddr_t        hd_assignalt ( );
extern struct bad_blk   *hd_fndbbrel ( );
extern void           hd_nqbblk ( );
extern void           hd_dqbblk ( );


/* hd_sched.c */


extern void           hd_schedule ( );
extern int          hd_avoid ( );
extern void           hd_resyncpp ( );
extern void           hd_freshpp ( );
extern void           hd_mirread ( );
extern void           hd_fixup ( );
extern void           hd_stalepp ( );
extern void           hd_staleppe ( );
extern void           hd_xlate ( );
extern int          hd_regular ( );
extern void           hd_finished ( );
extern int          hd_sequential ( );
extern int          hd_seqnext ( );
extern void           hd_seqwrite ( );
extern int          hd_parallel ( );
extern void           hd_freeall ( );
extern void           hd_append ( );
extern void           hd_nearby ( );
extern void           hd_parwrite ( );


/* hd_strat.c */


extern void           hd_strategy ( );
extern void           hd_initiate ( );
extern struct buf    *hd_reject ( );
extern void           hd_quiescevg ( );
```

FIG. 21-179

```
extern void            hd_quiet ( );
extern void            hd_redquiet ( );
extern int      hd_add2pool ( );
extern void            hd_deallocpbuf ( );
extern int      hd_numpbufs ( );
extern void            hd_terminate ( );
extern void            hd_unblock ( );
extern void            hd_quelb ( );
extern void            hd_kdis_dswadd ( );
extern void            hd_kdis_initmwc ( );
extern int      hd_kdis_chgqrm ( );
extern int      hd_kproc ( );


/* hd_vgsa.c */

extern int      hd_sa_strt ( );
extern void            hd_sa_wrt ( );
extern void            hd_sa_iodone ( );
extern void            hd_sa_cont ( );
extern void            hd_sa_hback ( );
extern void            hd_sa_rtn ( );
extern int      hd_sa_whladv ( );
extern void            hd_sa_update ( );
extern int      hd_sa_qrmchk ( );
extern int      hd_sa_config ( );
extern void            hd_bldpbuf ( );
extern int      hd_extend ( );
extern void            hd_reduce ( );
extern void            hd_sa_onerev ( );


/* hd_bbdir.c */

extern void            hd_upd_bbdir ( );
extern void            hd_bbdirend ( );
extern void            hd_bbdirop ( );
extern int      hd_bbadd ( );
extern int      hd_bbdel ( );
```

FIG. 21-180

```
extern int        hd_bbupd ( );
extern void          hd_chk_bbhld ( );
extern void          hd_bbdirdone ( );
extern void          hd_logerr ( );

#endif     /* _NO_PROTO */
#endif     /* _KERNEL  */

#endif /* _H_HD */
```

FIG. 21-181